# EUROPÄISCHE PATENTSCHRIFT

(11) **EP 3 768 692 B1**
(45) Veröffentlichungstag und Bekanntmachung des Hinweises auf die Patenterteilung: **17.08.2022**
(21) Anmeldenummer: 19710422.7
(22) Anmeldetag: 18.03.2019
(51) Int. Cl.: C07F 15/00, H01L 51/50, H01L 51/00

(54) **METALLKOMPLEXE**
METAL COMPLEXES
COMPLEXES MÉTALLIQUES

(30) Priorität: 19.03.2018 EP 18162438
(43) Veröffentlichungstag der Anmeldung: 27.01.2021
(73) Patentinhaber: Merck Patent GmbH, 64293 Darmstadt (DE)
(72) Erfinder: STOESSEL, Philipp, 60389 Frankfurt am Main (DE); EHRENREICH, Christian, 64285 Darmstadt (DE); AUCH, Armin, 64293 Darmstadt (DE)
(86) Internationale Anmeldenummer: PCT/EP2019/056648
(87) Internationale Veröffentlichungsnummer: WO 2019/179909

(56) Entgegenhaltungen:
- US-A1- 2015 069 334

## Beschreibung

Die vorliegende Erfindung betrifft Metallkomplexe, welche sich für den Einsatz als Emitter in organischen Elektrolumineszenzvorrichtungen und organischen Sensoren eignen.

Gemäß dem Stand der Technik werden in phosphoreszierenden organischen Elektrolumineszenzvorrichtungen (OLEDs) als Triplettemitter vor allem bis- und tris-ortho-metallierte Iridiumkomplexe sowie bis-ortho-metallierte Platinkomplexe mit aromatischen Liganden eingesetzt, wobei die Liganden über ein negativ geladenes Kohlenstoffatom und ein neutrales Stickstoffatom oder über ein negativ geladenes Kohlenstoffatom und ein neutrales Carben-Kohlenstoffatom an das Metall binden. Beispiele für solche Komplexe sind Tris(phenylpyridyl)iridium(III) und Derivate davon, wobei als Liganden beispielsweise 1- oder 3-Phenylisochinoline, 2-Phenylchinoline oder Phenylcarbene eingesetzt werden. Dabei weisen die Iridiumkomplexe im Allgemeinen eine recht lange Lumineszenzlebensdauer im Bereich von deutlich über 1 µs auf. Für die Verwendung in OLEDs sind jedoch kurze Lumineszenzlebensdauern gewünscht, um die OLED bei einer hohen Helligkeit mit einem geringen Roll-off-Verhalten betreiben zu können. Auch bei der Effizienz insbesondere rot phosphoreszierender Emitter gibt es noch Verbesserungsbedarf. Durch das geringe Triplettniveau T₁ liegt bei üblichen rot phosphoreszierenden Emittern die Photolumineszenzquantenausbeute häufig deutlich unter dem theoretisch möglichen Wert, da bei kleinem T₁ nicht-radiative Kanäle eine größere Rolle spielen, insbesondere wenn der Komplex eine hohe Lumineszenzlebensdauer aufweist. Hier ist eine Verbesserung durch Erhöhung der radiativen Raten wünschenswert, was wiederum durch eine Reduktion der Photolumineszenzlebensdauer erreicht werden kann.

Eine Verbesserung der Stabilität der Iridiumkomplexe kann durch die Verwendung polypodaler Liganden erreicht werden, wie beispielsweise in WO 2016/124304 beschrieben. Bei Platinkomplexen kann eine Verbesserung durch die Verwendung tetradentater Liganden erzielt werden, wie beispielsweise in WO 2005/042550 beschrieben. Diese Komplexe zeigen, je nach Ligandenstruktur, rote, orange, gelbe, grüne oder blaue Emission. Aus US 2015/0069334 A1 sind Metallkomplexe bekannt, in denen ein Iridium- und ein Platinkomplex miteinander über eine Einfachbindung oder eine organische Gruppe verknüpft sind und in denen der Platinkomplex einen tetradentaten Liganden enthält.

Auch bei Komplexen mit polypodalen bzw. tetradentaten Liganden sind noch Verbesserungen in Bezug auf die Eigenschaften bei Verwendung in einer organischen Elektrolumineszenzvorrichtung, insbesondere in Bezug auf die Lumineszenzlebensdauer des angeregten Zustands und/oder die Effizienz, aber auch die Spannung und/oder die Lebensdauer wünschenswert.

Ein noch nicht zufriedenstellend gelöstes technisches Problem ist weiterhin die Bereitstellung von organischen bzw. metallorganischen Verbindungen, die effizient Licht im infraroten Bereich des Spektrums emittieren, und auch bei tiefrot emittierenden Verbindungen sind noch weitere Verbesserungen wünschenswert. Insbesondere Verbindungen, welche im infraroten Bereich des Spektrums emittieren, sind von Interesse für die Verwendung für Sensoren, beispielsweise für Fingerabdrucksensoren oder Augeniris-Sensoren. Für IR-Augeniris-Sensoren werden die Augen mit IR-Licht beleuchtet, und das charakteristische Muster des vom Auge reflektierten IR-Lichts wird von einer IR-Kamera detektiert. Als Lichtquelle können hierfür organische Elektrolumineszenzvorrichtungen verwendet werden, die im infraroten Bereich des Spektrums emittieren, so dass hierfür die Bereitstellung infraroter Emitter erforderlich ist.

Aufgabe der vorliegenden Erfindung ist daher die Bereitstellung neuer Metallkomplexe, welche sich als Emitter für die Verwendung in OLEDs und in Sensoren eignen. Insbesondere ist die Aufgabe, Emitter bereitzustellen, welche verbesserte Eigenschaften in Bezug auf Lumineszenzlebensdauer, Effizienz, Betriebsspannung und/oder Lebensdauer zeigen. Aufgabe ist weiterhin die Bereitstellung von Emittern, die im tiefroten oder infraroten Bereich des Spektrums emittieren.

Überraschend wurde gefunden, dass die unten beschriebenen binuklearen, trinuklearen und tetranuklearen Iridium-/Platinkomplexe Verbesserungen der photophysikalischen Eigenschaften zeigen gegenüber entsprechenden mononuklearen Komplexen und dadurch auch zu verbesserten Eigenschaften bei Verwendung in einer organischen Elektrolumineszenzvorrichtung führen. Insbesondere weisen die erfindungsgemäßen Verbindungen eine verbesserte Photolumineszenzquantenausbeute sowie eine deutlich reduzierte Lumineszenzlebensdauer auf. Eine geringere Lumineszenzlebensdauer führt zu einem verbesserten Roll-off-Verhalten der organischen Elektrolumineszenzvorrichtung. Weiterhin zeigen die Komplexe orientierte Emission, so dass ihre Emission eine verbesserte Effizienz aufweist. Weiterhin emittieren diese Komplexe im tiefroten bzw. infraroten Bereich des Spektrums, so dass insbesondere auch Komplexe zugänglich sind, die hocheffiziente infrarote Emission zeigen. Diese Komplexe und organische Elektrolumineszenzvorrichtungen und Sensoren, welche diese Komplexe enthalten, sind der Gegenstand der vorliegenden Erfindung.

Gegenstand der Erfindung ist eine Verbindung gemäß der folgenden Formel (1a), (1b), (1c), (1d), (1e) oder (1f), 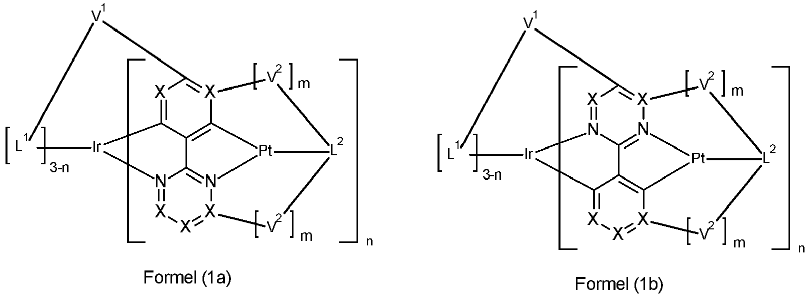 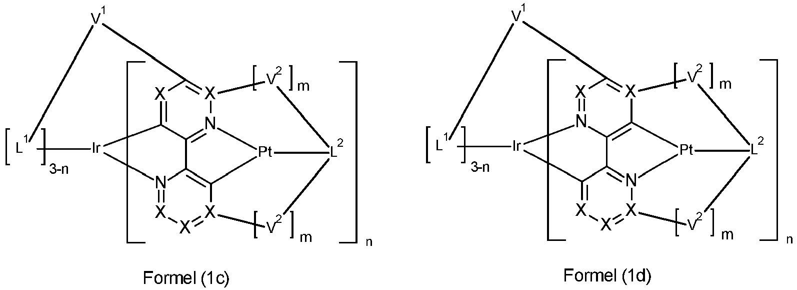 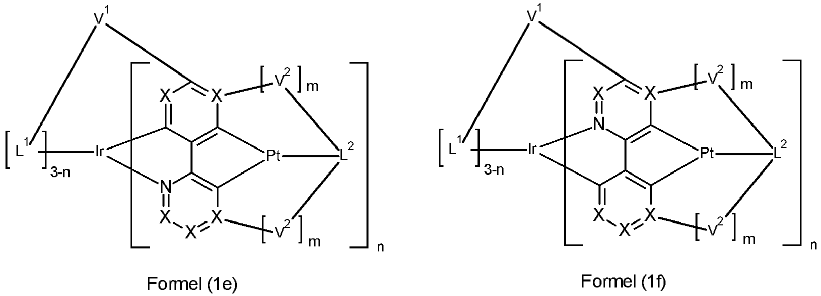 wobei für die verwendeten Symbole und Indizes gilt:
- X: ist bei jedem Auftreten gleich oder verschieden CR oder N;
- L¹, L²: ist gleich oder verschieden bei jedem Auftreten ein bidentater Teilligand;
- V¹: ist eine trivalente Gruppe, die den bzw. die zentralen Teilliganden, je nach Wahl von n, miteinander und mit L¹ verknüpft;
- V²: ist eine bivalente Gruppe oder eine Einfachbindung, die den zentralen Teilliganden und L² miteinander verknüpft;
- n: ist 1, 2 oder 3;
- m: ist bei jedem Auftreten gleich oder verschieden 0 oder 1, wobei für m = 1 das Atom X, an das die entsprechende Gruppe V² gebunden ist, für C steht; mit der Maßgabe, dass in jedem Platin-Teilkomplex mindestens ein m = 1 ist;
- R: ist bei jedem Auftreten gleich oder verschieden H, D, F, Cl, Br, I, N(R¹)₂, CN, NO₂, OR¹, SR¹, COOR¹, C(=O)N(R¹)₂, Si(R¹)₃, B(OR¹)₂, C(=O)R¹, P(=O)(R¹)₂, S(=O)R¹, S(=O)₂R¹, OSO₂R¹, eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R¹ substituiert sein kann, wobei eine oder mehrere nicht benachbarte CH₂-Gruppen durch Si(R¹)₂, C=O, NR¹, O, S oder CONR¹ ersetzt sein können, oder ein aromatisches oder heteroaromatisches Ring-system mit 5 bis 40 aromatischen Ringatomen, das jeweils durch einen oder mehrere Reste R¹ substituiert sein kann; dabei können zwei Reste R auch miteinander ein Ringsystem bilden;
- R¹: ist bei jedem Auftreten gleich oder verschieden H, D, F, Cl, Br, I, N(R²)₂, CN, NO₂, OR², SR², Si(R²)₃, B(OR²)₂, COOR², C(=O)R², P(=O)(R²)₂, S(=O)R², S(=O)₂R², OSO₂R², eine geradkettige Alkyl-gruppe mit 1 bis 20 C-Atomen oder eine Alkenyl- oder Alkinylgruppe mit 2 bis 20 C-Atomen oder eine verzweigte oder cyclische Alkyl-gruppe mit 3 bis 20 C-Atomen, wobei die Alkyl-, Alkenyl- oder Alkinylgruppe jeweils mit einem oder mehreren Resten R² substituiert sein kann, wobei eine oder mehrere nicht benachbarte CH₂-Gruppen durch Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann; dabei können zwei oder mehrere Reste R¹ miteinander ein Ringsystem bilden;
- R²: ist bei jedem Auftreten gleich oder verschieden H, D, F oder ein aliphatischer, aromatischer oder heteroaromatischer organischer Rest, insbesondere ein Kohlenwasserstoffrest, mit 1 bis 20 C-Atomen, in dem auch ein oder mehrere H-Atome durch F ersetzt sein können.

Wenn zwei Reste R bzw. R¹ miteinander ein Ringsystem bilden, so kann dieses mono- oder polycyclisch, aliphatisch, heteroaliphatisch, aromatisch oder heteroaromatisch sein. Dabei können die Reste, die miteinander ein Ringsystem bilden, benachbart sein, d. h. dass diese Reste an dasselbe Kohlenstoffatom oder an Kohlenstoffatome, die direkt aneinander gebunden sind, gebunden sind, oder sie können weiter voneinander entfernt sein. Bevorzugt ist eine solche Ringbildung bei Resten, die an direkt aneinander gebundene Kohlenstoffatome oder an dasselbe Kohlenstoffatom gebunden sind.

Unter der Formulierung, dass zwei oder mehr Reste miteinander einen Ring bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht.

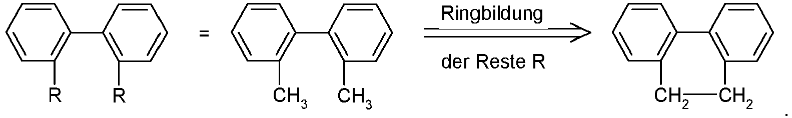

Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

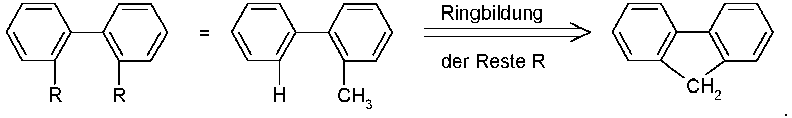

Die Bildung eines aromatischen Ringsystems soll durch das folgende Schema verdeutlicht werden:

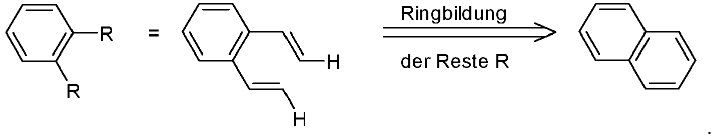

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 40 C-Atome im Ringsystem. Ein heteroaromatisches Ringsystem im Sinne dieser Erfindung enthält 1 bis 40 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl, Terphenyl, Quaterphenyl oder Bipyridin, ebenfalls als aromatisches bzw. heteroaromatisches Ringsystem verstanden werden. Bevorzugte aromatische bzw. heteroaromatische Ringsysteme sind Aryl- bzw. Heteroarylgruppen, sowie Systeme, in denen zwei oder mehrere Aryl- oder Heteroarylgruppen direkt aneinander gebunden sind, und Fluoren- und Spirobifluorengruppen.

Unter einer cyclischen Alkylgruppe im Sinne dieser Erfindung wird eine monocyclische, eine bicyclische oder eine polycyclische Gruppe verstanden.

Im Rahmen der vorliegenden Erfindung werden unter einer C₁- bis C₂₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₂₀-Alkoxygruppe, wie sie für OR¹ bzw. OR² vorliegt, werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 40 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Der Begriff "bidentater Teilligand" für L¹ bzw. L² bedeutet im Sinne dieser Anmeldung, dass es sich bei dieser Einheit um einen bidentaten Liganden handeln würde, wenn die Gruppe V¹ bzw. V² nicht vorhanden wäre. Durch die formale Abstraktion eines Wasserstoffatoms von diesem bidentaten Liganden und die Verknüpfung mit V¹ bzw. V² ist dieser jedoch kein separater Ligand, sondern ein Teil des so entstehenden höherdentaten Liganden, so dass hierfür der Begriff "Teilligand" verwendet wird.

Oben und in der nachfolgenden Beschreibung wird der Begriff "zentraler Teilligand" verwendet. Hierunter wird erfindungsgemäß jeder Teilligand innerhalb der Verbindung der Formel (1) verstanden, der gleichzeitig an Ir und Pt koordiniert.

Zur weiteren Veranschaulichung der erfindungsgemäßen Verbindung werden im Folgenden zwei einfache Strukturen gemäß Formel (1) vollständig dargestellt und erläutert:

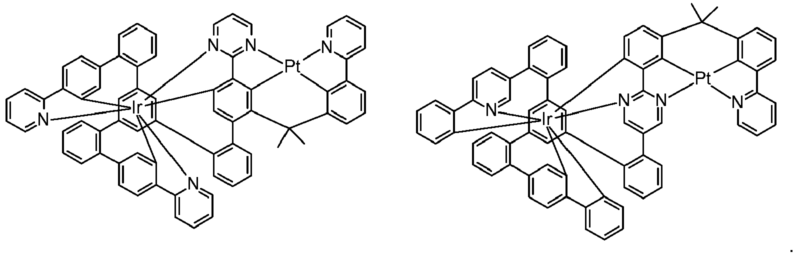

In diesen Strukturen steht der zentrale Teilligand, der an Iridium und Platin koordiniert ist, für eine 2-Phenylpyrimidingruppe. Die Gruppe V¹, die den zentralen Teilliganden und die beiden Teilliganden L¹ verbrückt, steht für eine 1,3,5-Triphenylbenzolgruppe. Die Gruppe V², die den zentralen Teilliganden und den Teilliganden L² verbrückt, steht für C(CH₃)₂. An die Gruppe V¹ sind noch zwei Teilliganden L¹ gebunden, welche in den oben abgebildeten Strukturen jeweils für Phenylpyridin stehen. An die Gruppe V² ist noch ein Teilligand L² gebunden, welcher in den oben abgebildeten Strukturen für Phenylpyridin steht. Der Index n ist 1, das heißt, die Struktur enthält nur ein Platinatom. In jeder der beiden Strukturen ist ein Index m = 1 und der andere Index m = 0, wobei in der ersten Struktur die Gruppe V² an denselben Cyclus gebunden ist wie die Gruppe V¹ und in der zweiten Struktur die Gruppen V¹ und V² an die beiden unterschiedlichen Cyclen des zentralen Teilliganden gebunden sind. Das Iridium ist somit in den oben abgebildeten Strukturen an zwei Phenylpyridin-Teilliganden und einen Phenylpyrimidin-Teilliganden koordiniert, und das Platin ist an einen Phenylpyridin-Teilliganden und einen Phenylpyrimidin-Teilliganden koordiniert. Dabei koordiniert die Phenylgruppe und die Pyrimidingruppe des Phenylpyrimidins sowohl an das Iridium wie auch an das Platin.

Die Bindung des Liganden an das Iridium bzw. Platin kann sowohl eine Koordinationsbindung als auch eine kovalente Bindung sein, bzw. der kovalente Anteil an der Bindung kann je nach Ligand variieren. Wenn in der vorliegenden Anmeldung die Rede davon ist, dass der Ligand bzw. der Teilligand an Iridum bzw. Platin koordiniert oder bindet, so bezeichnet dies im Sinne der vorliegenden Anmeldung jede Art der Bindung des Liganden bzw. Teilliganden an das Metall, unabhängig vom kovalenten Anteil der Bindung.

Die erfindungsgemäßen Verbindungen sind bevorzugt nicht geladen, d. h. sie sind elektrisch neutral. Dies wird dadurch erreicht, dass die Ladung der Teilliganden die Ladung der Metallatome kompensieren. Es ist daher bevorzugt, wenn das Iridiumatom, welches in der Oxidationsstufe +III vorliegt, an drei bidentate Teilliganden koordiniert, die insgesamt drei negative Ladungen aufweisen, und wenn das Platinatom, welches in der Oxidationsstufe +II vorliegt, an zwei bidentate Teilliganden koordiniert, die insgesamt zwei negative Ladungen aufweisen, wobei der zentrale Teilligand, der gleichzeitig an Ir und Pt koordiniert, bevorzugt zwei negative Ladungen aufweist. Dabei ist es bevorzugt, wenn jeder der Teilliganden L¹ und L² monoanionisch ist. Es ist aber auch möglich, dass beispielsweise der zentrale Teilligand, der an Ir und Pt koordiniert, über zwei neutrale Stickstoffatome an das Pt koordiniert und L² über zwei anionische Kohlenstoffatome an das Pt koordiniert. Ebenso ist es möglich, dass beispielsweise der zentrale Teilligand, der an Ir und Pt koordiniert, über zwei anionische Kohlenstoffatome an das Pt koordiniert und L² über zwei neutrale Stickstoffatome an das Pt koordiniert.

Für n = 1 handelt es sich bei der erfindungsgemäßen Verbindung um eine binukleare Verbindung, welche ein Iridium- und ein Platinatom aufweist. Für n = 2 handelt es sich bei der erfindungsgemäßen Verbindung um eine trinukleare Verbindung, welche ein Iridium- und zwei Platinatome aufweist. Für n = 3 handelt es sich bei der erfindungsgemäßen Verbindung um eine tetranukleare Verbindung, welche ein Iridium- und drei Platinatome aufweist. In einer bevorzugten Ausführungsform der Erfindung ist n = 1.

In den erfindungsgemäßen Verbindungen ist das Ir von einem Kohlenstoffatom und einem Stickstoffatom des zentralen Teilliganden koordiniert und das Pt ist von einem Kohlenstoffatom und einem Stickstoffatom oder von zwei Kohlenstoffatomen des zentralen Teilliganden koordiniert. Da der zentrale Teilligand in den Formeln (1e) und (1f) über zwei anionische Kohlenstoffatome an Pt koordiniert, ist es bevorzugt, wenn der Teilligand L² in diesen Strukturen über zwei neutrale Atome an Pt koordiniert, insbesondere über zwei neutrale Stickstoffatome.

Besonders bevorzugt ist sowohl das Ir wie auch das Pt von jeweils einem Kohlenstoffatom und einem Stickstoffatom des zentralen Teilliganden koordiniert, so dass bevorzugte Ausführungsformen die Strukturen der Formeln (1a) bis (1d) sind.

In einer bevorzugten Ausführungsform ist ein Index m = 1 und der andere Index m = 0, so dass die erfindungsgemäße Verbindung bevorzugt genau eine Gruppe V² pro Platin-Teilkomplex aufweist. Weiterhin ist es in Verbindungen, die nur eine Gruppe V² aufweisen, bevorzugt, wenn diese am zentralen Teilliganden an die Aryl- oder Heteroarylgruppe gebunden ist, die über ein Kohlenstoff an das Ir koordiniert. Bevorzugte Verbindungen sind somit die Verbindungen der folgenden Formeln (1a-1) bis (1f-1), 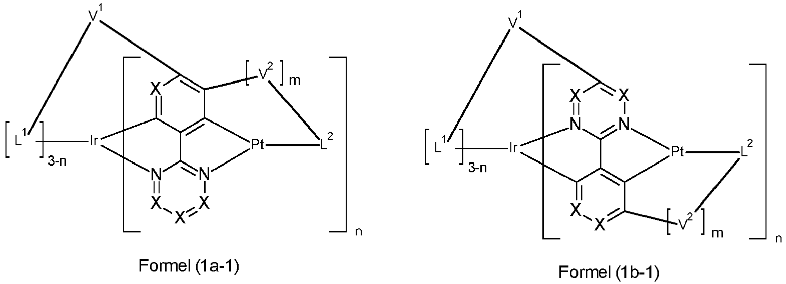 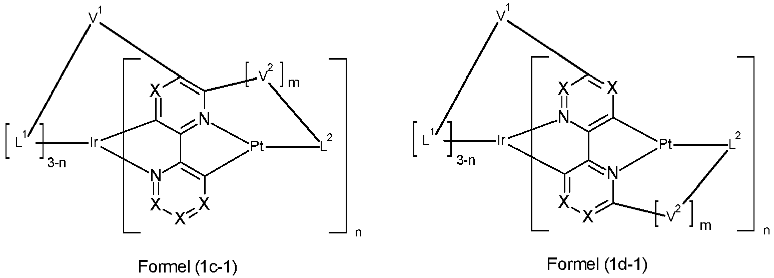 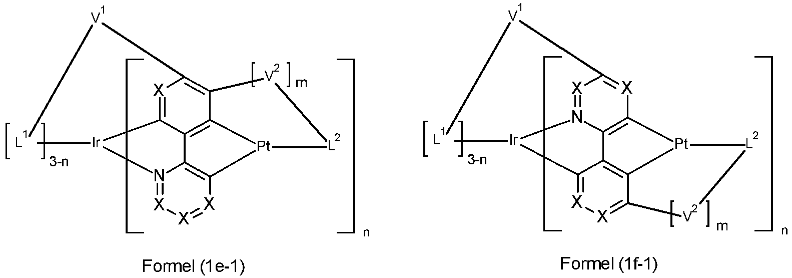 wobei die verwendeten Symbole und Indizes die oben genannten Bedeutungen aufweisen.

In einer bevorzugten Auführungsform der Erfindung steht X in den Formeln (1a) bis (1f) für CR, so dass die Strukturen bevorzugt ausgewählt sind aus den Verbindungen der Formeln (1a-2) bis (1f-2), 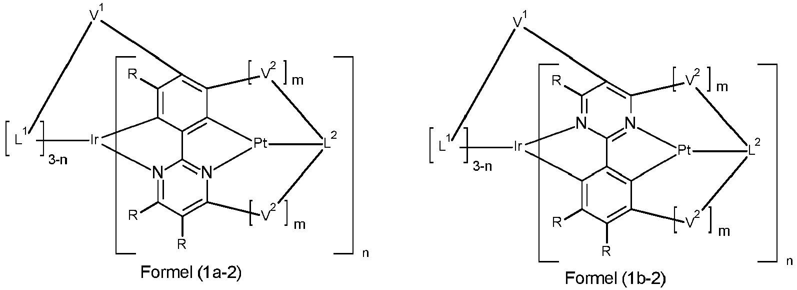 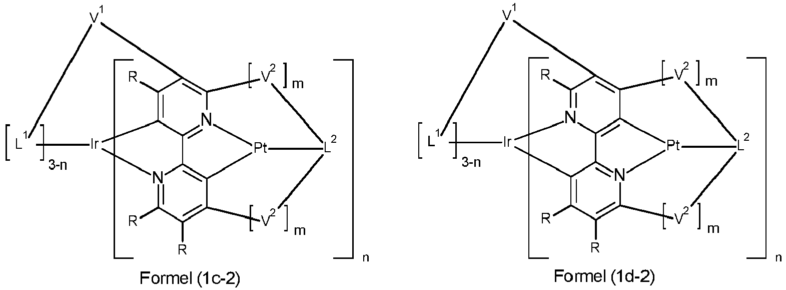 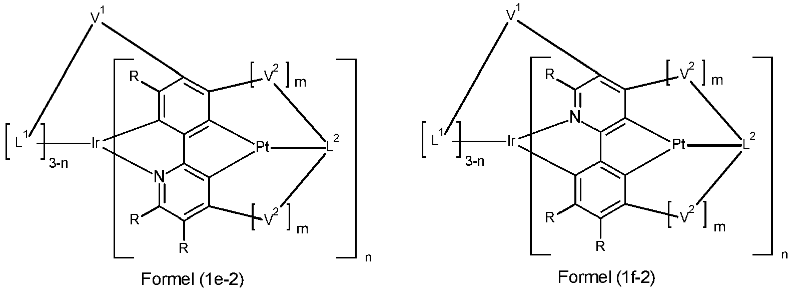 wobei für m = 0 an das Kohlenstoffatom, an das das entsprechende V² gebunden wäre, ein Rest R gebunden ist, die Reste R in ortho-Position zu D jeweils gleich oder verschieden bei jedem Auftreten ausgewählt sind aus der Gruppe bestehend aus H, D (Deuterium), F, CH₃ und CD₃ und bevorzugt für H stehen und die weiteren verwendeten Symbole und Indizes die oben aufgeführten Bedeutungen aufweisen.

Besonders bevorzugt sind die Verbindungen der folgenden Formeln (1a-3) bis (1f-3), 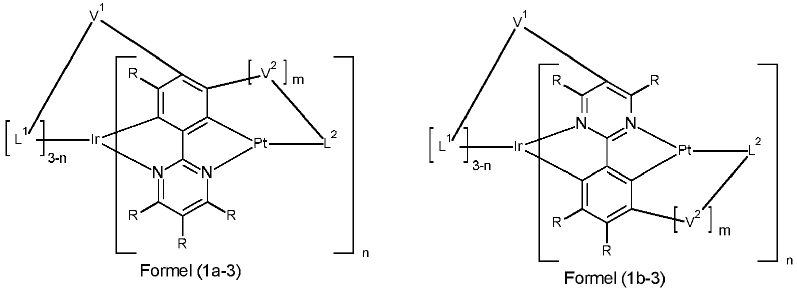 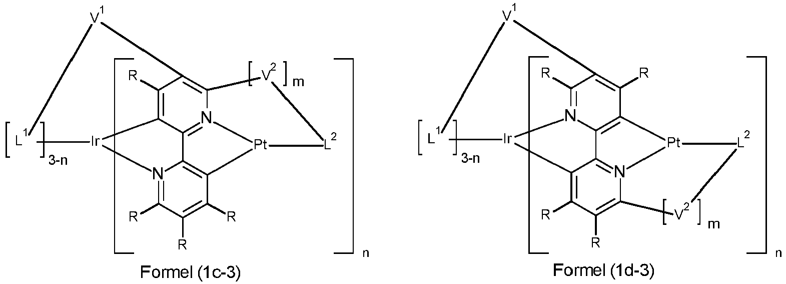 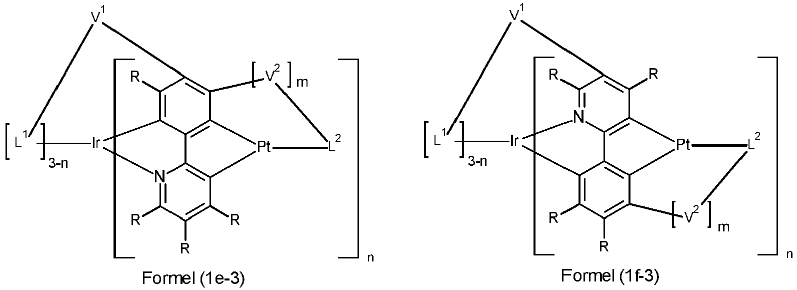 wobei die verwendeten Symbole und Indizes die oben genannten Bedeutungen aufweisen. Dabei sind die Reste R in ortho-Position zu D bevorzugt jeweils gleich oder verschieden bei jedem Auftreten ausgewählt aus der Gruppe bestehend aus H, D (Deuterium), F, CH₃ und CD₃ und stehen besonders bevorzugt für H.

Im Folgenden werden bevorzugte Ausführungsformen für die Gruppe V¹ beschrieben. Wie oben beschrieben, stellt V¹ eine trivalente Gruppe dar, die den zentralen Teilliganden und die beiden Teilliganden L¹ für n = 1 miteinder verknüpft, bzw. die die beiden zentralen Teilliganden und den Teilliganden L¹ für n = 2 miteinander verknüpft, bzw. die die drei zentralen Teilliganden für n = 3 miteinander verknüpft.

In einer bevorzugten Ausführungsform der Erfindung ist V¹ ausgewählt aus den Gruppen der folgenden Formeln (2) oder (3), 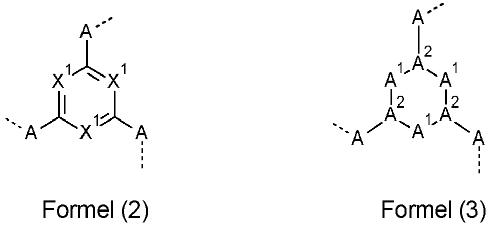 wobei die gestrichelten Bindungen die Bindungen an den zentralen Teilliganden und an den oder die Teilliganden L¹ darstellen, R die oben genannten Bedeutungen aufweist und für die weiteren verwendeten Symbole gilt:
- A: ist bei jedem Auftreten gleich oder verschieden -CR=CR-, -C(=O)-NR'-, -C(=O)-O-, -CR₂-CR₂-, -CR₂-O- oder eine Gruppe der folgenden Formel (4), 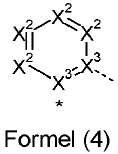 wobei die gestrichelte Bindung die Position der Bindung des zentralen Teilliganden oder eines Teilliganden L¹ an diese Struktur darstellt und * die Position der Verknüpfung der Einheit der Formel (4) mit der zentralen cyclischen Gruppe darstellt, also der Gruppe, die explizit in Formel (2) bzw. (3) aufgeführt ist;
X¹ ist bei jedem Auftreten gleich oder verschieden CR oder N;
X² ist bei jedem Auftreten gleich oder verschieden CR oder N, oder zwei benachbarte Gruppen X² stehen zusammen für NR, O oder S, so dass ein Fünfring entsteht, und die verbleibenden X² stehen gleich oder verschieden bei jedem Auftreten für CR oder N; oder zwei benachbarte Gruppen X² stehen zusammen für CR oder N, wenn in dem Cyclus eine der Gruppen X³ für N steht, so dass ein Fünfring entsteht; mit der Maßgabe, dass maximal zwei benachbarte Gruppen X² für N stehen;
X³ ist bei jedem Auftreten C oder eine Gruppe X³ steht für N und die anderen Gruppen X³ in demselben Cyclus stehen für C; mit der Maß-gabe, dass zwei benachbarte Gruppen X² zusammen für CR oder N stehen, wenn in dem Cyclus eine der Gruppen X³ für N steht;
A¹ ist bei jedem Auftreten gleich oder verschieden C(R)₂ oder O;
A² ist bei jedem Auftreten gleich oder verschieden CR, P(=O), B oder SiR, mit der Maßgabe, dass für A² = P(=O), B oder SiR das Symbol A¹ für O steht und das Symbol A, das an dieses A² gebunden ist, nicht für -C(=O)-NR'- oder -C(=O)-O- steht;
R' ist bei jedem Auftreten gleich oder verschieden H, D, eine geradkettige Alkylgruppe mit 1 bis 20 C-Atomen oder eine verzweigte oder cyclische Alkylgruppe mit 3 bis 20 C-Atomen, wobei die Alkylgruppe jeweils mit einem oder mehreren Resten R¹ substituiert sein kann und wobei eine oder mehrere nicht benachbarte CH₂-Gruppen durch Si(R¹)₂ ersetzt sein können, oder ein aromatisches oder heteroaromatisches Ringsystem mit 5 bis 40 aromatischen Ringatomen, das jeweils durch einen oder mehrere Reste R¹ substituiert sein kann.

Wenn in Formel (3) A² für CR steht, insbesondere wenn alle A² für CR stehen, ganz besonders wenn zusätzlich 0, 1, 2 oder 3, insbesondere 3, der A¹ für CR₂ stehen, können die Reste R an A² abhängig von der Konfiguration unterschiedliche Positionen einnehmen. Bevorzugt sind dabei kleine Reste R, wie H oder D. Bevorzugt ist, dass sie entweder alle weg vom Metall gerichtet sind (apical) oder alle nach innen zum Metall hin gerichtet sind (endohedral). Dies ist nachfolgend an einem Beispiel veranschaulicht, in dem die Gruppen A jeweils für eine ortho-Phenylengruppe stehen.

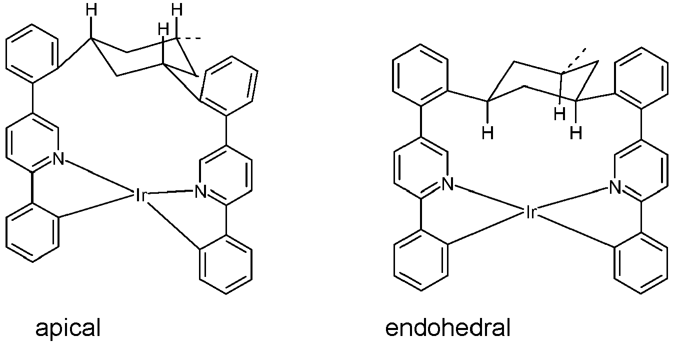

Der dritte Teilligand, der sowohl an Ir wie auch an Pt koordiniert, ist der Übersichtlichkeit halber nicht dargestellt, sondern nur durch die gestrichelte Bindung angedeutet. Bevorzugt sind daher Komplexe, welche mindestens eine der beiden Konfigurationen einnehmen können. Dies sind Komplexe, bei welchen alle drei Teilliganden äquatorial am zentralen Ring angeordnet sind.

Geeignete Ausführungsformen der Gruppe der Formel (2) sind die Strukturen der folgenden Formeln (5) bis (8), und geeignete Ausführungsformen der Gruppe der Formel (3) sind die Strukturen der folgenden Formeln (9) bis (13), 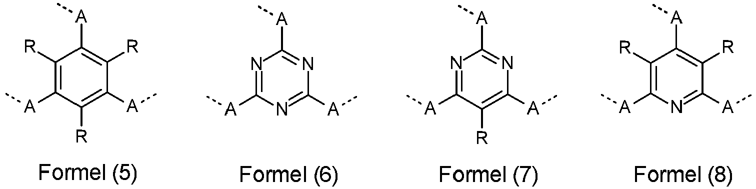 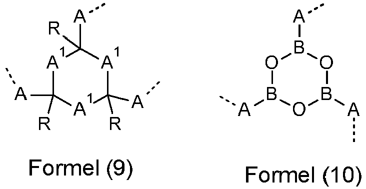 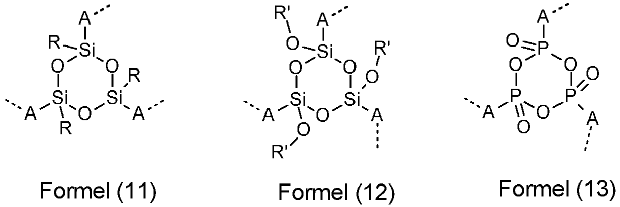 wobei die Symbole die oben genannten Bedeutungen aufweisen.

Für bevorzugte Reste R in den Formeln (2), (3) und (5) bis (13) gilt:
- R: ist bei jedem Auftreten gleich oder verschieden H, D, F, CN, OR¹, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, die jeweils mit einem oder mehreren Resten R¹ substituiert sein kann, oder ein aromatisches oder heteroaromatisches Ringsystem mit 5 bis 24 aromatischen Ringatomen, das jeweils durch einen oder mehrere Reste R¹ substituiert sein kann;
- R¹: ist bei jedem Auftreten gleich oder verschieden H, D, F, CN, OR², eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, die jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein Ringsystem bilden;
- R²: ist bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch F ersetzt sein können.

Für besonders bevorzugte Reste R in den Formeln (2), (3) und (5) bis (13) gilt:
- R: ist bei jedem Auftreten gleich oder verschieden H, D, F, CN, eine geradkettige Alkylgruppe mit 1 bis 4 C-Atomen oder eine verzweigte oder cyclische Alkylgruppe mit 3 bis 6 C-Atomen, die jeweils mit einem oder mehreren Resten R¹ substituiert sein kann, oder ein aromatisches oder heteroaromatisches Ringsystem mit 6 bis 12 aromatischen Ringatomen, das jeweils durch einen oder mehrere Reste R¹ substituiert sein kann;
- R¹: ist bei jedem Auftreten gleich oder verschieden H, D, F, CN, eine geradkettige Alkylgruppe mit 1 bis 4 C-Atomen oder eine verzweigte oder cyclische Alkylgruppe mit 3 bis 6 C-Atomen, die jeweils mit einem oder mehreren Resten R² substituiert sein kann, oder ein aromatisches oder heteroaromatisches Ringsystem mit 6 bis 12 aromatischen Ringatomen, das jeweils durch einen oder mehrere Reste R² substituiert sein kann; dabei können zwei oder mehrere benachbarte Reste R¹ miteinander ein Ringsystem bilden;
- R²: ist bei jedem Auftreten gleich oder verschieden H, D, F oder ein aliphatischer oder aromatischer Kohlenwasserstoffrest mit 1 bis 12 C-Atomen.

In einer bevorzugten Ausführungsform der Erfindung stehen alle Gruppen X¹ in der Gruppe der Formel (2) für CR, so dass der zentrale trivalente Cyclus der Formel (2) ein Benzol darstellt. Besonders bevorzugt stehen alle Gruppen X¹ für CH oder CD, insbesondere für CH. In einer weiteren bevorzugten Ausführungsform der Erfindung stehen alle Gruppen X¹ für ein Stickstoffatom, so dass der zentrale trivalente Cyclus der Formel (2) ein Triazin darstellt. Bevorzugte Ausführungsformen der Formel (2) sind somit die Strukturen der oben abgebildeten Formeln (5) und (6). Besonders bevorzugt ist die Struktur der Formel (5) eine Struktur der folgenden Formel (5'), 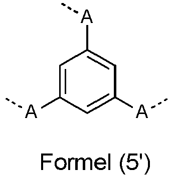 wobei die Symbole die oben genannten Bedeutungen aufweisen.

In einer weiteren bevorzugten Ausführungsform der Erfindung stehen alle Gruppen A² in der Gruppe der Formel (3) für CR. Besonders bevorzugt stehen alle Gruppen A² für CH. Bevorzugte Ausführungsformen der Formel (3) sind somit die Strukturen der oben abgebildeten Formel (9). Besonders bevorzugt ist die Struktur der Formel (9) eine Struktur der folgenden Formel (9') oder (9"), 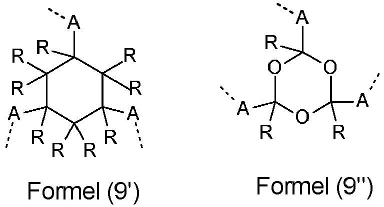 wobei die Symbole die oben genannten Bedeutungen aufweisen und R bevorzugt für H steht.

Wie oben bereits beschrieben, können Reste R in diesen Strukturen auch ein Ringsystem miteinander bilden. So ist beispielsweise durch Ringbildung der Reste R in Formel (9') die Bildung eines Adamantan-Brückenkopfes möglich, wie in den folgenden beiden Formeln gezeigt: 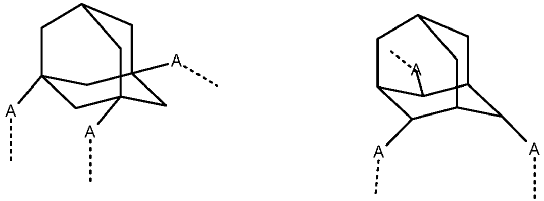 Im Folgenden werden bevorzugte Gruppen A beschrieben, wie sie in den Strukturen der Formeln (2) und (3), sowie (5) bis (13) vorkommen. Die Gruppe A kann gleich oder verschieden bei jedem Auftreten eine Alkenylgruppe, eine Amidgruppe, eine Estergruppe, eine Alkylengruppe, eine Methylenethergruppe oder eine ortho-verknüpfte Arylen- bzw. Heteroarylengruppe der Formel (4) darstellen. Wenn A für eine Alkenylgruppe steht, dann handelt es sich um eine cis-verknüpfte Alkenylgruppe. Bei unsymmetrischen Gruppen A ist jede Orientierung der Gruppen möglich. So ist es für A = -C(=O)-O- beispielsweise möglich, dass entweder das Sauerstoffatom oder die Carbonylgruppe an den zentralen Teilliganden bzw. an die Teilliganden L¹ bindet. Dasselbe gilt analog für A = -N(R¹)-C(=O)-.

In einer bevorzugten Ausführungsform der Erfindung sind die Gruppen A gleich oder verschieden, bevorzugt gleich, bei jedem Auftreten ausgewählt aus der Gruppe bestehend aus -CR₂-CR₂-, -C(=O)-O-, -C(=O)-NR'- oder einer Gruppe der Formel (4). Besonders bevorzugt sind alle Gruppen A gleich und auch gleich substituiert. Bevorzugte Kombinationen für die Gruppen A innerhalb einer Formel (2) und (3) und den bevorzugten Ausführungsformen sind:

| A | A | A |
|---|---|---|
| Formel (4) | Formel (4) | Formel (4) |
| -CR₂-CR₂- | -CR₂-CR₂- | -CR₂-CR₂- |
| -C(=O)-O- | -C(=O)-O- | -C(=O)-O- |
| -C(=O)-NR'- | -C(=O)-NR'- | -C(=O)-NR'- |
| -C(=O)-O- | Formel (4) | Formel (4) |
| -C(=O)-NR'- | Formel (4) | Formel (4) |
| -CR₂-CR₂- | Formel (4) | Formel (4) |
| -CR₂-CR₂- | -CR₂-CR₂- | Formel (4) |
| -C(=O)-O- | -C(=O)-O- | Formel (4) |
| -C(=O)-NR'- | -C(=O)-NR'- | Formel (4) |
| -CR₂-CR₂- | -CR₂-CR₂- | -C(=O)-NR'- |
| -CR₂-CR₂- | -CR₂-CR₂- | -C(=O)-O- |
| -CR₂-CR₂- | -C(=O)-NR'- | -C(=O)-NR'- |
| -CR₂-CR₂- | -C(=O)-O- | -C(=O)-O- |

Wenn A für -C(=O)-NR'- steht, dann steht R' bevorzugt gleich oder verschieden bei jedem Auftreten für eine geradkettige Alkylgruppe mit 1 bis 10 C-Atomen oder eine verzweigte oder cyclische Alkylgruppe mit 3 bis 10 C-Atomen oder ein aromatisches oder heteroaromatisches Ringsystem mit 6 bis 24 aromatischen Ringatomen, das jeweils durch einen oder mehrere Reste R¹ substituiert sein kann. Besonders bevorzugt steht R' gleich oder verschieden bei jedem Auftreten für eine geradkettige Alkylgruppe mit 1 bis 5 C-Atomen oder eine verzweigte oder cyclische Alkylgruppe mit 3 bis 6 C-Atomen oder ein aromatisches oder heteroaromatisches Ringsystem mit 6 bis 12 aromatischen Ringatomen, das jeweils durch einen oder mehrere Reste R¹ substituiert sein kann, bevorzugt aber unsubstituiert ist. Im Folgenden werden bevorzugte Ausführungsformen der Gruppe der Formel (4) beschrieben. Die Gruppe der Formel (4) kann einen heteroaromatischen Fünfring oder einen aromatischen oder heteroaromatischen Sechsring darstellen. In einer bevorzugten Ausführungsform der Erfindung enthält die Gruppe der Formel (4) maximal zwei Heteroatome in der aromatischen bzw. heteroaromatischen Einheit, besonders bevorzugt maximal ein Heteroatom. Dies schließt nicht aus, dass Substituenten, die gegebenenfalls an dieser Gruppe gebunden sind, auch Heteroatome enthalten können. Weiterhin schließt diese Definition nicht aus, dass durch die Ringbildung von Substituenten kondensierte aromatische oder heteroaromatische Strukturen entstehen, wie beispielsweise Naphthalin, Benzimidazol, etc..

Wenn beide Gruppen X³ in Formel (4) für Kohlenstoffatome stehen, sind bevorzugte Ausführungsformen der Gruppe der Formel (4) die Strukturen der folgenden Formeln (14) bis (30), und wenn eine Gruppe X³ für ein Kohlenstoffatom und die andere Gruppe X³ in demselben Cyclus für ein Stickstoffatom steht, sind bevorzugte Ausführungsformen der Gruppe der Formel (4) die Strukturen der folgenden Formeln (31) bis (38), 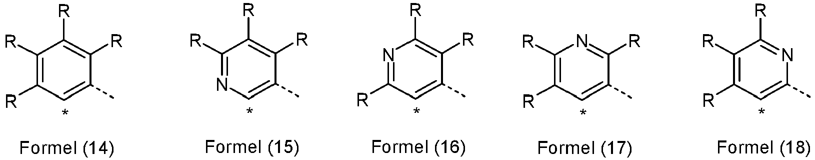 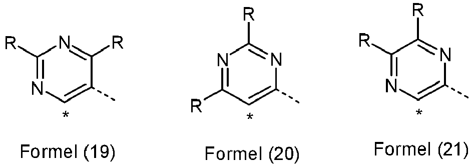 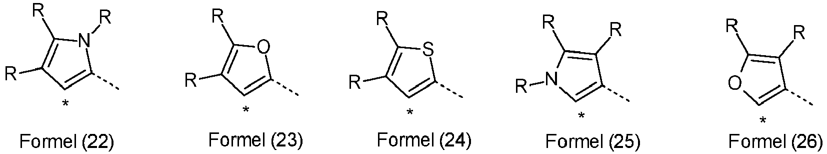 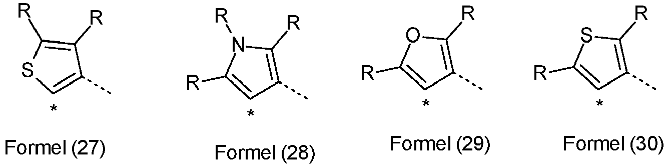 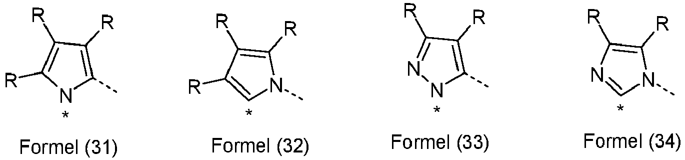 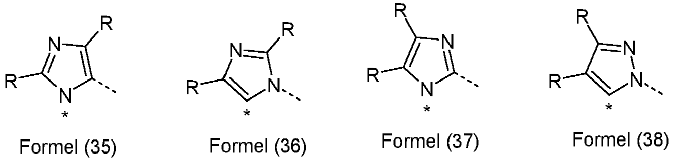 wobei die Symbole die oben genannten Bedeutungen aufweisen.

Besonders bevorzugt sind die Sechsring-Aromaten und -Heteroaromaten der oben abgebildeten Formeln (14) bis (18). Ganz besonders bevorzugt ist ortho-Phenylen, also eine Gruppe der oben genannten Formel (14).

Dabei können auch benachbarte Substituenten R miteinander ein Ringsystem bilden, so dass kondensierte Strukturen, auch kondensierte Aryl- und Heteroarylgruppen, wie beispielsweise Naphthalin, Chinolin, Benzimidazol, Carbazol, Dibenzofuran oder Dibenzothiophen, entstehen können. Eine solche Ringbildung ist im Folgenden schematisch an Gruppen der oben genannten Formel (14) aufgeführt, was beispielsweise zu Gruppen der folgenden Formeln (14a) bis (14j) führen kann: 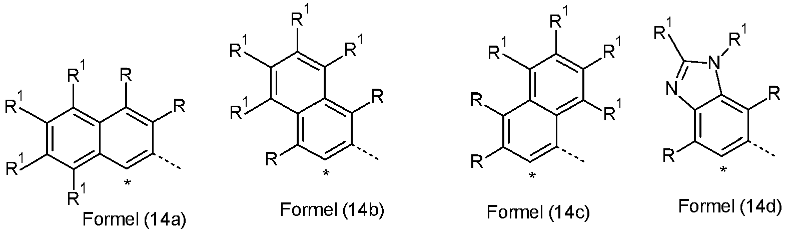 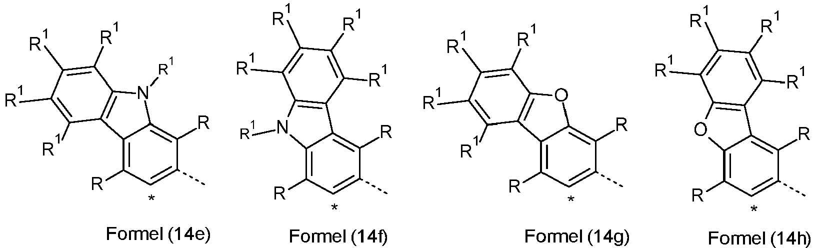 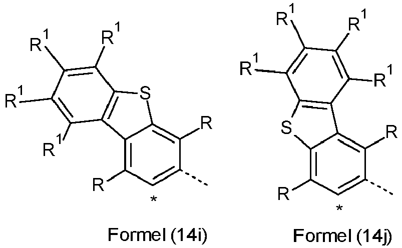 wobei die Symbole die oben genannten Bedeutungen aufweisen.

Generell können die ankondensierten Gruppen an jeder Position der Einheit gemäß Formel (4) ankondensiert sein, wie durch die ankondensierte Benzogruppe in den Formeln (14a) bis (14c) dargestellt. Die Gruppen, wie sie in den Formeln (14d) bis (14j) an die Einheit der Formel (4) ankondensiert sind, können daher auch an anderen Positionen der Einheit der Formel (4) ankondensiert werden.

Bevorzugte Gruppen der Formel (2) sind die Gruppen der Formel (5), und bevorzugte Gruppen der Formel (3) sind die Gruppen der Formel (9). Die Gruppe der Formel (5) kann besonders bevorzugt durch die folgenden Formeln (5a) bis (5x) dargestellt werden, und die Gruppe der Formel (9) kann besonders bevorzugt durch die folgenden Formeln (9a) bis (9x) dargestellt werden, 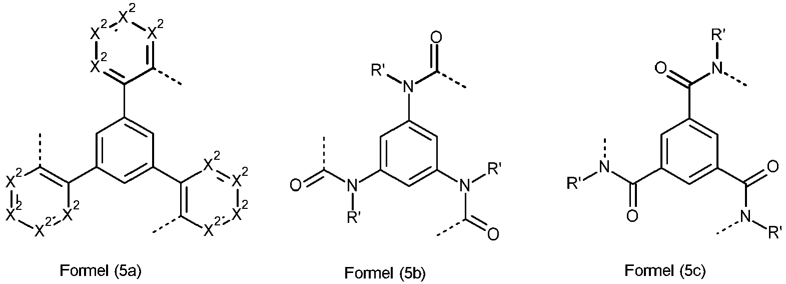 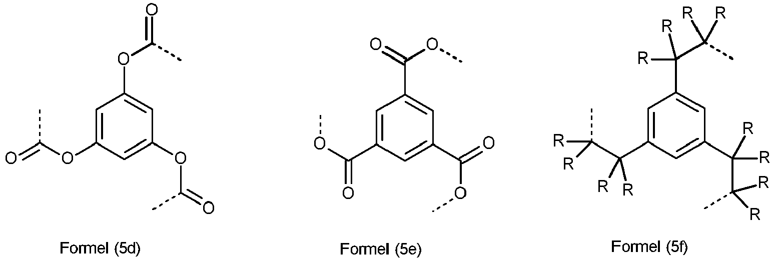 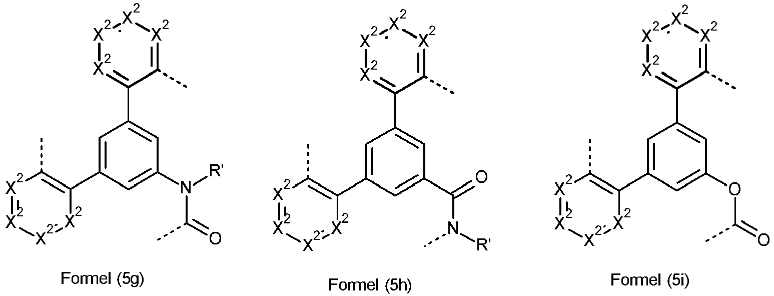 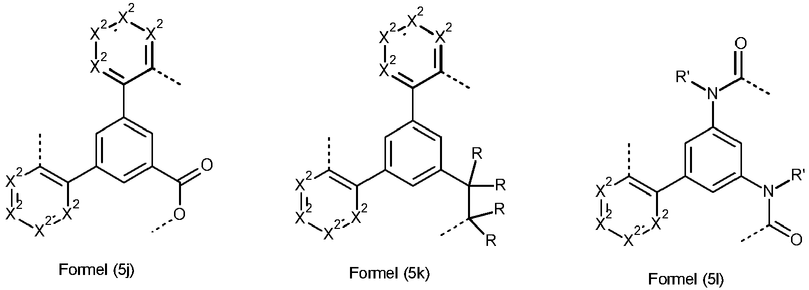 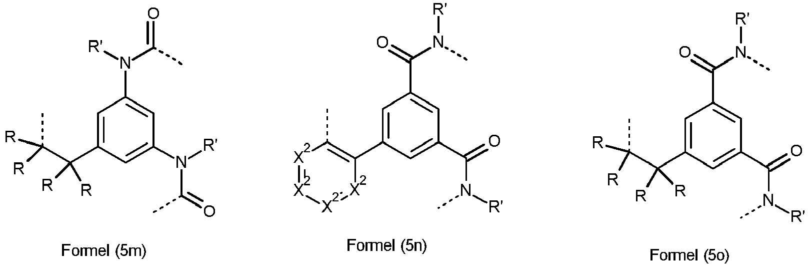 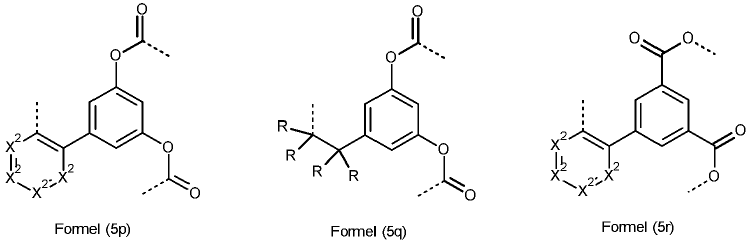 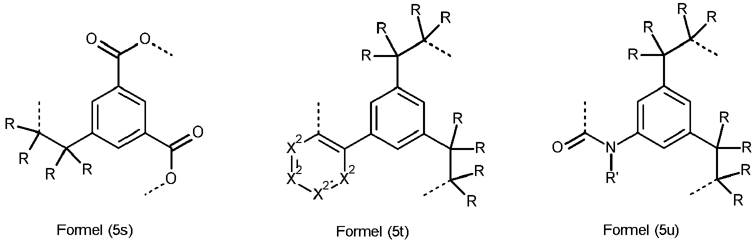 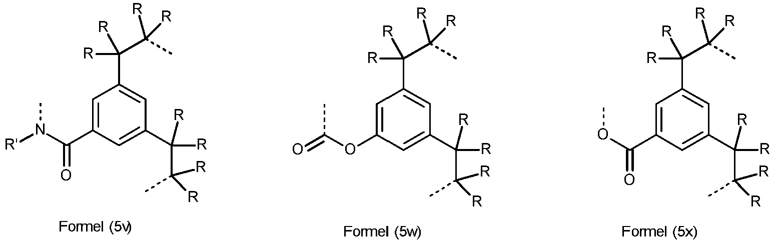 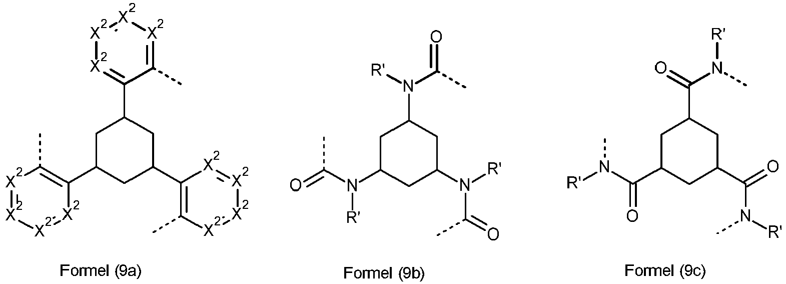 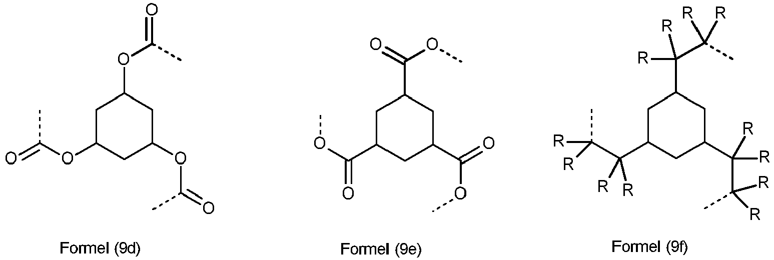 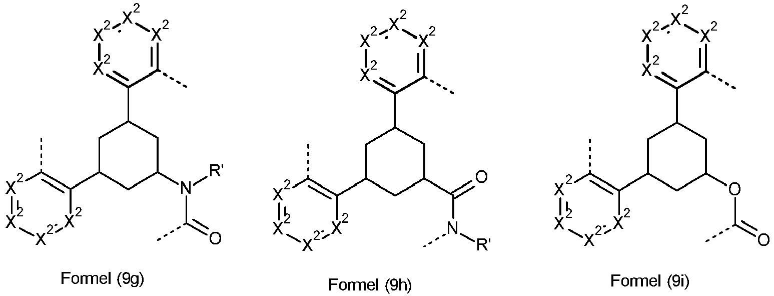 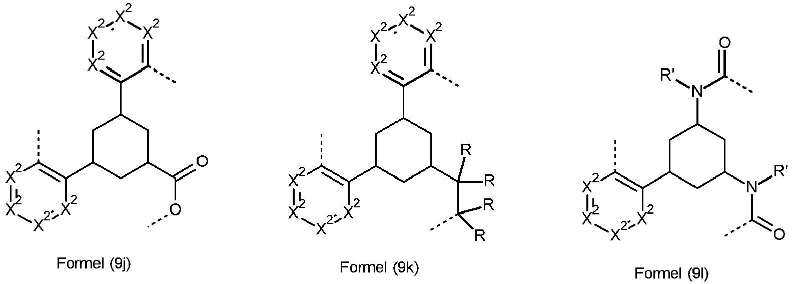 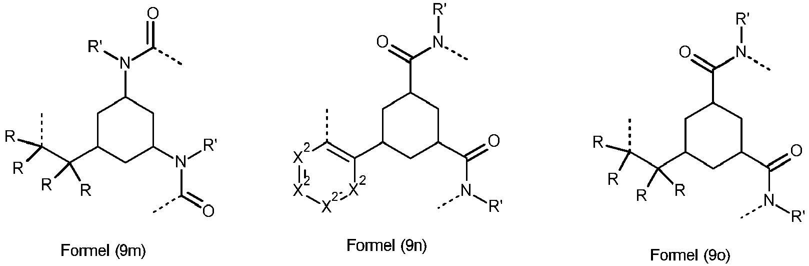 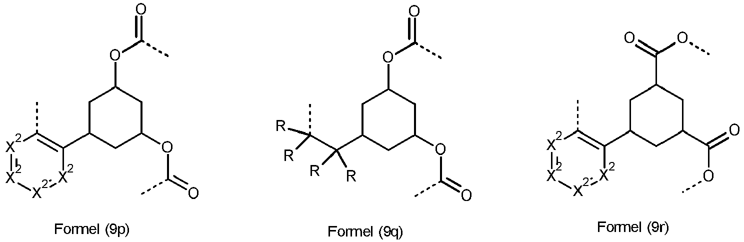 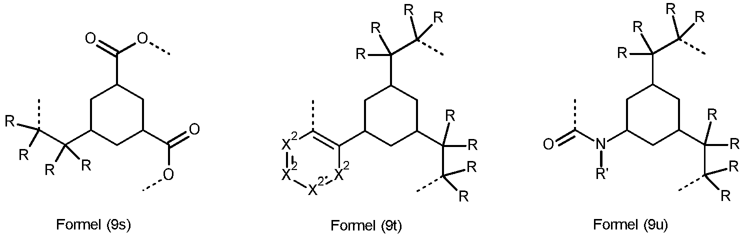 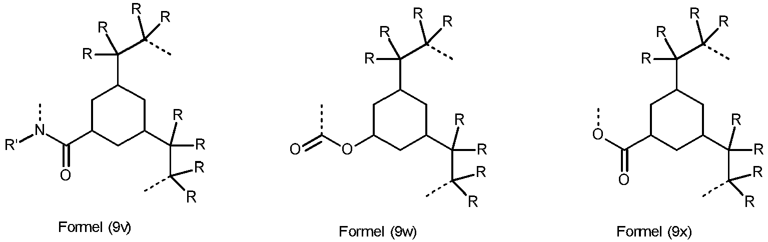 wobei die Symbole die oben genannten Bedeutungen aufweisen. Bevorzugt steht X² gleich oder verschieden bei jedem Auftreten für CR, insbesondere für CH.

In den oben abgebildeten Strukturen, in denen zwei Gruppen A gleich und die dritte Gruppe A von den ersten beiden Gruppen A verschieden ist, ist es bevorzugt, wenn für n = 1 die gleichen Gruppen A beide an L¹ binden und die Gruppe A, die von den ersten beiden Gruppen A verschieden ist, an den zentralen Teilliganden bindet. Weiterhin ist es für n = 2 bevorzugt, wenn die beiden gleichen Gruppen A beide an die zentralen Teilliganden binden und die Gruppe A, die von den ersten beiden Gruppen A verschieden ist, an L¹ bindet.

Eine besonders bevorzugte Ausführungsform der Gruppe der Formel (2) ist die Gruppe der folgenden Formel (5a"), 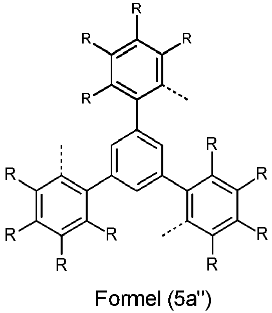 wobei die Symbole die oben genannten Bedeutungen aufweisen.

Besonders bevorzugt sind die Gruppen R in den oben genannten Formeln gleich oder verschieden H, D oder eine Alkylgruppe mit 1 bis 4 C-Atomen. Ganz besonders bevorzugt ist R = H. Ganz besonders bevorzugt ist also die Struktur der folgenden Formeln (5a‴), 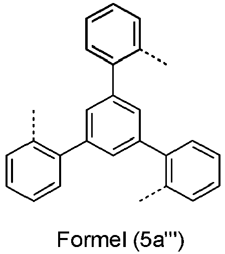 wobei die Symbole die oben genannten Bedeutungen aufweisen.

Weitere geeignete Brückenköpfe V¹ sind die Strukturen der folgenden Formel (V¹-a), 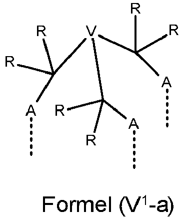 wobei A und R die oben genannten Bedeutungen aufweisen und V für CR, N, SiR, P oder P=O steht, bevorzugt für CR oder N. Dabei stehen die explizit eingezeichneten Substituenten R an den Methylengruppen bevorzugt für H.

Im Folgenden werden bevorzugte Ausführungsformen für die Gruppe V² beschrieben. Wie oben beschrieben, stellt V² eine bivalente Gruppe oder eine Einfachbindung dar, die den zentralen Teilliganden und den Teilliganden L² miteinder verknüpft.

In einer bevorzugten Ausführungsform der Erfindung stellt V² eine bivalente Gruppe dar. Diese ist bevorzugt ausgewählt aus der Gruppe bestehend aus CR₂, NR, O, S, Se, -CR₂-CR₂-, -CR₂-O-, -CR=CR- oder einer ortho-verknüpften Arylen- oder Heteroarylengruppe mit 5 oder 6 aromatischen Ringatomen, welche durch einen oder mehrere Reste R substituiert sein kann. Wenn V² für eine ortho-verknüpfte Arylen- oder Heteroarylengruppe steht, so sind bevorzugte Ausführungsformen die Gruppen, wie sie oben als bevorzugte Ausführungsformen für Strukturen der Formel (4) ausgeführt sind.

Wenn ein Index m = 1 und der andere Index m = 0 ist, so es bevorzugt, wenn die entsprechende Gruppe V² für m = 1 ausgewählt ist aus der Gruppe bestehend aus NR, CR₂, O oder S, besonders bevorzugt NR, CR₂ oder O.

Wenn beide Indizes m = 1 sind, so ist es bevorzugt, wenn eine der Gruppen V² ausgewählt ist aus der Gruppe bestehend aus CR₂, NR, O oder S, besonders bevorzugt CR₂ oder NR, und die andere Gruppe V² ausgewählt ist aus der Gruppe bestehend aus -CR₂-CR₂-, -CR₂-O-, -CR=CR- oder einer ortho-verknüpften Arylen- oder Heteroarylengruppe mit 5 oder 6 aromatischen Ringatomen, welche durch einen oder mehrere Reste R substituiert sein kann.

Wenn V² für eine Gruppe CR₂, -CR₂-CR₂-, -CR₂-O- oder -CR=CR- steht, sind bevorzugte Reste R gleich oder verschieden bei jedem Auftreten ausgewählt aus der Gruppe bestehend aus H, einer Alkylgruppe mit 1 bis 10 C-Atomen, welche auch durch einen oder mehrere Reste R¹ substituiert sein kann, oder einem aromatischen oder heteroaromatischen Ringsystem mit 5 bis 13 aromatischen Ringatomen, welches durch einen oder mehrere Reste R¹ substituiert sein kann. Dabei können mehrere Reste R, welche an dasselbe Kohlenstoffatom oder an benachbarte Kohlenstoffatome binden, auch miteinander ein Ringsystem bilden. Besonders bevorzugt sind diese Reste R gleich oder verschieden bei jedem Auftreten ausgewählt aus der Gruppe bestehend aus H, einer Alkylgruppe mit 1 bis 5 C-Atomen oder einem aromatischen oder heteroaromatischen Ringsystem mit 5 bis 10 aromatischen Ringatomen, welches durch einen oder mehrere Reste R¹ substituiert sein kann. Dabei können mehrere Reste R, welche an dasselbe Kohlenstoffatom oder an benachbarte Kohlenstoffatome binden, auch miteinander ein Ringsystem bilden.

Wenn V² für eine Gruppe NR steht, sind bevorzugte Reste R ausgewählt aus der Gruppe bestehend aus einer Alkylgruppe mit 1 bis 10 C-Atomen, welche auch durch einen oder mehrere Reste R¹ substituiert sein kann, oder einem aromatischen oder heteroaromatischen Ringsystem mit 5 bis 24 aromatischen Ringatomen, welches durch einen oder mehrere Reste R¹ substituiert sein kann. Besonders bevorzugt sind diese Reste R ausgewählt aus einem aromatischen oder heteroaromatischen Ringsystem mit 5 bis 13 aromatischen Ringatomen, besonders bevorzugt mit 6 bis 10 aromatischen Ringatomen, welches jeweils durch einen oder mehrere Reste R¹ substituiert sein kann.

Im Folgenden werden die bidentaten Teilliganden L¹ und L² beschrieben. Die Teilliganden L¹ und L² können gleich oder verschieden sein. Dabei ist es bevorzugt, wenn in Verbindungen, welche zwei Teilliganden L¹ enthalten, diese gleich sind und auch gleich substituiert sind. In einer bevorzugten Ausführungsform der Erfindung sind die bidentaten Teilliganden L¹ monoanionisch. In einer weiteren bevorzugten Ausführungsform der Erfindung sind die bidentaten Teilliganden L² monoanionisch oder neutral.

In einer weiteren bevorzugten Ausführungsform der Erfindung sind die koordinierenden Atome der bidentaten Teilliganden L¹ und L² gleich oder verschieden bei jedem Auftreten ausgewählt aus C, N, P, O, S und/oder B, besonders bevorzugt C, N und/oder O und ganz besonders bevorzugt C und/oder N. Dabei weisen die bidentaten Teilliganden L¹ bevorzugt jeweils ein Kohlenstoffatom und ein Stickstoffatom oder zwei Kohlenstoffatome oder zwei Stickstoffatome oder zwei Sauerstoffatome oder ein Sauerstoffatom und ein Stickstoffatom als koordinierende Atome auf. Weiterhin weisen die bidentaten Teilliganden L² bevorzugt jeweils ein Kohlenstoffatom und ein Stickstoffatom oder zwei Stickstoffatome als koordinierende Atome auf. Dabei können die koordinierenden Atome von jedem der Teilliganden L¹ und L² gleich sein, oder sie können unterschiedlich sein. Bevorzugt weist mindestens einer der bidentaten Teilliganden L¹ ein Kohlenstoffatom und ein Stickstoffatom oder zwei Kohlenstoffatome als koordinierende Atome auf, insbesondere ein Kohlenstoffatom und ein Stickstoffatom. Besonders bevorzugt weisen alle bidentaten Teilliganden L¹ und L² ein Kohlenstoffatom und ein Stickstoffatom oder zwei Kohlenstoffatome als koordinierende Atome auf, insbesondere ein Kohlenstoffatom und ein Stickstoffatom. Besonders bevorzugt handelt es sich somit um einen Metallkomplex, in dem alle Teilliganden ortho-metalliert sind, d. h. mit dem Ir bzw. Pt einen Metallacyclus bilden, in dem mindestens eine Metall-Kohlenstoff-Bindung vorliegt.

Es ist weiterhin bevorzugt, wenn es sich bei dem Metallacyclus, der aus dem Iridium bzw. Platin und dem bidentaten Teilliganden L¹ bzw. L² aufgespannt wird, um einen Fünfring handelt, der vor allem dann bevorzugt ist, wenn die koordinierenden Atome C und N, N und N oder N und O sind. Wenn es sich bei den koordinierenden Atomen um O handelt, kann auch ein Metallasechsring bevorzugt sein. Dies wird im Folgenden schematisch dargestellt: 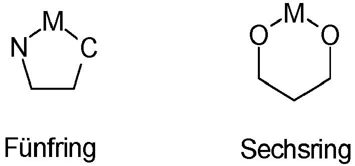 wobei M für Ir oder Pt steht, N ein koordinierendes Stickstoffatom, C ein koordinierendes Kohlenstoffatom und O koordinierende Sauerstoffatome darstellen und die eingezeichneten Kohlenstoffatome Atome des bidentaten Teilliganden L¹ bzw. L² darstellen.

In einer bevorzugten Ausführungsform der Erfindung ist L² und mindestens einer der bidentaten Teilliganden L¹ und besonders bevorzugt alle bidentaten Teilliganden L¹ gleich oder verschieden bei jedem Auftreten ausgewählt aus den Strukturen der folgenden Formeln (L-1), (L-2) oder (L-3), 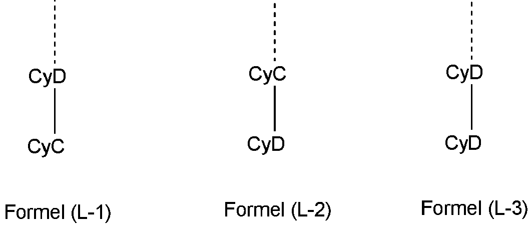 wobei die gestrichelte Bindung die Bindung des Teilliganden L¹ an V¹ bzw. die Bindung des Teilliganden L² an V² darstellt und für die weiteren verwendeten Symbole gilt:
- CyC: ist gleich oder verschieden bei jedem Auftreten eine substituierte oder unsubstituierte Aryl- oder Heteroarylgruppe mit 5 bis 14 aromatischen Ringatomen, welche über ein Kohlenstoffatom an M koordiniert und welche über eine kovalente Bindung mit CyD verbunden ist;

- CyD: ist gleich oder verschieden bei jedem Auftreten eine substituierte oder unsubstituierte Heteroarylgruppe mit 5 bis 14 aromatischen Ringatomen, welche über ein Stickstoffatom oder über ein Carben-Kohlenstoffatom an M koordiniert und welche über eine kovalente Bindung mit CyC verbunden ist;
dabei können mehrere der optionalen Substituenten miteinander ein Ringsystem bilden; weiterhin sind die optionalen Reste bevorzugt ausgewählt aus den oben genannten Resten R.

Dabei koordiniert CyD in den Teilliganden der Formeln (L-1) und (L-2) bevorzugt über ein neutrales Stickstoffatom oder über ein Carben-Kohlenstoffatom, insbesondere über ein neutrales Stickstoffatom. Weiterhin bevorzugt koordiniert eine der beiden Gruppen CyD in dem Liganden der Formel (L-3) über ein neutrales Stickstoffatom und die andere der beiden Gruppen CyD über ein anionisches Stickstoffatom, oder beide Gruppen CyD koordinieren über neutrale Stickstoffatome. Weiterhin bevorzugt koordiniert CyC in den Teilliganden der Formeln (L-1) und (L-2) über anionische Kohlenstoffatome.

Wenn mehrere der Substituenten, insbesondere mehrere Reste R, miteinander ein Ringsystem bilden, so ist die Bildung eines Ringsystems aus Substituenten, die an direkt benachbarten Kohlenstoffatomen gebunden sind, möglich. Weiterhin ist es auch möglich, dass die Substituenten an CyC und CyD in den Formeln (L-1) und (L-2) bzw. die Substituenten an den beiden Gruppen CyD in Formel (L-3) miteinander einen Ring bilden, wodurch CyC und CyD bzw. die beiden Gruppen CyD auch zusammen eine einzige kondensierte Aryl- bzw. Heteroarylgruppe als bidentaten Liganden bilden können.

In einer bevorzugten Ausführungsform der vorliegenden Erfindung ist CyC eine Aryl- oder Heteroarylgruppe mit 6 bis 13 aromatischen Ringatomen, besonders bevorzugt mit 6 bis 10 aromatischen Ringatomen, ganz besonders bevorzugt mit 6 aromatischen Ringatomen, insbesondere eine Phenylgruppe, welche über ein Kohlenstoffatom an das Metall koordiniert, welche mit einem oder mehreren Resten R substituiert sein kann und welche über eine kovalente Bindung mit CyD verbunden ist.

Bevorzugte Ausführungsformen der Gruppe CyC sind die Strukturen der folgenden Formeln (CyC-1) bis (CyC-20), 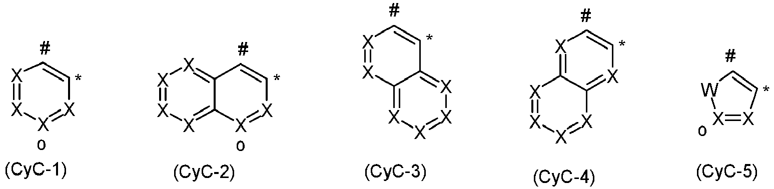 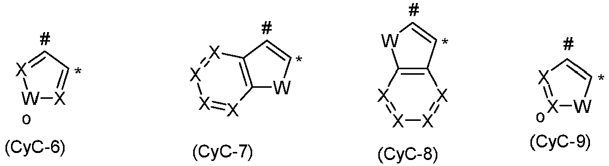 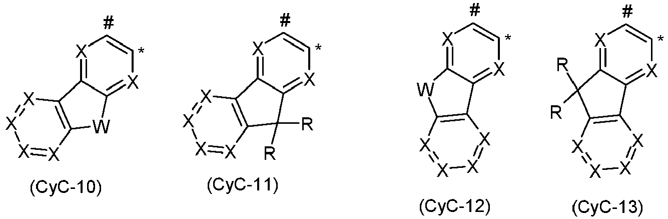 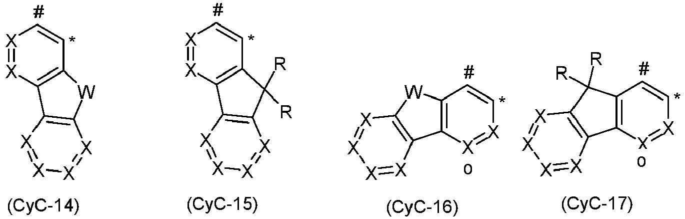 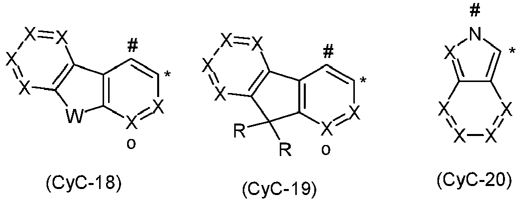 wobei CyC jeweils an der durch # gekennzeichneten Position an CyD bindet und an der durch * gekennzeichneten Position an das Metall koordiniert, R die oben genannten Bedeutungen aufweist und für die weiteren verwendeten Symbole gilt:
- X: ist bei jedem Auftreten gleich oder verschieden CR oder N mit der Maßgabe, dass maximal zwei Symbole X pro Cyclus für N stehen;
- W: ist NR, O oder S;
mit der Maßgabe, dass, wenn der Teilligand L¹ über CyC an V¹ gebunden ist, ein Symbol X für C steht und V¹ an dieses Kohlenstoffatom gebunden ist, und weiterhin mit der Maßgabe, dass, wenn der Teilligand L² über CyC an V² gebunden ist, ein Symbol X für C steht und V² an dieses Kohlenstoffatom gebunden ist. Wenn der Teilligand L¹ über die Gruppe CyC an V¹ gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen für L¹, die kein mit "o" markiertes Symbol X enthalten, sind bevorzugt nicht an V¹ gebunden, da eine solche Bindung an die Brücke aus sterischen Gründen nicht vorteilhaft ist. Wenn der Teilligand L² über die Gruppe CyC an V² gebunden ist, so erfolgt die Bindung bevorzugt über die Position ortho zur Koordination an das Pt.

Bevorzugt stehen insgesamt maximal zwei Symbole X in CyC für N, besonders bevorzugt steht maximal ein Symbol X in CyC für N, ganz besonders bevorzugt stehen alle Symbole X für CR, mit der Maßgabe, dass, wenn CyC an V¹ oder V² gebunden ist, ein Symbol X für C steht und V¹ bzw. V² an dieses Kohlenstoffatom gebunden ist.

Besonders bevorzugte Gruppen CyC sind die Gruppen der folgenden Formeln (CyC-1a) bis (CyC-20a), 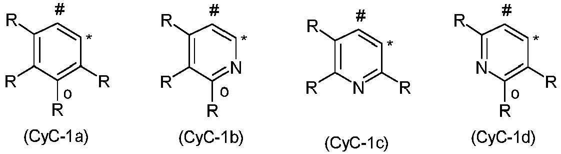 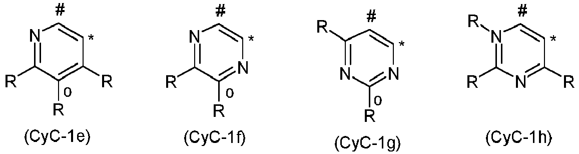 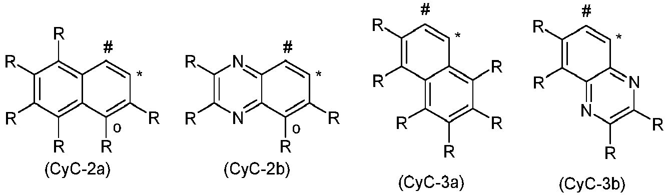 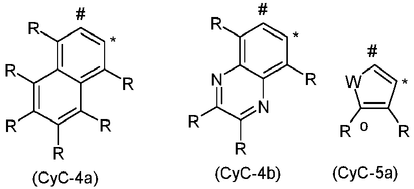 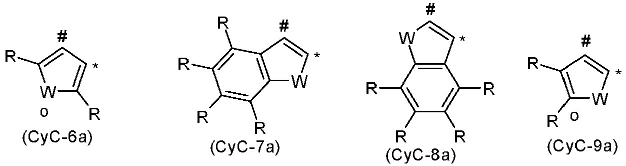 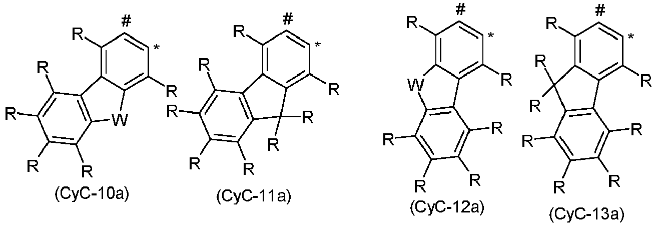 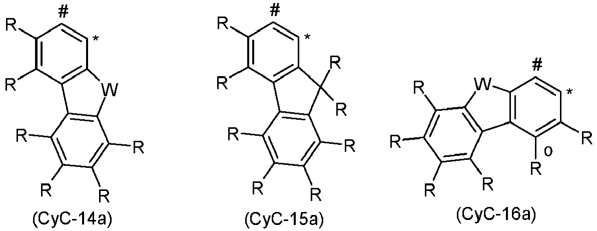 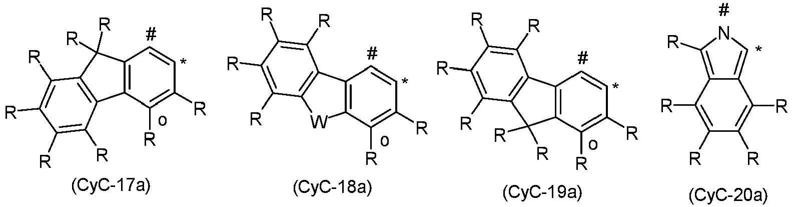 wobei die Symbole die oben genannten Bedeutungen aufweisen, mit der Maßgabe, dass, wenn der Teilligand L¹ über CyC an V¹ gebunden ist, ein Rest R nicht vorhanden ist und V¹ an das entsprechende Kohlenstoffatom gebunden ist, und weiterhin mit der Maßgabe, dass, wenn der Teilligand L² über CyC an V² gebunden ist, ein Rest R nicht vorhanden ist und V² an das entsprechende Kohlenstoffatom gebunden ist. Wenn der Teilligand L¹ über die Gruppe CyC an V¹ gebunden ist, so erfolgt die Bindung bevorzugt über die mit "o" markierte Position der oben abgebildeten Formeln, so dass dann bevorzugt in der mit "o" markierten Position der Rest R nicht vorhanden ist. Die oben abgebildeten Strukturen für L¹, die kein mit "o" markiertes Kohlenstoffatom enthalten, sind bevorzugt nicht an V¹ gebunden, da eine solche Bindung an die Brücke aus sterischen Gründen nicht vorteilhaft ist. Wenn der Teilligand L² über die Gruppe CyC an V² gebunden ist, so erfolgt die Bindung bevorzugt über die Position ortho zur Koordination an das Pt.

Bevorzugte Gruppen unter den Gruppen (CyC-1) bis (CyC-20) sind die Gruppen (CyC-1), (CyC-3), (CyC-8), (CyC-10), (CyC-12), (CyC-13) und (CyC-16), und besonders bevorzugt sind die Gruppen (CyC-1a), (CyC-3a), (CyC-8a), (CyC-10a), (CyC-12a), (CyC-13a) und (CyC-16a).

In einer weiteren bevorzugten Ausführungsform der Erfindung ist CyD eine Heteroarylgruppe 5 bis 13 aromatischen Ringatomen, besonders bevorzugt mit 6 bis 10 aromatischen Ringatomen, welche über ein neutrales Stickstoffatom oder über ein Carben-Kohlenstoffatom an das Metall koordiniert und welche mit einem oder mehreren Resten R substituiert sein kann und welche über eine kovalente Bindung mit CyC verbunden ist.

Bevorzugte Ausführungsformen der Gruppe CyD sind die Strukturen der folgenden Formeln (CyD-1) bis (CyD-14), 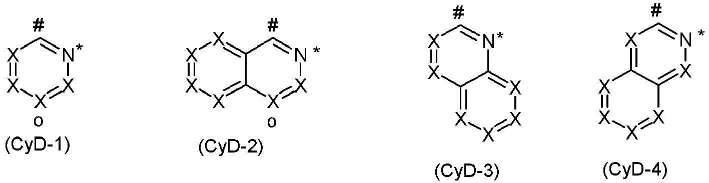 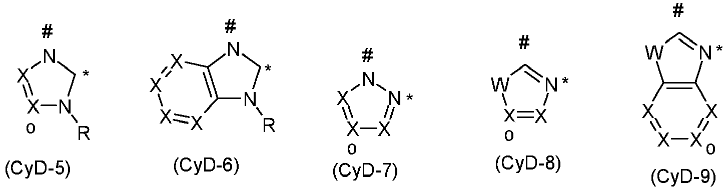 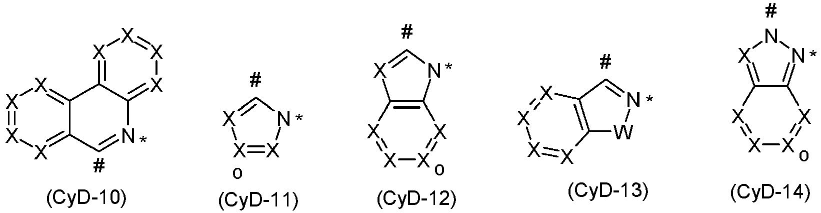 wobei die Gruppe CyD jeweils an der durch # gekennzeichneten Position an CyC bindet und an der durch * gekennzeichneten Position an das Metall koordiniert und wobei X, W und R die oben genannten Bedeutungen aufweisen, mit der Maßgabe, dass, wenn der Teilligand L¹ über CyD an V¹ gebunden ist, ein Symbol X für C steht und V¹ an dieses Kohlenstoffatom gebunden ist, und weiterhin mit der Maßgabe, dass, wenn der Teilligand L² über CyD an V² gebunden ist, ein Symbol X für C steht und V² an dieses Kohlenstoffatom gebunden ist. Wenn der Teilligand L¹ über die Gruppe CyD an V¹ gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen für L¹, die kein mit "o" markiertes Symbol X enthalten, sind bevorzugt nicht an V¹ gebunden, da eine solche Bindung an die Brücke aus sterischen Gründen nicht vorteilhaft ist. Wenn der Teilligand L² über die Gruppe CyD an V² gebunden ist, so erfolgt die Bindung bevorzugt über die Position ortho zur Koordination an das Pt.

Dabei koordinieren die Gruppen (CyD-1) bis (CyD-4), (CyD-7) bis (CyD-10), (CyD-13) und (CyD-14) über ein neutrales Stickstoffatom, (CyD-5) und (CyD-6) über ein Carben-Kohlenstoffatom und (CyD-11) und (CyD-12) über ein anionisches Stickstoffatom an das Metall.

Bevorzugt stehen insgesamt maximal zwei Symbole X in CyD für N, besonders bevorzugt steht maximal ein Symbol X in CyD für N, insbesondere bevorzugt stehen alle Symbole X für CR, mit der Maßgabe, dass, wenn CyD an V¹ bzw. V² gebunden ist, ein Symbol X für C steht und V¹ bzw. V² an dieses Kohlenstoffatom gebunden ist.

Besonders bevorzugte Gruppen CyD sind die Gruppen der folgenden Formeln (CyD-1a) bis (CyD-14b), 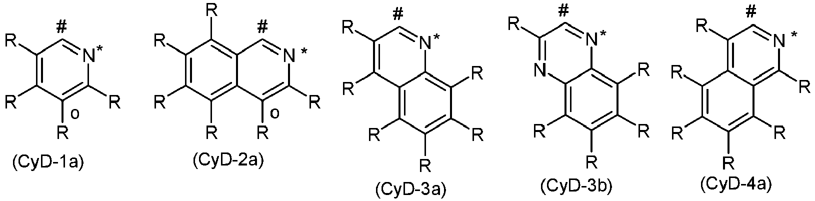 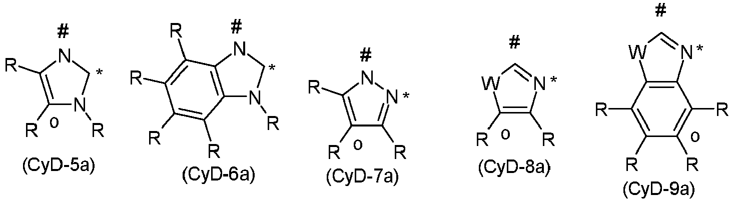 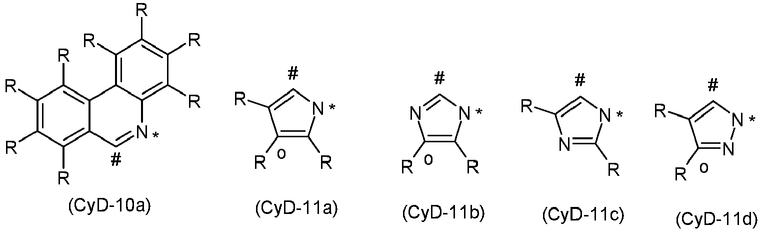 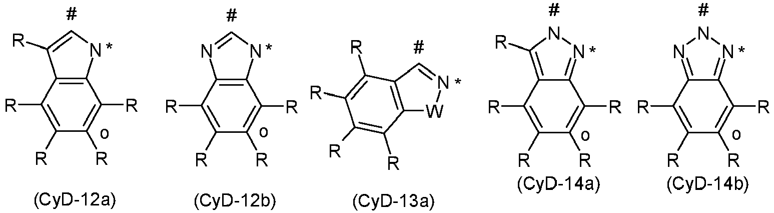 wobei die verwendeten Symbole die oben genannten Bedeutungen aufweisen und, wenn CyD an V¹ bzw. V² gebunden ist, ein Rest R nicht vorhanden ist und V¹ bzw. V² an das entsprechende Kohlenstoffatom gebunden ist. Wenn der Teilligand L¹ über die Gruppe CyD an V¹ gebunden ist, so erfolgt die Bindung bevorzugt über die mit "o" markierte Position der oben abgebildeten Formeln, so dass dann bevorzugt der entsprechende Rest R nicht vorhanden ist. Die oben abgebildeten Strukturen für L¹, die kein mit "o" markiertes Kohlenstoffatom enthalten, sind bevorzugt nicht an V¹ gebunden, da eine solche Bindung an die Brücke aus sterischen Gründen nicht vorteilhaft ist. Wenn der Teilligand L² über die Gruppe CyD an V² gebunden ist, so erfolgt die Bindung bevorzugt über die Position ortho zur Koordination an das Pt.

Bevorzugte Gruppen unter den Gruppen (CyD-1) bis (CyD-14) sind die Gruppen (CyD-1), (CyD-2), (CyD-3), (CyD-4), (CyD-5) und (CyD-6), insbesondere (CyD-1), (CyD-2) und (CyD-3), und besonders bevorzugt sind die Gruppen (CyD-1a), (CyD-2a), (CyD-3a), (CyD-4a), (CyD-5a) und (CyD-6a), insbesondere (CyD-1a), (CyD-2a) und (CyD-3a).

In einer bevorzugten Ausführungsform der vorliegenden Erfindung ist CyC eine Aryl- oder Heteroarylgruppe mit 6 bis 13 aromatischen Ringatomen, und gleichzeitig ist CyD eine Heteroarylgruppe mit 5 bis 13 aromatischen Ringatomen. Besonders bevorzugt ist CyC eine Aryl- oder Heteroarylgruppe mit 6 bis 10 aromatischen Ringatomen, und gleichzeitig ist CyD eine Heteroarylgruppe mit 5 bis 10 aromatischen Ringatomen. Ganz besonders bevorzugt ist CyC eine Aryl- oder Heteroarylgruppe mit 6 aromatischen Ringatomen, insbesondere Phenyl, und CyD eine Heteroarylgruppe mit 6 bis 10 aromatischen Ringatomen. Dabei können CyC und CyD mit einem oder mehreren Resten R substituiert sein.

Die oben genannten bevorzugten Gruppen (CyC-1) bis (CyC-20) und (CyD-1) bis (CyD-14) können in den Teilliganden der Formeln (L-1) und (L-2) beliebig miteinander kombiniert werden, sofern mindestens eine der Gruppen CyC bzw. CyD eine geeignete Anknüpfungsstelle an die Gruppen V¹ bzw. V² aufweist. Insbesondere bevorzugt ist es, wenn die oben als besonders bevorzugt genannten Gruppen CyC und CyD, also die Gruppen der Formeln (CyC-1a) bis (CyC-20a) und die Gruppen der Formeln (CyD1-a) bis (CyD-14b) miteinander kombiniert werden, sofern mindestens eine der bevorzugten Gruppen CyC bzw. CyD eine geeignete Anknüpfungsstelle an V¹ bzw. V² aufweist.

Ganz besonders bevorzugt ist es, wenn eine der Gruppen (CyC-1), (CyC-3), (CyC-8), (CyC-10), (CyC-12), (CyC-13) und (CyC-16), und insbesondere die Gruppen (CyC-1a), (CyC-3a), (CyC-8a), (CyC-10a), (CyC-12a), (CyC-13a) und (CyC-16a), mit einer der Gruppen (CyD-1), (CyD-2) und (CyD-3), und insbesondere mit einer der Gruppen (CyD-1a), (CyD-2a) und (CyD-3a), kombiniert wird.

Bevorzugte Teilliganden (L-1) sind die Strukturen der folgenden Formeln (L-1-1) und (L-1-2), und bevorzugte Teilliganden (L-2) sind die Strukturen der folgenden Formeln (L-2-1) bis (L-2-3), 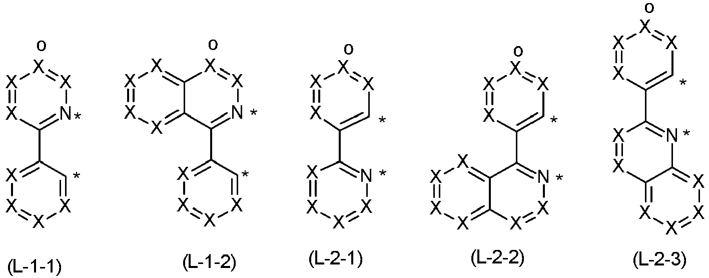 wobei die verwendeten Symbole die oben genannten Bedeutungen aufweisen, * die Position der Koordination an das Ir bzw. das Pt andeutet und "o" die Position der Bindung an V¹ darstellt, falls es sich bei den Strukturen um eine Ausführungsform von L¹ handelt. Falls es sich bei den Strukturen um eine Ausführungsform von L² handelt, ist V² bevorzugt in einer Position ortho zur Koordination an das Pt gebunden. Das Symbol X, an das V¹ bzw. V² gebunden ist, steht dann für C.

Besonders bevorzugt steht in diesen Strukturen X gleich oder verschieden bei jedem Auftreten für CR, so dass es sich bevorzugt um die Strukturen der folgenden Formeln (L-1-1a) bis (L-2-3a) handelt, 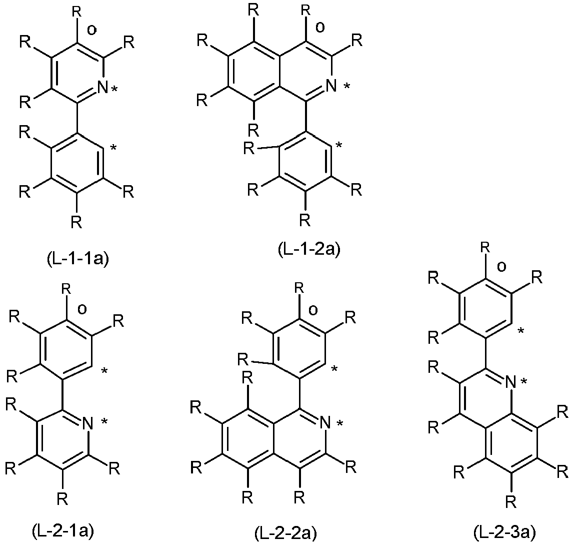 wobei die verwendeten Symbole die oben genannten Bedeutungen aufweisen und "o" die Position der Bindung an V¹ darstellt, falls es sich bei den Strukturen um eine Ausführungsform von L¹ handelt. Falls es sich bei den Strukturen um eine Ausführungsform von L² handelt, ist V² bevorzugt in einer Position ortho zur Koordination an das Pt gebunden. Der Rest R an dem Kohlenstoffatom, an das V¹ bzw. V² gebunden ist, ist dann nicht vorhanden.

Ebenso können die oben genannten bevorzugten Gruppen CyD in den Teilliganden der Formel (L-3) beliebig miteinander kombiniert werden, wobei eine neutrale Gruppe CyD, also eine Gruppe (CyD-1) bis (CyD-10), (CyD-13) oder (CyD-14), mit einer anionischen Gruppe CyD, also einer Gruppe (CyD-11) oder CyD-12) kombiniert wird, oder wobei zwei neutrale Gruppen CyD miteinander kombiniert werden, sofern mindestens eine der Gruppen CyD eine geeignete Anknüpfungsstelle an V¹ bzw. V² aufweist.

Wenn zwei Reste R, von denen einer an CyC und der andere an CyD in den Formeln (L-1) und (L-2) gebunden sind bzw. von denen einer an die eine Gruppe CyD und der andere an die andere Gruppe CyD in Formel (L-3) gebunden sind, miteinander ein aromatisches Ringsystem bilden, können sich überbrückte Teilliganden und auch Teilliganden ergeben, die insgesamt eine einzige größere Heteroarylgruppe darstellen, wie beispielsweise Benzo[h]chinolin, etc.. Die Ringbildung zwischen den Substituenten an CyC und CyD in den Formeln (L-1) und (L-2) bzw. zwischen den Substituenten an den beiden Gruppen CyD in Formel (L-3) erfolgt dabei bevorzugt durch eine Gruppe gemäß einer der folgenden Formeln (39) bis (48), 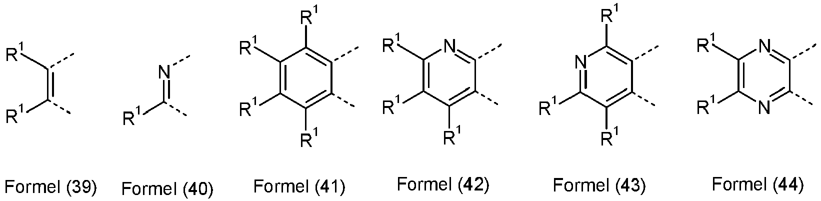 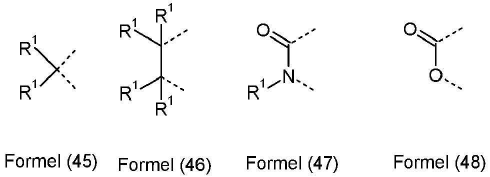 wobei R¹ die oben genannten Bedeutungen aufweist und die gestrichelten Bindungen die Bindungen an CyC bzw. CyD andeuten. Dabei können die unsymmetrischen der oben genannten Gruppen in jeder der beiden Orientierungen eingebaut werden, beispielsweise kann bei der Gruppe der Formel (48) das Sauerstoffatom an die Gruppe CyC und die Carbonylgruppe an die Gruppe CyD binden, oder das Sauerstoffatom kann an die Gruppe CyD und die Carbonylgruppe an die Gruppe CyC binden.

Dabei ist die Gruppe der Formel (45) besonders dann bevorzugt, wenn sich dadurch die Ringbildung zu einem Sechsring ergibt, wie beispielsweise unten durch die Formeln (L-22) und (L-23) dargestellt.

Bevorzugte Liganden, die durch Ringbildung zweier Reste R an den unterschiedlichen Cyclen entstehen, sind die im Folgenden aufgeführten Strukturen der Formeln (L-4) bis (L-31), 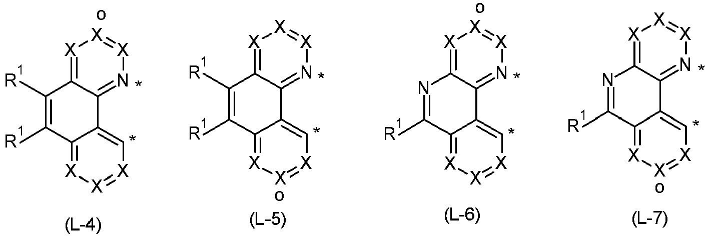 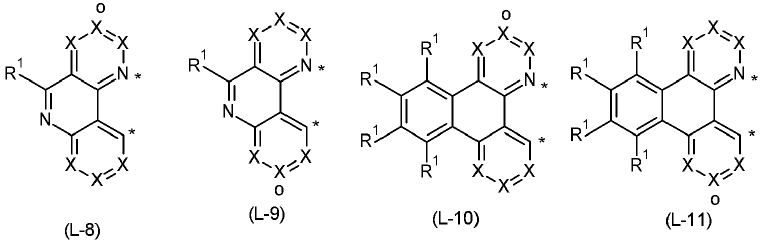 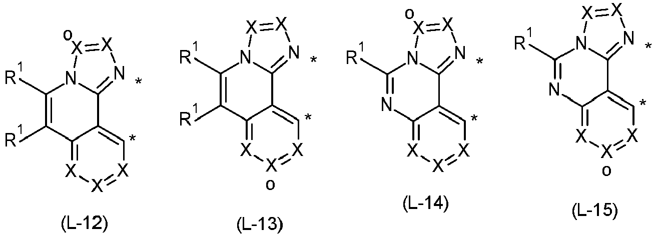 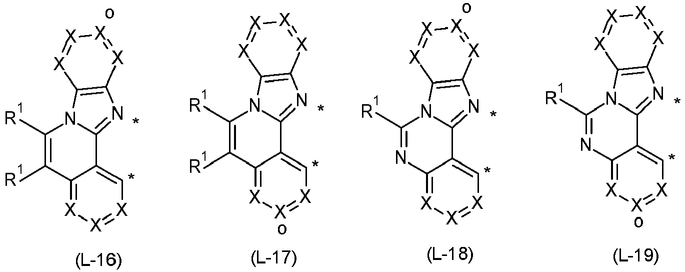 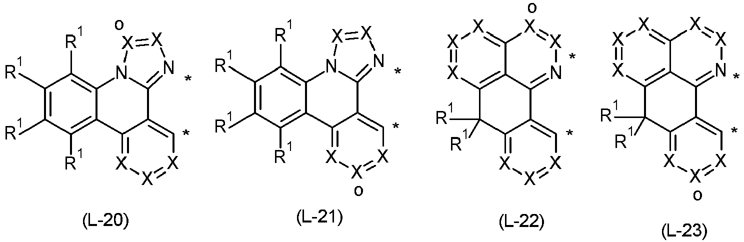 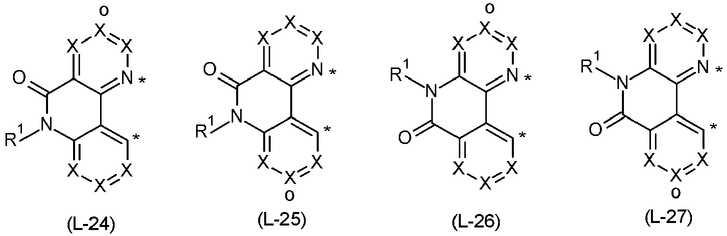 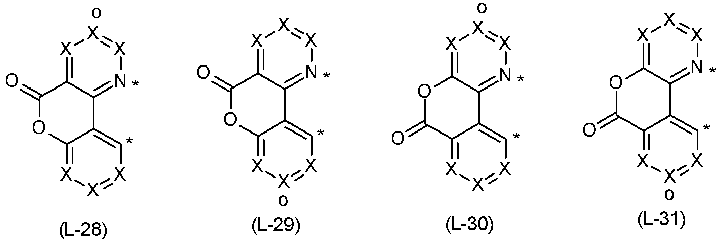 wobei die verwendeten Symbole die oben genannten Bedeutungen aufweisen und "o" die Position angibt, an denen dieser Teilligand mit V¹ verknüpft ist, wenn es sich um eine Ausführungsform von L¹ handelt. Falls es sich bei den Strukturen um eine Ausführungsform von L² handelt, ist V² bevorzugt in einer Position ortho zur Koordination an das Pt gebunden. Das Symbol X, an das V¹ bzw. V² gebunden ist, steht dann für Kohlenstoff.

In einer bevorzugten Ausführungsform der Teilliganden der Formeln (L-4) bis (L-31) steht insgesamt ein Symbol X für N und die anderen Symbole X stehen für CR, oder alle Symbole X stehen für CR.

In einer weiteren Ausführungsform der Erfindung ist es bevorzugt, falls in den Gruppen (CyC-1) bis (CyC-20) oder (CyD-1) bis (CyD-14) oder in den Teilliganden (L-1-1) bis (L-2-3), (L-4) bis (L-31) eines der Atome X für N steht, wenn benachbart zu diesem Stickstoffatom eine Gruppe R als Substituent gebunden ist, welche ungleich Wasserstoff oder Deuterium ist. Dies gilt analog für die bevorzugten Strukturen (CyC-1a) bis (CyC-20a) oder (CyD-1a) bis (CyD-14b), in denen bevorzugt benachbart zu einem nicht koordinierenden Stickstoffatom eine Gruppe R als Substituent gebunden ist, welche ungleich Wasserstoff oder Deuterium ist. Dabei ist dieser Substituent R bevorzugt eine Gruppe, ausgewählt aus CF₃, OR¹ wobei R¹ für eine Alkylgruppe mit 1 bis 10 C-Atomen steht, Alkylgruppen mit 1 bis 10 C-Atomen, insbesondere verzweigten oder cyclischen Alkylgruppen mit 3 bis 10 C-Atomen, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

Weitere geeignete bidentate Teilliganden L¹ bzw. L² sind die Teilliganden der folgenden Formeln (L-32) oder (L-33), 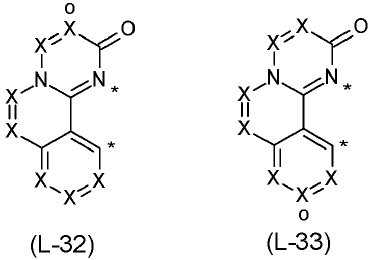 wobei R die oben genannten Bedeutungen aufweist, * die Position der Koordination an das Metall darstellt, "o" die Position der Verknüpfung des Teilliganden mit V¹ darstellt, wenn es sich um eine Ausführungsform von L¹ handelt, und für die weiteren verwendeten Symbole gilt:
- X: ist bei jedem Auftreten gleich oder verschieden CR oder N mit der Maßgabe, dass maximal ein Symbol X pro Cyclus für N steht und weiterhin mit der Maßgabe, dass ein Symbol X für C steht und der Teilligand über dieses Kohlenstoffatom an V¹ bzw. V² gebunden sind.

Wenn (L-32) bzw. (L-33) für eine Ausführungsform von L² stehen, erfolgt die Bindung an V² an dem Cyclus, der über das Kohlenstoffatom an das Pt koordiniert, in ortho-Position zu diesem Kohlenstoffatom.

Wenn zwei Reste R, die in den Teilliganden (L-32) bzw. (L-33) an benachbarten Kohlenstoffatomen gebunden sind, miteinander einen aromatischen Cyclus bilden, so ist dieser zusammen mit den beiden benachbarten Kohlenstoffatomen bevorzugt eine Struktur der folgenden Formel (49), 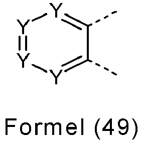 wobei die gestrichelten Bindungen die Verknüpfung dieser Gruppe im Teilliganden symbolisieren und Y gleich oder verschieden bei jedem Auftreten für CR¹ oder N steht, wobei bevorzugt maximal ein Symbol Y für N steht. In einer bevorzugten Ausführungsform des Teilliganden (L-32) bzw. (L-33) ist maximal eine Gruppe der Formel (50) vorhanden. In einer bevorzugten Ausführungsform der Erfindung stehen im Teilliganden der Formel (L-32) und (L-33) insgesamt 0, 1 oder 2 der Symbole X und, falls vorhanden, Y für N. Besonders bevorzugt stehen insgesamt 0 oder 1 der Symbole X und, falls vorhanden, Y für N.

Weitere geeignete bidentate Teilliganden L¹ bzw. L² sind die Strukturen der folgenden Formeln (L-34) bis (L-38), wobei bevorzugt maximal eine der beiden bidentaten Teilliganden L¹ für eine dieser Strukturen steht, 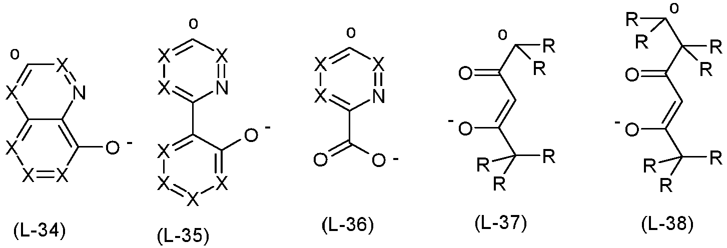 wobei die Teilliganden (L-34) bis (L-36) jeweils über das explizit eingezeichnete Stickstoffatom und das negativ geladene Sauerstoffatom und die Teilliganden (L-37) und (L-38) über die beiden Sauerstoffatome an das Metall koordinieren, X die oben genannten Bedeutungen aufweist und "o" die Position angibt, über die der Teilligand L¹ mit V¹ bzw. der Teilligand L² mit V² verknüpft ist. Wenn (L-35) eine Ausführungsform von L² ist, ist es auch bevorzugt, wenn V² für eine Einfachbindung steht.

Bevorzugte Teilliganden der Formeln (L-34) bis (L-36) sind die Teilliganden der folgenden Formeln (L-34a) bis (L-36a), 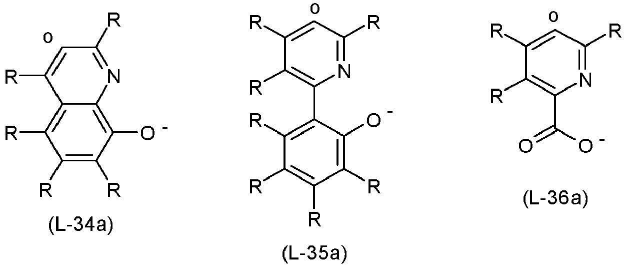 wobei die verwendeten Symbole die oben genannten Bedeutungen aufweisen und "o" die Position angibt, über die der Teilligand L¹ mit V¹ bzw. der Teilligand L² mit V² verknüpft ist.

Besonders bevorzugt steht in diesen Formeln R für Wasserstoff, wobei "o" die Position angibt, über die der Teilligand L¹ mit V¹ bzw. L² mit V² verknüpft ist, so dass es sich um die Strukturen der folgenden Formeln (L-34b) bis (L-36b) handelt, 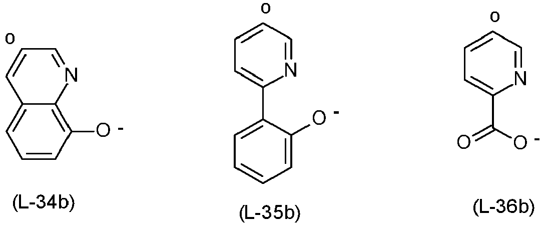 wobei die verwendeten Symbole die oben genannten Bedeutungen aufweisen.

Wenn die Teilliganden L¹ und/oder L² als monoanionische Teilliganden über Stickstoffatome an das Iridium bzw. Platin koordinieren, dann handelt es sich bevorzugt gleich oder verschieden um Teilliganden gemäß einer der folgenden Formeln (L-39), (L-40) und (L-41), 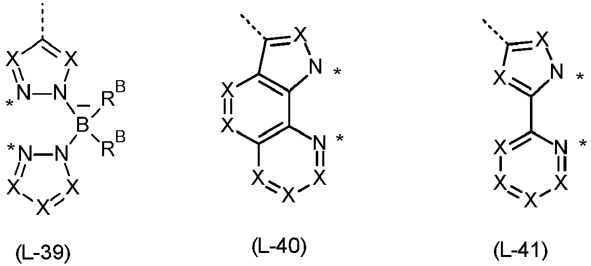 wobei X und R¹ die oben genannten Bedeutungen aufweisen, wobei maximal eine Gruppe X pro Ring für N steht, und R^{B} bei jedem Auftreten gleich oder verschieden ausgewählt ist aus der Gruppe bestehend aus F, OR¹, einer geradkettigen Alkylgruppe mit 1 bis 10 C-Atomen oder einer verzweigten oder cyclischen Alkylgruppe mit 3 bis 10 C-Atomen, wobei die Alkylgruppe jeweils mit einem oder mehreren Resten R¹ substituiert sein kann, oder einem aromatischen oder heteroaromatischen Ringsystem mit 5 bis 24 aromatischen Ringatomen, das jeweils durch einen oder mehrere Reste R¹ substituiert sein kann; dabei können die beiden Reste R^{B} auch miteinander ein Ringsystem bilden. Dabei koordinieren die Teilliganden über die beiden mit * markierten N-Atome an das Iridium bzw. Platin.

Im Folgenden werden bevorzugte Substituenten beschrieben, wie sie an den oben beschriebenen Teilliganden, aber auch an A, wenn A für eine Gruppe der Formel (4) steht, vorliegen können.

In einer Ausführungsform der Erfindung enthält die erfindungsgemäße Verbindung zwei Substituenten R, die an benachbarte Kohlenstoffatome gebunden sind und die miteinander einen aliphatischen Ring gemäß einer der nachfolgend beschriebenen Formeln bilden. Dabei können die beiden Substituenten R, die diesen aliphatischen Ring bilden, an der Brücke der Formeln (2) bzw. (3) bzw. den bevorzugten Ausführungsformen vorliegen und/oder an einem oder mehreren der bidentaten Teilliganden L¹ und/oder L² vorliegen. Der aliphatische Ring, der durch die Ringbildung von zwei Substituenten R miteinander gebildet wird, wird bevorzugt durch eine der folgenden Formeln (50) bis (56) beschrieben, 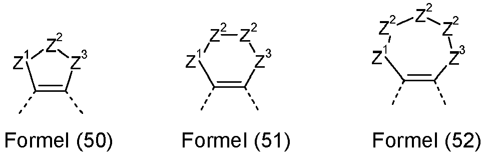 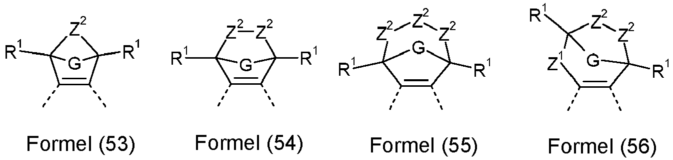 wobei R¹ und R² die oben genannten Bedeutungen aufweisen, die gestrichelten Bindungen die Verknüpfung der beiden Kohlenstoffatome im Liganden andeuten und weiterhin gilt:
- Z¹, Z³: ist gleich oder verschieden bei jedem Auftreten C(R³)₂, O, S, NR³ oder C(=O);
- Z²: ist C(R¹)₂, O, S, NR³ oder C(=O);
- G: ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 bis 14 aromatischen Ringatomen, welche durch einen oder mehrere Reste R² substituiert sein kann;
- R³: ist gleich oder verschieden bei jedem Auftreten H, F, eine geradkettige Alkyl- oder Alkoxygruppe mit 1 bis 10 C-Atomen, eine verzweigte oder cyclische Alkyl- oder Alkoxygruppe mit 3 bis 10 C-Atomen, wobei die Alkyl- oder Alkoxygruppe jeweils mit einem oder mehreren Resten R² substituiert sein kann, wobei eine oder mehrere nicht benachbarte CH₂-Gruppen durch R²C=CR², C=C, Si(R²)₂, C=O, NR², O, S oder CONR² ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryl-oxygruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden;
mit der Maßgabe, dass in diesen Gruppen nicht zwei Heteroatome direkt aneinander gebunden sind und nicht zwei Gruppen C=O direkt aneinander gebunden sind.

In einer bevorzugten Ausführungsform der Erfindung ist R³ ungleich H.

In den oben abgebildeten Strukturen der Formeln (50) bis (56) sowie den weiteren als bevorzugt genannten Ausführungsformen dieser Strukturen wird formal eine Doppelbindung zwischen den zwei Kohlenstoffatomen abgebildet. Dies stellt eine Vereinfachung der chemischen Struktur dar, wenn diese beiden Kohlenstoffatome in ein aromatisches oder heteroaromatisches System eingebunden sind und somit die Bindung zwischen diesen beiden Kohlenstoffatomen formal zwischen dem Bindungsgrad einer Einfachbindung und dem einer Doppelbindung liegt. Das Einzeichnen der formalen Doppelbindung ist somit nicht limitierend für die Struktur auszulegen, sondern es ist für den Fachmann offensichtlich, dass es sich hier um eine aromatische Bindung handelt.

Wenn benachbarte Reste in den erfindungsgemäßen Strukturen ein aliphatisches Ringsystem bilden, dann ist es bevorzugt, wenn dieses keine aziden benzylischen Protonen aufweist. Unter benzylischen Protonen werden Protonen verstanden, die an ein Kohlenstoffatom binden, welches direkt an den Liganden gebunden sind. Dies kann dadurch erreicht werden, dass die Kohlenstoffatome des aliphatischen Ringsystems, die direkt an eine Aryl- oder Heteroarylgruppe binden, vollständig substituiert sind und keine Wasserstoffatome gebunden enthalten. So wird die Abwesenheit von aziden benzylischen Protonen in den Formeln (50) bis (52) dadurch erreicht, dass Z¹ und Z³, wenn diese für C(R³)₂ stehen, so definiert sind, dass R³ ungleich Wasserstoff ist. Dies kann weiterhin auch dadurch erreicht werden, dass die Kohlenstoffatome des aliphatischen Ringsystems, die direkt an eine Aryl- oder Heteroarylgruppe binden, die Brückenköpfe einer bi- oder polycyclischen Struktur sind. Die an Brückenkopfkohlenstoffatome gebundenen Protonen sind aufgrund der räumlichen Struktur des Bi- oder Polycyclus wesentlich weniger azide als benzylische Protonen an Kohlenstoffatomen, die nicht in einer bi- oder polycyclischen Struktur gebunden sind, und werden im Sinne der vorliegenden Erfindung als nicht-azide Protonen angesehen. So wird die Abwesenheit von aziden benzylischen Protonen ist in Formeln (53) bis (56) dadurch erreicht, dass es sich dabei um eine bicyclische Struktur handelt, wodurch R¹, wenn es für H steht, deutlich weniger azide als benzylische Protonen, da das korrespondierende Anion der bicyclischen Struktur nicht mesomeriestabilisiert ist. Auch wenn R¹ in Formeln (53) bis (56) für H steht, handelt es sich dabei daher um ein nicht-azides Proton im Sinne der vorliegenden Anmeldung.

In einer bevorzugten Ausführungsform der Struktur gemäß Formel (50) bis (56) steht maximal eine der Gruppen Z¹, Z² und Z³ für ein Heteroatom, insbesondere für O oder NR³, und die anderen Gruppen stehen für C(R³)₂ bzw. C(R¹)₂ oder Z¹ und Z³ stehen gleich oder verschieden bei jedem Auftreten für O oder NR³ und Z² steht für C(R¹)₂. In einer besonders bevorzugten Ausführungsform der Erfindung stehen Z¹ und Z³ gleich oder verschieden bei jedem Auftreten für C(R³)₂ und Z² steht für C(R¹)₂ und besonders bevorzugt für C(R³)₂ oder CH₂.

Bevorzugte Ausführungsformen der Formel (50) sind somit die Strukturen der Formel (50-A), (50-B), (50-C) und (50-D), und eine besonders bevorzugte Ausführungsform der Formel (50-A) sind die Strukturen der Formel (50-E) und (50-F), 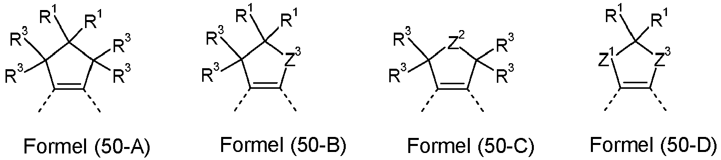 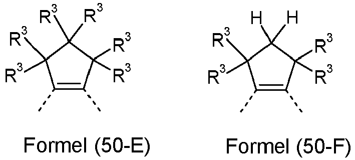 wobei R¹ und R³ die oben genannten Bedeutungen aufweisen und Z¹, Z² und Z³ gleich oder verschieden bei jedem Auftreten für O oder NR³ steht.

Bevorzugte Ausführungsformen der Formel (51) sind die Strukturen der folgenden Formeln (51-A) bis (51-F), 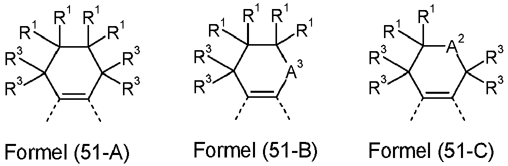 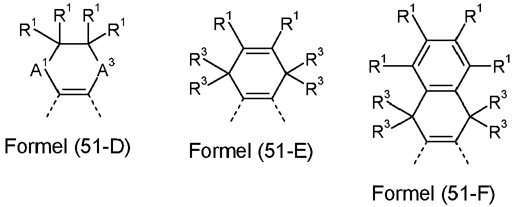 wobei R¹ und R³ die oben genannten Bedeutungen aufweisen und Z¹, Z² und Z³ gleich oder verschieden bei jedem Auftreten für O oder NR³ steht.

Bevorzugte Ausführungsformen der Formel (52) sind die Strukturen der folgenden Formeln (52-A) bis (52-E), 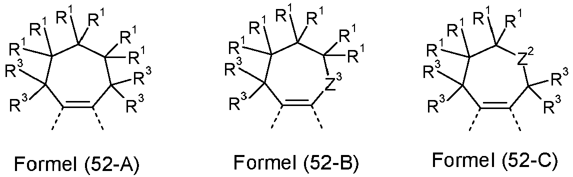 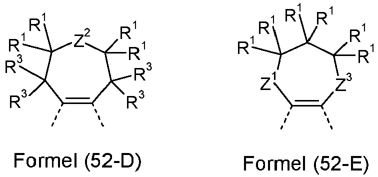 wobei R¹ und R³ die oben genannten Bedeutungen aufweisen und Z¹, Z² und Z³ gleich oder verschieden bei jedem Auftreten für O oder NR³ steht.

In einer bevorzugten Ausführungsform der Struktur gemäß Formel (53) stehen die Reste R¹, die an den Brückenkopf gebunden sind, für H, D, F oder CH₃. Weiterhin bevorzugt steht Z² für C(R¹)₂ oder O, und besonders bevorzugt für C(R³)₂. Bevorzugte Ausführungsformen der Formel (53) sind somit eine Strukturen der Formel (53-A) und (53-B), und eine besonders bevorzugte Ausführungsform der Formel (53-A) ist eine Struktur der Formel (53-C), 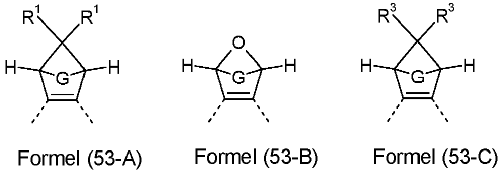 wobei die verwendeten Symbole die oben genannten Bedeutungen aufweisen.

In einer bevorzugten Ausführungsform der Struktur gemäß Formel (54), (55) und (56) stehen die Reste R¹, die an den Brückenkopf gebunden sind, für H, D, F oder CH₃. Weiterhin bevorzugt steht Z² für C(R¹)₂. Bevorzugte Ausführungsformen der Formel (54), (55) und (56) sind somit die Strukturen der Formeln (54-A), (55-A) und (56-A), 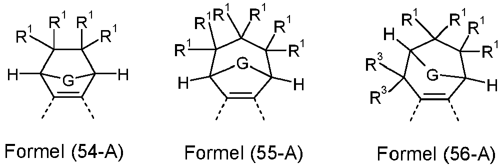 wobei die verwendeten Symbole die oben genannten Bedeutungen aufweisen.

Weiterhin bevorzugt steht die Gruppe G in den Formeln (53), (53-A), (53-B), (53-C), (54), (54-A), (55), (55-A), (56) und (56-A) für eine 1,2-Ethylengruppe, welche mit einem oder mehreren Resten R² substituiert sein kann, wobei R² bevorzugt gleich oder verschieden bei jedem Auftreten für H oder eine Alkylgruppe mit 1 bis 4 C-Atomen steht, oder eine ortho-Arylengruppe mit 6 bis 10 C-Atomen, welche mit einem oder mehreren Resten R² substituiert sein kann, bevorzugt aber unsubstituiert ist, insbesondere eine ortho-Phenylengruppe, welche mit einem oder mehreren Resten R² substituiert sein kann, bevorzugt aber unsubstituiert ist.

In einer weiteren bevorzugten Ausführungsform der Erfindung steht R³ in den Gruppen der Formel (50) bis (56) und in den bevorzugten Ausführungsformen gleich oder verschieden bei jedem Auftreten für F, eine geradkettige Alkylgruppe mit 1 bis 10 C-Atomen oder eine verzweigte oder cyclische Alkylgruppe mit 3 bis 20 C-Atomen, wobei jeweils eine oder mehrere nicht benachbarte CH₂-Gruppen durch R²C=CR² ersetzt sein können und ein oder mehrere H-Atome durch D oder F ersetzt sein können, oder ein aromatisches oder heteroaromatisches Ringsystem mit 5 bis 14 aromatischen Ringatomen, das jeweils durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

In einer besonders bevorzugten Ausführungsform der Erfindung steht R³ in den Gruppen der Formeln (50) bis (56) und in den bevorzugten Ausführungsformen gleich oder verschieden bei jedem Auftreten für F, eine geradkettige Alkylgruppe mit 1 bis 3 C-Atomen, insbesondere Methyl, oder ein aromatisches oder heteroaromatisches Ringsystem mit 5 bis 12 aromatischen Ringatomen, das jeweils durch einen oder mehrere Reste R² substituiert sein kann, bevorzugt aber unsubstituiert ist; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

Beispiele für besonders geeignete Gruppen der Formel (50) sind die im Folgenden abgebildeten Gruppen:

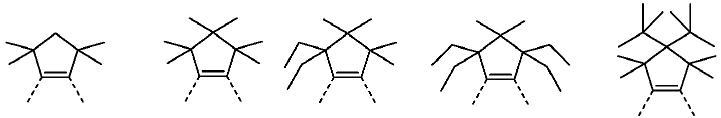

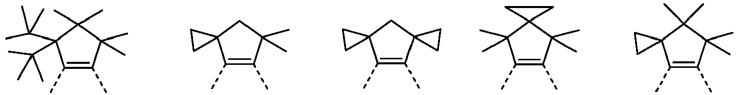

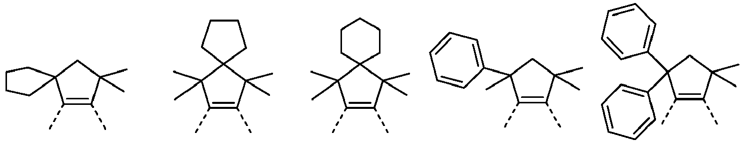

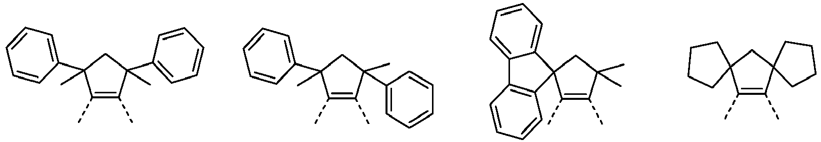

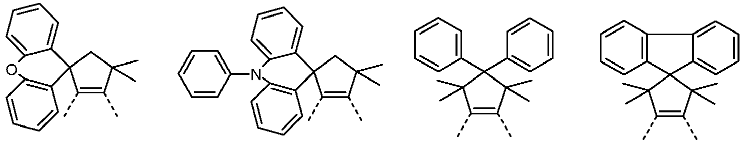

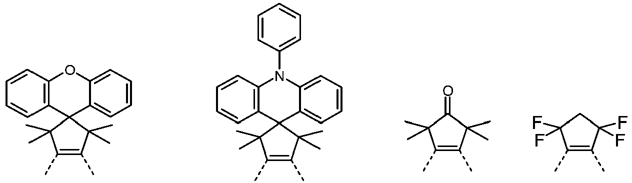

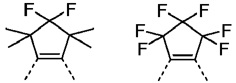

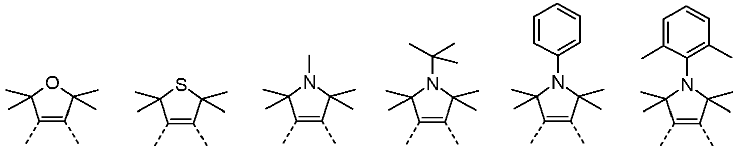

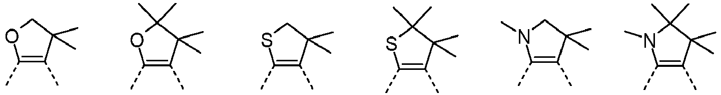

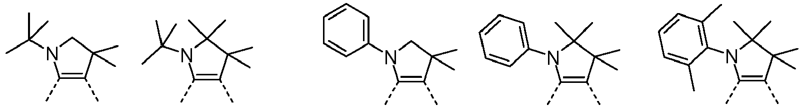

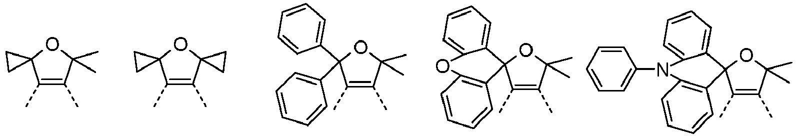

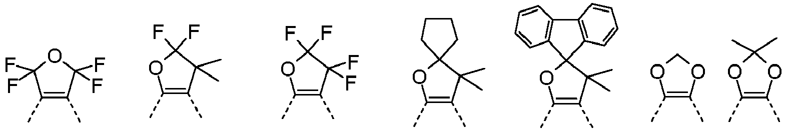

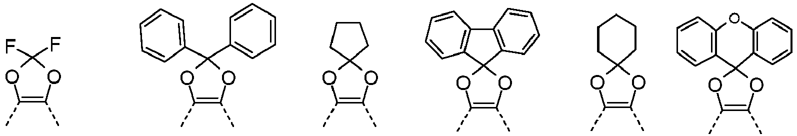

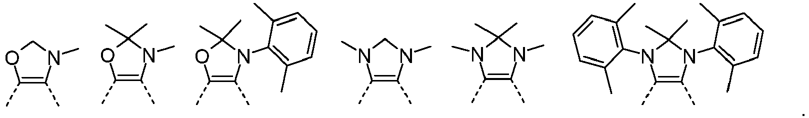

Beispiele für besonders geeignete Gruppen der Formel (51) sind die im Folgenden abgebildeten Gruppen:

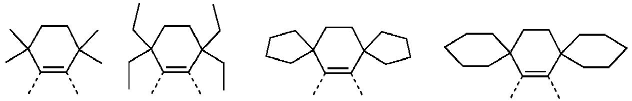

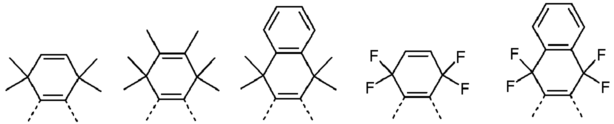

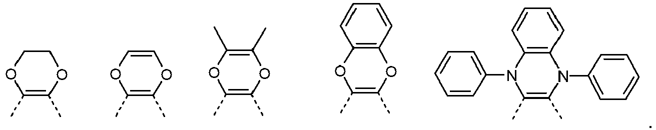

Beispiele für besonders geeignete Gruppen der Formel (52), (55) und (56) sind die im Folgenden abgebildeten Gruppen:

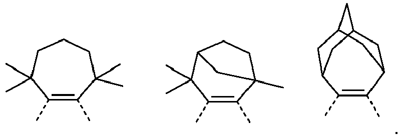

Beispiele für besonders geeignete Gruppen der Formel (53) sind die im Folgenden abgebildeten Gruppen:

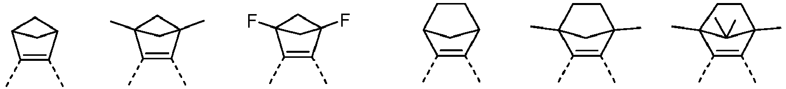

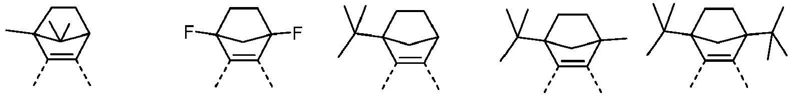

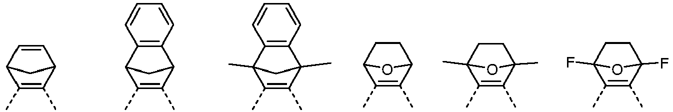

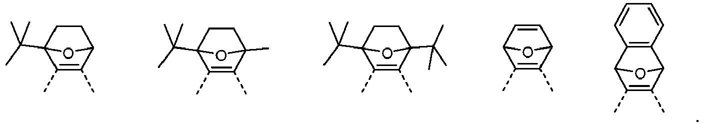

Beispiele für besonders geeignete Gruppen der Formel (54) sind die im Folgenden abgebildeten Gruppen:

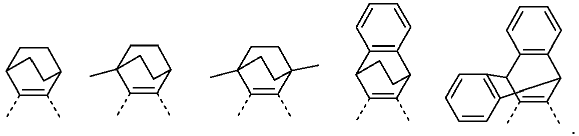

Wenn in den bidentaten Teilliganden bzw. Liganden bzw. in den bivalenten Arylen- bzw. Heteroarylengruppen der Formel (4), welche in den Formeln (2) bzw. (3) bzw. den bevorzugten Ausführungsformen gebunden sind, Reste R gebunden sind, so sind diese Reste R bei jedem Auftreten gleich oder verschieden bevorzugt ausgewählt aus der Gruppe bestehend aus H, D, F, Br, I, N(R¹)₂, OR¹, CN, Si(R¹)₃, B(OR¹)₂, C(=O)R¹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, wobei die Alkyl oder Alkenylgruppe jeweils mit einem oder mehreren Resten R¹ substituiert sein kann, oder einem aromatischen oder heteroaromatischen Ringsystem mit 5 bis 30 aromatischen Ringatomen, das jeweils durch einen oder mehrere Reste R¹ substituiert sein kann; dabei können zwei benachbarte Reste R oder R mit R¹ auch miteinander ein mono- oder polycyclisches, aliphatisches oder aromatisches Ringsystem bilden. Besonders bevorzugt sind diese Reste R bei jedem Auftreten gleich oder verschieden ausgewählt aus der Gruppe bestehend aus H, D, F, N(R¹)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, bevorzugt mit 6 bis 13 aromatischen Ringatomen, das jeweils durch einen oder mehrere Reste R¹ substituiert sein kann; dabei können zwei benachbarte Reste R oder R mit R¹ auch miteinander ein mono- oder polycyclisches, aliphatisches oder aromatisches Ringsystem bilden.

Bevorzugte Reste R¹, die an R gebunden sind, sind bei jedem Auftreten gleich oder verschieden H, D, F, N(R²)₂, OR², CN, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, wobei die Alkylgruppe jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden. Besonders bevorzugte Reste R¹, die an R gebunden sind, sind bei jedem Auftreten gleich oder verschieden H, F, CN, eine geradkettige Alkylgruppe mit 1 bis 5 C-Atomen oder eine verzweigte oder cyclische Alkylgruppe mit 3 bis 5 C-Atomen, die jeweils mit einem oder mehreren Resten R² substituiert sein kann, oder ein aromatisches oder heteroaromatisches Ringsystem mit 5 bis 13 aromatischen Ringatomen, bevorzugt mit 6 bis 13 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden.

Bevorzugte Reste R² sind bei jedem Auftreten gleich oder verschieden H, F oder ein aliphatischer Kohlenwasserstoffrest mit 1 bis 5 C-Atomen oder ein aromatischer Kohlenwasserstoffrest mit 6 bis 12 C-Atomen; dabei können zwei oder mehrere Substituenten R² auch miteinander ein mono- oder polycyclisches, aliphatisches Ringsystem bilden.

Die oben genannten bevorzugten Ausführungsformen sind beliebig innerhalb der Grenzen des Anspruchs 1 miteinander kombinierbar. In einer besonders bevorzugten Ausführungsform der Erfindung gelten die oben genannten bevorzugten Ausführungsformen gleichzeitig.

Beispiele für erfindungsgemäße Verbindungen sind die nachfolgend aufgeführten Strukturen.

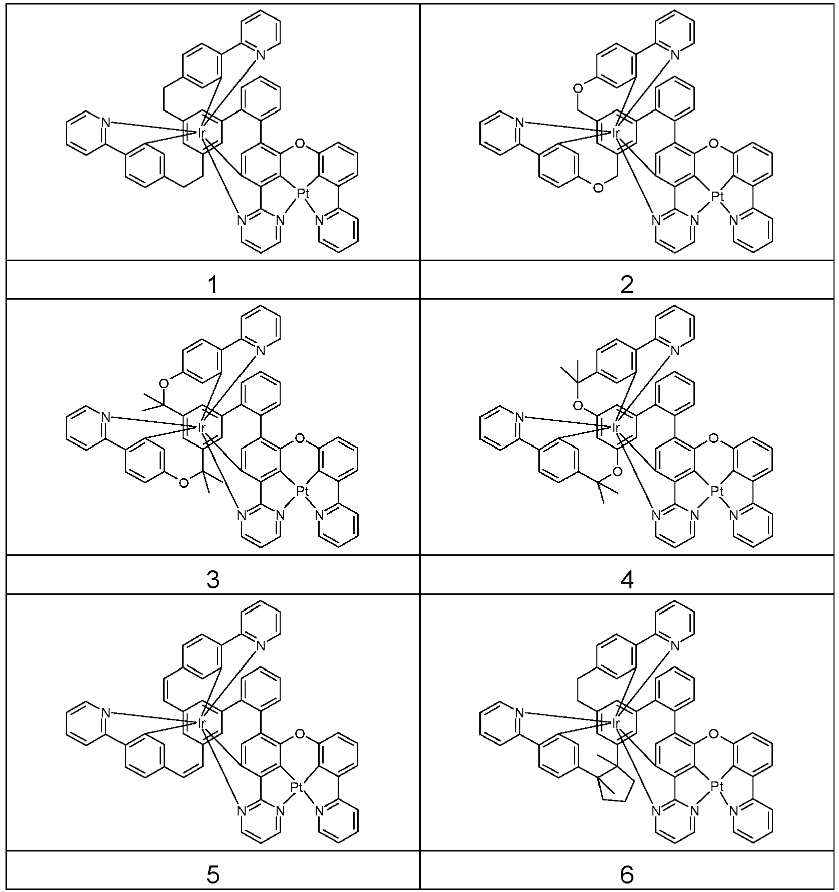

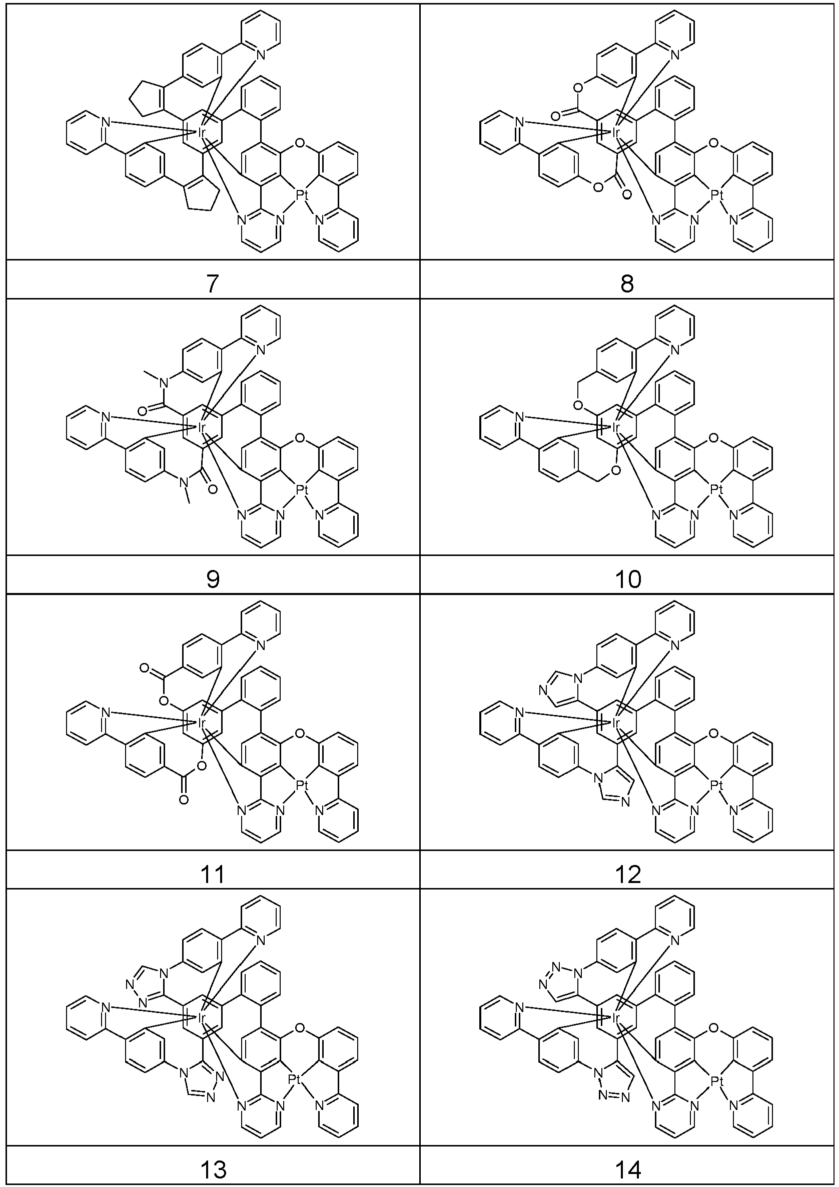

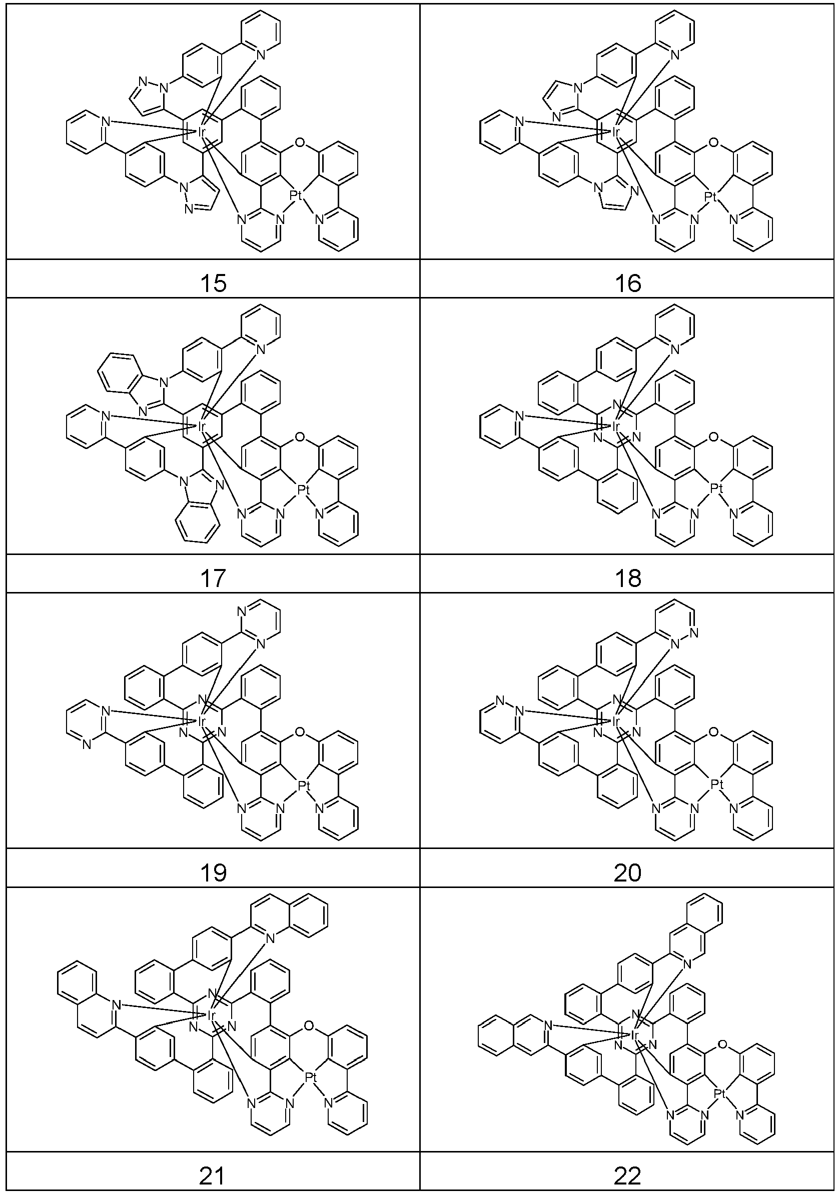

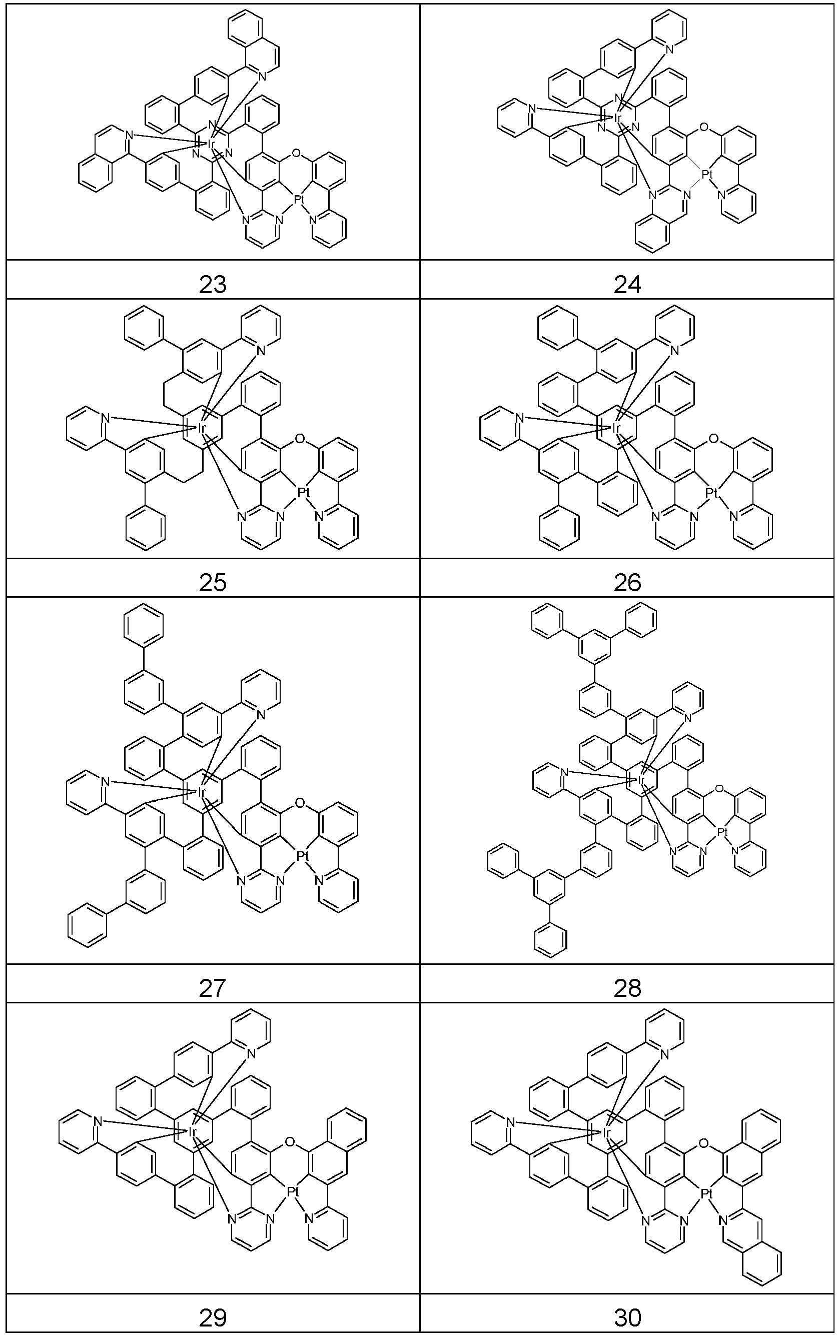

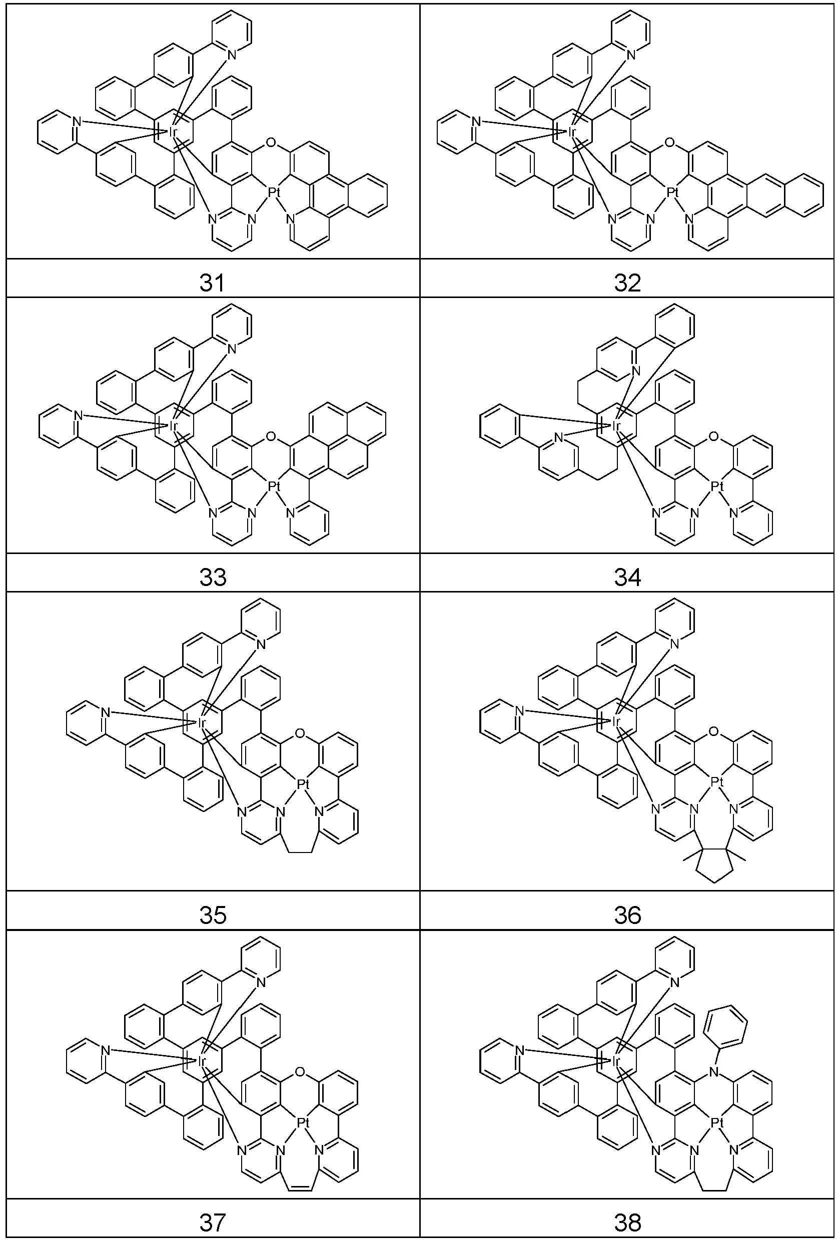

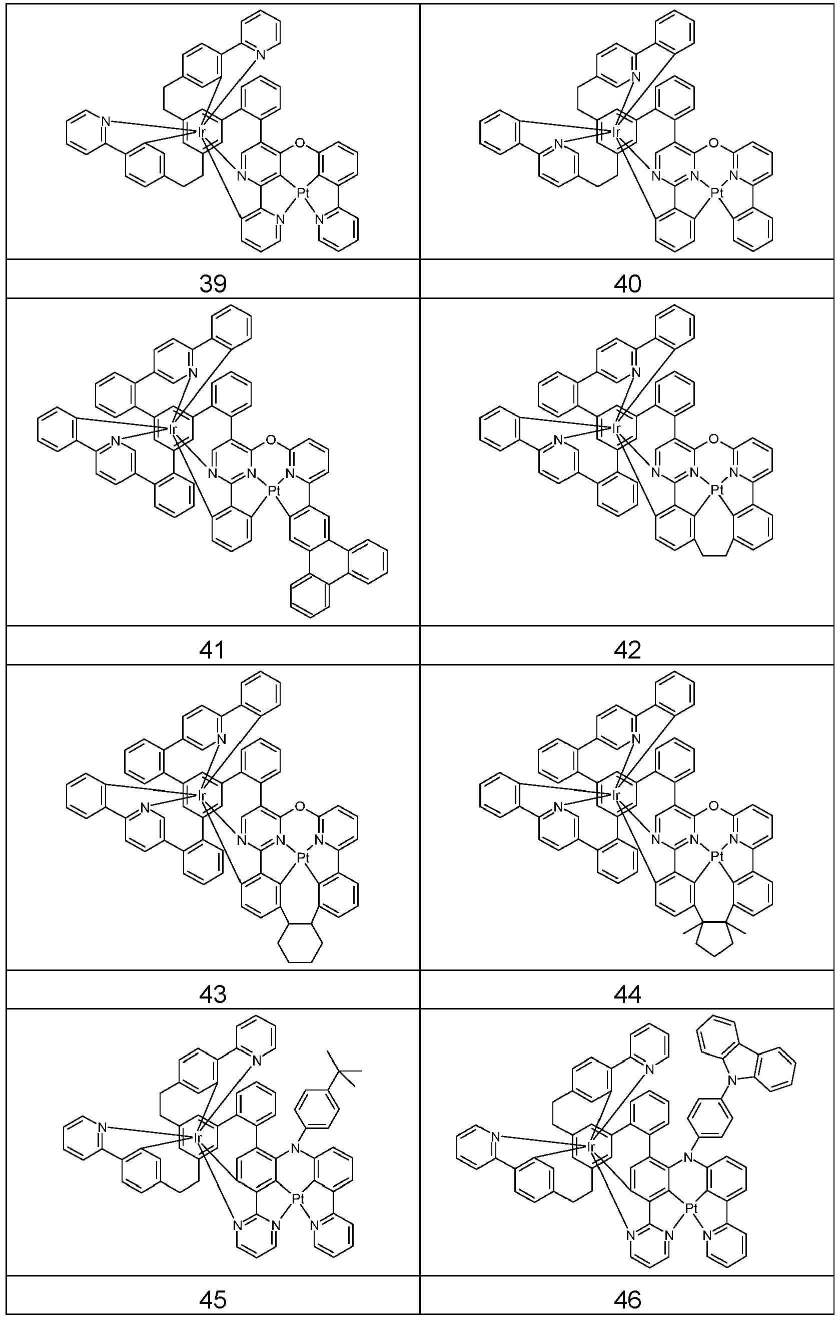

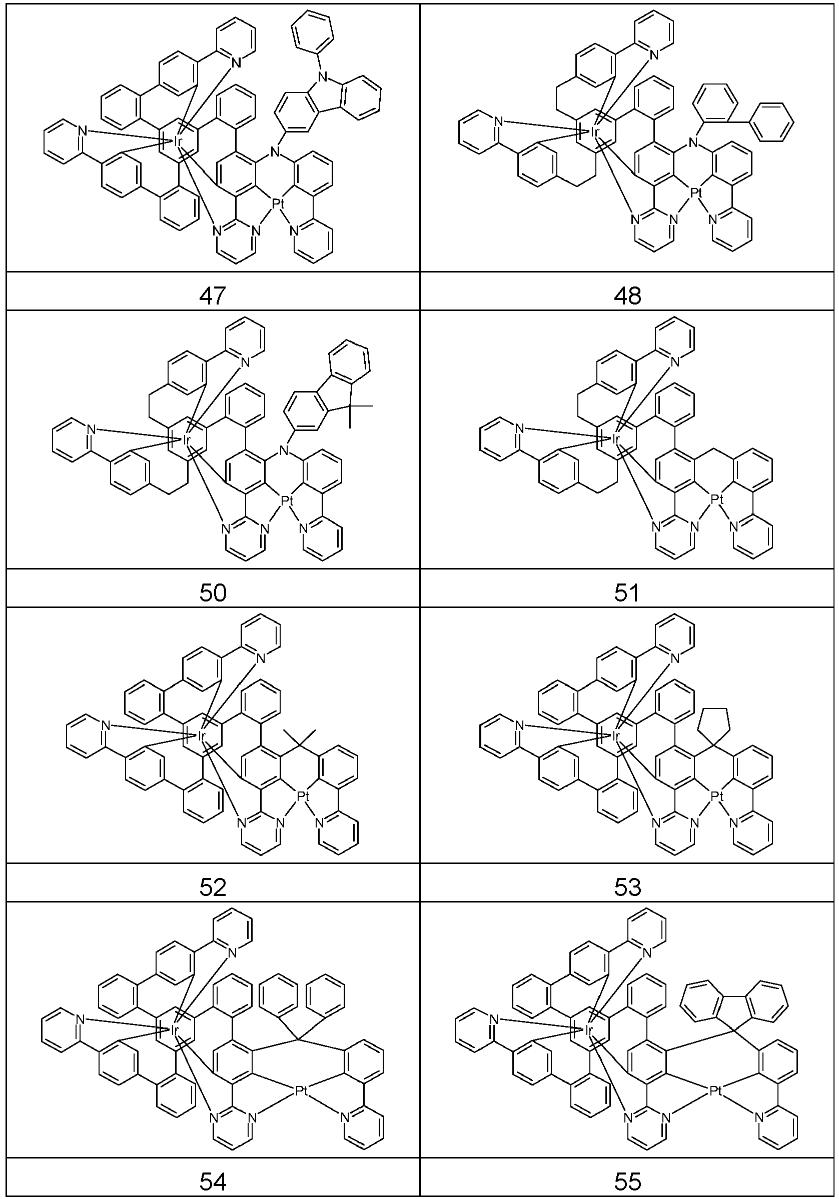

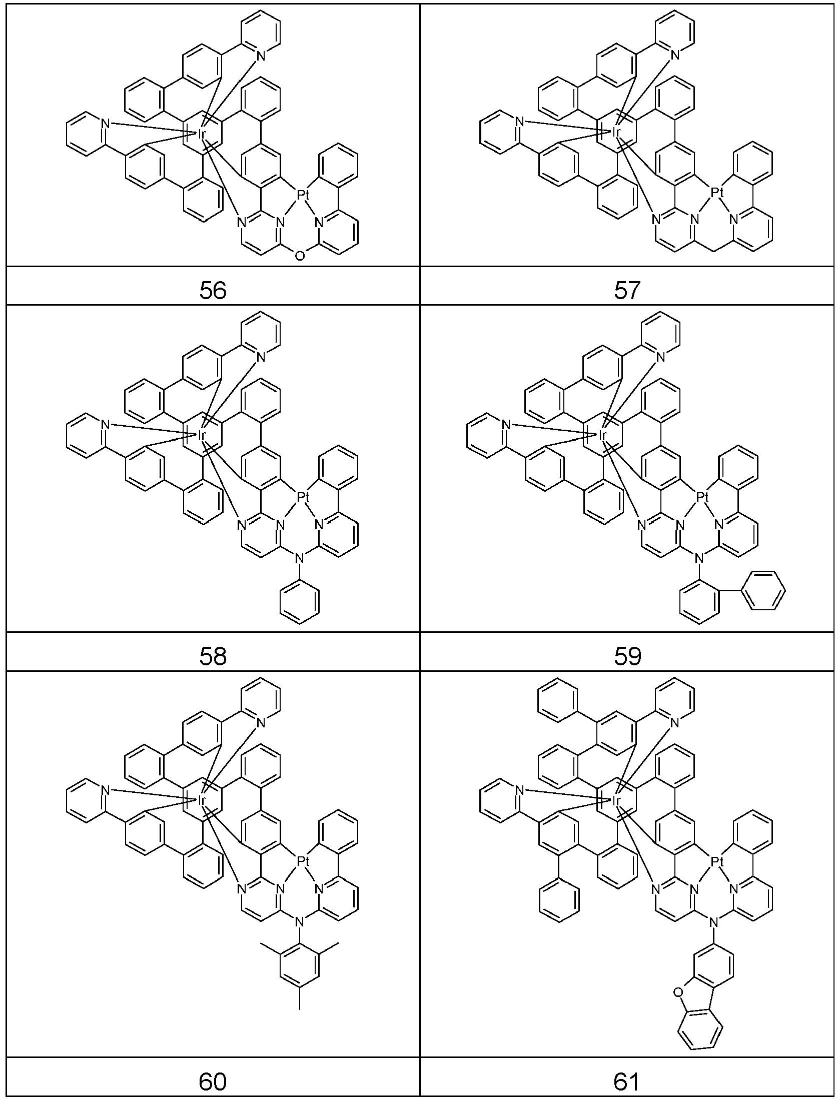

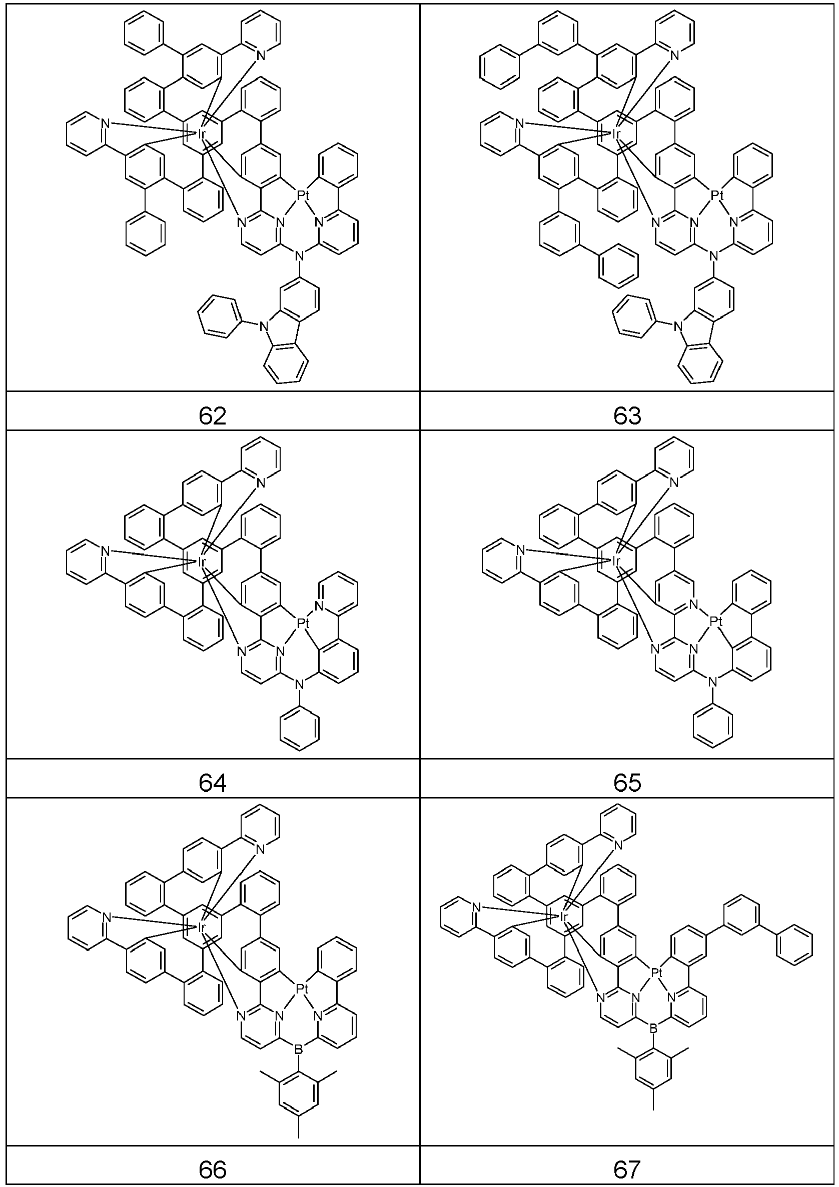

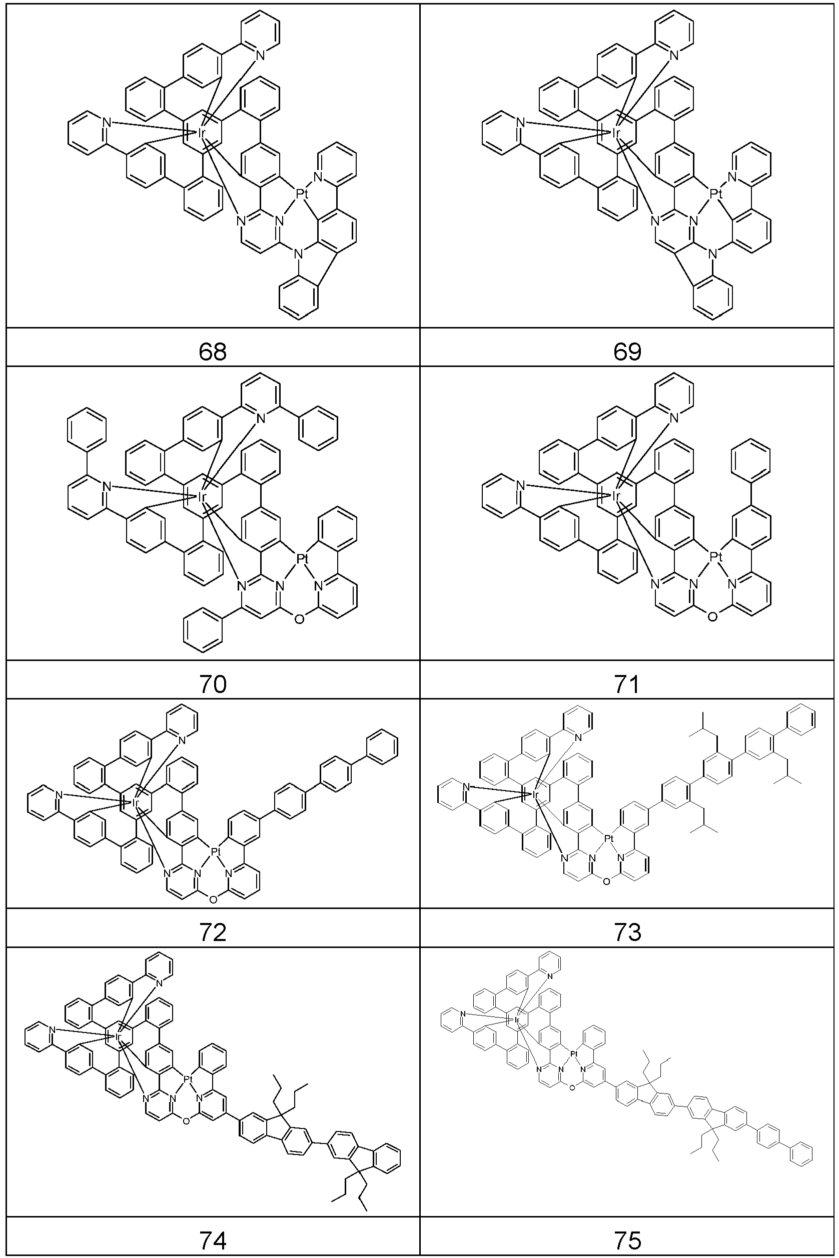

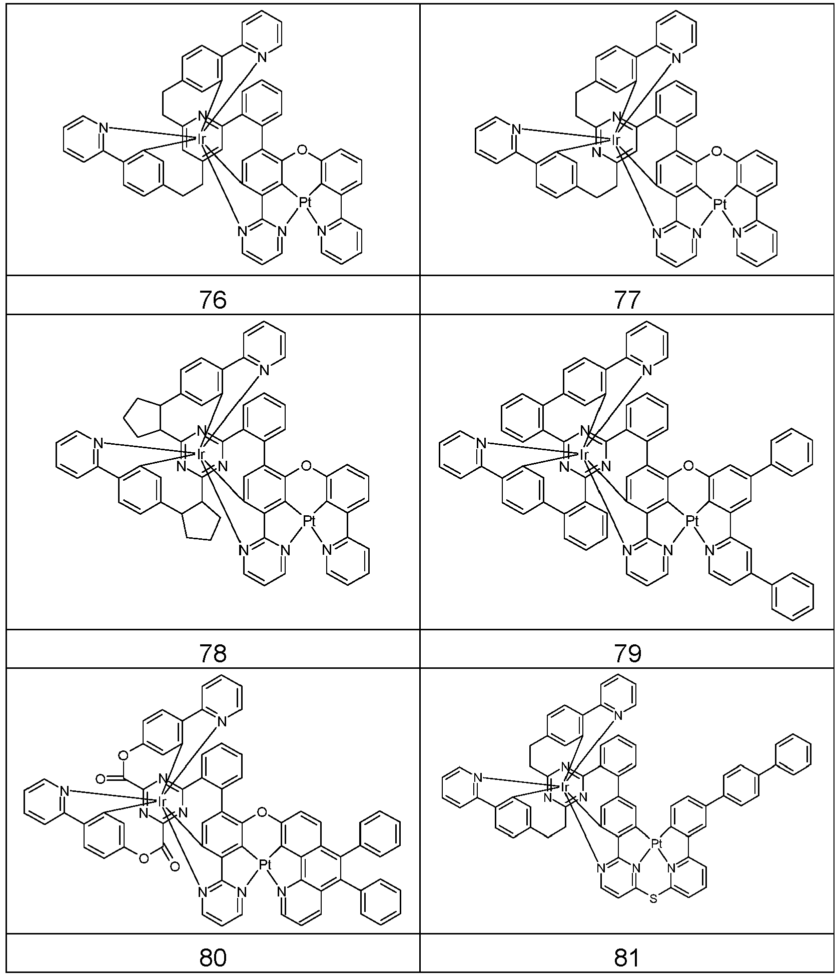

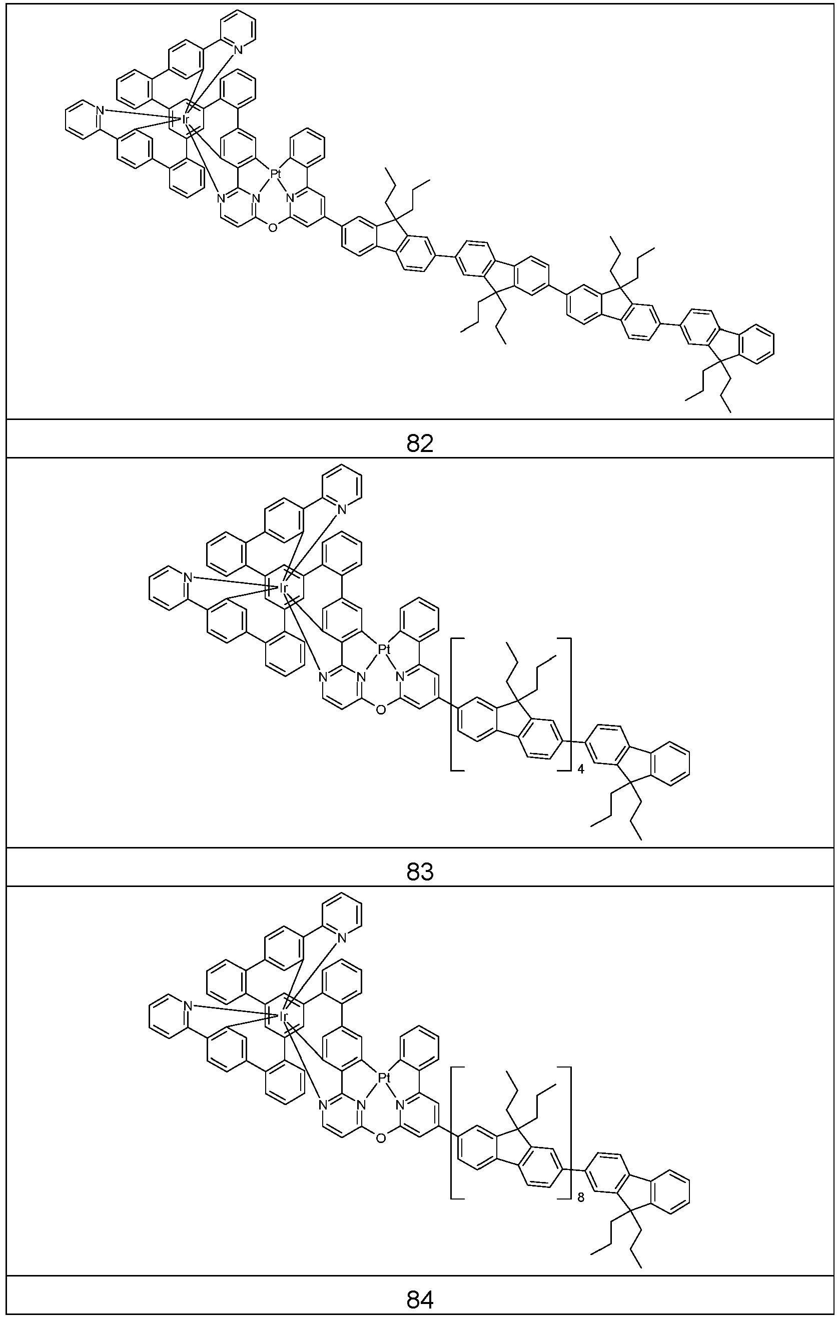

Bei den erfindungsgemäßen Ir-Pt-Komplexen handelt es sich um chirale Strukturen. Wenn zusätzlich auch der tripodale Ligand der Komplexe chiral ist, ist die Bildung von Diastereomeren und mehreren Enantiomerenpaaren möglich. Die erfindungsgemäßen Komplexe umfassen dann sowohl die Mischungen der verschiedenen Diastereomere bzw. die entsprechenden Racemate, wie auch die einzelnen isolierten Diastereomere bzw. Enantiomere.

Werden in der ortho-Metallierung zum Ir-Komplex Liganden mit zwei identischen Teilliganden L¹ eingesetzt, fällt üblicherweise ein racemisches Gemisch der C₁-symmetrischen Komplexe, also des Δ- und des Λ-Enantiomers, an. Diese können durch gängige Methoden (Chromatographie an chiralen Materialien / Säulen oder Racemattrennung durch Kristallisation) getrennt werden.

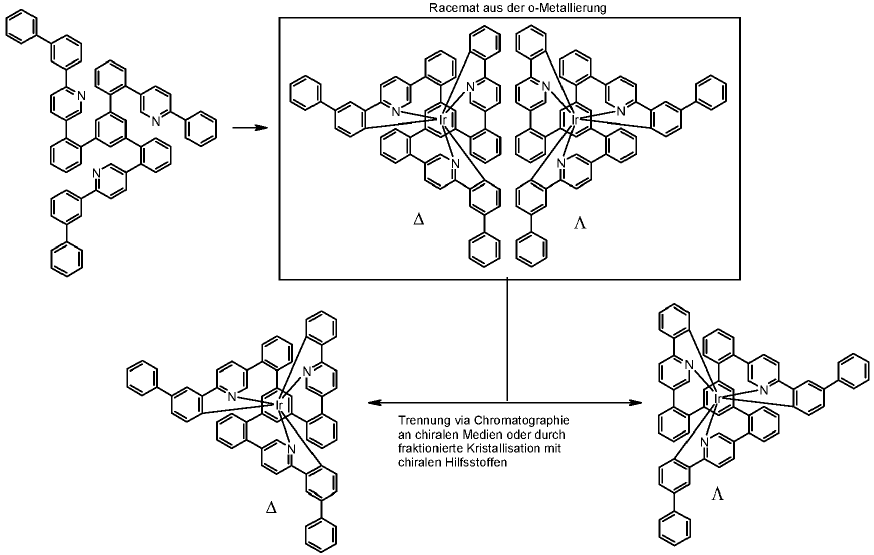

Die Racemattrennung via fraktionierter Kristallisation von diastereomeren Salzpaaren kann nach üblichen Methoden erfolgen. Hierzu bietet es sich an, die neutralen Ir(III)-Komplexe zu oxidieren (z. B. mit Peroxiden, H₂O₂ oder elektrochemisch), die so erzeugten kationischen Ir(IV)-Komplexe mit dem Salz einer enantiomerenreinen, monoanionischen Base (chirale Base) zu versetzen, die so erzeugten diasteromeren Salze durch fraktionierte Kristallisation zu trennen und diese dann mit Hilfe eines Reduktionsmittels (z. B. Zink, Hydrazinhydrat, Ascorbinsäure, etc.) zu den enantiomerenreinen neutralen Komplex zu reduzieren, wie im Folgenden schematisch dargestellt.

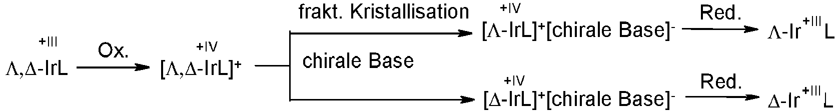

Daneben ist eine enantiomerenreine bzw. enantiomerenanreichernde Synthese durch Komplexierung in einem chiralen Medium (z. B. R- oder S-1,1-Binaphthol) möglich.

Werden in der Komplexierung Liganden mit drei unterschiedlichen Teilliganden eingesetzt, fällt üblicherweise ein Diastereomerengemisch der Komplexe an, das durch gängige Methoden (Chromatographie, Kristallisation, etc.) getrennt werden kann.

Enantiomerenreine C₁-symmetrische Komplexe können auch gezielt synthetisiert werden, wie im folgenden Schema dargestellt. Dazu wird ein enantiomerenreiner, C₁-symmetrischer Ligand dargestellt, komplexiert, das erhaltene Diasteroemerengemisch wird getrennt und anschließend wird die chirale Gruppe abgespalten.

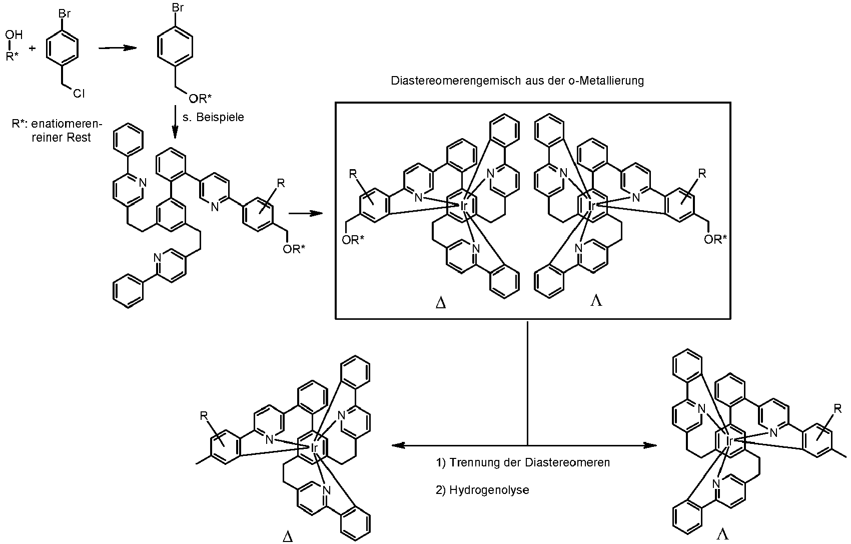

Die weitere Funktionalisierung zu den Ir-Pt-Komplexen kann am Enantiomerengemisch oder an den einzelnen Enantiomeren erfolgen. Dabei ändert sich die Stereochemie am Iridium nicht. Werden bei der Funktionalisierung zu den Ir-Pt-Komplexen weitere Stereozentren eingebracht, entstehen Diastereomere, die durch gängige Methoden (Chromatographie, fraktionierte Kristallisation, etc.) getrennt werden können.

Die erfindungsgemäßen Komplexe können insbesondere durch den nachfolgend beschriebenen Weg dargestellt werden. Dazu wird zunächst ein hexadentater Ligand dargestellt, enthaltend den bzw. die zentralen Teilliganden, die Gruppe V¹ und für n = 1 oder 2 die bzw. den Teilliganden L¹. Mit diesem Liganden wird dann ein Iridiumkomplex dargestellt, welcher dann am zentralen Teilliganden in para-Position zu dem Kohlenstoffatom, welches an Ir koordiniert, funktionalisiert, insbesondere halogeniert wird, bevorzugt bromiert. In einer Kupplungsreaktion wird in einem nächsten Schritt die Gruppe L²-V² eingeführt, und in einem letzten Schritt wird der so entstandene tetradentate Ligand an das Pt koordiniert.

Daher ist ein weiterer Gegenstand der vorliegenden Erfindung ein Verfahren zur Herstellung der erfindungsgemäßen Verbindung, gekennzeichnet durch die folgenden Verfahrensschritte:
a) Synthese eines hexadentaten Liganden, der die Gruppe L²-V² noch nicht enthält;
b) Synthese eines Ir-Komplexes aus dem hexadentaten Liganden;
c) Funktionalisierung des Ir-Komplexes, insbesondere Bromierung;
d) Einführung der Gruppe L²-V² durch eine Kupplungsreaktion; und
e) Synthese des Pt-Komplexes.

Als Iridiumedukte für die Herstellung des Iridiumkomplexes eignen sich insbesondere Iridiumalkoholate der Formel (57), Iridiumketoketonate der Formel (58), Iridiumhalogenide der Formel (59) oder Iridiumcarboxylate der Formel (60),

Ir(OR)₃ Formel (57)

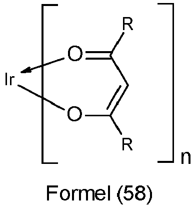

IrHal₃ Formel (59)

Ir(OOCR)₃ Formel (60)

wobei R die oben angegebenen Bedeutungen aufweist, Hal = F, Cl, Br oder I ist und die Iridiumedukte auch als die entsprechenden Hydrate vorliegen können. Dabei steht R bevorzugt für eine Alkylgruppe mit 1 bis 4 C-Atomen.

Es können ebenfalls Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet sind [IrCl₂(acac)₂]⁻, beispielsweise Na[IrCl₂(acac)₂], Metallkomplexe mit Acetylacetonat-Derivaten als Ligand, beispielsweise Ir(acac)₃ oder Tris(2,2,6,6-Tetramethylheptan-3,5-dionato)iridium, und IrCl₃·xH₂O, wobei x üblicherweise für eine Zahl zwischen 2 und 4 steht.

Die Synthese der Iridiumkomplexe wird bevorzugt durchgeführt wie in WO 2002/060910 und in WO 2004/085449 beschrieben. Dabei kann die Synthese beispielsweise auch thermisch, photochemisch und/oder durch Mikrowellenstrahlung aktiviert werden. Weiterhin kann die Synthese auch im Autoklaven bei erhöhtem Druck und/oder erhöhter Temperatur durchgeführt werden.

Die Reaktionen können ohne Zusatz von Lösemitteln oder Schmelzhilfen in einer Schmelze der entsprechenden zu o-metallierenden Liganden durchgeführt werden. Gegebenenfalls können Lösemittel oder Schmelzhilfen zugesetzt werden. Geeignete Lösemittel sind protische oder aprotische Lösemittel, wie aliphatische und / oder aromatische Alkohle (Methanol, Ethanol, iso-Propanol, t-Butanol, etc.), Oligo- und Polyalkohole (Ethylenglykol, 1,2-Propandiol, Glycerin, etc.), Alkoholether (Ethoxyethanol, Diethylenglykol, Triethylenglycol, Polyethylenglykol, etc.), Ether (Di- und Triethylenglykoldimethylether, Diphenylether, etc.), aromatische, heteroaromatische und oder aliphatische Kohlenwasserstoffe (Toluol, Xylol, Mesitylen, Chlorbenzol, Pyridin, Lutidin, Chinolin, iso-Chinolin, Tridecan, Hexadecan, etc.), Amide (DMF, DMAC, etc.), Lactame (NMP), Sulfoxide (DMSO), Sulfone (Dimethylsulfon, Sulfolan, etc.), Carbonsäuren (wie Eisessig, Propionsäure, Fettsäuren, Benzoesäure) und Wasser sowie Gemische dieser Lösungsmittel. Geeignete Schmelzhilfen sind Verbindungen, die bei Rautemperatur fest vorliegen, jedoch beim Erwärmen der Reaktionsmischung schmelzen und die Reaktanden lösen, so dass eine homogene Schmelze entsteht. Besonders geeignet sind Biphenyl, m-Terphenyl, Triphenylen, R- oder S-Binaphthol oder auch das entsprechende Racemat, 1,2-, 1,3-, 1,4-Bis-phenoxybenzol, Triphenylphosphinoxid, 18-Krone-6, Phenol, 1-Naphthol, R-, S-oder RS-1,1 '-Bisnaphthol, Brenzcatechin, Resorcin, Hydrochinon, etc.. Dabei ist die Verwendung von Hydrochinon besonders bevorzugt.

Als Platinedukte für die Herstellung des Platinkomplexes im letzten Syntheseschritt eignen sich beispielsweise PtCl₂, Pt(ac)₂, K₂PtCl₄, (DMSO)₂PtCl₂, (DMSO)₂PtMe₂ oder (COD)PtCl₂.

Die Synthese des Platinkomplexes wird bevorzugt in Lösung, in Suspension oder in der Schmelze durchgeführt. Es können die gleichen Lösungsmittel / Schmelzhilfen wie bei der Darstellung der Iridiumkomplexe eingesetzt werden. Bevorzugt wird als Lösungsmittel Essigsäure bzw. Eisessig und als Schmelzhilfe Hydrochinon eingesetzt.

Gegebenenfalls können zur Verbesserung der Löslichkeit salzartiger Pt-Komplexen Salze wie Lithiumchlorid, Ammoniumchlorid, Tetraalkylammoniumhalogenide oder -sulfate in katalytischer, stöchiometrischer oder überstöchiometrischer Menge zugesetzt werden.

Durch diese Verfahren, gegebenenfalls gefolgt von Aufreinigung, wie z. B. Umkristallisation oder Sublimation, lassen sich die erfindungsgemäßen Verbindungen gemäß Formel (1) in hoher Reinheit, bevorzugt mehr als 99 % (bestimmt mittels ¹H-NMR und/oder HPLC) erhalten.

Die erfindungsgemäßen Verbindungen können auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Insbesondere auch die Verwendung von ankondensierten aliphatischen Gruppen, wie sie beispielsweise durch die oben offenbarten Formeln (50) bis (56) dargestellt werden, führt zu einer deutlichen Verbesserung der Löslichkeit der Metallkomplexe. Solche Verbindungen sind dann in gängigen organischen Lösemitteln, wie beispielsweise Toluol oder Xylol bei Raumtemperatur in ausreichender Konzentration löslich, um die Komplexe aus Lösung verarbeiten zu können. Diese löslichen Verbindungen eignen sich besonders gut für die Verarbeitung aus Lösung, beispielsweise durch Druckverfahren.

Für die Verarbeitung der erfindungsgemäßen Metallkomplexe aus flüssiger Phase, beispielsweise durch Spin-Coating oder durch Druckverfahren, sind Formulierungen der erfindungsgemäßen Metallkomplexe erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropylenglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, Hexamethylindan, 2-Methylbiphenyl, 3-Methylbiphenyl, 1-Methylnaphthalin, 1-Ethylnaphthalin, Ethyloctanoat, Sebacinsäure-diethylester, Octyloctanoat, Heptylbenzol, Menthyl-isovalerat, Cyclohexylhexanoat oder Mischungen dieser Lösemittel.

Ein weiterer Gegenstand der vorliegenden Erfindung ist daher eine Formulierung, enthaltend mindestens eine erfindungsgemäße Verbindung und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Die erfindungsgemäße Verbindung kann in einer elektronischen Vorrichtung als aktive Komponente oder als Sauerstoff-Sensibilisatoren oder als Photokatalysatoren verwendet werden. Ein weiterer Gegenstand der vorliegenden Erfindung ist somit die Verwendung einer erfindungsgemäßen Verbindung in einer elektronischen Vorrichtung oder als Sauerstoff-Sensibilisator oder als Photokatalysator. Nochmals ein weiterer Gegenstand der vorliegenden Erfindung ist eine elektronische Vorrichtung enthaltend mindestens eine erfindungsgemäße Verbindung.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens einen erfindungsgemäßen Metallkomplex enthält. Dabei sind bevorzugte elektronische Vorrichtungen ausgewählt aus der Gruppe bestehend aus organischen Elektrolumineszenzvorrichtungen (OLEDs, PLEDs), organischen Infrarot-Elektrolumineszenzsensoren, organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), wobei hierunter sowohl rein organische Solarzellen wie auch farbstoffsensibilisierte Solarzellen (Grätzel-Zellen) verstanden werden, organischen optischen Detektoren, organischen Photorezeptoren, organischen Feld-Quench-Devices (O-FQDs), lichtemittierenden elektrochemischen Zellen (LECs), Sauerstoff-Sensoren oder organischen Laserdioden (O-Laser), enthaltend in mindestens einer Schicht mindestens einen erfindungsgemäßen Metallkomplex. Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen. Weiterhin können die erfindungsgemäßen Verbindungen zur Erzeugung von Singulett-Sauerstoff oder in der Photokatalyse eingesetzt werden.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie MoO₃ oder WO₃ oder mit (per)fluorierten elektronenarmen Aromaten, und/oder dass eine oder mehrere Elektronentransportschichten n-dotiert sind. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen bzw. Systeme, welche mehr als drei emittierende Schichten aufweisen. Weiterhin bevorzugt sind Tandem-OLEDs Es kann sich auch um ein Hybrid-System handeln, wobei eine oder mehrere Schichten fluoreszieren und eine oder mehrere andere Schichten phosphoreszieren. Weiß emittierende organische Elektrolumineszenzvorrichtungen können für Beleuchtungsanwendungen oder mit Farbfilter auch für Vollfarb-Displays verwendet werden.

Auch Infrarot-Augeniris-Sensoren beruhen auf dem oben beschriebenen Prinzip der organischen Elektrolumineszenzvorrichtungen, wobei die organische Elektrolumineszenzvorrichtung für diese Anwendung Licht im infraroten Bereich des Spektrums emittiert. Das charakteristische vom Auge reflektierte Licht wird dann von einer Kamera detektiert.

In einer bevorzugten Ausführungsform der Erfindung enthält die organische Elektrolumineszenzvorrichtung den erfindungsgemäßen Metallkomplex als emittierende Verbindung in einer oder mehreren emittierenden Schichten, insbesondere in einer rot oder infrarot emittierenden Schicht.

Wenn der erfindungsgemäße Metallkomplex als emittierende Verbindung in einer emittierenden Schicht eingesetzt wird, wird er bevorzugt in Kombination mit einem oder mehreren Matrixmaterialien eingesetzt. Die Mischung aus dem erfindungsgemäßen Metallkomplex und dem Matrixmaterial enthält zwischen 0.1 und 99 Gew.-%, vorzugsweise zwischen 1 und 90 Gew.-%, besonders bevorzugt zwischen 3 und 40 Gew.-%, insbesondere zwischen 5 und 25 Gew.-% des erfindungsgemäßen Metallkomplexes bezogen auf die Gesamtmischung aus Emitter und Matrixmaterial. Entsprechend enthält die Mischung zwischen 99.9 und 1 Gew.-%, vorzugsweise zwischen 99 und 10 Gew.-%, besonders bevorzugt zwischen 97 und 60 Gew.-%, insbesondere zwischen 95 und 75 Gew.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl), m-CBP oder die in WO 2005/039246, US 2005/0069729, JP 2004/288381, EP 1205527, WO 2008/086851 oder US 2009/0134784 offenbarten Carbazolderivate, Biscarbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015 oder WO 2015/169412, oder verbrückte Carbazolderivate, z. B. gemäß US 2009/0136779, WO 2010/050778, WO 2011/042107 oder WO 2011/088877.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat, insbesondere einem Biscarbazol-Derivat, als gemischte Matrix für die erfindungsgemäße Verbindung. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben. Ebenso bevorzugt ist die Verwendung von zwei elektronentransportierenden Matrixmaterialien, beispielsweise Triazinderivaten und Lactamderivaten, wie z. B. in WO 2014/094964 beschrieben.

Nachfolgend sind Beispiele für Verbindungen abgebildet, die sich als Matrixmaterialien für die erfindungsgemäßen Verbindungen eignen.

Beispiele für Triazine und Pyrimidine, welche als elektronentransportierende Matrixmaterialien eingesetzt werden können, sind die folgenden Verbindungen:

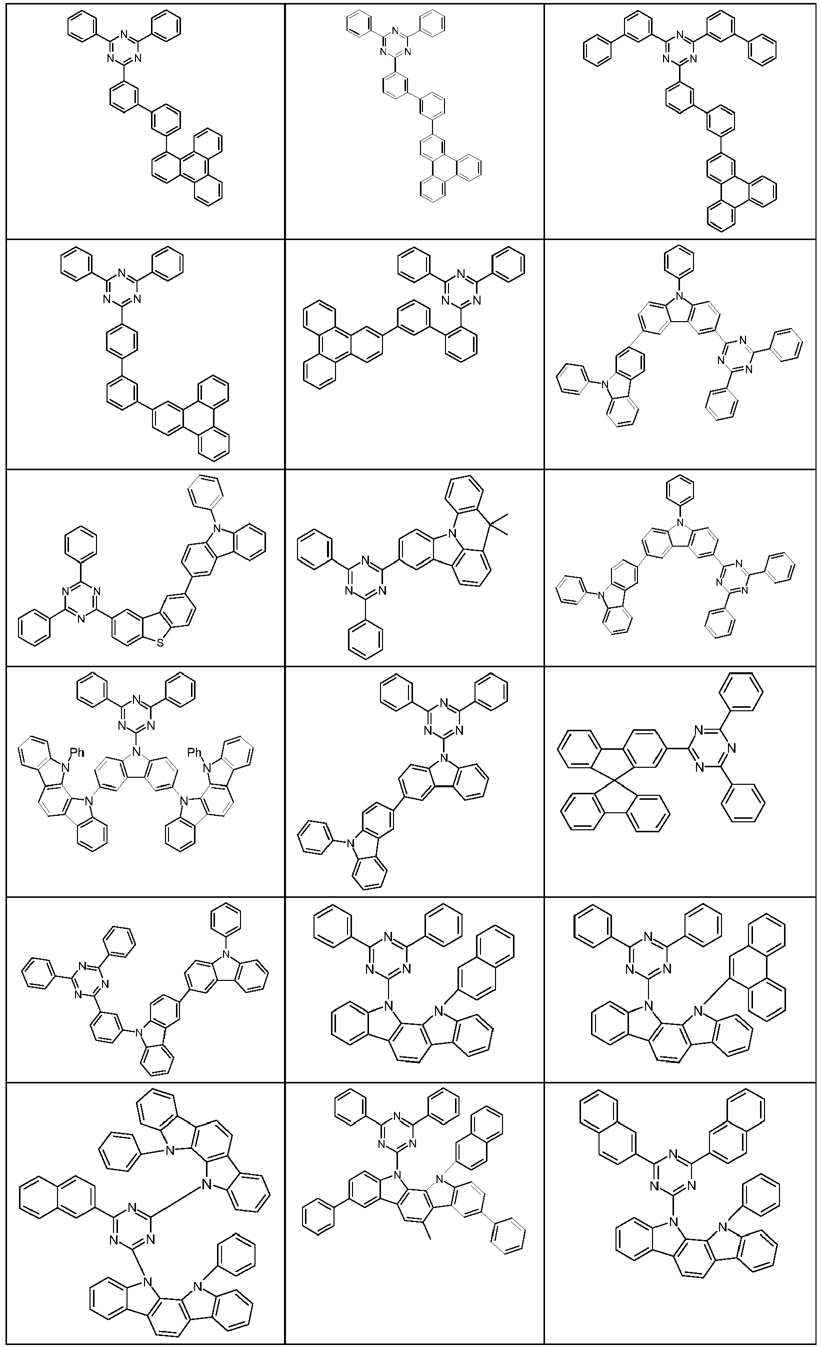

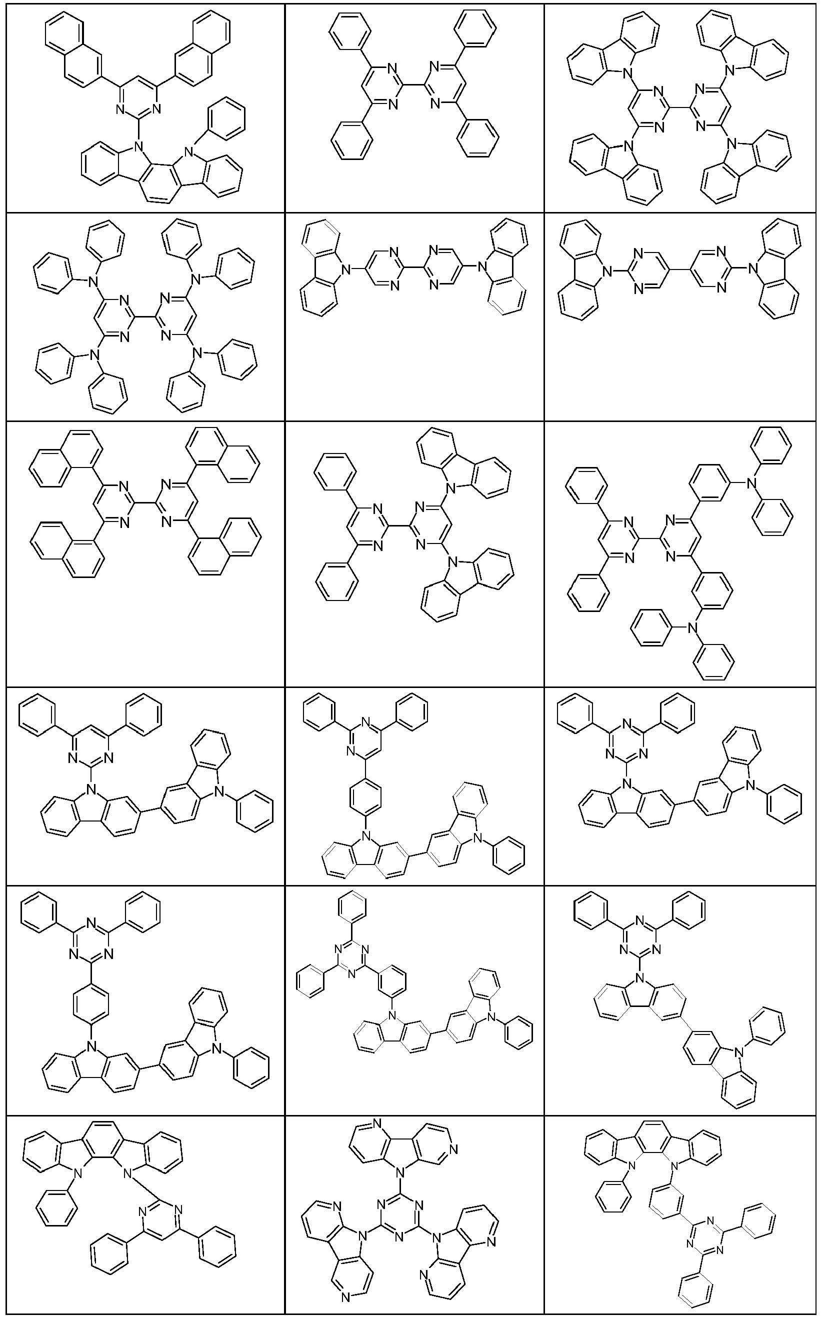

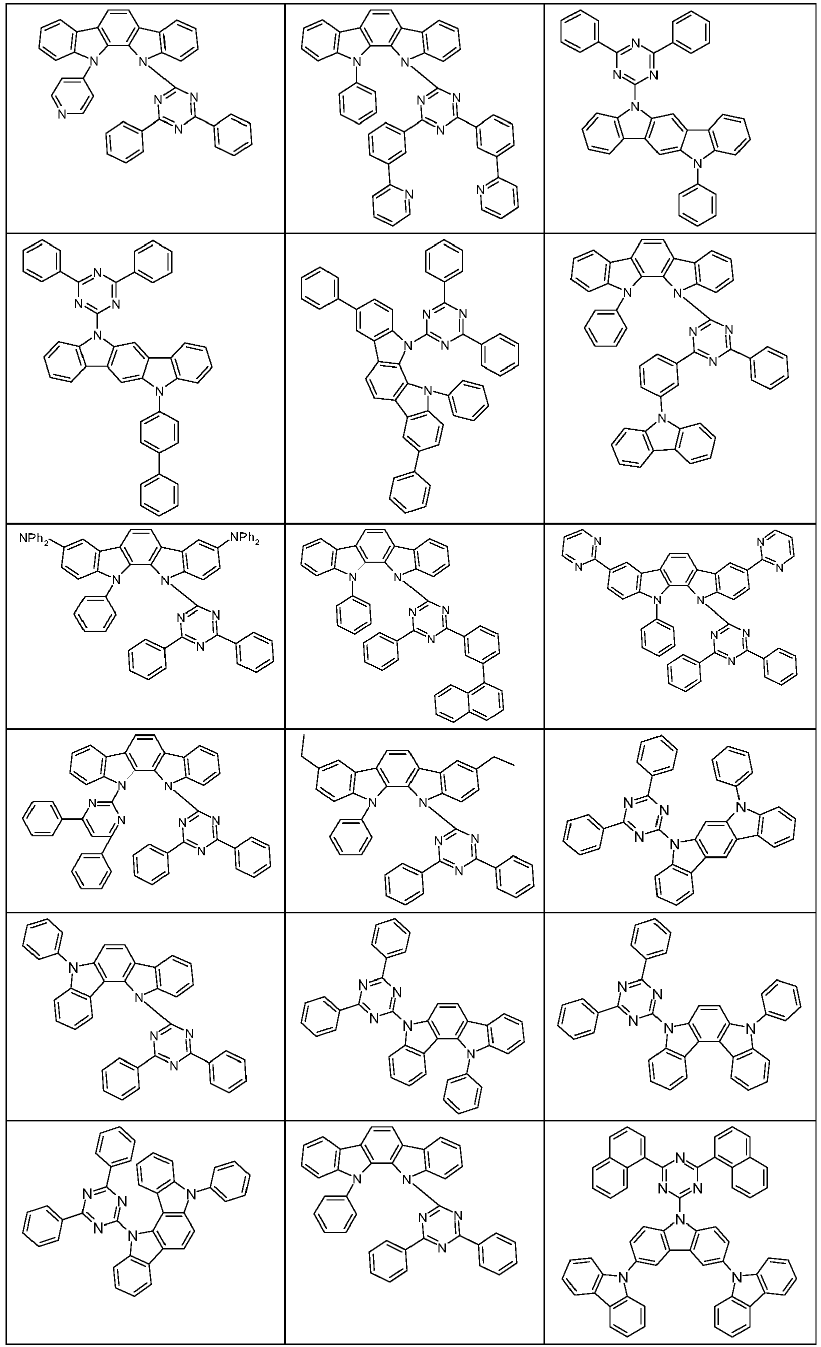

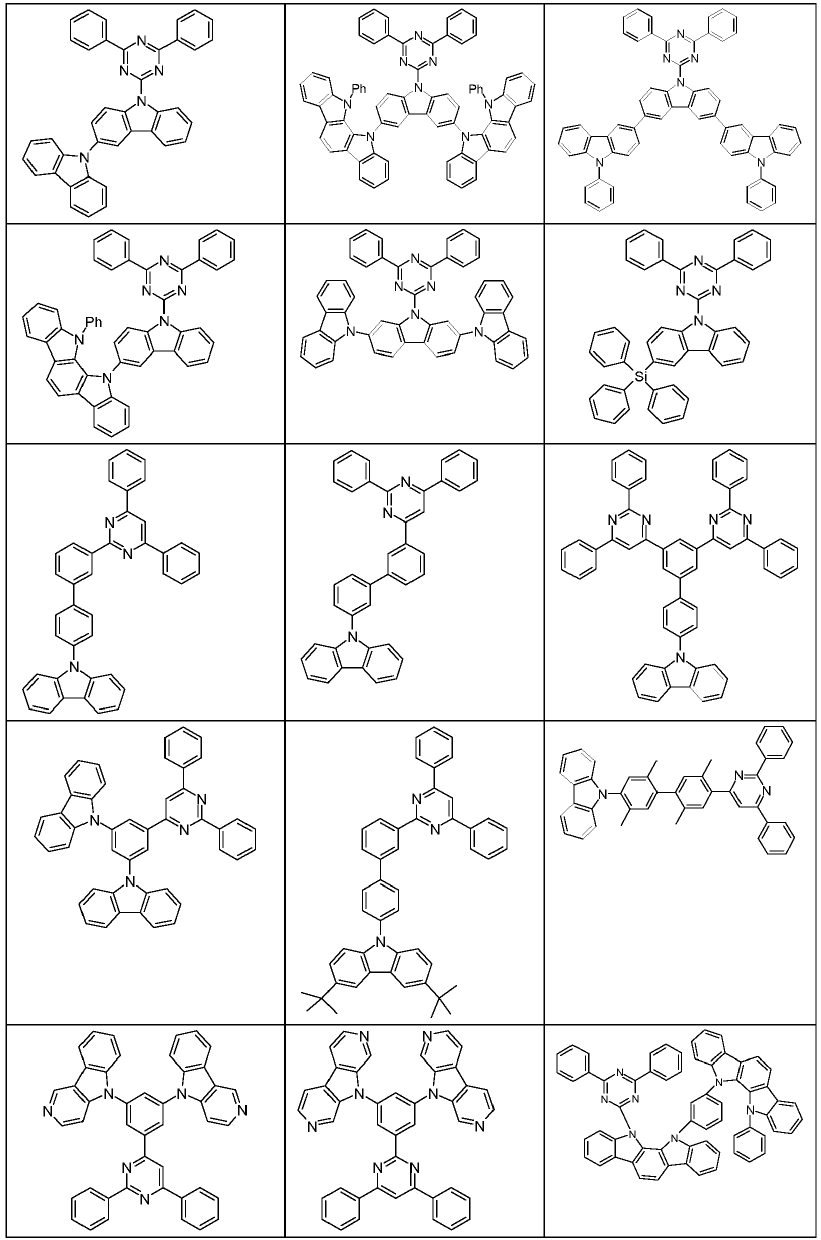

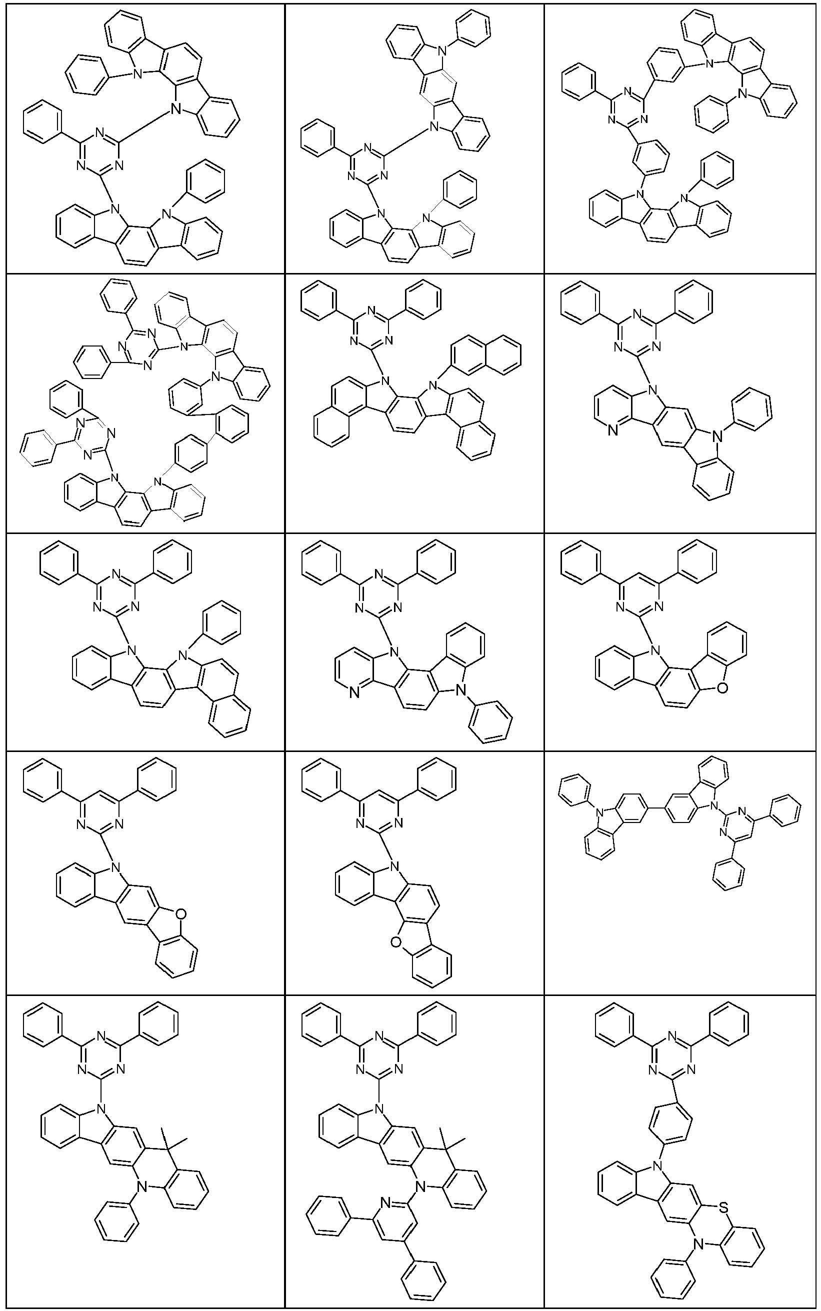

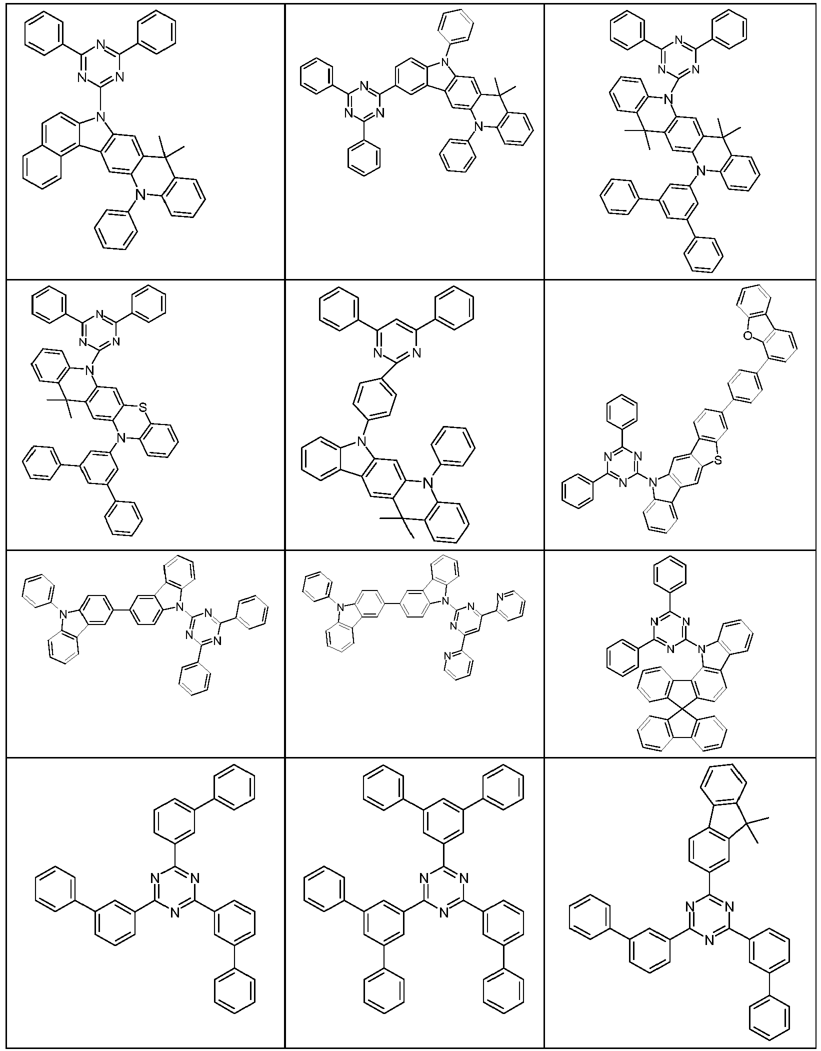

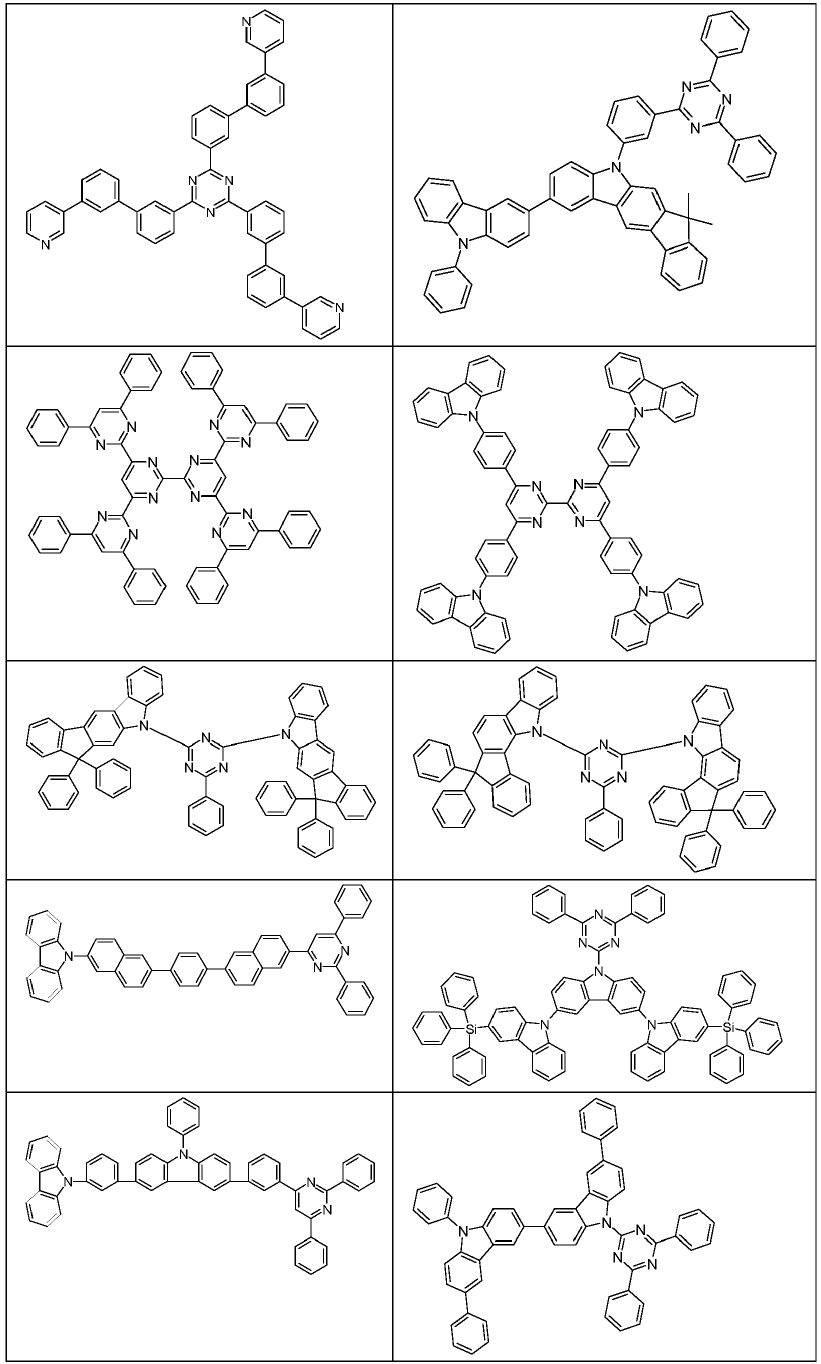

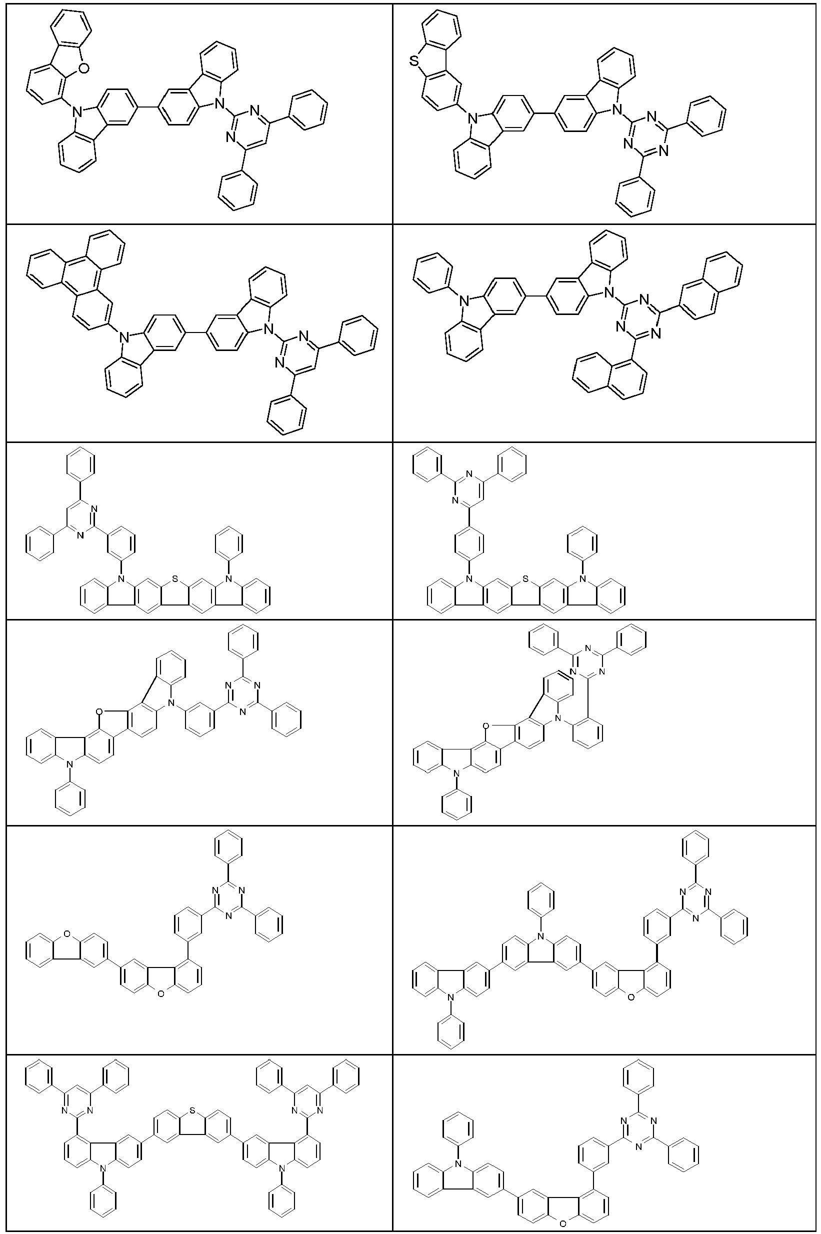

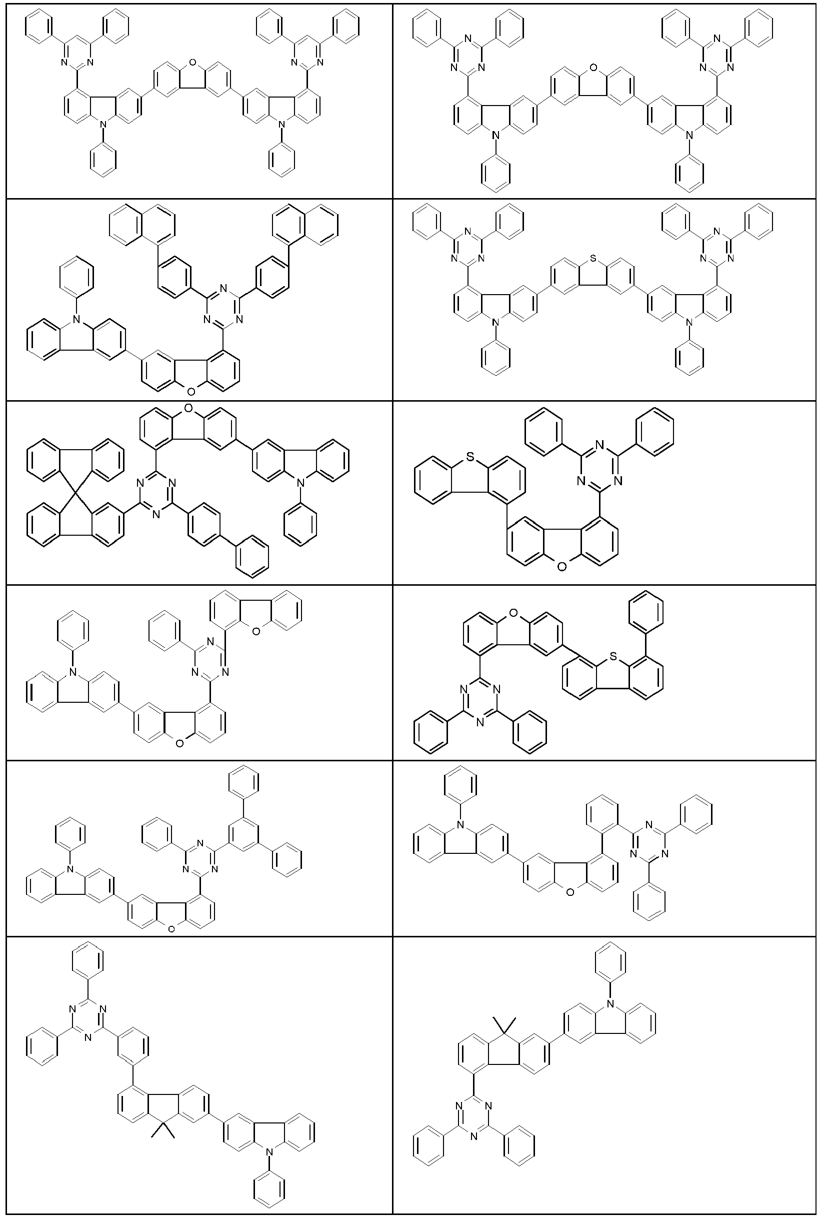

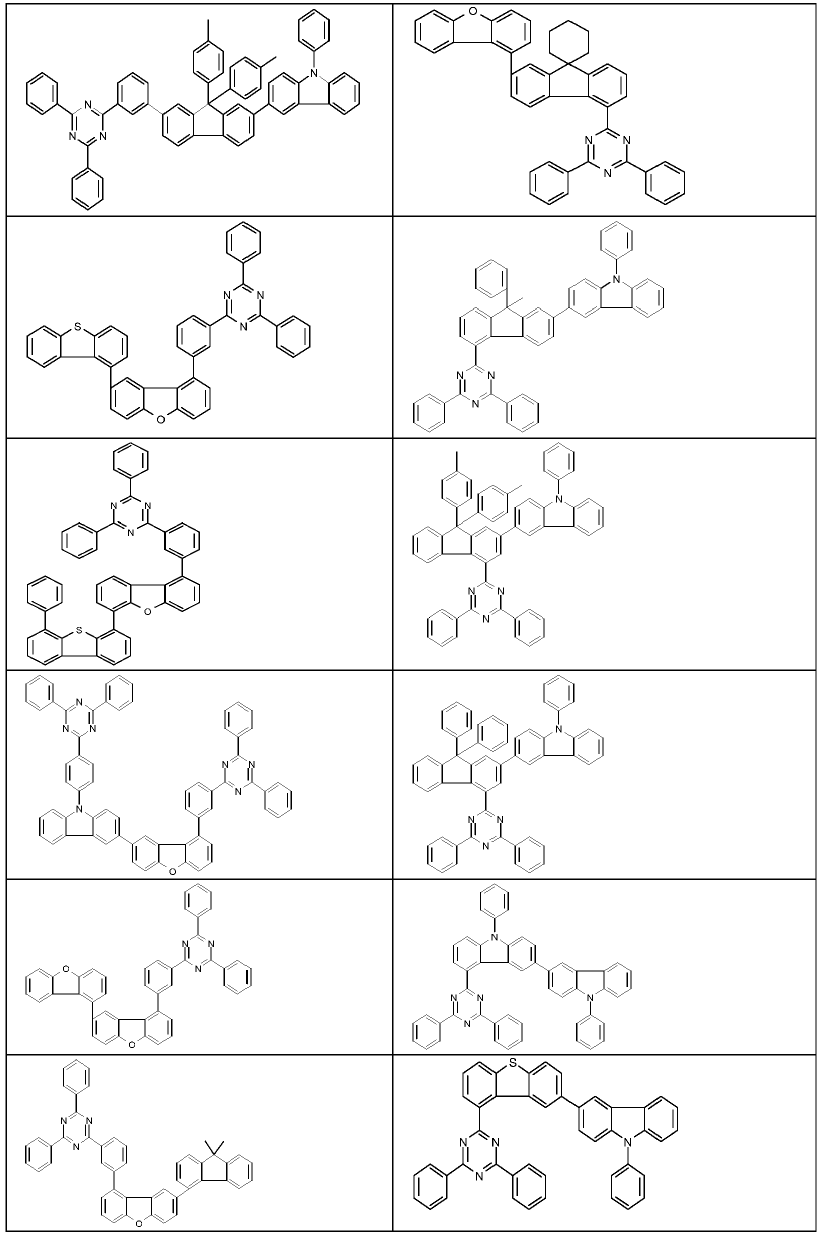

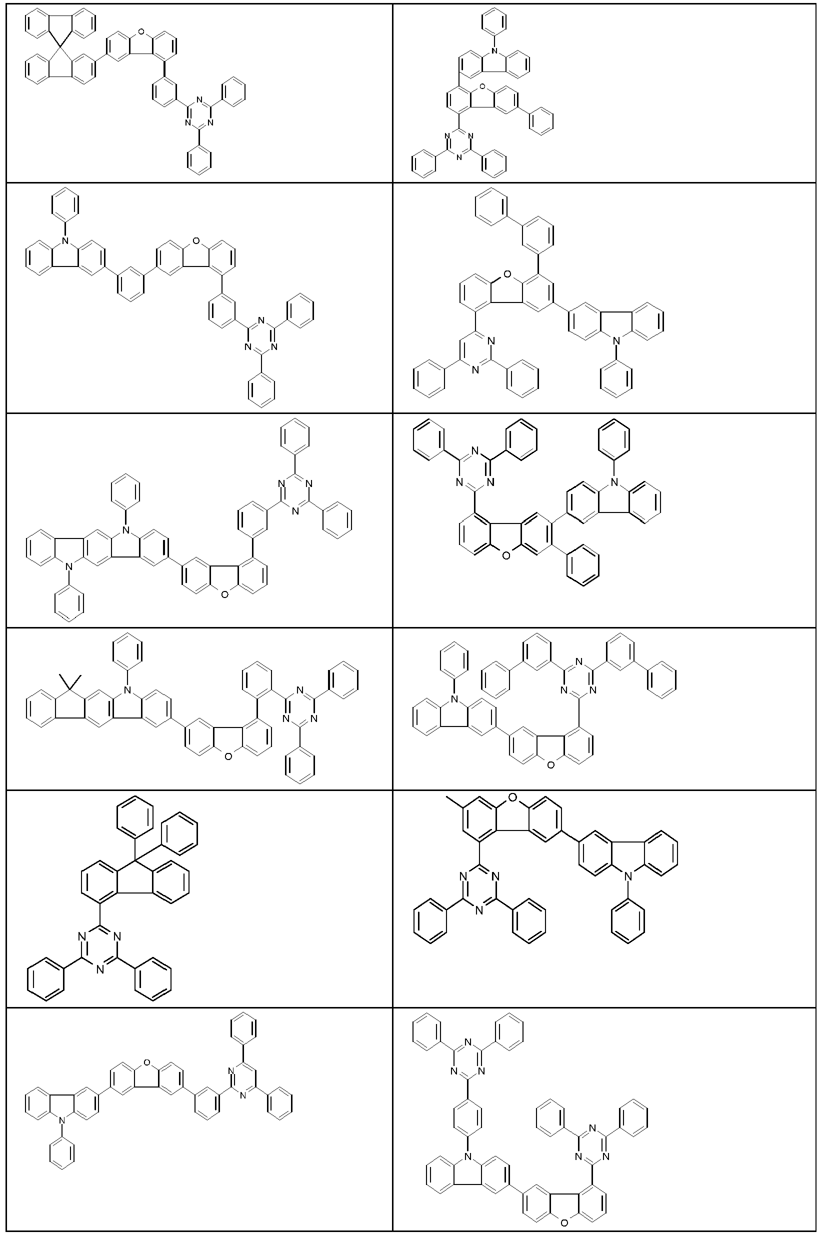

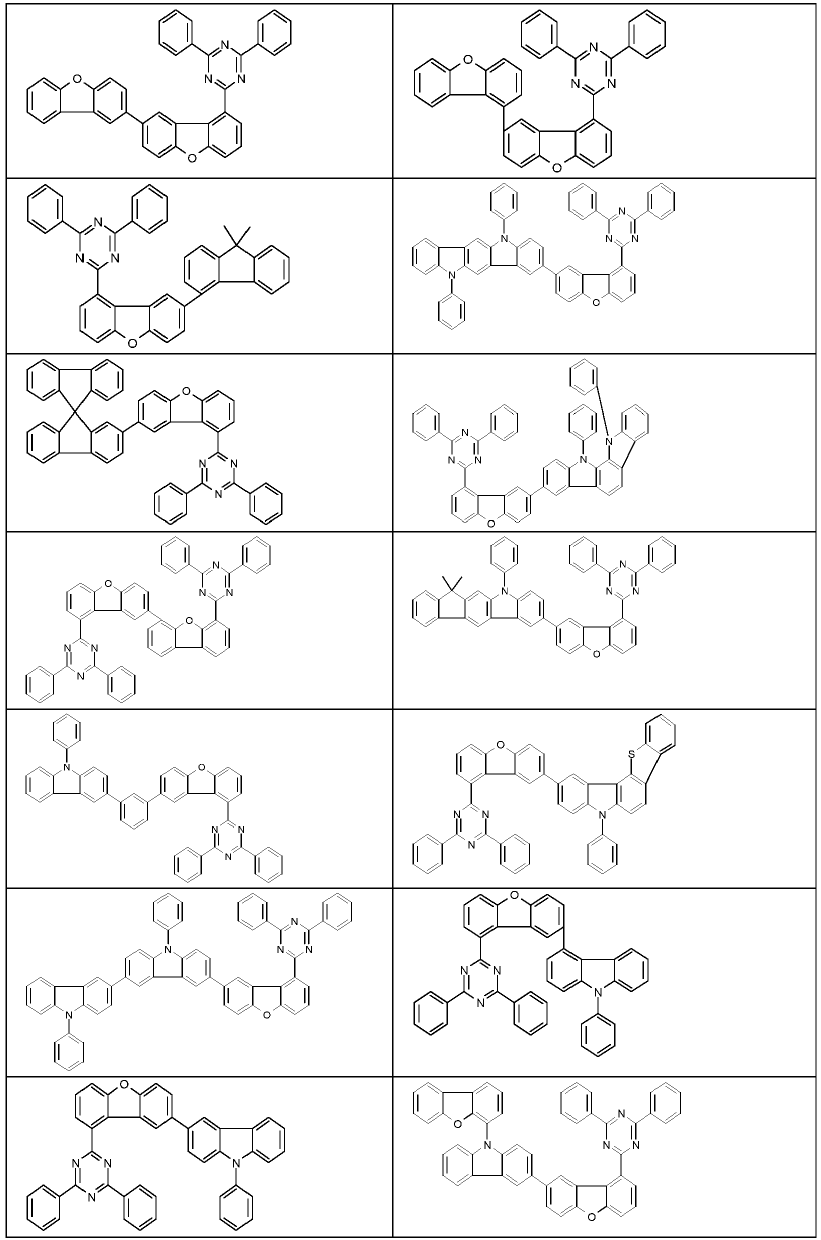

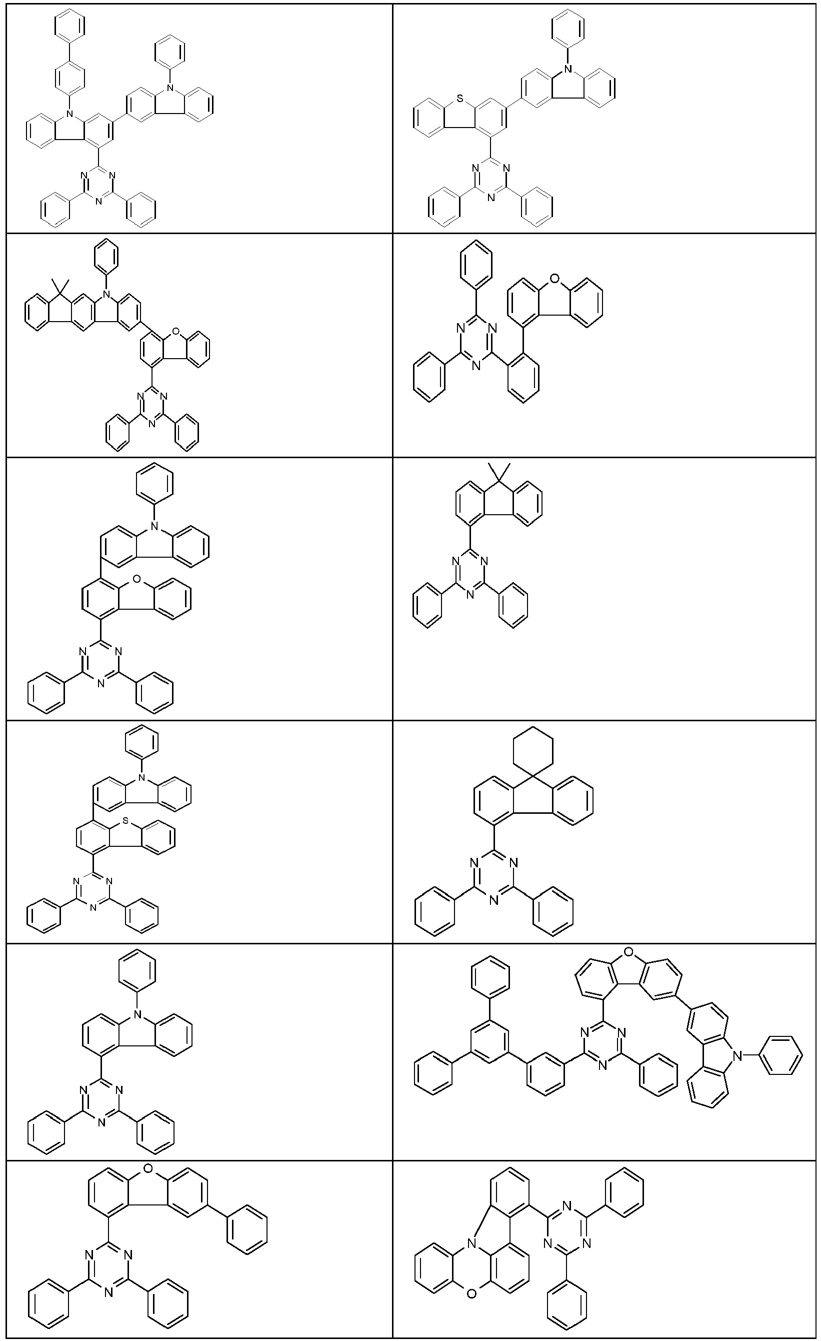

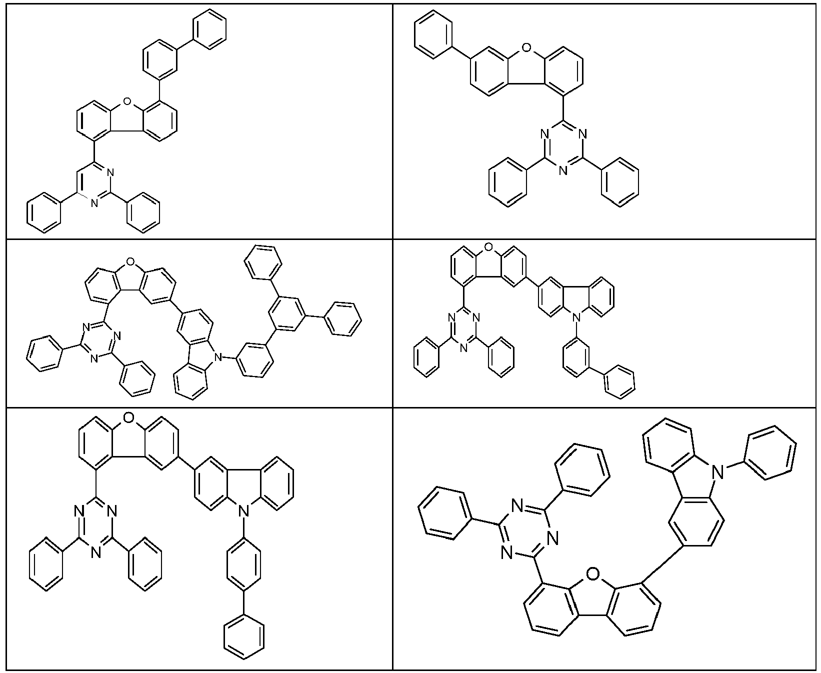

Beispiele für Lactame, welche als elektronentransportierende Matrix-materialien eingesetzt werden können, sind die folgenden Verbindungen:

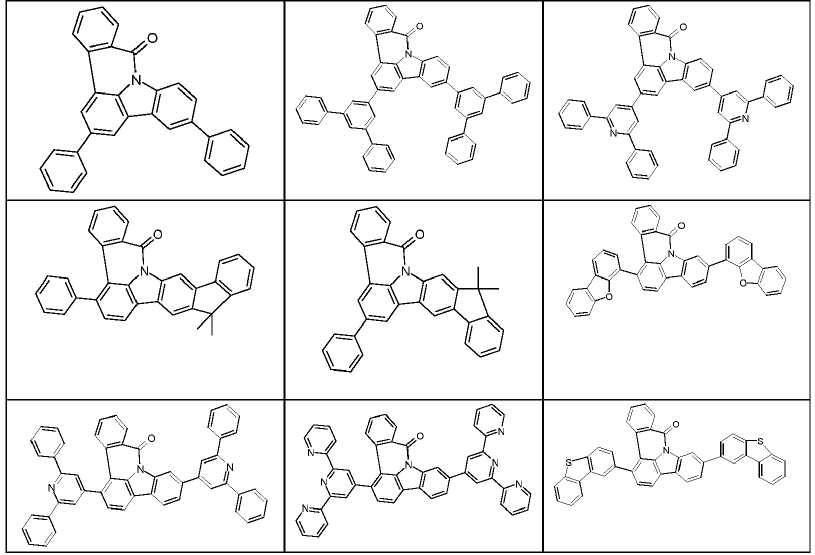

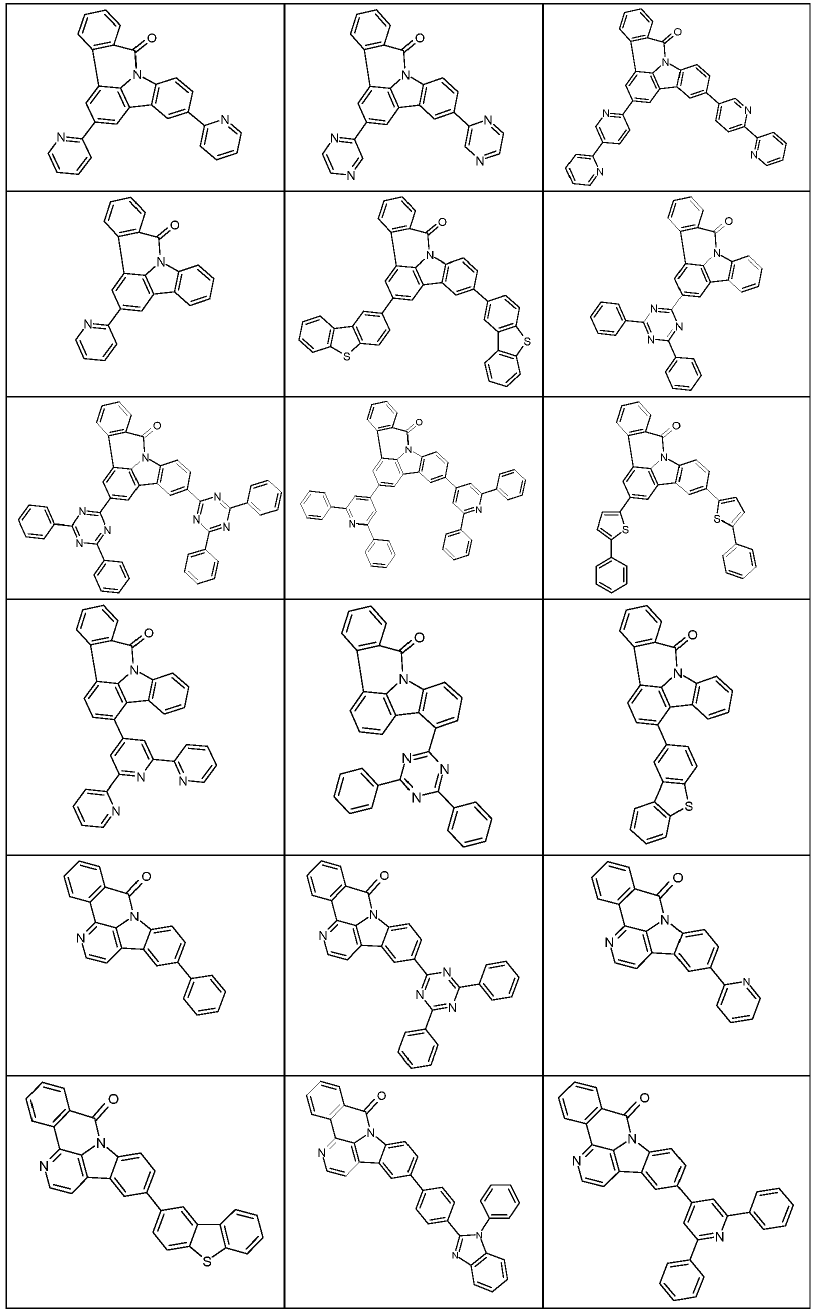

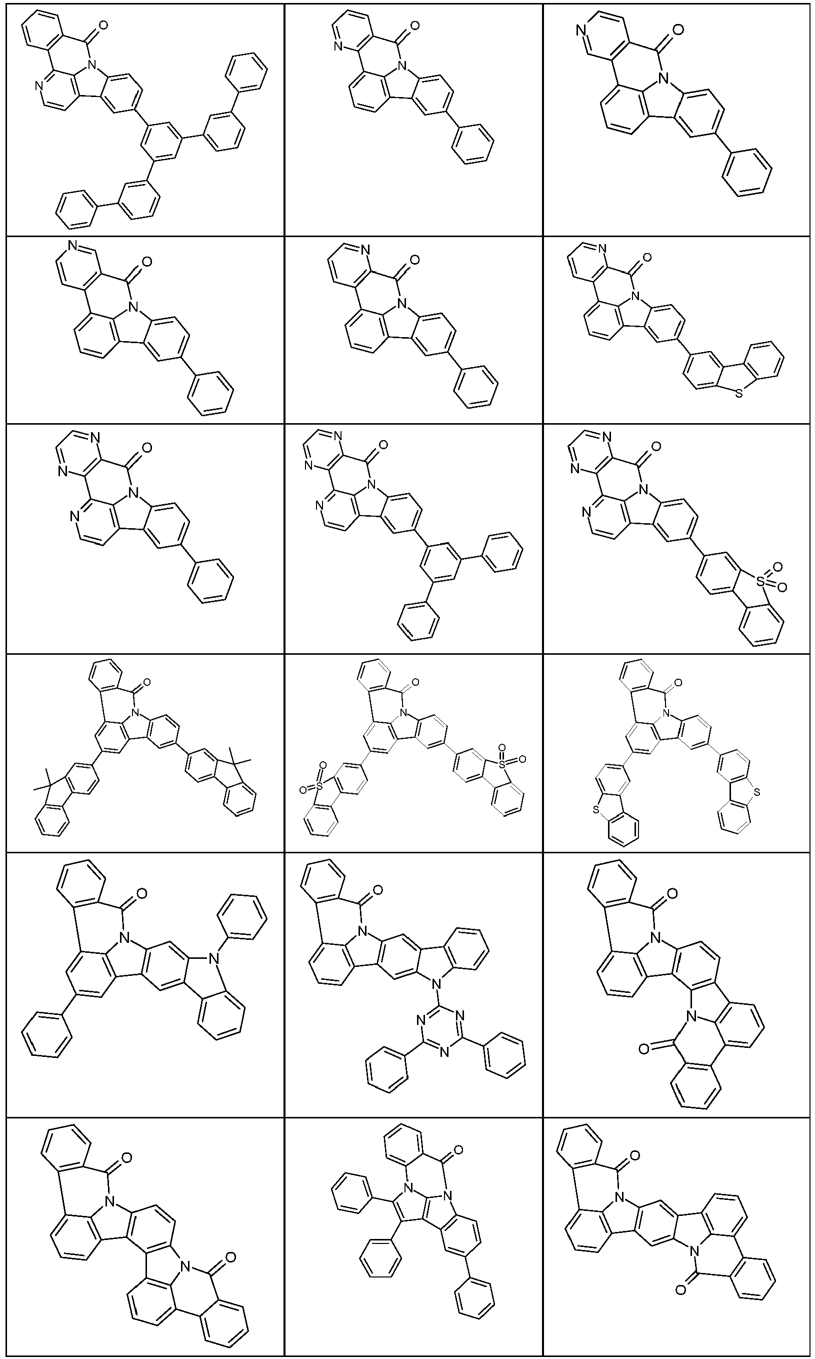

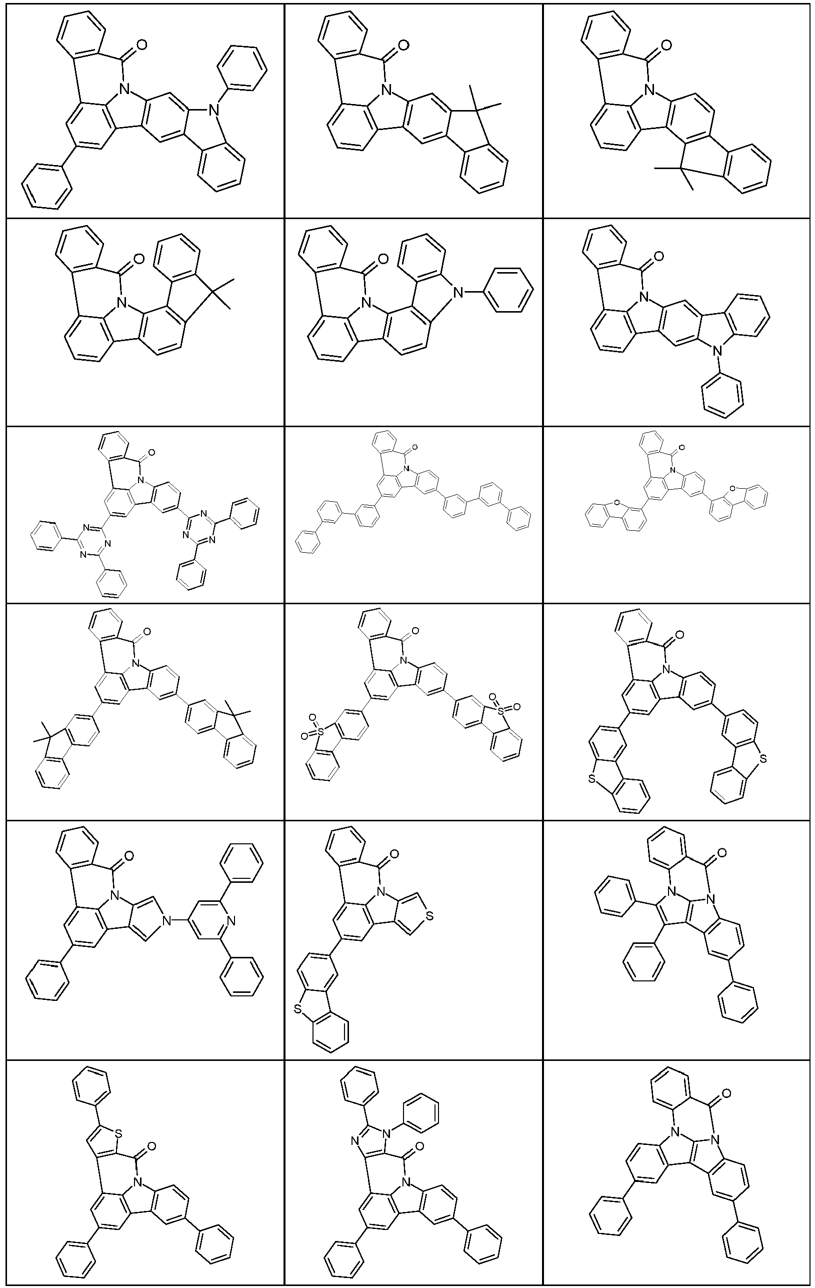

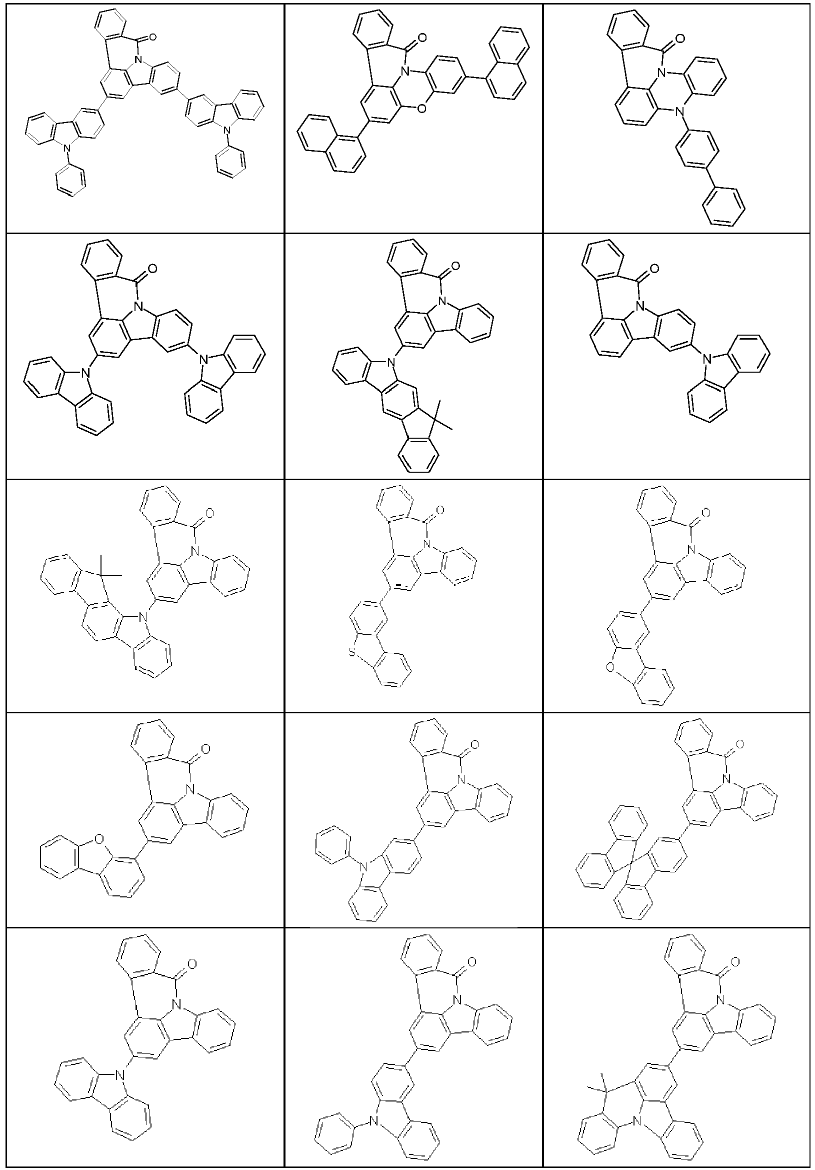

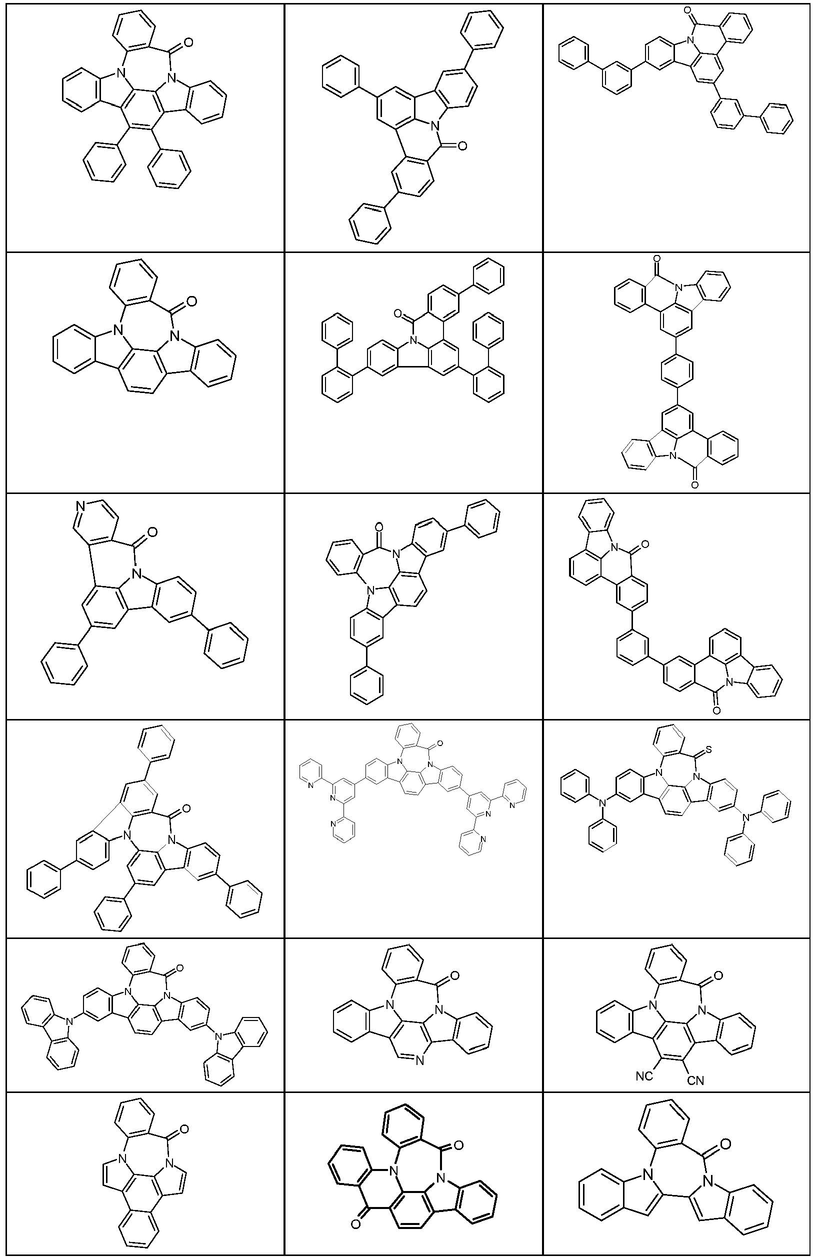

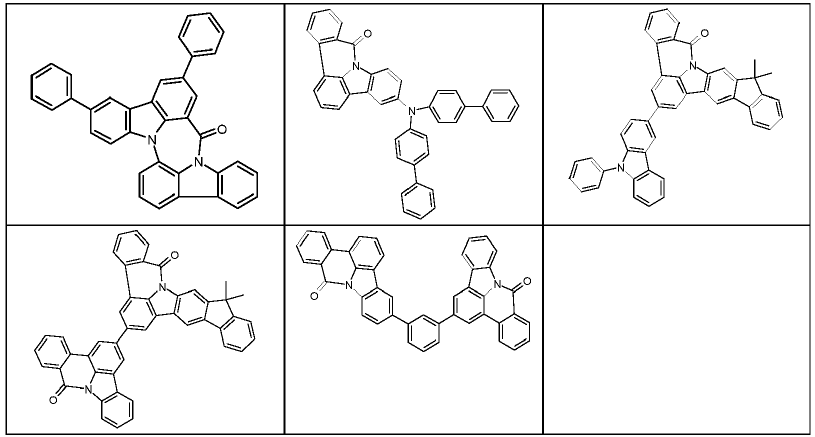

Beispiele für Indolo- und Indenocarbazolderivate im weitesten Sinn, welche je nach Substitutionsmuster als loch- oder elektronentransportierende Matrixmaterialien eingesetzt werden können, sind die folgenden Verbindungen:

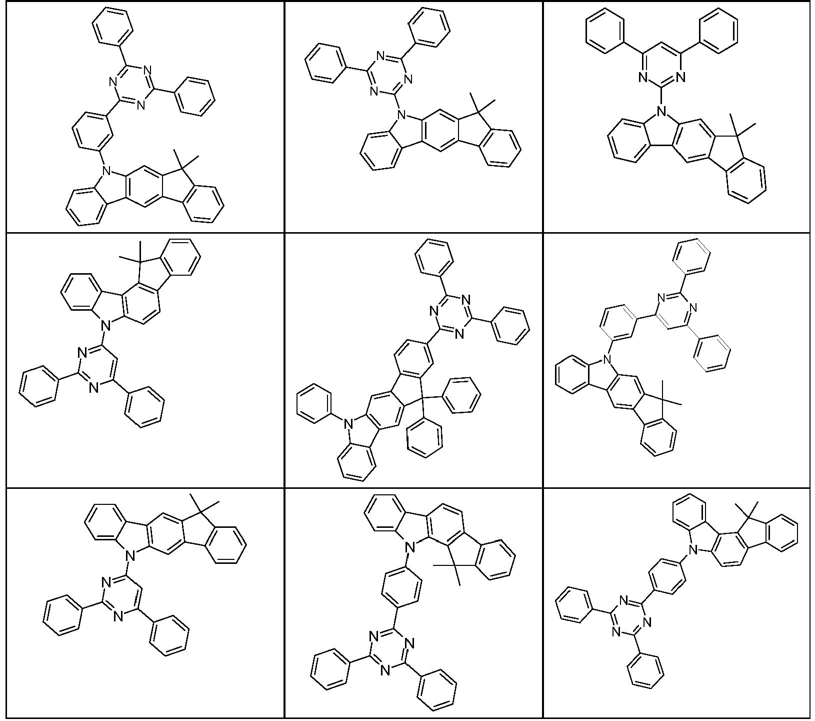

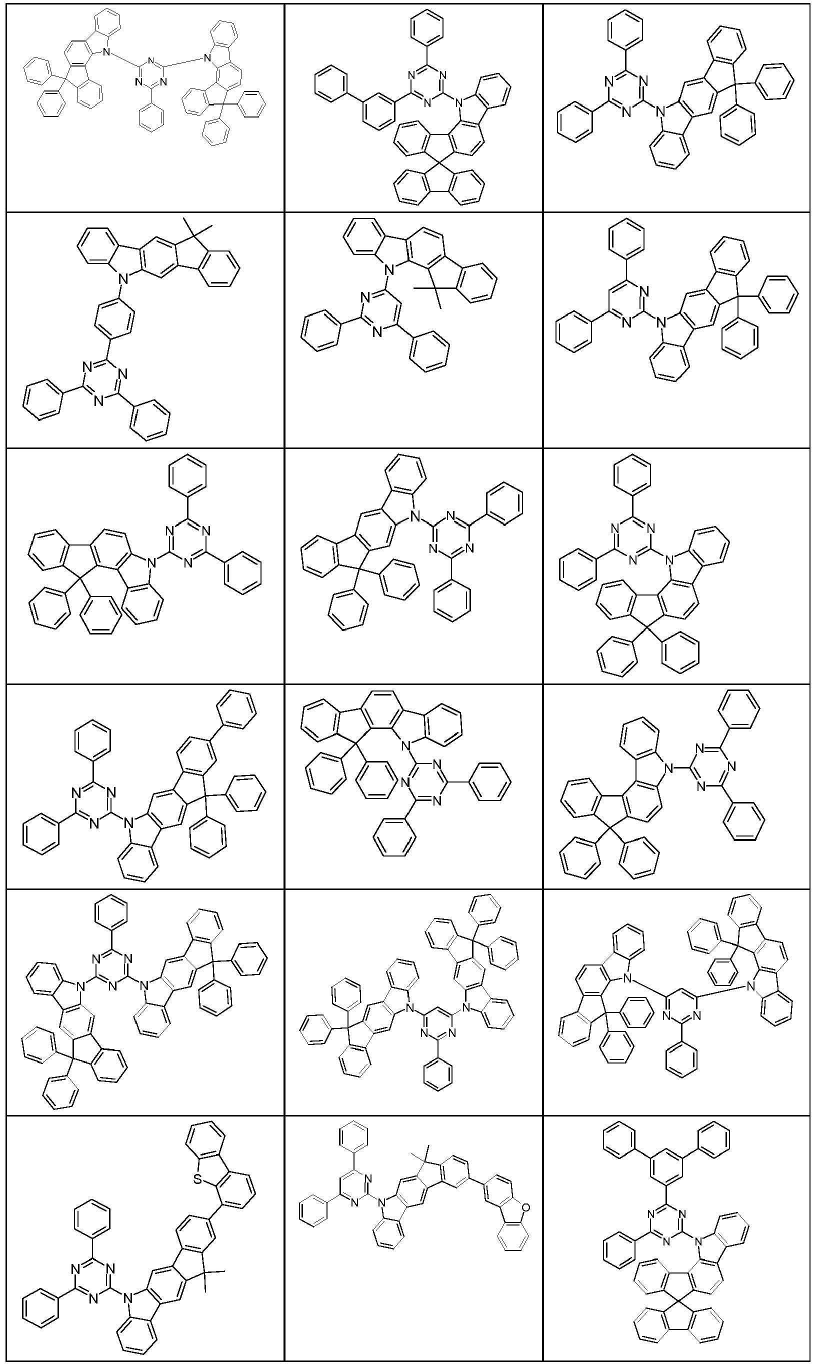

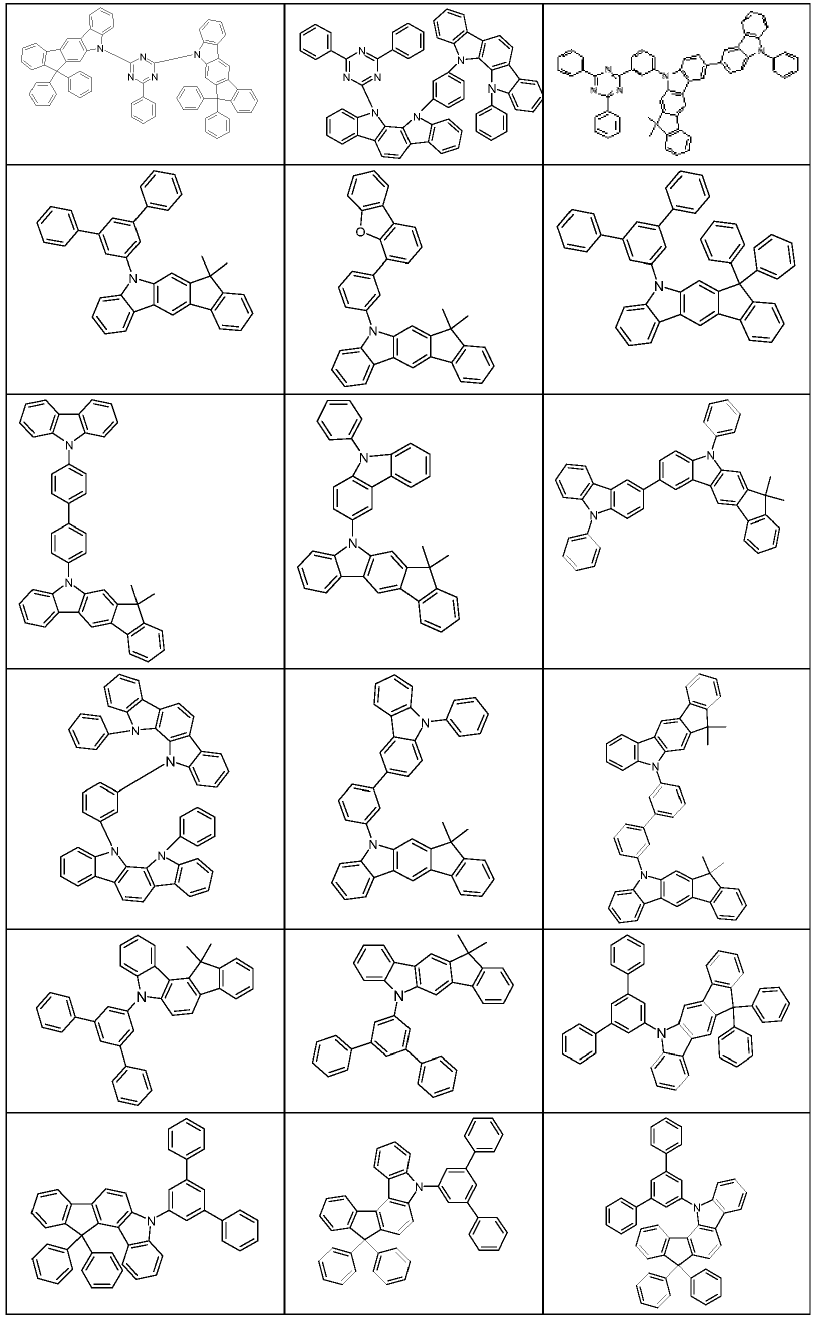

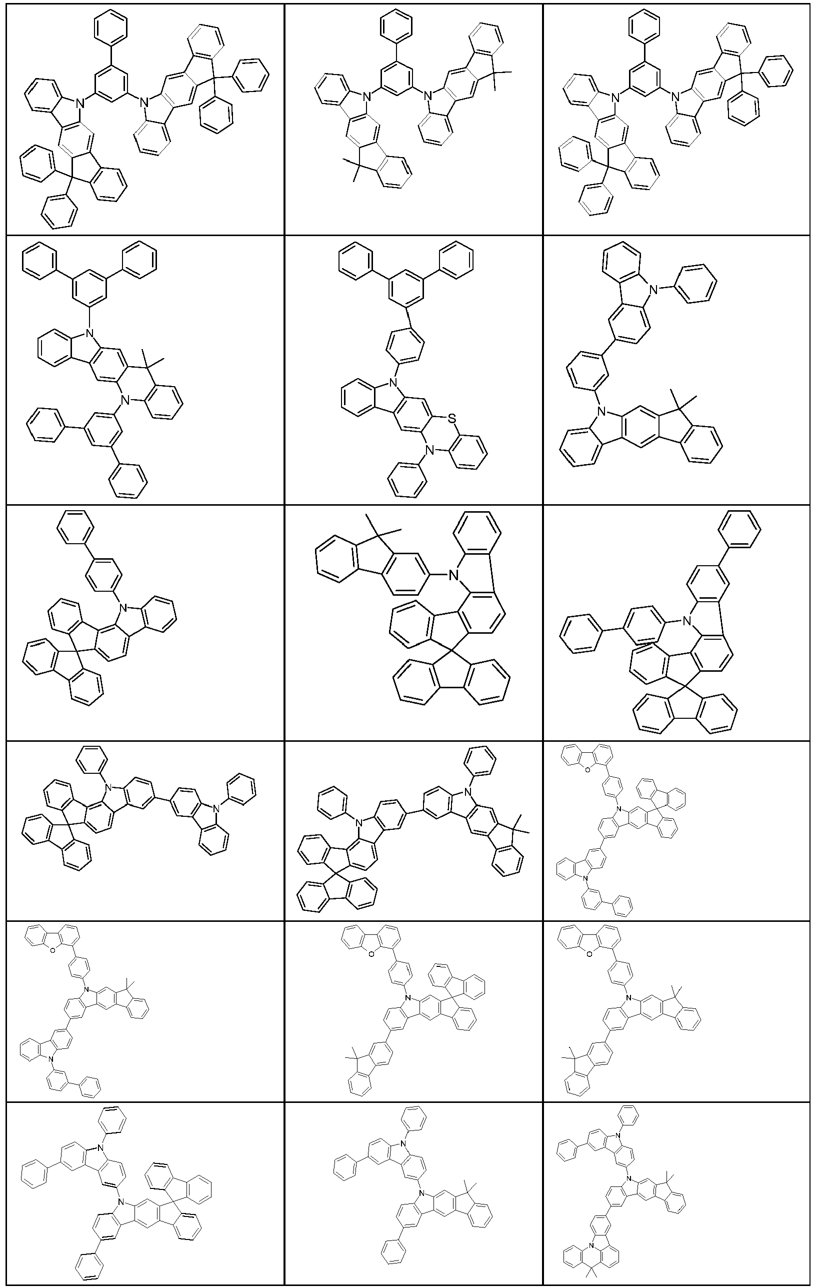

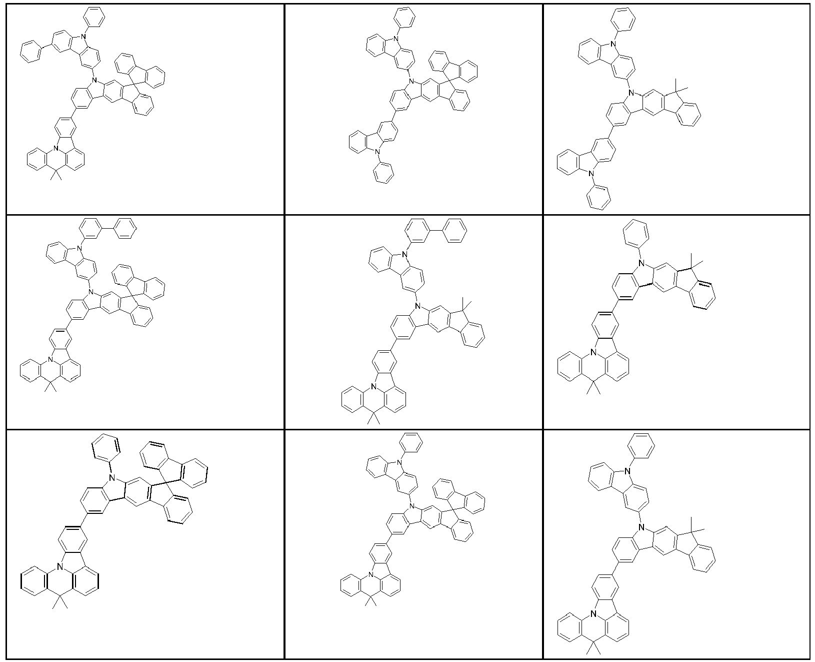

Beispiele für Carbazolderivate, welche je nach Substitutionsmuster als loch- oder elektronentransportierende Matrixmaterialien eingesetzt werden können, sind die folgenden Verbindungen:

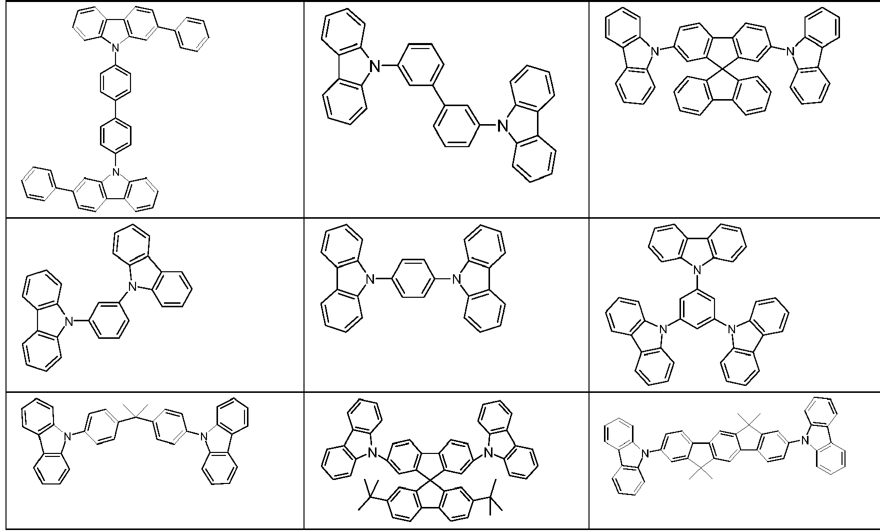

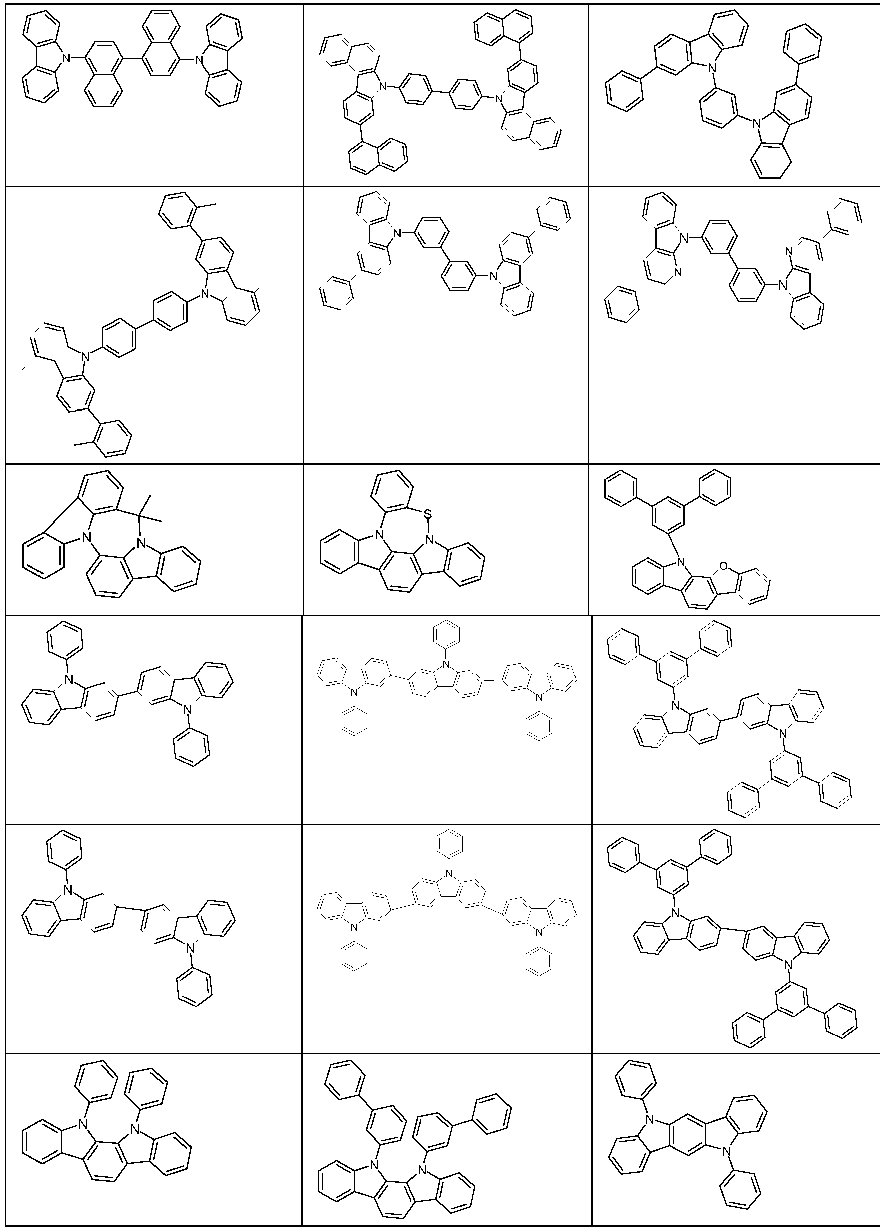

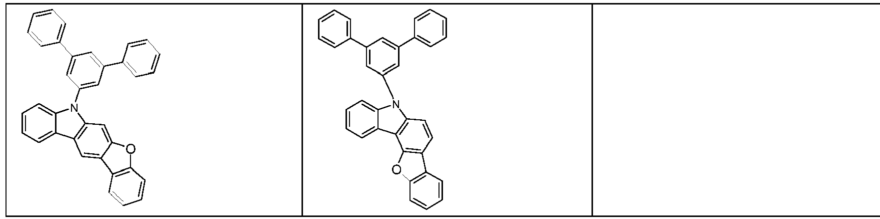

Beispiele für verbrückte Carbazolderivate, welche als lochtransportierende Matrixmaterialien eingesetzt werden können, sind die folgenden Verbindungen:

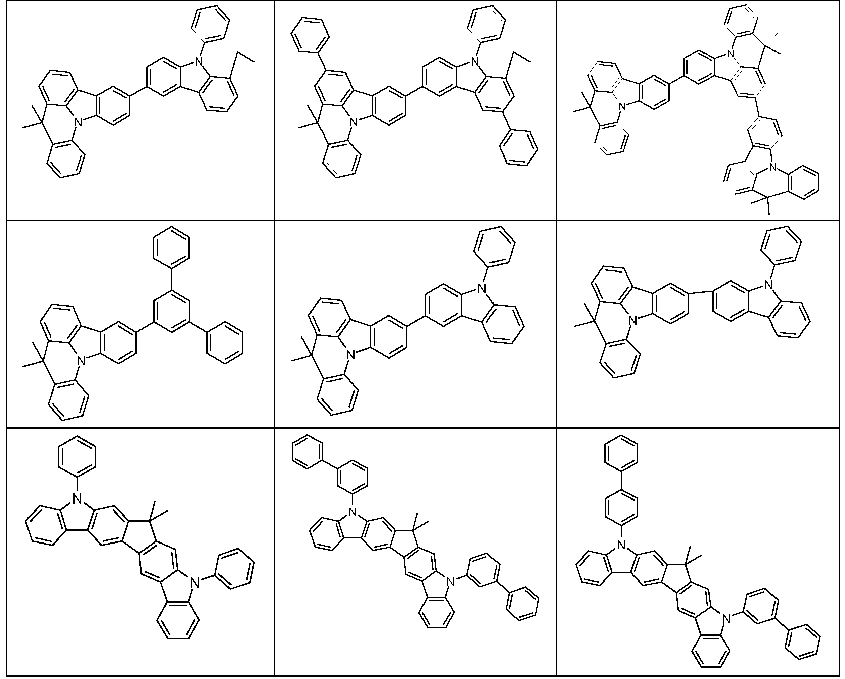

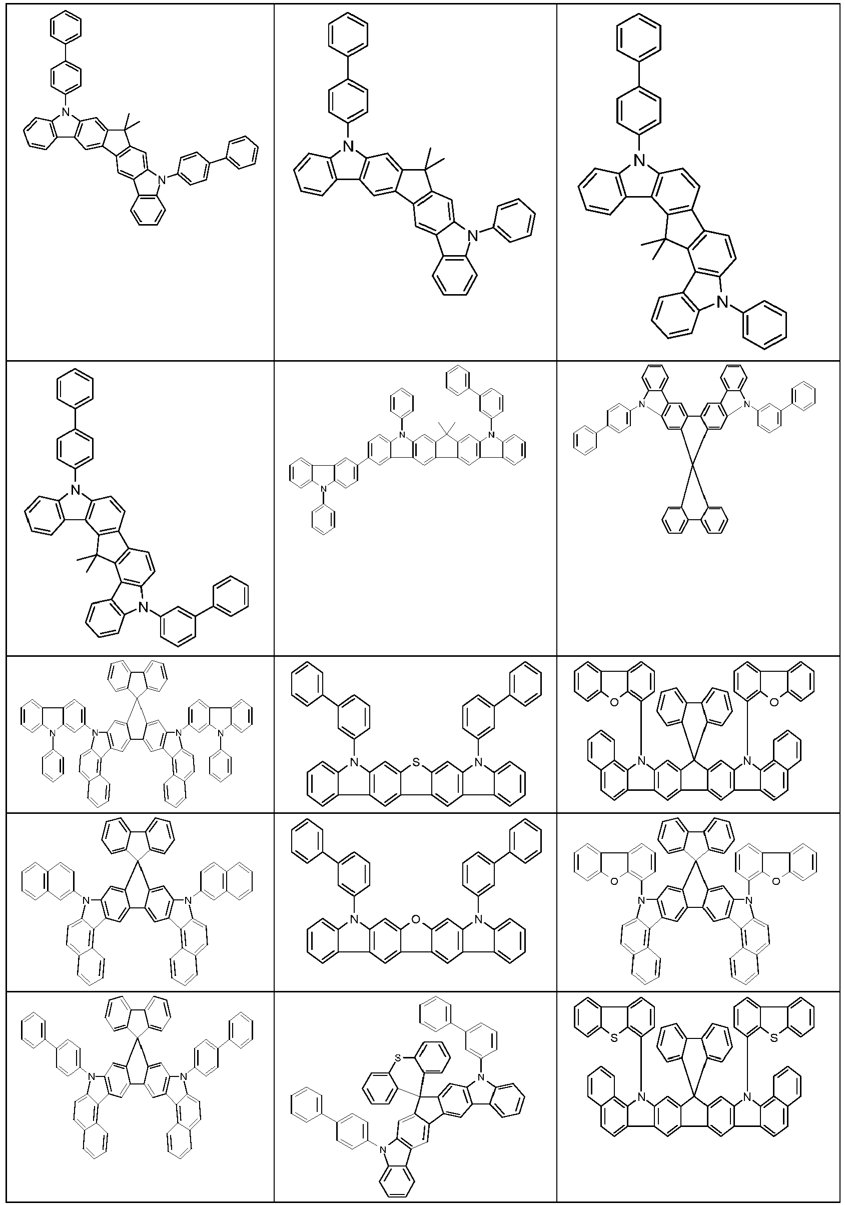

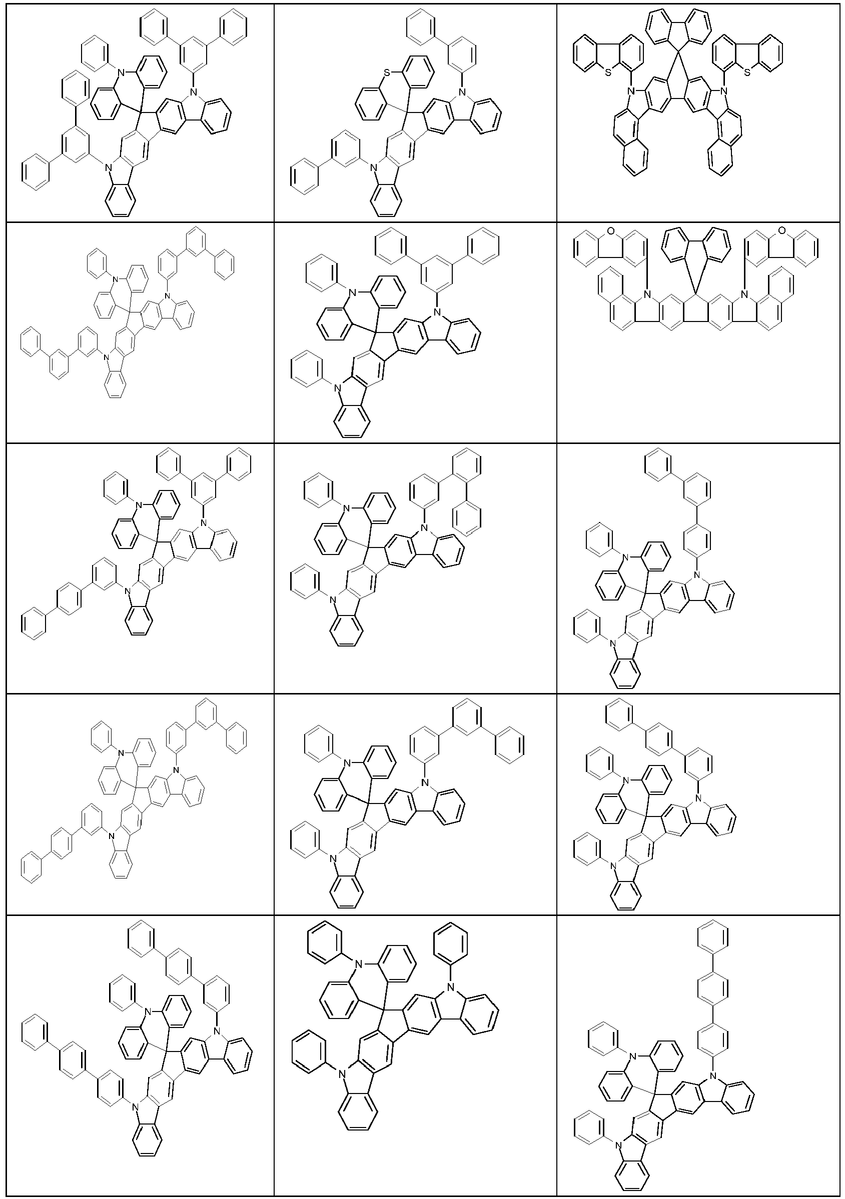

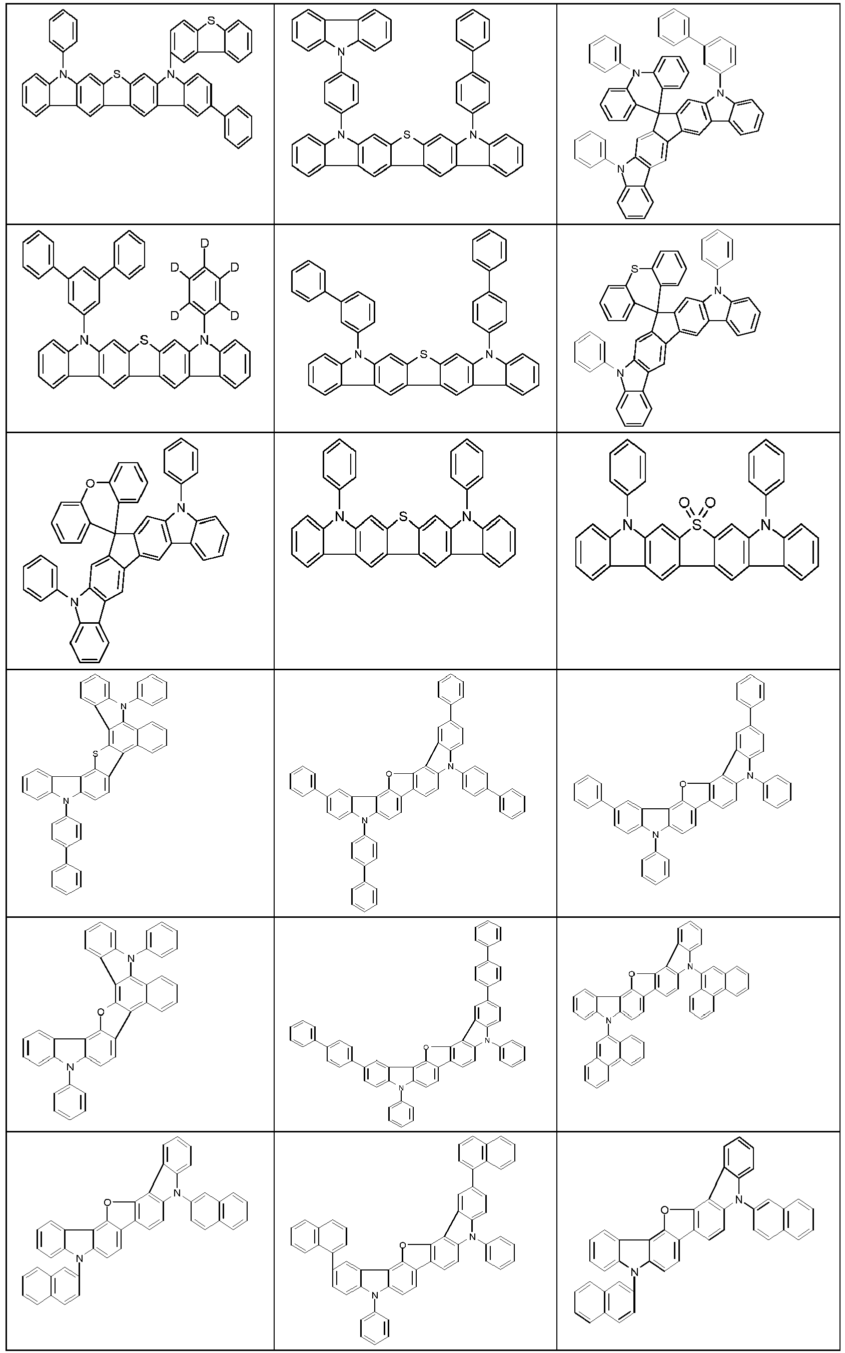

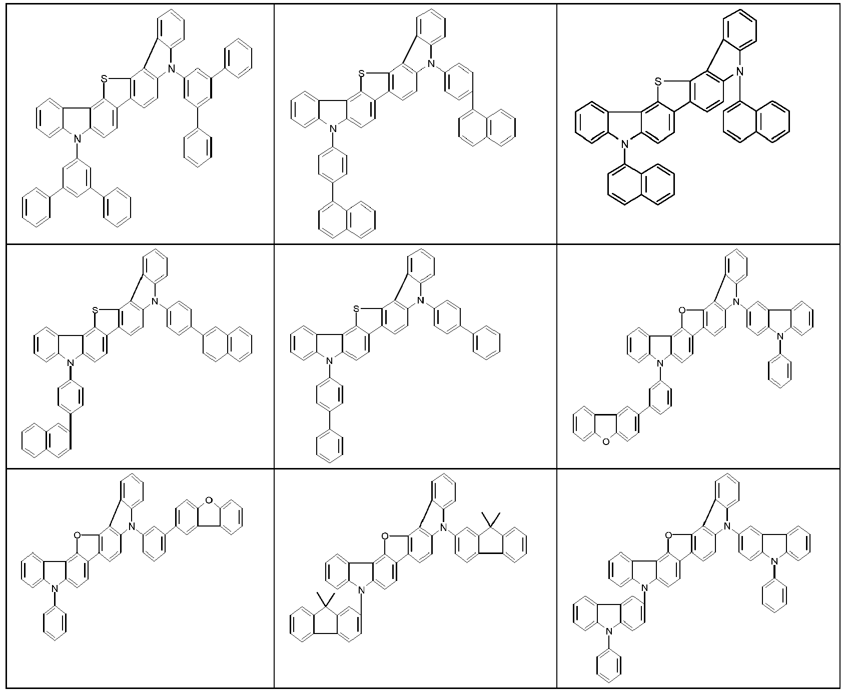

Beispiele für Biscarbazole, welche als lochtransportierende Matrix-materialien eingesetzt werden können, sind die folgenden Verbindungen:

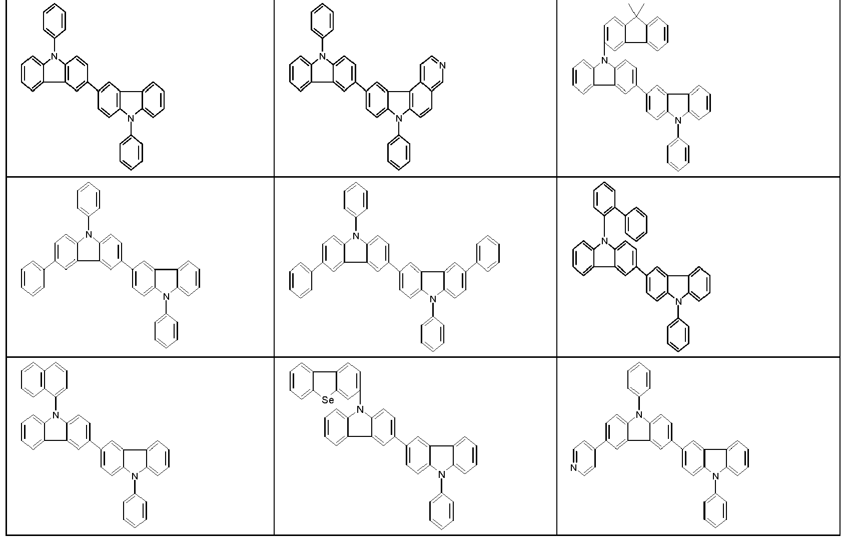

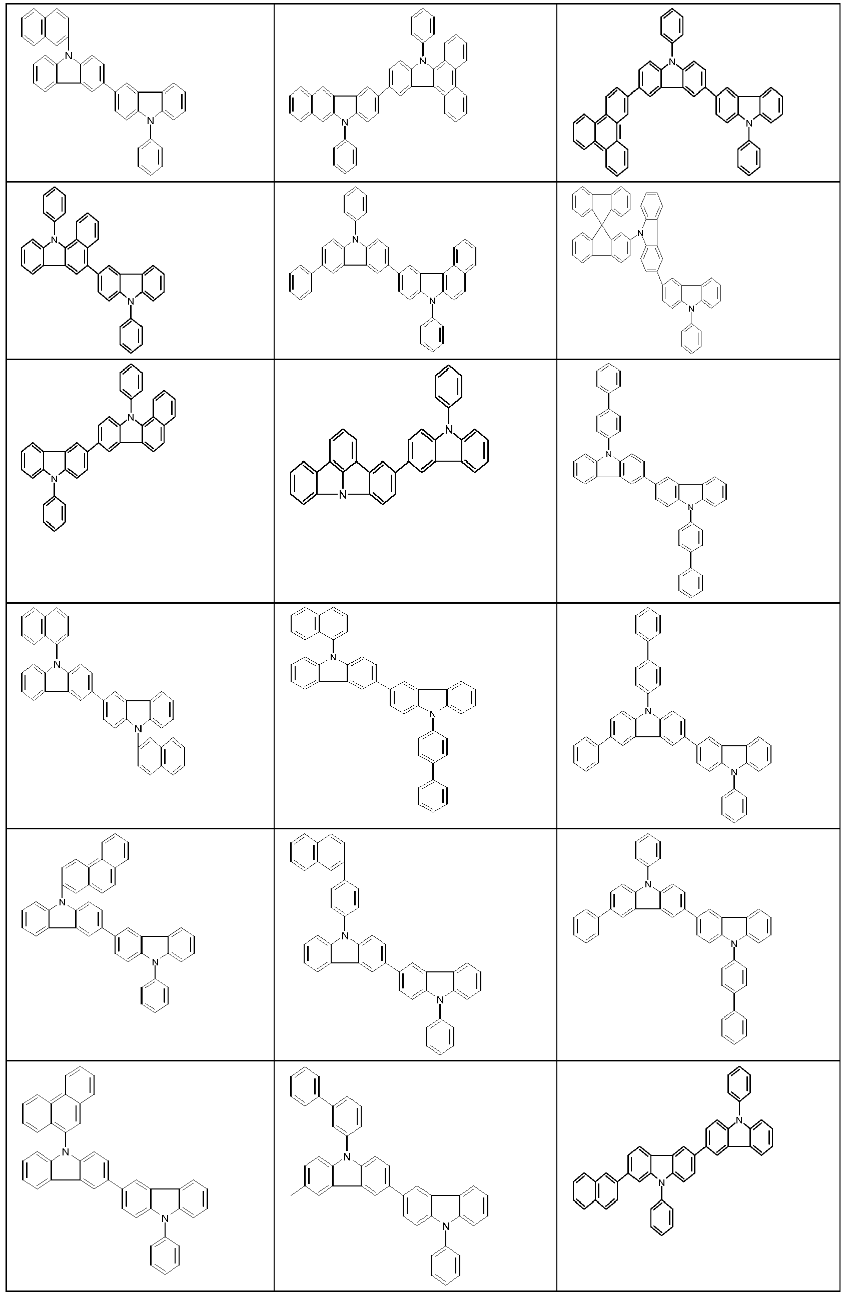

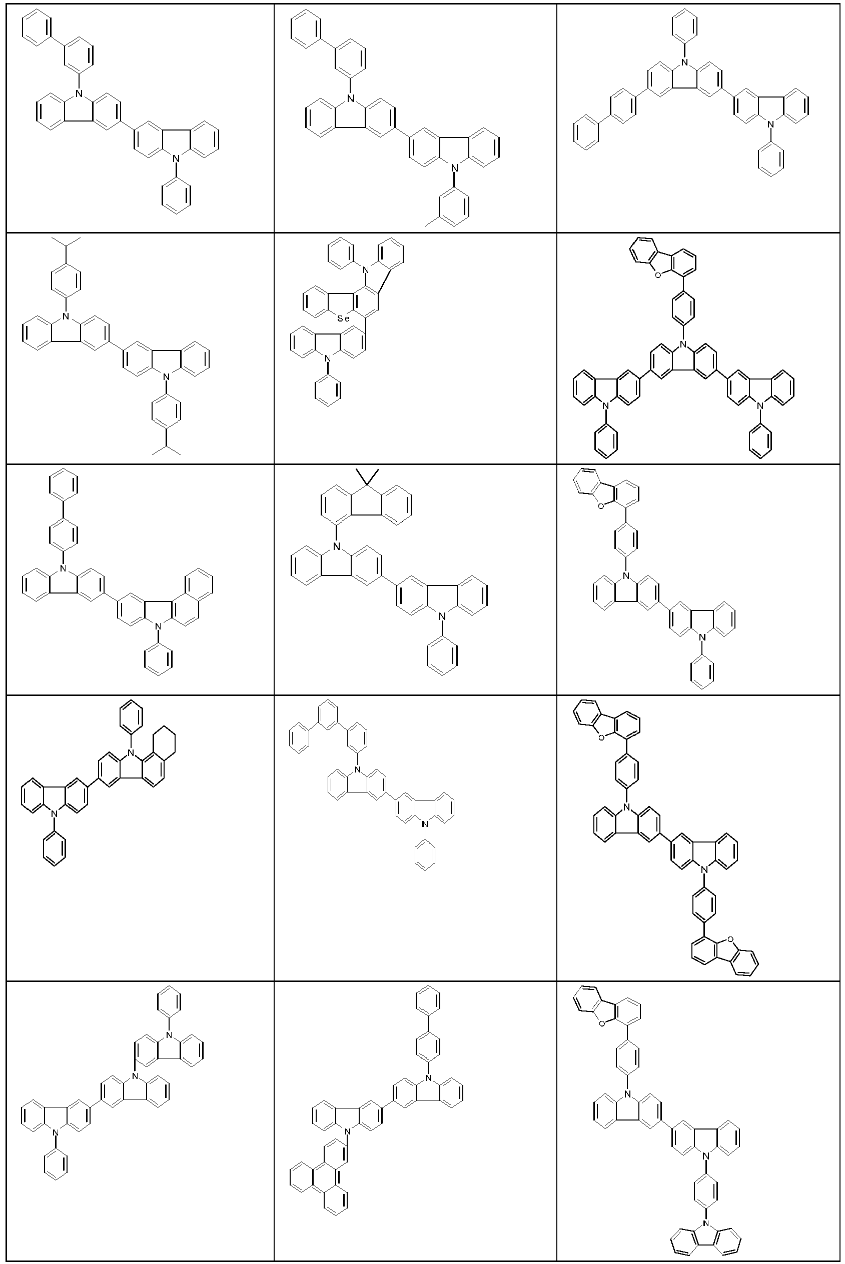

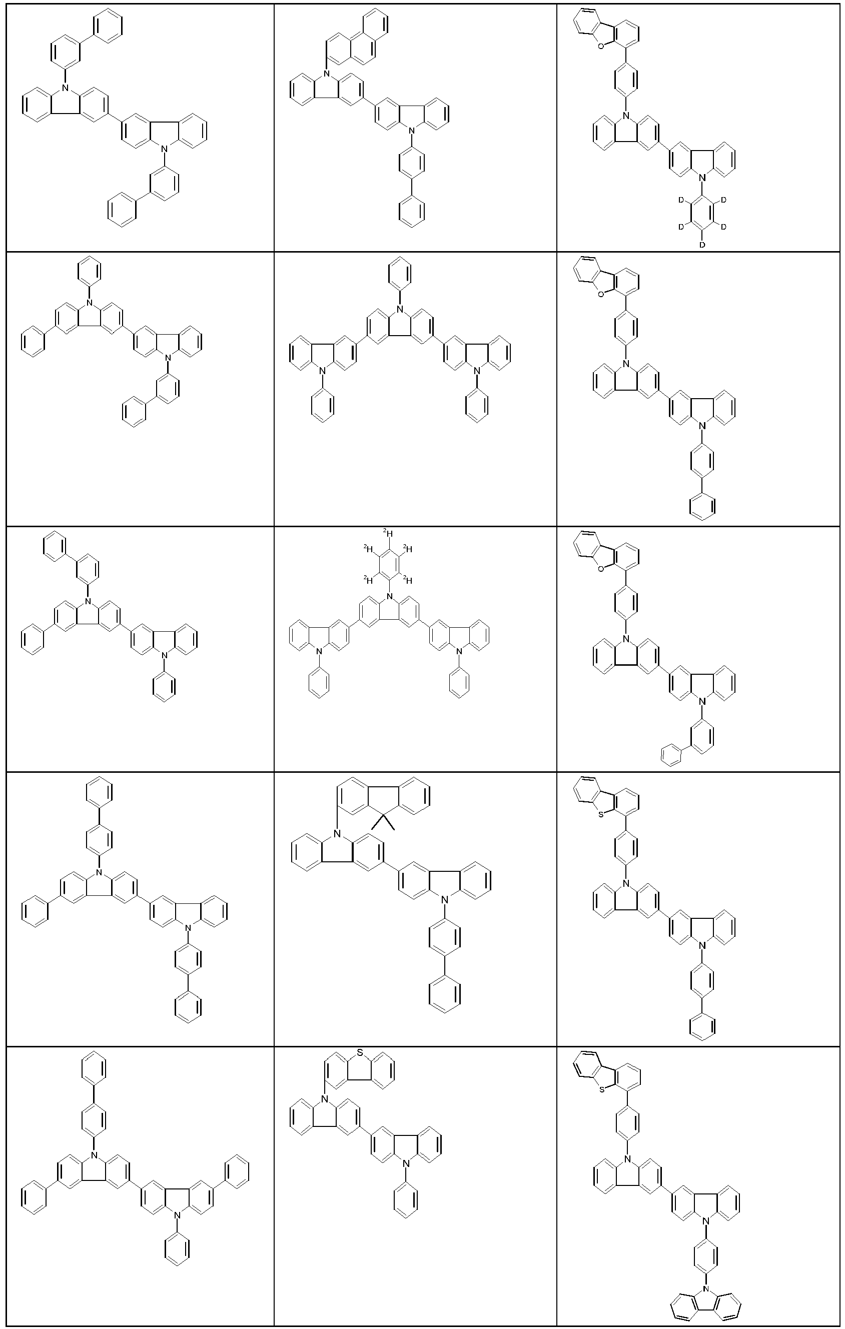

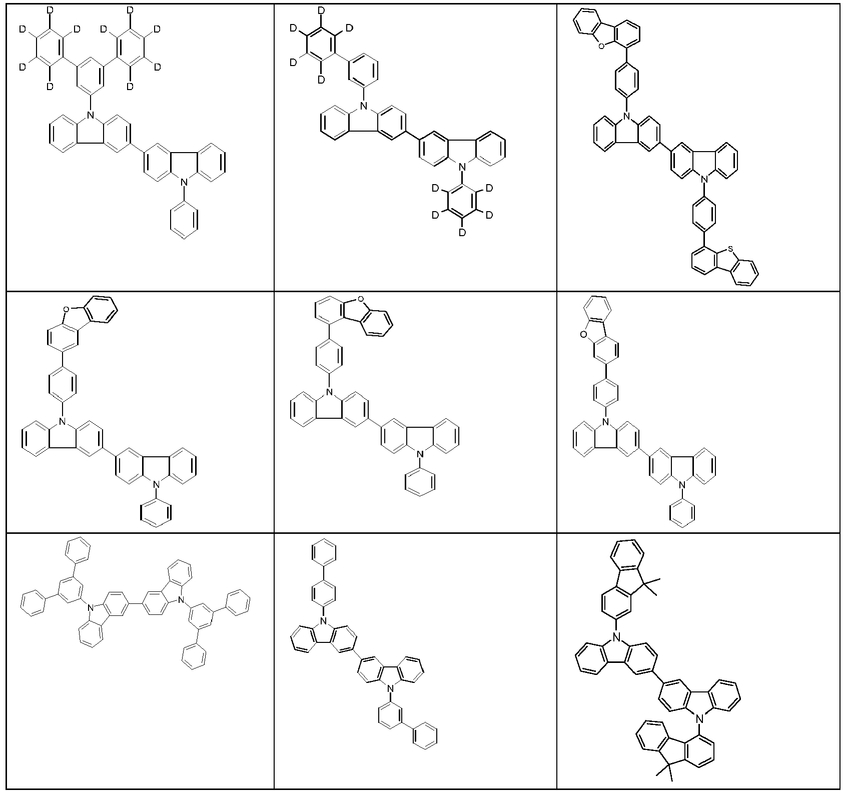

Beispiele für Amine, welche als lochtransportierende Matrixmaterialien eingesetzt werden können, sind die folgenden Verbindungen:

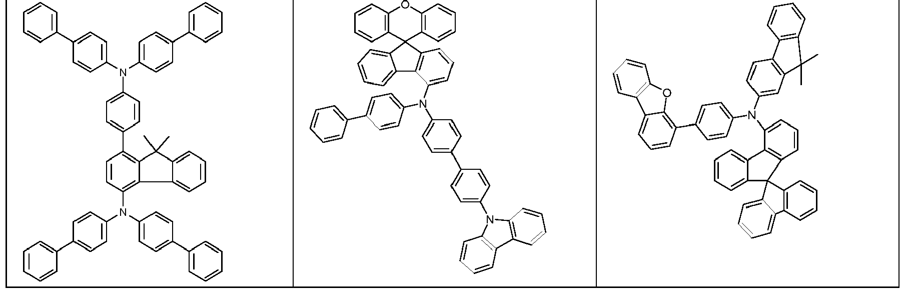

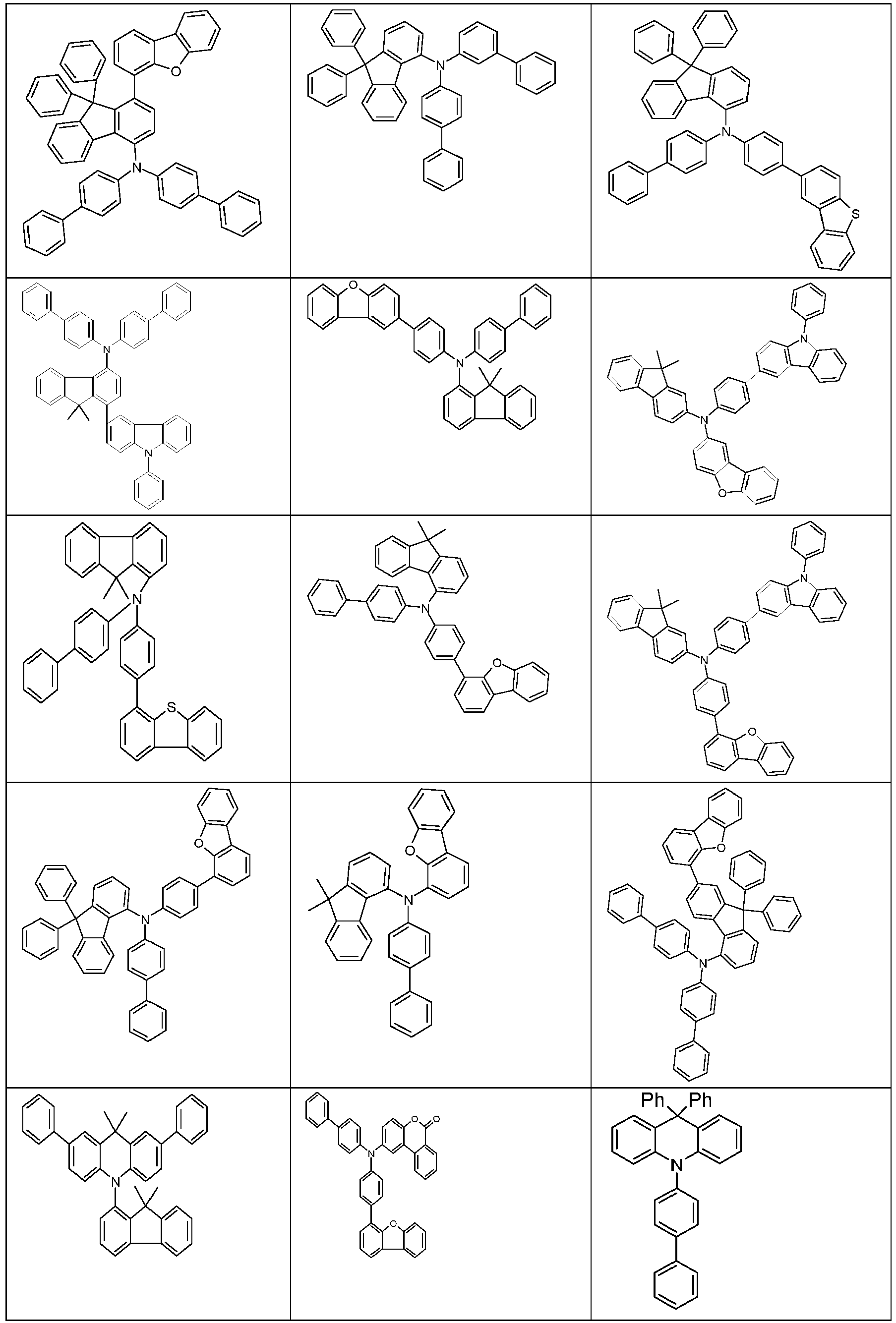

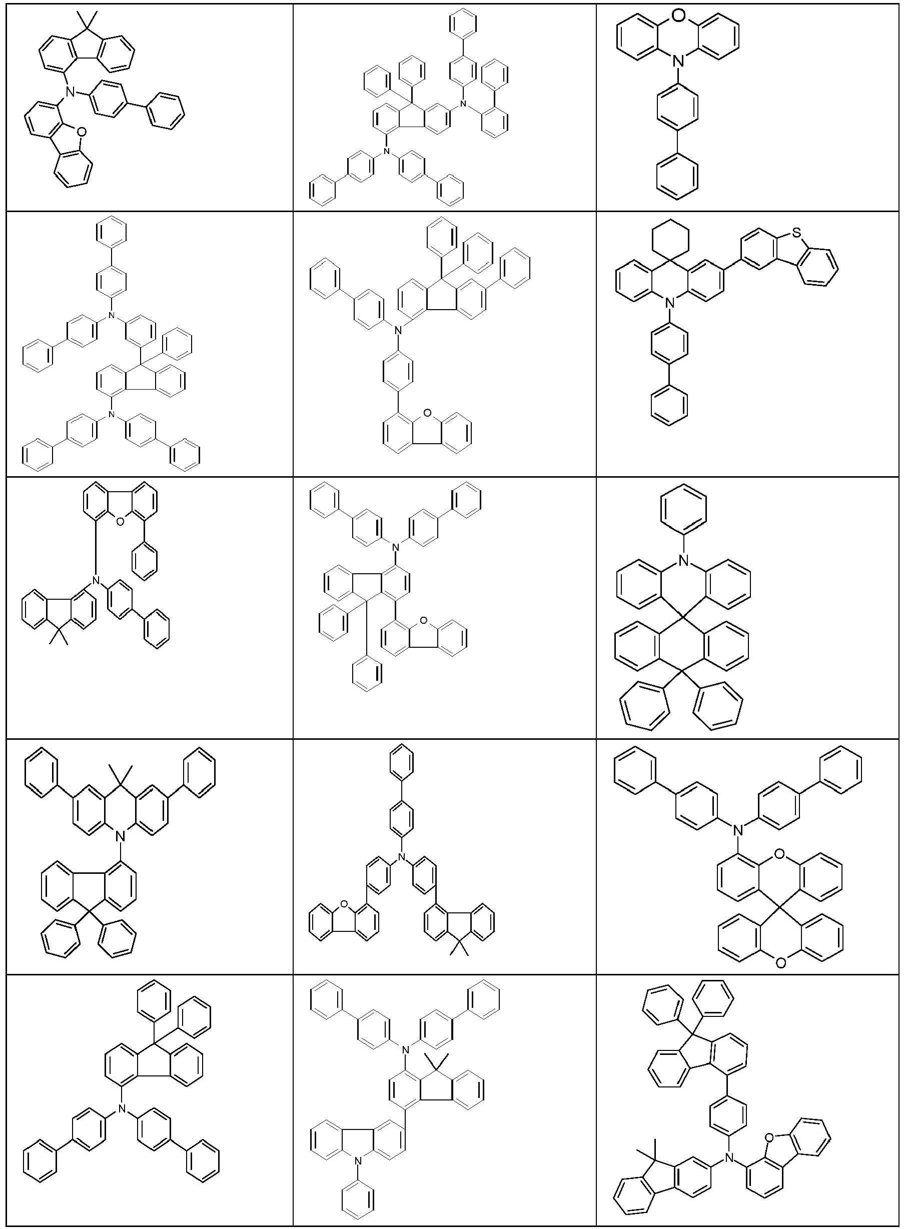

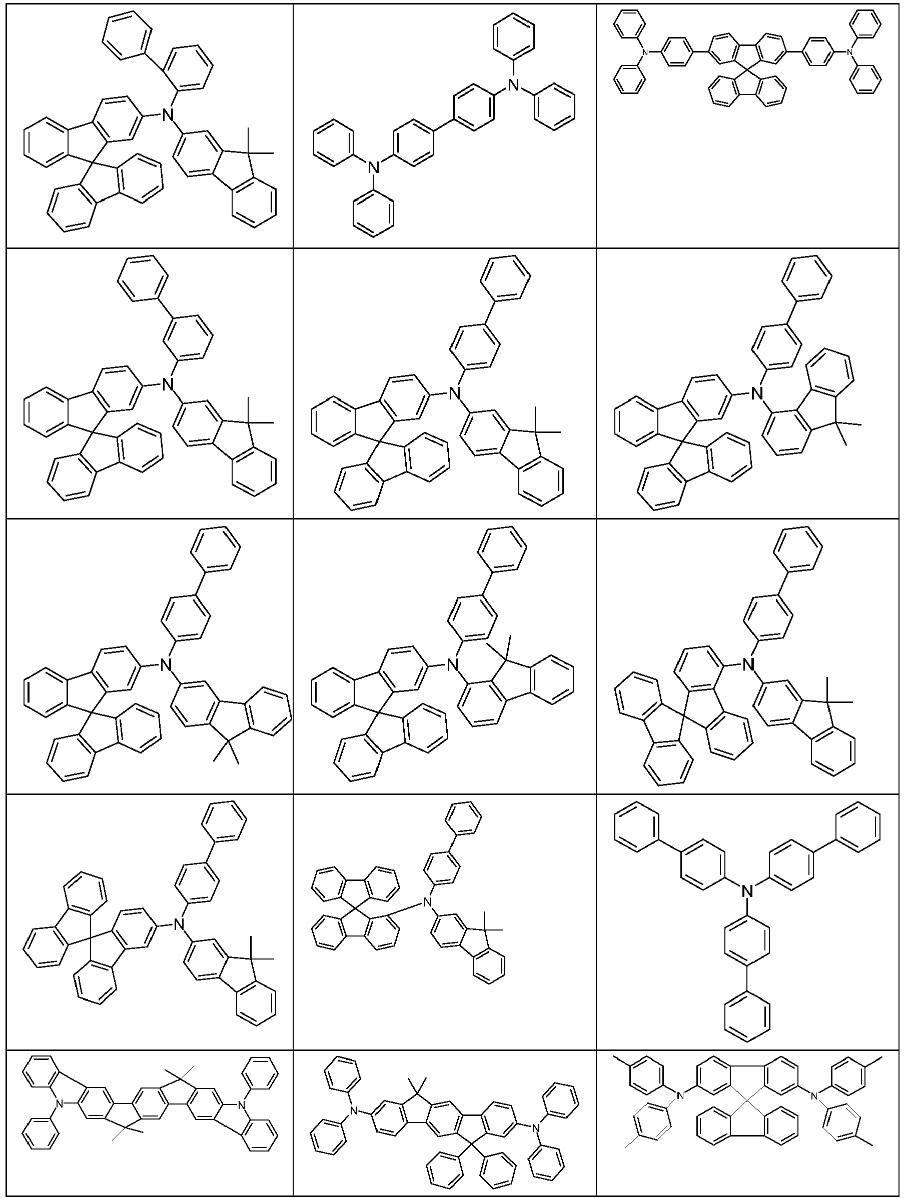

Beispiele für Materialien, welche als Wide Bandgap Matrixmaterialien eingesetzt werden können, sind die folgenden Verbindungen:

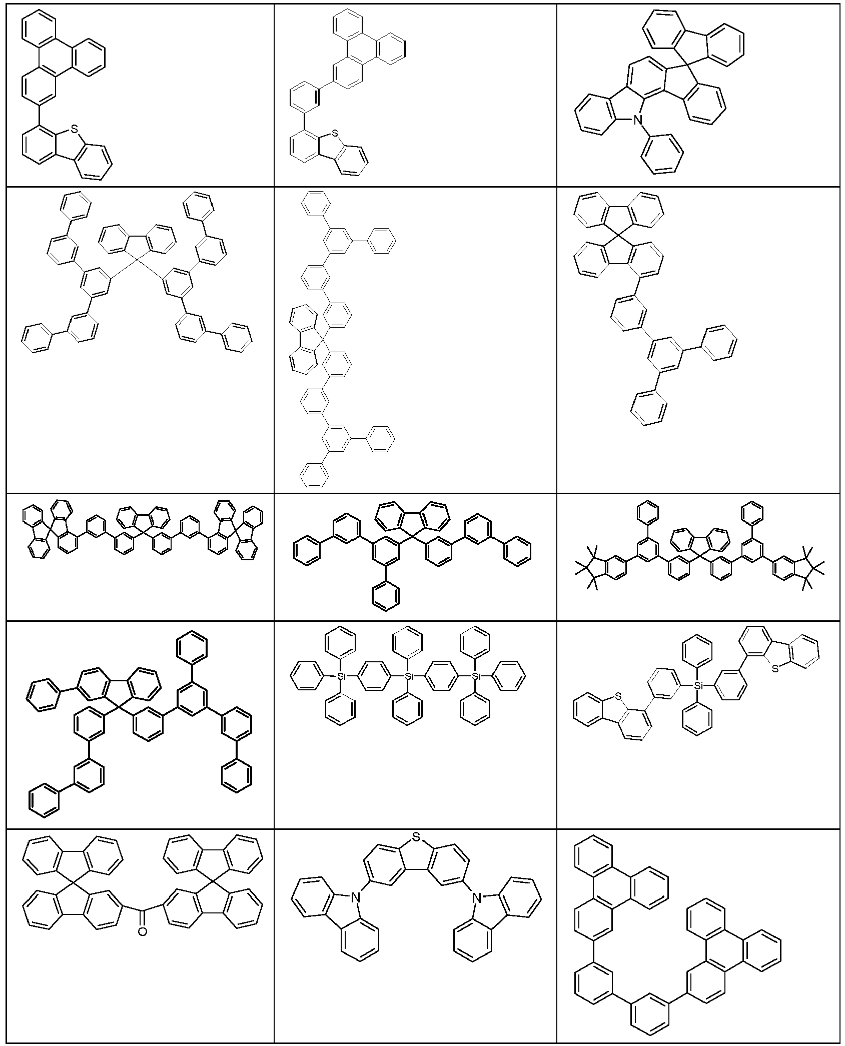

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum. So kann beispielsweise ein kürzerwellig emittierender Metallkomplex als Co-Matrix für einen längerwellig emittierenden erfindungsgemäßen Metallkomplex eingesetzt werden. Dabei kann es auch bevorzugt sein, wenn sowohl der kürzerwellig wie auch der längerwellig emittierende Metallkomplex eine erfindungsgemäße Verbindung ist. Als Co-Matrix-Materialien eignen sich insbesondere auch die Verbindungen, die in WO 2016/124304 und WO 2017/032439 offenbart sind.

Beispiele für geeignete Triplettemitter, welche als Co-Dotanden für die erfindungsgemäßen Verbindungen eingesetzt werden können, sind in der folgenden Tabelle abgebildet.

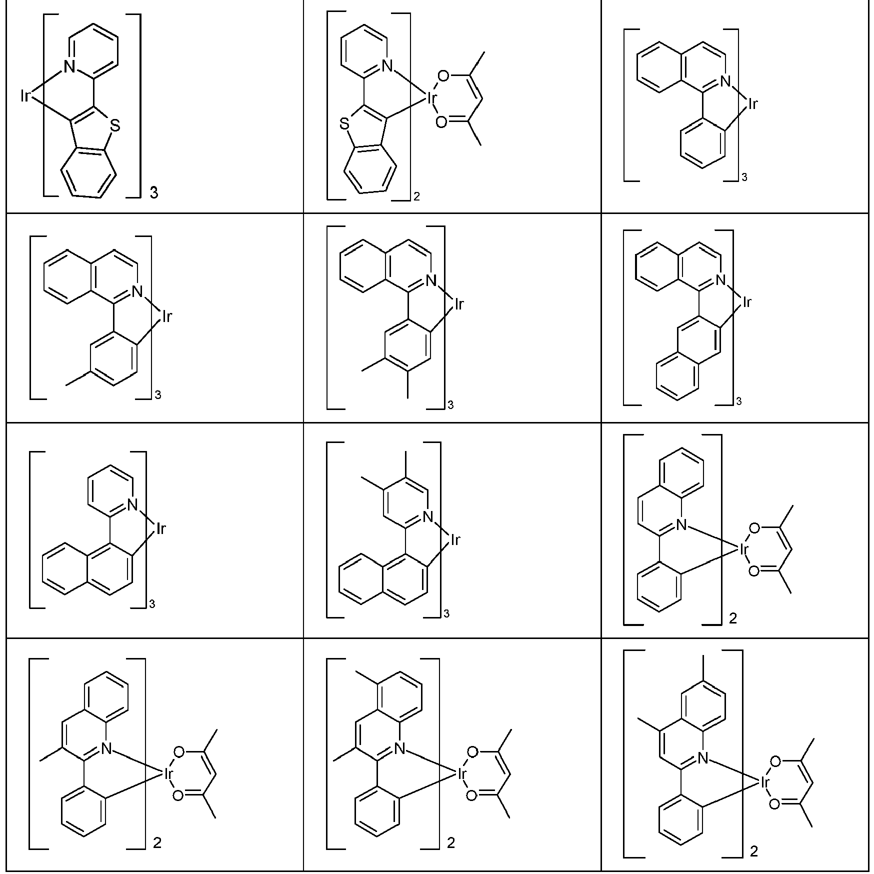

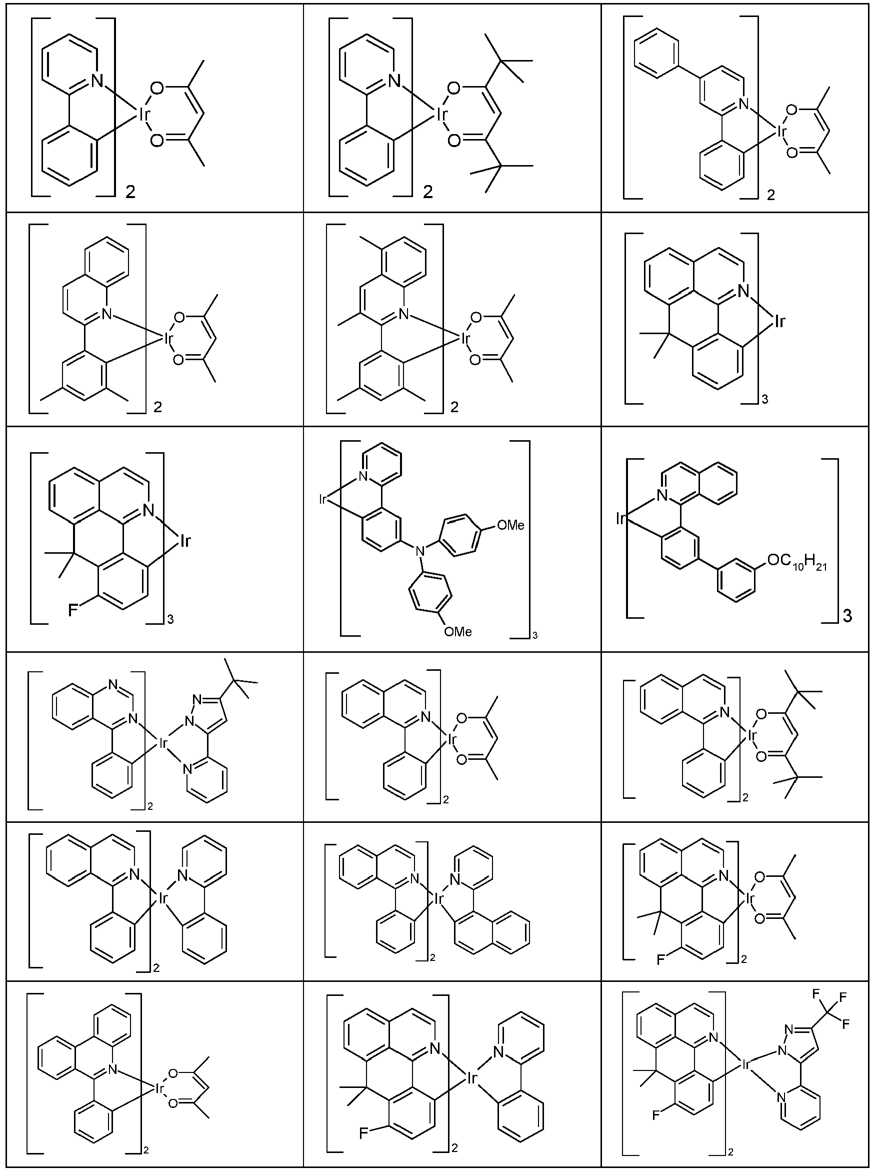

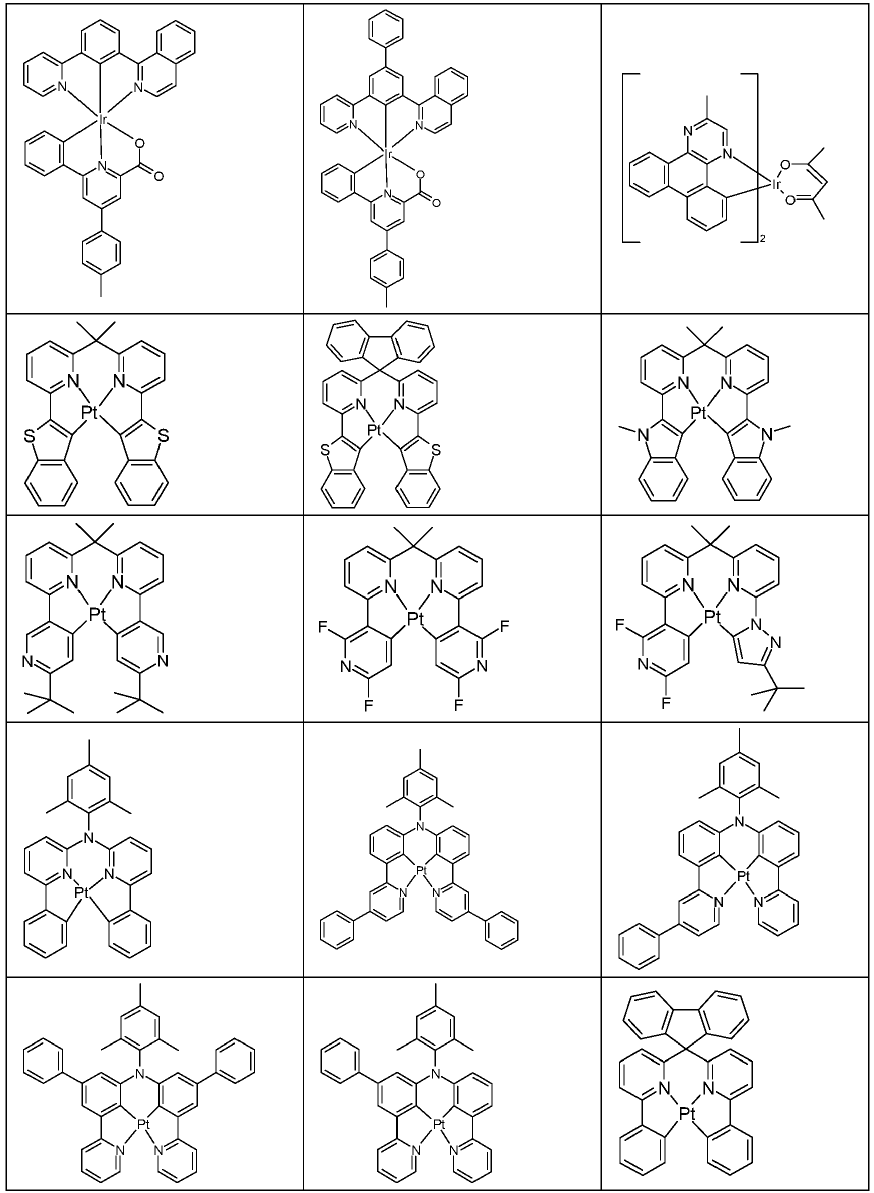

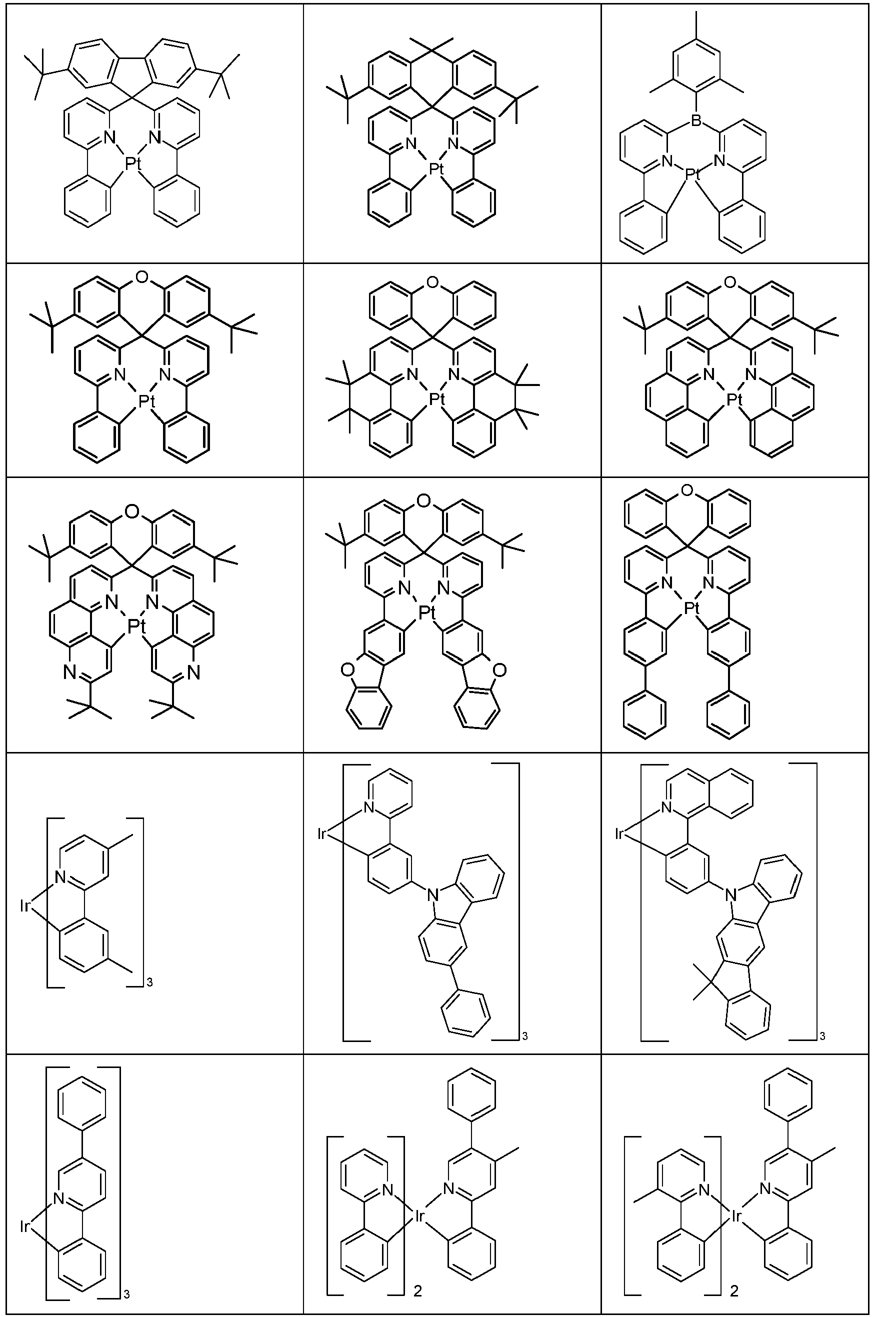

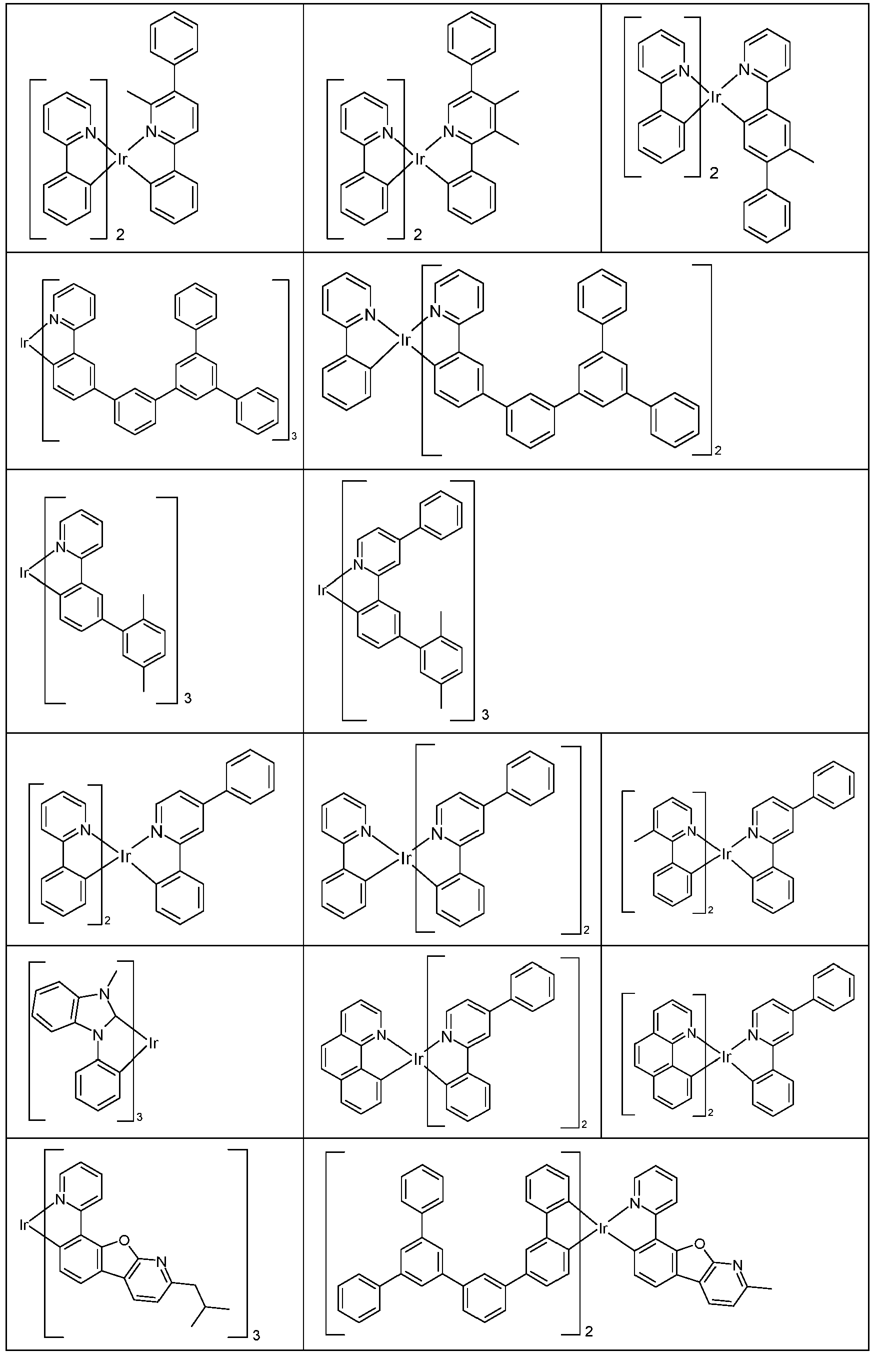

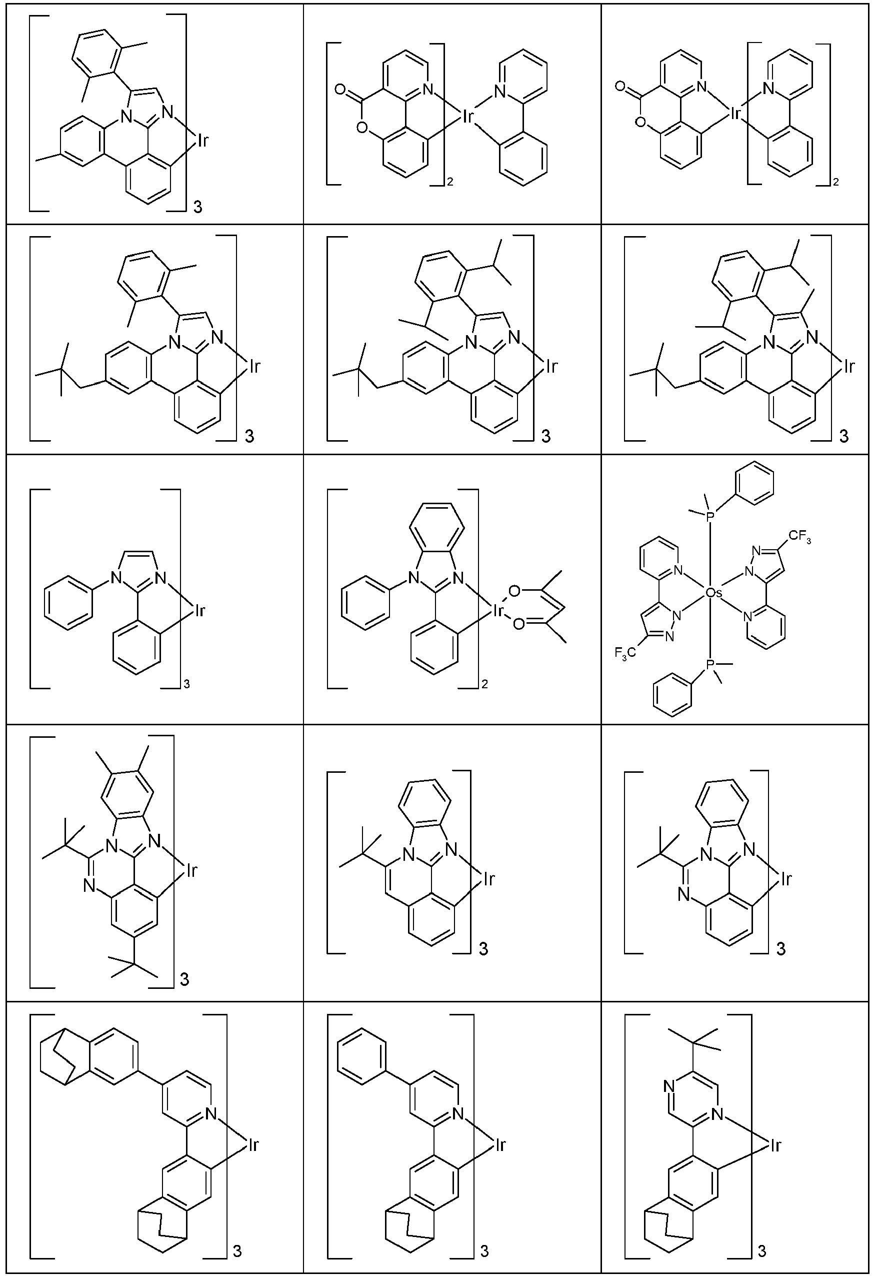

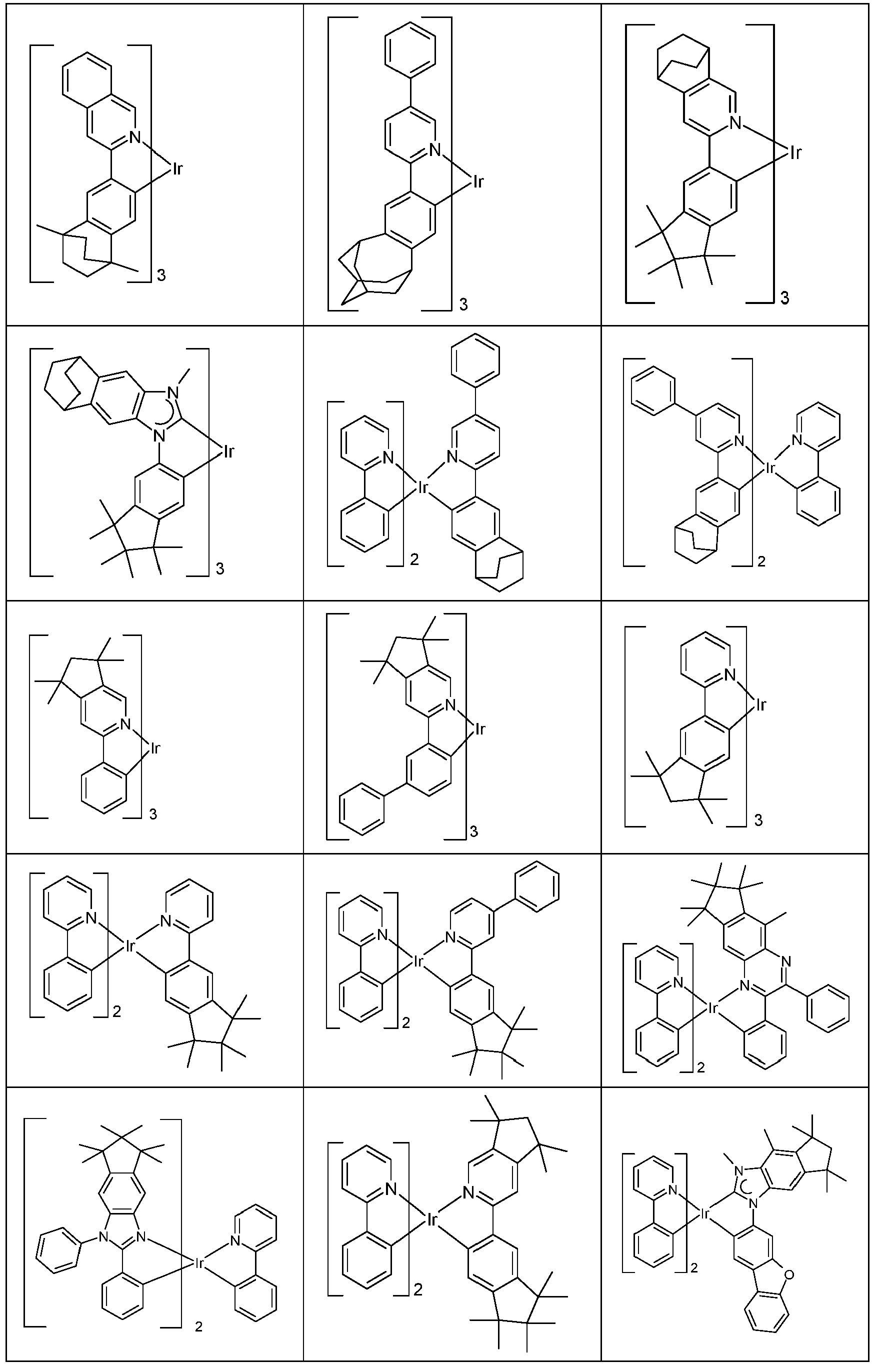

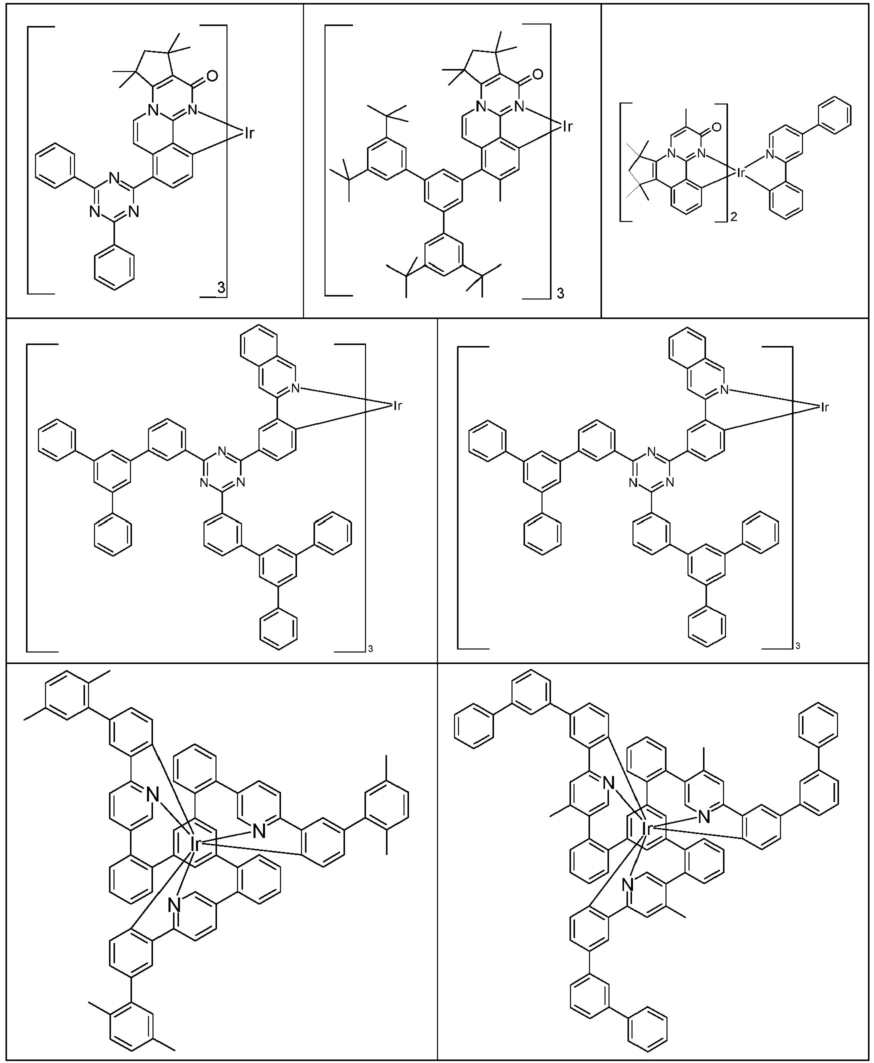

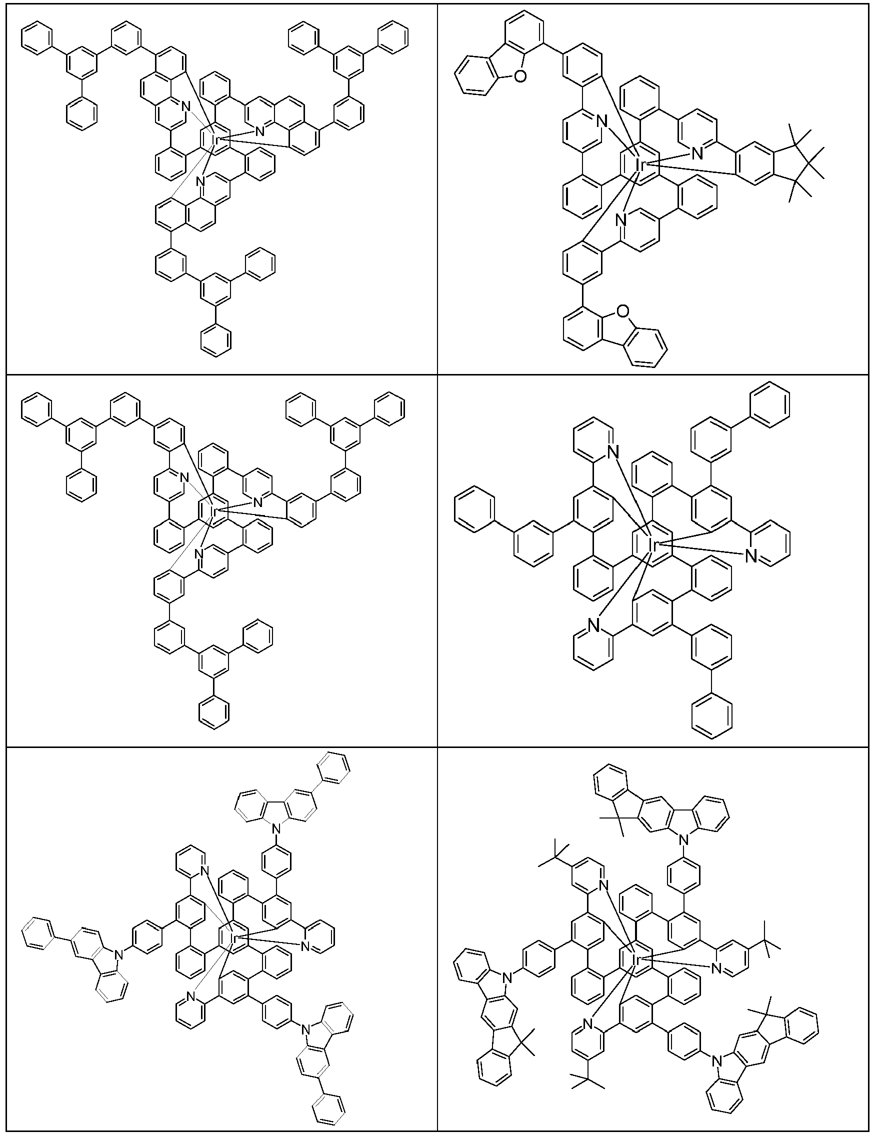

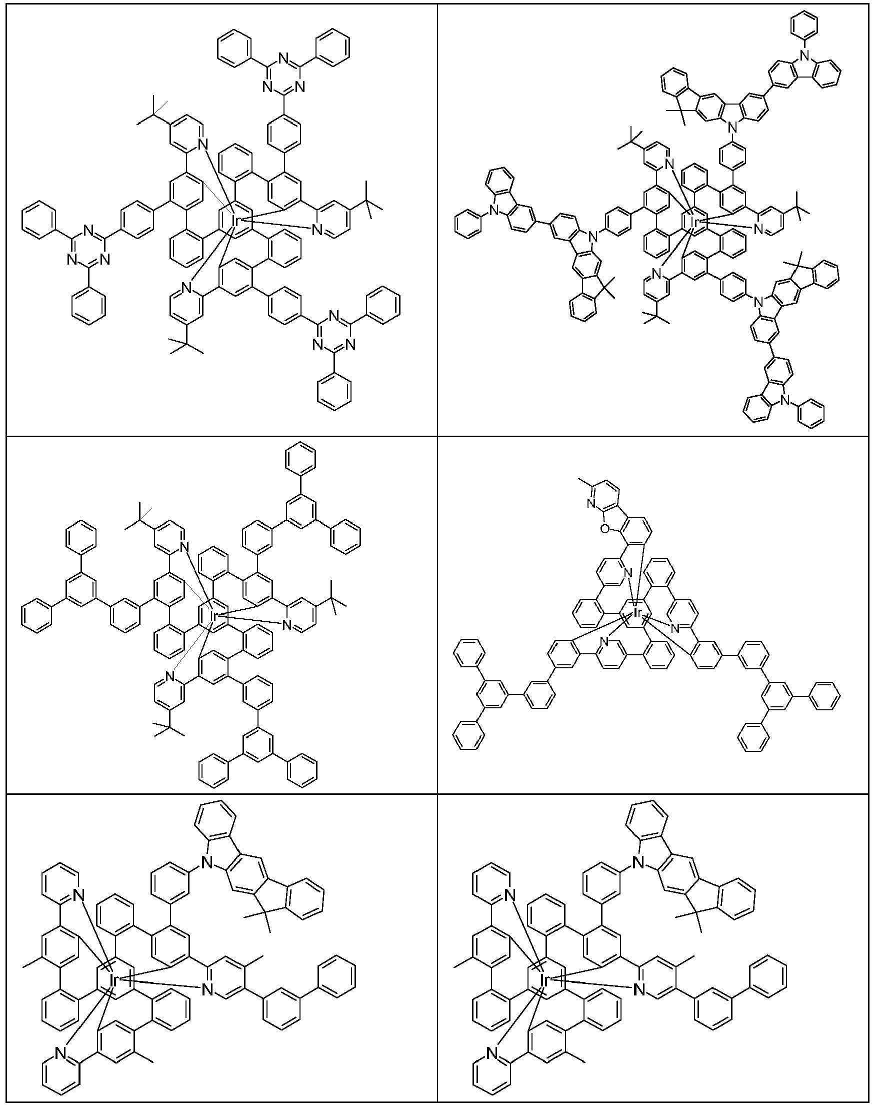

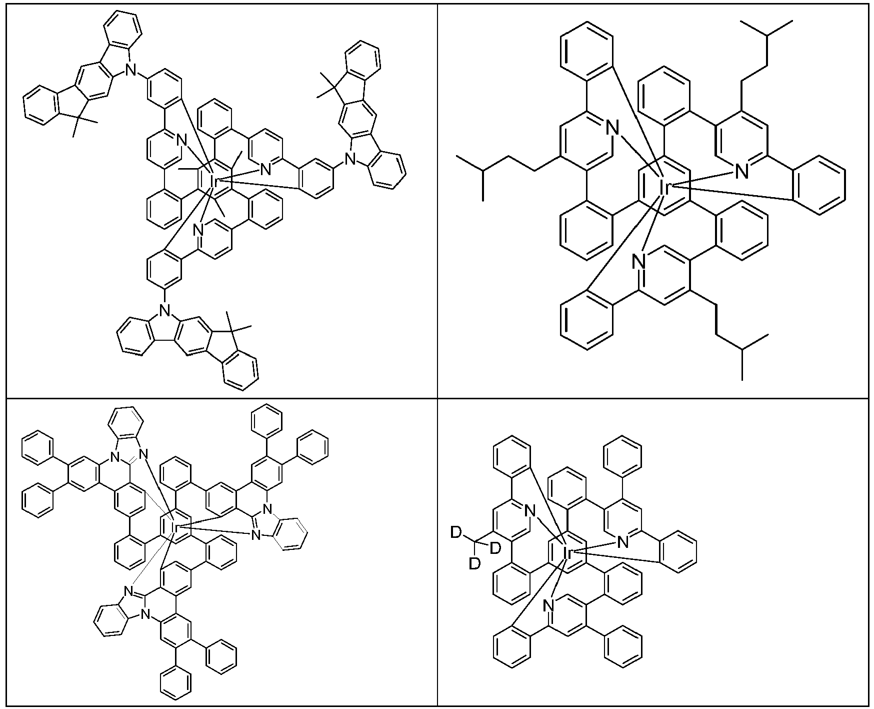

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise MoO₃ oder WO₃, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden.

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. In einer bevorzugten Ausführungsform der Erfindung wird die Schicht, die die erfindungsgemäße Verbindung enthält, aus Lösung aufgebracht.

Die organische Elektrolumineszenzvorrichtung kann auch als Hybrid-system hergestellt werden, indem eine oder mehrere Schichten aus Lösung aufgebracht werden und eine oder mehrere andere Schichten aufgedampft werden. So ist es beispielsweise möglich, eine emittierende Schicht enthaltend einen erfindungsgemäßen Metallkomplex und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch einen oder mehrere der folgenden überraschenden Vorteile gegenüber dem Stand der Technik aus:
1. Mit den erfindungsgemäßen Verbindungen ist tiefrote und infrarote Emission möglich.
2. Die erfindungsgemäßen Verbindungen weisen eine sehr hohe Photolumineszenz-Quantenausbeute für den Infrorot-Bereich auf. Dies führt bei Verwendung in einer infrarot emittierenden organischen Elektrolumineszenzvorrichtung zu hervorragenden Effizienzen.
3. Die erfindungsgemäßen Verbindungen weisen eine sehr geringe Lumineszenzlebensdauer auf. Dies führt bei Verwendung in einer organischen Elektrolumineszenzvorrichtung zu einem verbesserten Roll-off-Verhalten, sowie durch Vermeidung nicht-radiativer Relaxationskanäle zu einer höheren Lumineszenz-Quantenausbeute.
4. Die erfindungsgemäßen Verbindungen, insbesondere Verbindungen mit n = 1, zeigen orientierte Emission und weisen daher eine hohe Effizienz auf.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen. Bei Verbindungen, die mehrere tautomere Formen aufweisen könnenm wird eine tautomere Form stellvertretend gezeigt. Die Ir-Komplexe fallen üblicherweise als Gemische der Δ- und Λ-Enatiomere an.

### A: Synthese der Synthone S:

### Beispiel S1:

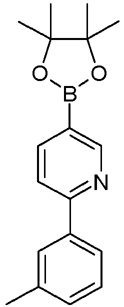

Darstellung analog zu Beispiel 21 in WO 2016/124304, s. S. 116. Edukt: 24.8 g (100 mmol) 5-Brom-2-(3-methylphenyl)-pyridin [1215073-45-2]. Ausbeute: 22.2 g (75 mmol); 75% d. Th.; Reinheit: 98 % n. ¹H-NMR.

### Beispiel S50:

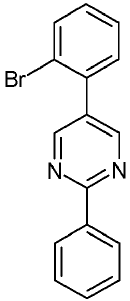

Darstellung analog zu Beispiel 200 in WO 2016/124304, s. S. 140. Edukt: 28.2 g (100 mmol) 2-Phenyl-5-(4,4,5,5-tetramethyl-1,3,2-dioxaborolan-2-yl)-pyrimidin [1319255-85-0]. Ausbeute: 22.2 g (75 mmol); 75% d. Th.; Reinheit: 98 % n. ¹H-NMR.

**Analog können folgende Verbindungen dargestellt werden:**

| Bsp. | Edukt | Produkt | Ausbeute |
|---|---|---|---|
| S51 | 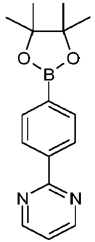 | 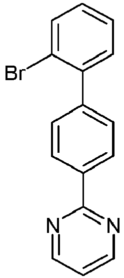 | 70% |
| | 1220526-74-8 | | |
| S52 | 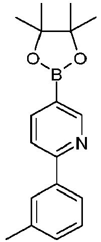 | 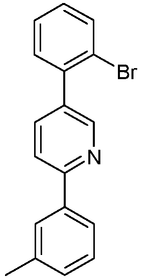 | 83% |
| | S1 | | |
| S53 | 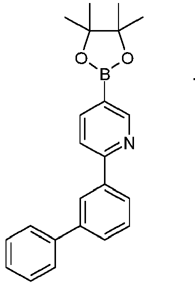 | 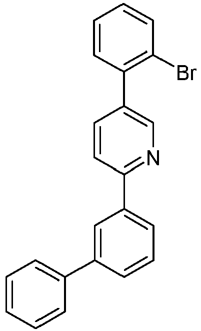 | 79% |
| | 1989596-34-0 | | |
| S54 | 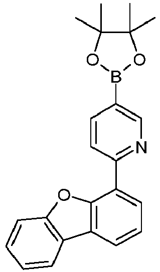 | 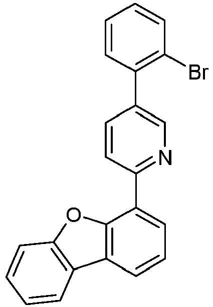 | 81% |
| | 1621690-56-9 | | |

### Beispiel S100:

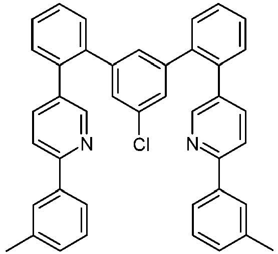

Darstellung analog zu Beispiel 5 in WO 2017/032439, s. S. 93. Edukt: 68.1 g (210 mmol) S52. Ausbeute: 42.5 g (71 mmol); 71 % d. Th.; Reinheit: 98 % n. ¹H-NMR.

**Analog können folgende Verbindungen dargestellt werden:**

| Bsp. | Edukt | Produkt | Ausbeute |
|---|---|---|---|
| S101 | S53 | 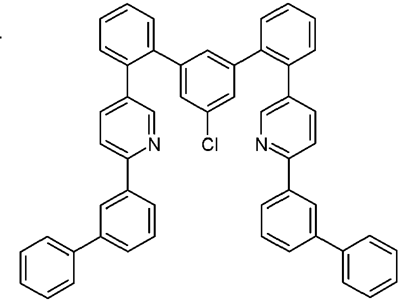 | 70% |
| S102 | S54 | 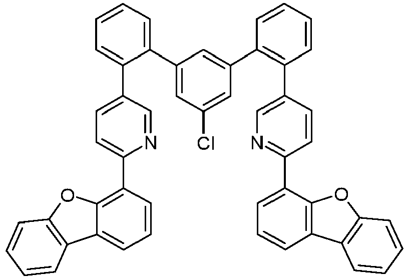 | 75% |
| S103 | S55 | 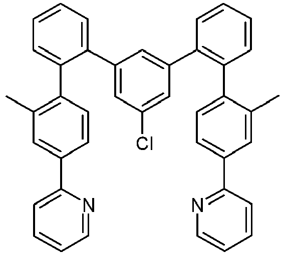 | 77% |
| | 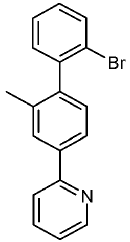 | | |
| | 1989597-31-0 | | |

### Beispiel S150:

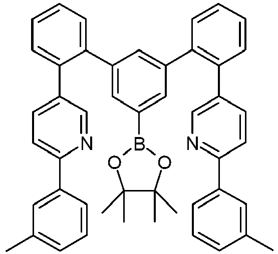

Ein Gemisch aus 59.9 g (100 mmol) S100, 26.7 g (105 mmol) Bis(pinaco-lato)diboran, 29.4 g (300 mmol) Kaliumacetat (wasserfrei), 50 g Glaskugeln (3 mm Durchmesser) und 500 ml THF wird unter gutem Rühren mit 821 mg (2 mmol) SPhos und dann mit 225 mg (1 mmol) Palladium(II)-acetat versetzt und 24 h unter Rückfluss erhitzt. Nach Erkalten saugt man von den Salzen und Glaskugeln über ein mit THF vorgeschlämmtes Celite-Bett ab, wäscht dieses mit etwas THF nach und engt das Filtrat zur Trockene ein. Man nimmt den Rückstand in 150 ml MeOH auf, rührt warm aus, saugt vom auskristallisierten Produkt ab, wäscht zweimal mit je 30 ml Methanol nach und trocknet im Vakuum. Ausbeute: 56.0 g (81 mmol); 81 % d. Th.; Reinheit: ca. 95 %ig n. ¹H-NMR.

**Analog können folgende Verbindungen dargestellt werden:**

| Bsp. | Edukt | Produkt | Ausbeute |
|---|---|---|---|
| S151 | S101 | 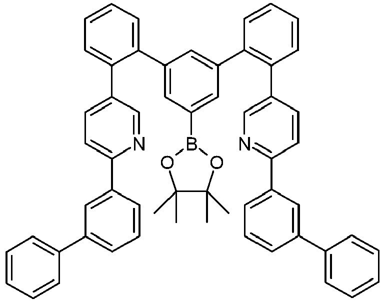 | 76% |
| S152 | S102 | 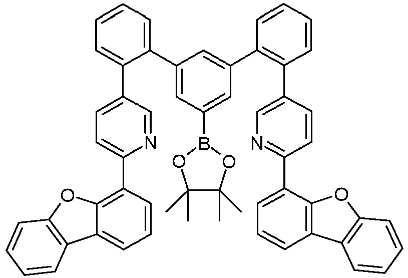 | 79% |
| S153 | S103 | 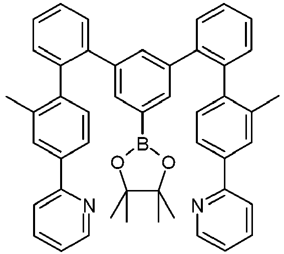 | 83% |

### B: Synthese der Ir-Liganden L:

### Beispiel L1

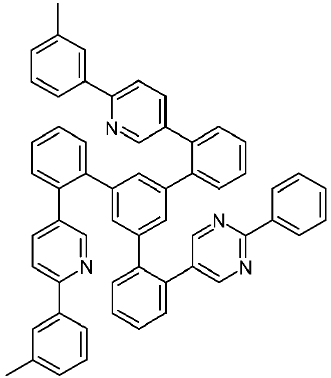

Ein Gemisch aus 69.1 g (100 mmol) S150, 31.1 g (100 mmol) S50, 63.7 g (300 mmol) Trikaliumphosphat, 400 ml Toluol, 200 ml Dioxan und 400 ml Wasser wird unter gutem Rühren mit 1.64 g (4 mmol) SPhos und dann mit 449 mg (2 mmol) Palladium(II)acetat versetzt und anschließend 24 h unter Rückfluss erhitzt. Nach Erkalten trennt man die organische Phase ab, wäscht diese zweimal mit je 300 ml Wasser und einmal mit 300 ml gesättigter Kochsalzlösung und trocknet über Magnesiumsulfat. Man filtriert vom Trockenmittel über ein mit Toluol vorgeschlämmtes Celite-Bett ab, engt das Filtrat im Vakuum zur Trockene ein und kristallisiert das glasartige Rohprodukt in der Siedehitze aus Acetonitril/Ethylacetat um. Ausbeute: 56.5 g (71 mmol); 71 % d. Th.; Reinheit: ca. 95 %ig n. ¹H-NMR.

**Analog können folgende Verbindungen dargestellt werden:**

| Bsp. | Edukt | Produkt | Ausbeute |
|---|---|---|---|
| L2 | S151 S50 | 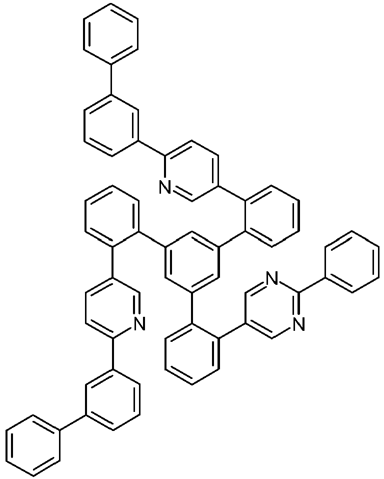 | 74% |
| L3 | S152 S50 | 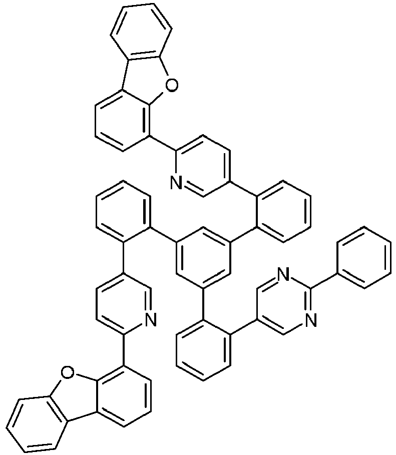 | 77% |
| L4 | S153 S51 | 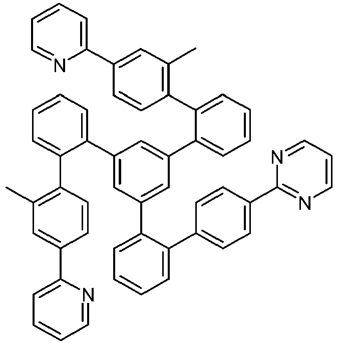 | 72% |

### C: Synthese der Ir-Komplexe und deren Bromierung Beispiel Ir(L1)

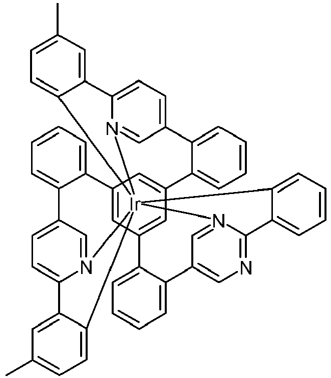

Ein Gemisch aus 7.95 g (10 mmol) des Liganden L1, 4.90 g (10 mmol) Tris-acetylacetonato-iridium(III) [15635-87-7] und 120 g Hydrochinon [123-31-9] werden in einem 1000 mL Zweihalsrundkolben mit einem glasummantelten Magnetkern vorgelegt. Der Kolben wird mit einem Wasserabscheider (für Medien geringerer Dichte als Wasser) und einem Luftkühler mit Argonüberlagerung versehen. Der Kolben wird in einer Metallheizschale platziert. Die Apparatur wird über die Argonüberlagerung von oben her 15 min. mit Argon gespült, wobei man das Argon aus dem Seitenhals des Zweihalskolbens ausströmen lässt. Über den Seitenhals des Zweihalskolbens führt man ein glasummanteltes Pt-100 Thermoelement in den Kolben ein und platziert das Ende kurz oberhalb des Magnetrührkerns. Dann wird die Apparatur mit mehreren lockeren Wicklungen von Haushaltsaluminiumfolie thermisch isoliert, wobei die Isolation bis zur Mitte des Steigrohres des Wasserabscheiders geführt wird. Dann wird die Apparatur schnell mit einem Laborheizrührwerk auf 250-255 °C, gemessen am Pt-100 Thermofühler, der in die aufgeschmolzene, gerührte Reaktionsmischung eintaucht, erhitzt. Während der nächsten 2 h wird das Reaktionsgemisch bei 250-255 °C gehalten, wobei wenig Kondensat abdestilliert und sich im Wasserabscheider sammelt. Nach 2 h lässt man auf 190 °C abkühlen, entfernt die Heizschale und tropft dann 100 ml Ethylenglycol zu. Nach Erkalten auf 100 °C tropft man langsam 400 ml Methanol zu. Die so erhaltene gelbe-orange Suspension wird über eine Umkehrfritte filtriert, der gelbe Feststoff wird dreimal mit 50 ml Methanol gewaschen und dann im Vakuum getrocknet. Rohausbeute: quantitativ. Der so erhaltene Feststoff wird in ca. 200 ml Dichlormethan gelöst und über ca. 1 kg mit Dichlormethan vorgeschlämmtes Kieselgel (Säulendurchmesser ca. 18 cm) unter Luft- und Lichtausschluss filtriert, wobei dunkle Anteile am Start liegen bleiben. Die Kernfraktion wird herausgeschnitten und am Rotationsverdampfer eingeengt, wobei gleichzeitig kontinuierlich MeOH bis zur Kristallisation zugetropft wird. Nach Absaugen, Waschen mit wenig MeOH und Trocknen im Vakuum erfolgt die weitere Reinigung des orangefarbenen Produkts durch dreimalige kontinuierliche Heißextraktion mit Dichlormethan/iso-Propanol 1:1 (vv) und dann zweimalige Heißextraktion mit Dichlormethan/Acetonitril (Vorlagemenge jeweils ca. 200 ml, Extraktionshülse: Standard Soxhletthülsen aus Cellulose der Fa. Whatman) unter sorgfältigem Luft- und Lichtausschluss. Über das Verhältnis Dichlormethan (Niedersieder und Gutlöser) : iso-Propanol bzw. Acetonitril (Hochsieder und Schlechtlöser) kann der Verlust in die Mutterlauge eingestellt werden. Typischerweise sollte er 3-6 Gew.-% der eingesetzten Menge betragen. Es können zur Heißextration auch andere Lösungsmittel wie Toluol, Xylol, Essigester, Butylacetat, etc. verwendet werden. Abschließend wird das Produkt im Hochvakuum bei p ~ 10⁻⁶ mbar und T ~ 350 - 400 °C getempert. Ausbeute: 7.48 g (7.6 mmol), 76 %; Reinheit: ca. 99.8 %ig nach HPLC.

**Analog können folgendes Verbindungen dargestellt werden:**

| Bsp. | Edukt | Produkt | Ausbeute |
|---|---|---|---|
| Ir(L2) | L2 | 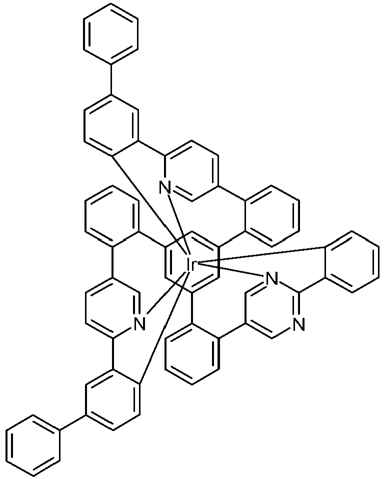 | 68% |
| Ir(L3) | L3 | 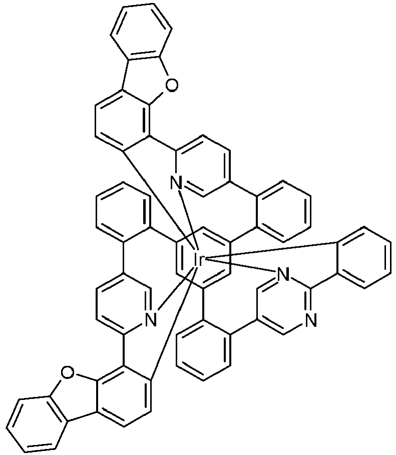 | 71% |
| Ir(L4) | L4 | 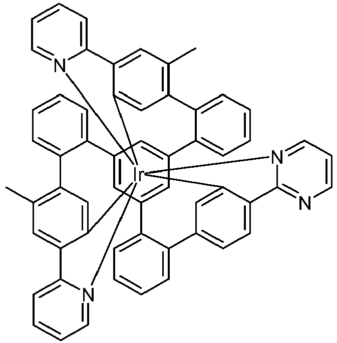 | 70% |

### Beispiel Ir(L1-Br)

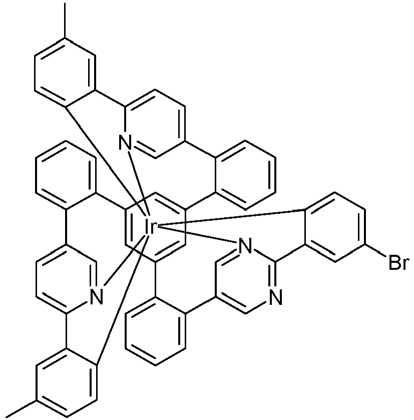

Eine gut gerührte Suspension von 9.84 g (10 mmol) Ir(L1) in 500 ml DCM wird bei Raumtemperatur unter Lichtausschluss auf einmal mit 1.78 g (10.5 mmol) N-Bromsuccinimid versetzt und dann weitere 16 h gerührt. Nach Entfernen von ca. 450 ml des DCMs im Vakuum wird die gelbegrüne Suspension mit 100 ml Methanol und 0.3 ml Hydrazinhydrat versetzt, der gelbe Feststoff wird abgesaugt, dreimal mit ca. 50 ml Methanol gewaschen und dann im Vakuum getrocknet. Ausbeute: 9.78 g (9.2 mmol); 92 % d. Th.; Reinheit: > 99.0 %ig nach NMR.

**Analog können folgende Verbindungen dargestellt werden:**

| Bsp. | Edukt | Produkt | Ausbeute |
|---|---|---|---|
| Ir(L2-Br) | Ir(L2) | 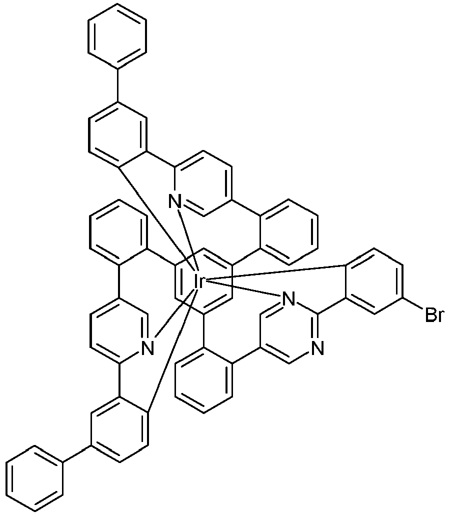 | 90% |
| Ir(L3-Br) | Ir(L3) | 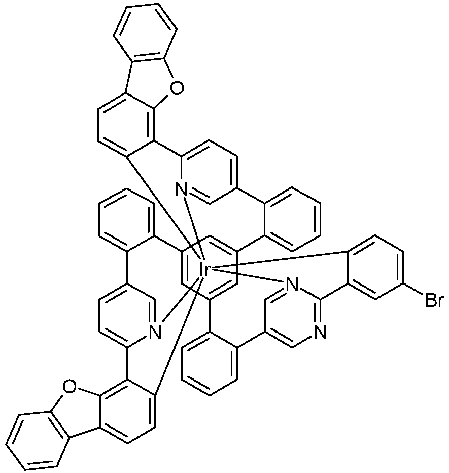 | 86% |
| Ir(L4-Br) | Ir(L4) | 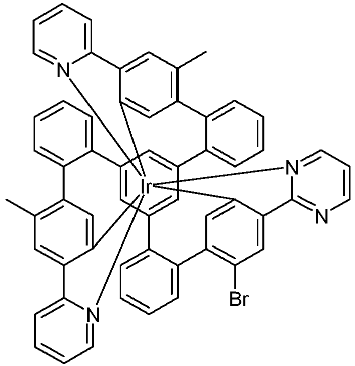 | 94% |

### D: Synthese der Ir-Komplexe mit Pt-Liganden

### Beispiel Ir(L1A)

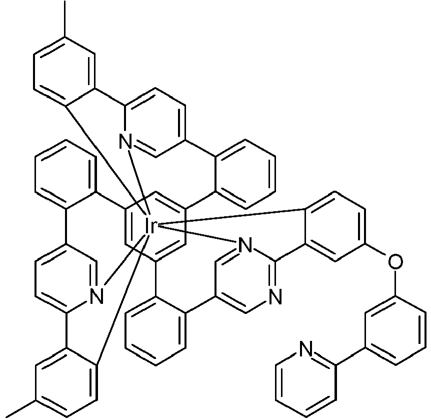

Ein Gemisch aus 10.66 g (10 mmol) Ir(L1-Br), 3.43 g (20 mmol) 3-(2-Pyridinyl)phenol [98061-22-4], 5.53 g (40 mmol) Kaliumcarbonat, 930 mg (1 mmol) Triphenylphosphin-kupfer(I)bromid [15709-74-7], 50 g Glaskugeln, 70 ml DMF und 90 ml o-Xylol wird so lange am Wasserabscheider erhitzt, bis sich kein Wasser mehr abscheidet (ca. 18 h). Man lässt die Reaktionsmischung auf 70 °C erkalten, saugt über ein mit o-Xylol vorgeschlämmtes Celite-Bett ab und engt das Filtrat zur Trockene ein. Der Rückstand wird mit ca. 150 ml MeOH heiß ausgerührt, der Feststoff wird abgesaugt, dreimal mit je 20 ml MeOH gewaschen und getrocknet. Man nimmt den Feststoff in ca. 200 ml Dichlormethan (DCM) : Ethylacetat (EE) (9:1 vv) auf, filtriert über eine mit DCM:EE (9:1 vv) vorgeschlämmte Kieselgelsäule (8 cm Durchmesser, 30 cm Länge) und schneidet die orange Kernfraktion heraus. Das Dichlormethan wird am Rotationsverdampfer bei Normaldruck abdestilliert und das abdestillierte Volumen wird dabei kontinuierlich durch Methanol ersetzt, wobei das Produkt auskristallisiert. Man saugt vom orange Produkt ab, wäscht dieses zweimal mit je 20 ml Methanol und trocknet im Vakuum. Ausbeute: 8.85 g (7.6 mmol); 76 % d. Th.; Reinheit: > 99.0 %ig nach NMR.

**Analog können folgende Verbindungen dargestellt werden:**

| Bsp. | Edukt | Produkt | Ausbeute |
|---|---|---|---|
| Ir(L1B) | Ir(L1-Br) | 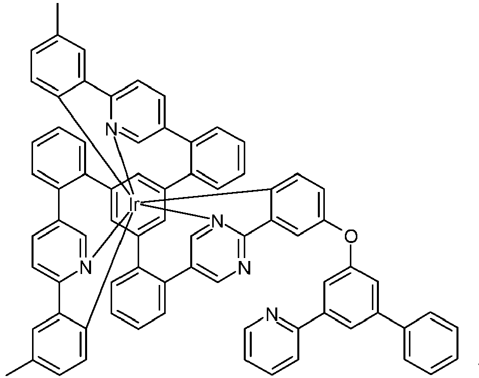 | 71% |
| | 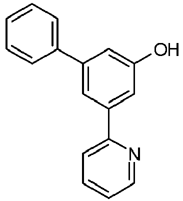 | | |
| | 1939918-12-3 | | |
| Ir(L1C) | Ir(L1-Br) | 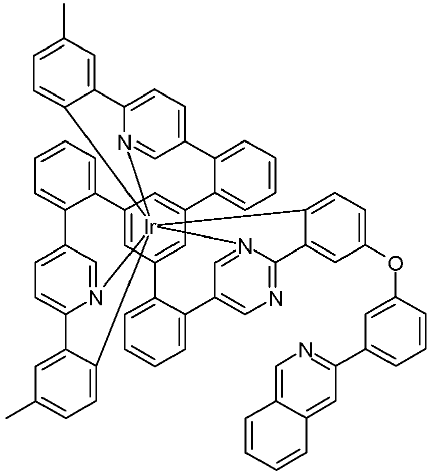 | 73% |
| | 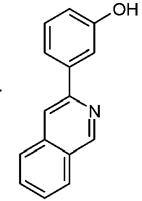 | | |
| | 134949-01-2 | | |
| Ir(L1D) | Ir(L1-Br) | 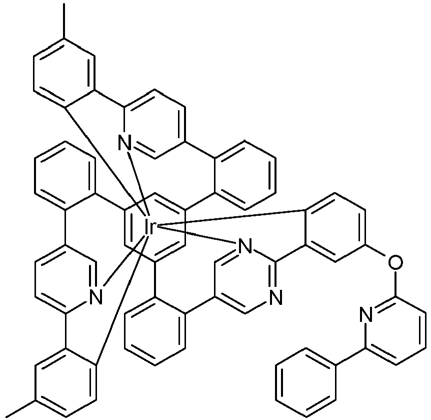 | 56% |
| | 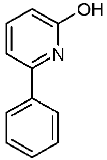 | | |
| | 19006-82-7 | | |
| Ir(L1E) | Ir(L1-Br) | 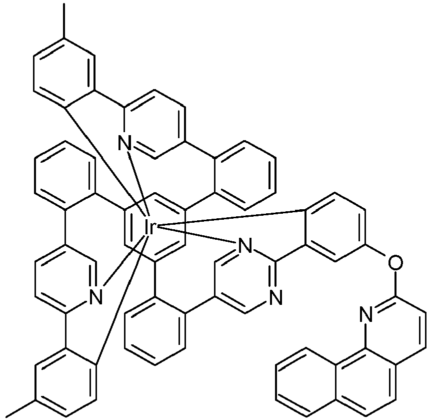 | 56% |
| | 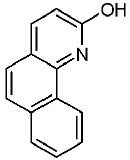 | | |
| | 23981-06-8 | | |
| Ir(L2A) | Ir(L2-Br) | 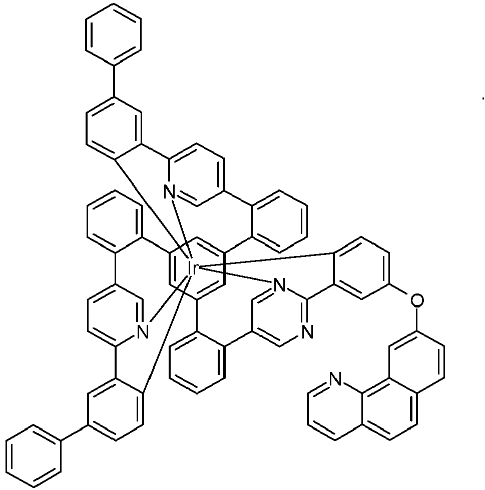 | 65% |
| | 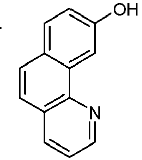 | | |
| | 57442-06-5 | | |
| Ir(L3A) | Ir(L3-Br) | 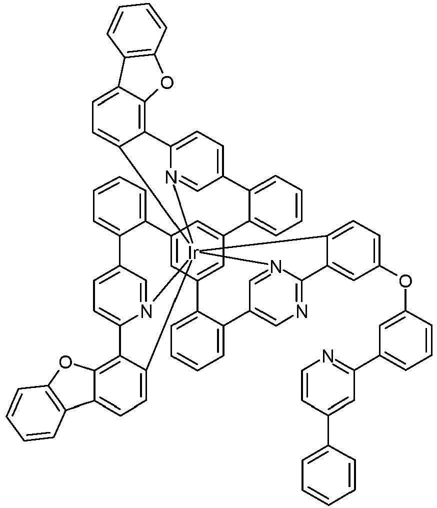 | 68% |
| | 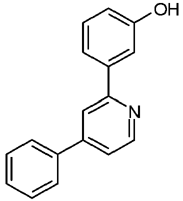 | | |
| | 1939917-94-8 | | |
| Ir(L4A) | Ir(L4-Br) | 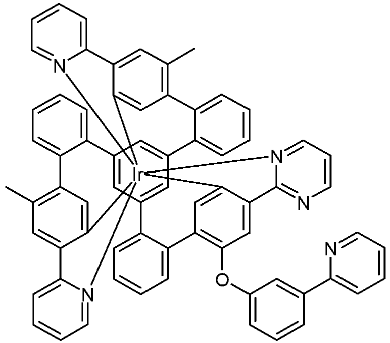 | 63% |
| | 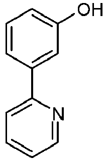 | | |
| | 98061-22-4 | | |
| Ir(L5A) | 2170151-15-0 | 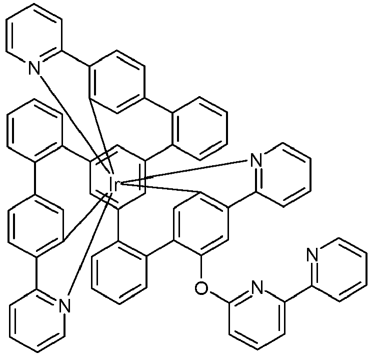 | 49% |
| | 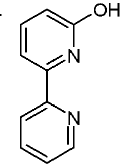 | | |
| | 101001-09-5 | | |
| Ir(L5B) | 2170151-15-0 | 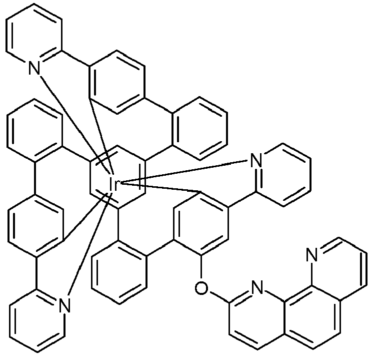 | 53% |
| | 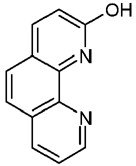 | | |
| | 92695-50-6 | | |
| Ir(L6A) | 1989601-73-1 | 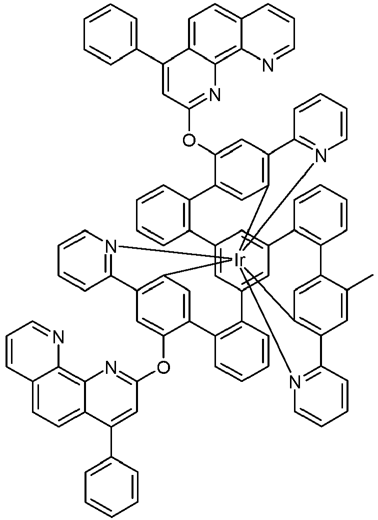 | 45% |
| | 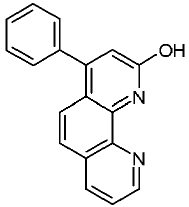 | | |
| | 2172780-00-4 30 mmol | | |
| Ir(L7A) | 1989601-53-7 | 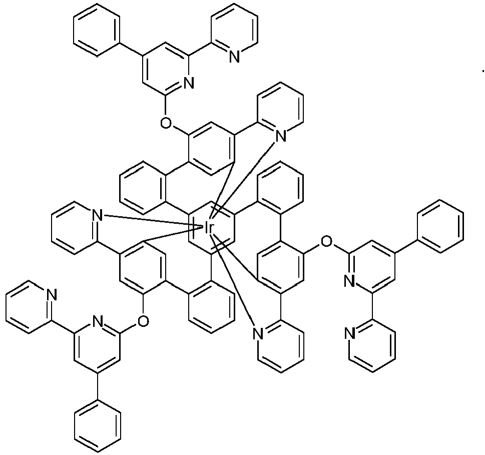 | 31% |
| | 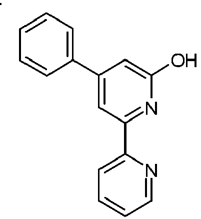 | | |
| | 220482-78-0 50 mmol | | |
| Ir(L8A) | 1989601-74-2 | 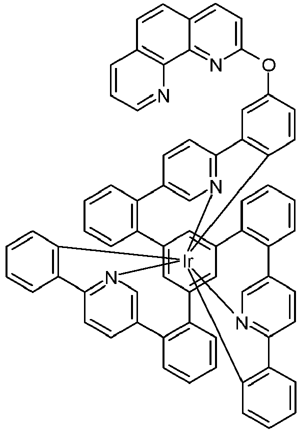 | 49% |
| | 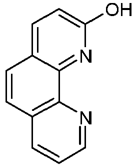 | | |
| | 92695-50-6 | | |

### Beispiel Ir(L1F)

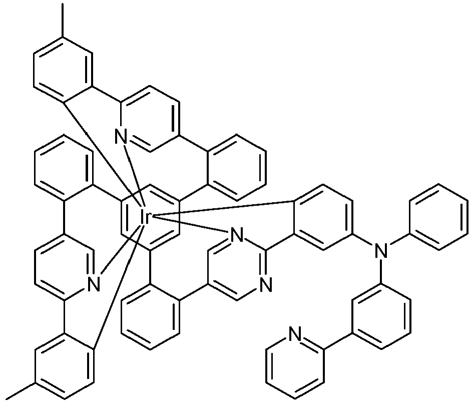

Ein gut gerührtes Gemisch von 10.66 g (10 mmol) Ir(L1-Br), 4.92 g (20 mmol) *N*-Phenyl-3-(2-pyridinyl)-phenylamin [1325592-74-2], 1.94 g (20 mmol) Natrium-tert-butanolat, 202 mg (1 mmol) Tri-tert-butylphosphin, 157 mg (0.7 mmol) Palladium(II)acetat und 150 ml o-Xylol wird 18 h unter Rückfluss erhitzt. Man lässt die Reaktionsmischung auf 70 °C erkalten, saugt über ein mit o-Xylol vorgeschlämmtes Celite-Bett ab und engt das Filtrat zur Trockene ein. Man nimmt den Feststoff in ca. 200 ml Dichlormethan (DCM):Ethylacetat (EE) (9:1 vv) auf, filtriert über eine mit DCM:EE (9:1 vv) vorgeschlämmte Kieselgelsäule (8 cm Durchmesser, 30 cm Länge) und schneidet die orange Kernfraktion heraus. Das Dichlormethan wird am Roationsverdampfer bei Normaldruck abdestilliert und das abdestillierte Volumen wird dabei kontinuierlich durch Methanol ersetzt, wobei das Produkt auskristallisiert. Man saugt vom orange Produkt ab, wäscht dieses zweimal mit je 20 ml Methanol und trocknet im Vakuum. Ausbeute: 8.37 g (6.8 mmol); 68 % d. Th.; Reinheit: > 99.0 %ig nach NMR.

**Analog können folgende Verbindungen dargestellt werden:**

| Bsp. | Edukt | Produkt | Ausbeute |
|---|---|---|---|
| Ir(L1G) | Ir(L1-Br) | 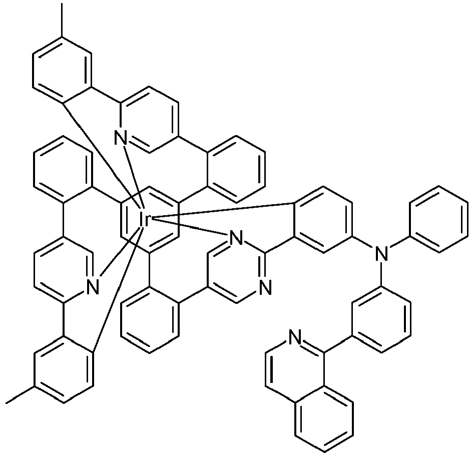 | 63% |
| | 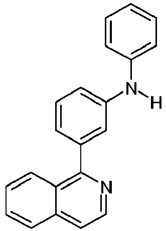 | | |
| | 1325592-71-9 | | |
| Ir(L1H) | Ir(L1-Br) | 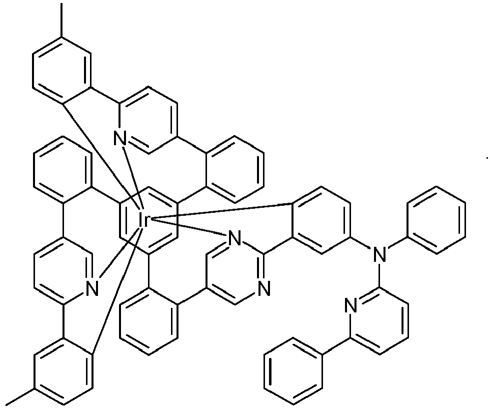 | 46% |
| | 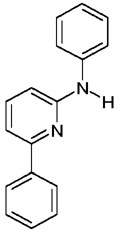 | | |
| | 84794-03-6 | | |
| Ir(L4B) | Ir(L4-Br) | 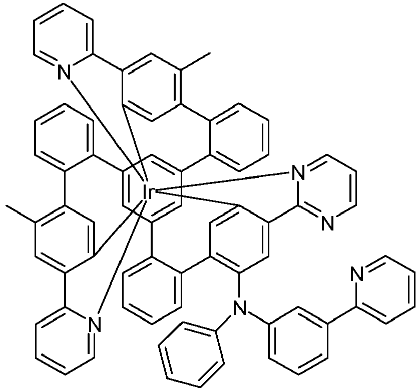 | 61% |
| | 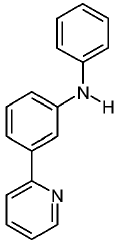 | | |
| | 1325592-74-2 | | |

### E: Synhese der Ir-Pt-Komplexe

### Beispiel IrPt(L1A)

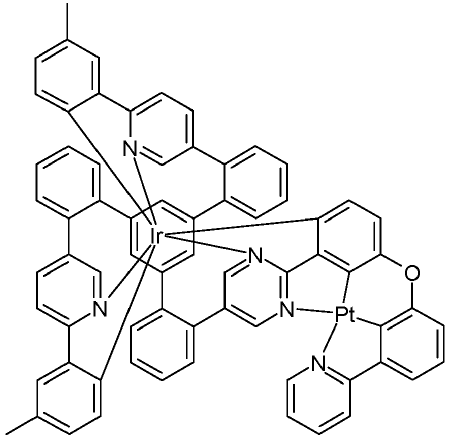

Ein Gemisch aus 11.56 g (10 mmol) Ir(L1A), 4.15 g (10 mmol) Kaliumtetrachloroplatinat [10025-99-7], 3.4 g (80 mmol) Lithiumchlorid, wasserfrei, 50 g Glaskugeln und 100 ml Eisessig wird unter gutem Rühren 60 h bei 80 °C gerührt. Nach Abkühlen auf ca. 50 °C setzt man tropfenweise 100 ml Wasser zu, saugt vom ausgefallenen Rohprodukt ab, wäscht dieses dreimal mit 30 ml eines Gemischs aus Methanol:Wasser (1:1 vv) und dreimal mit je 30 ml Methanol und trocknet im Vakuum. Man nimmt den Feststoff unter Lichtausschluss in ca. 200 ml DCM auf, filtriert über eine mit DCM vorgeschlämmte Kieselgelsäule (8 cm Durchmesser, 30 cm Länge) und schneidet die tiefrote Kernfraktion heraus. Das DCM wird am Rotationsverdampfer bei Normaldruck abdestilliert und das abdestillierte Volumen wird dabei kontinuierlich durch Methanol ersetzt, wobei das Produkt auskristallisiert. Man saugt vom Produkt ab, wäscht dieses zweimal mit je 20 ml Methanol und trocknet im Vakuum. Die weitere Reinigung des Produkts erfolgt durch viermalige kontinuierliche Heißextraktion mit Dichlormethan/iso-Propanol 1:1 (vv) und dann viermalige Heißextraktion mit Dichlormethan/Acetonitril (Vorlagemenge jeweils ca. 200 ml, Extraktionshülse: Standard Soxhletthülsen aus Cellulose der Fa. Whatman) unter sorgfältigem Luft- und Lichtausschluss. Über das Verhältnis Dichlormethan (Niedersieder und Gutlöser) : iso-Propanol bzw. Acetonitril (Hochsieder und Schlechtlöser) kann der Verlust in die Mutterlauge eingestellt werden. Typischerweise sollte er 3-6 Gew.-% der eingesetzten Menge betragen. Es können zur Heißextration auch andere Lösungsmittel wie Toluol, Xylol, Essigester, Butylacetat, etc. verwendet werden. Abschließend wird das Produkt im Hochvakuum bei p ~ 10⁻⁶ mbar und T ~ 370 - 450 °C getempert oder fraktioniert sublimiert. Ausbeute: 7.16 g (5.3 mmol); 53 % d. Th.; Reinheit: > 99.8 %ig nach NMR.

**Analog können folgendes Verbindungen dargestellt werden:**

| Bsp. | Edukt | Produkt | Ausbeute |
|---|---|---|---|
| IrPt(L1B) | Ir(L1B) | 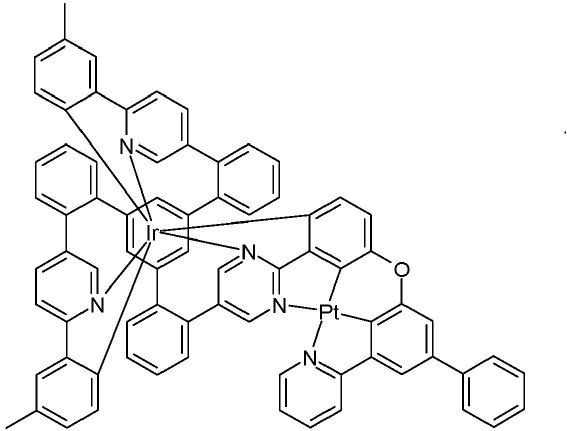 | 55% |
| IrPt(L1C) | Ir(L1C) | 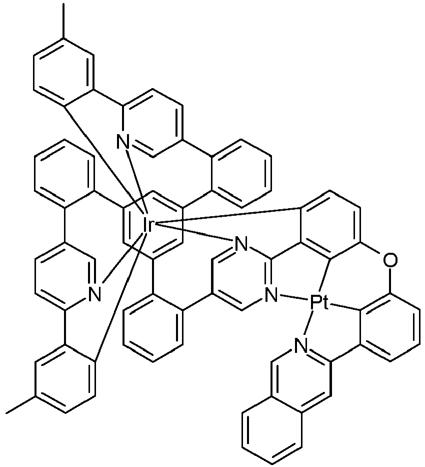 | 51% |
| IrPt(L1D) | Ir(L1D) | 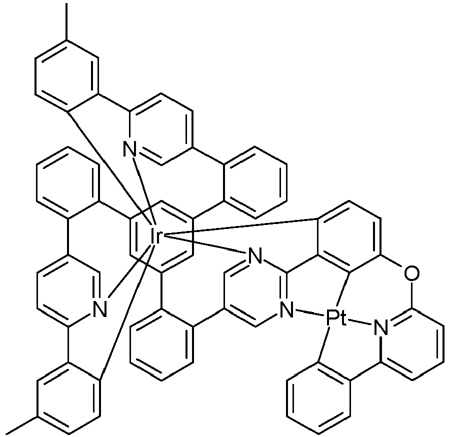 | 60% |
| IrPt(L1E) | Ir(L1E) | 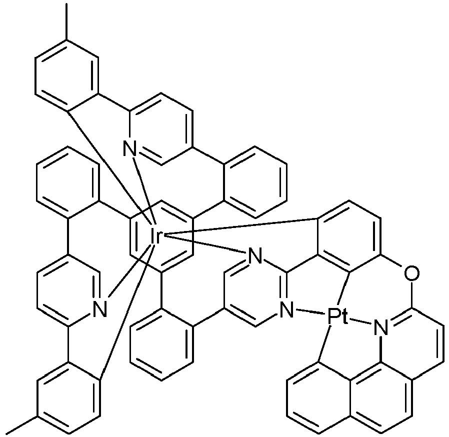 | 56% |
| IrPt(L2A) | Ir(L2A) | 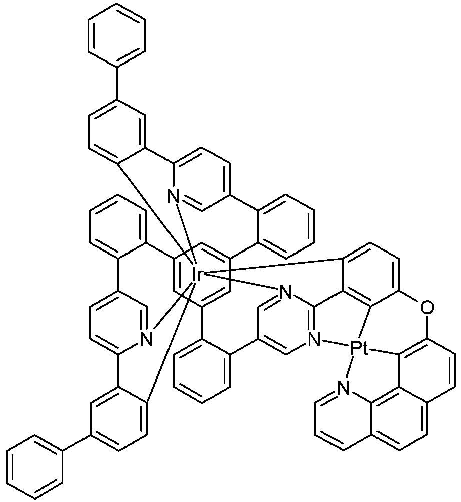 | 61% |
| IrPt(L3A) | Ir(L3A) | 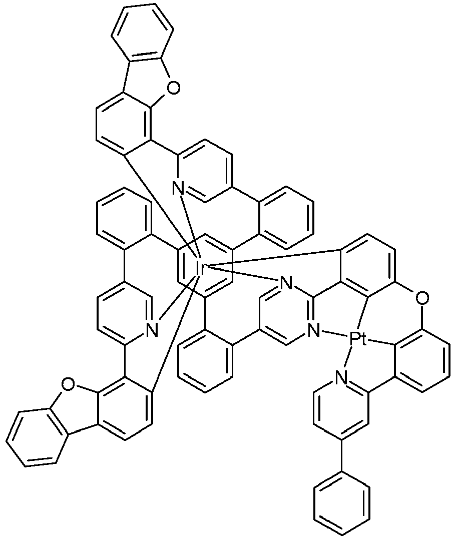 | 59% |
| IrPt(L4A) | Ir(L4A) | 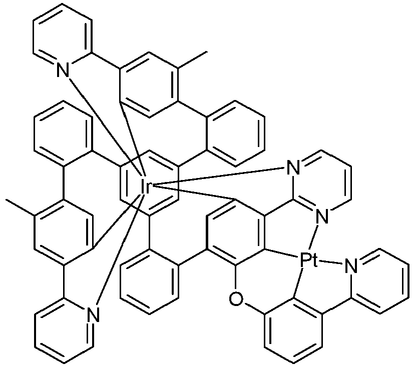 | 60% |
| IrPt(L5A) | Ir(L5A) | 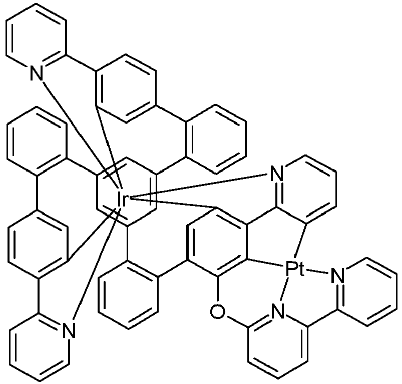 | 48% |
| IrPt(L5B) | Ir(L5B) | 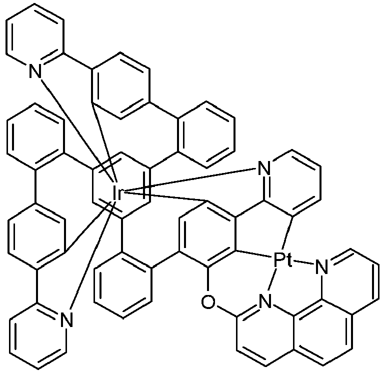 | 45% |
| IrPt(L6A) | Ir(L6A) | 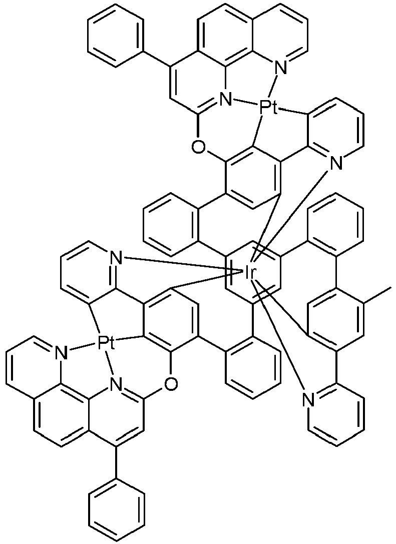 | 31% |
| IrPt(L7A) | Ir(L7A) | 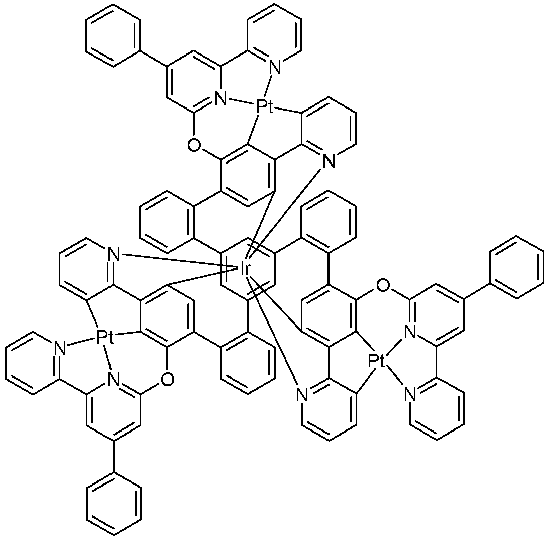 | 22% |
| IrPt(L8A) | Ir(L8A) | 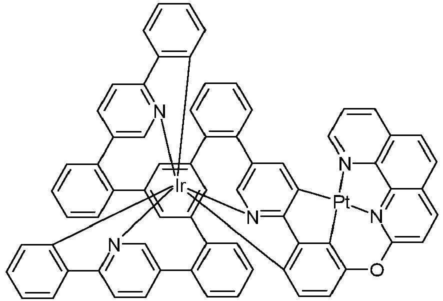 | 51$ |
| IrPt(L1F) | Ir(L1F) | 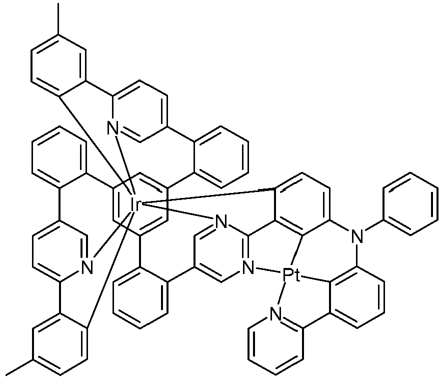 | 61% |
| IrPt(L1G) | Ir(L1G) | 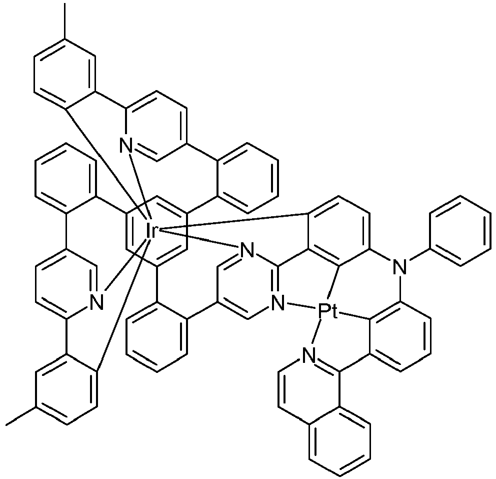 | 57% |
| IrPt(L1H) | Ir(L1H) | 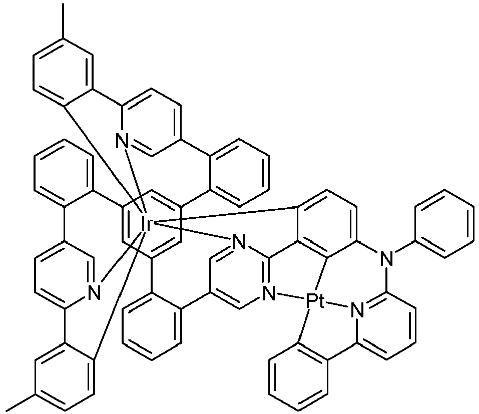 | 54% |
| IrPt(L4B) | Ir(L4B) | 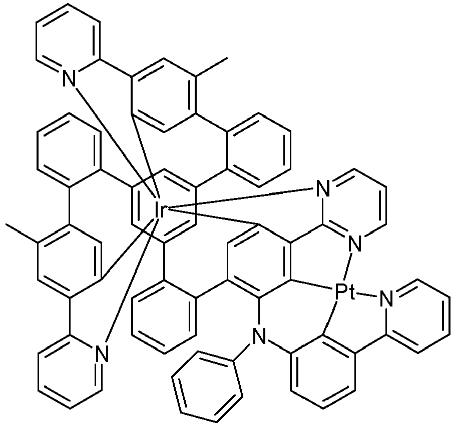 | 41% |

### Beispiel: Herstellung der OLEDs

### 1) Vakuum-prozessierte Devices:

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen werden die Ergebnisse verschiedener OLEDs vorgestellt. Gereinigte Glasplättchen (Reinigung in Miele Laborspülmaschine, Reiniger Merck Extran), die mit strukturiertem ITO (Indium Zinn Oxid) der Dicke 50 nm beschichtet sind, werden 25 Minuten mit UV-Ozon vorbehandelt (UV-Ozon Generator PR-100, Firma UVP), innerhalb 30 min. zur verbesserten Prozessierung mit 20 nm PEDOT:PSS beschichtet (Poly-(3,4-ethylendioxythiophen)poly(styrolsulfonat), bezogen als CLEVIOS^{™} P VP AI 4083 von Heraeus Precious Metals GmbH Deutschland, aus wässriger Lösung aufgeschleudert) und anschließend bei 180 °C 10 min. lang ausgeheizt. Diese beschichteten Glasplättchen bilden die Substrate, auf welche die OLEDs aufgebracht werden. Die OLEDs haben prinzipiell folgenden Schichtaufbau: Substrat / Lochinjektionsschicht 1 (HIL1) bestehend aus HTM1 dotiert mit 5 % NDP-9 (kommerziell erhältlich von der Fa. Novaled), 20 nm / Lochtransportschicht 1 (HTL1) bestehend aus HTM1, 150 nm / Lochtransportschicht 2 (HTL2) / Emissionsschicht (EML) / Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet.

Zunächst werden vakuum-prozessierte OLEDs beschrieben. Hierfür werden alle Materialien in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Co-Verdampfung in einem bestimmten Volumenanteil beigemischt wird. Eine Angabe wie M1:M2:IrPt(L) (55%:35%:10%) bedeutet hierbei, dass das Material M1 in einem Volumenanteil von 55%, M2 in einem Volumenanteil von 35% und IrPt(L) in einem Volumenanteil von 10% in der Schicht vorliegt. Analog kann auch die Elektronentransportschicht aus einer Mischung zweier Materialien bestehen. Der genaue Aufbau der OLEDs ist Tabelle 1 zu entnehmen. Die zur Herstellung der OLEDs verwendeten Materialien sind in Tabelle 4 gezeigt.

Die OLEDs werden standardmäßig charakterisiert. Hierfür werden die Elektrolumineszenzspektren, die Stromeffizienz (gemessen in cd/A), die Leistungseffizienz (gemessen in Im/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik, sowie die Lebensdauer bestimmt. Die Elektrolumineszenzspektren werden bei einer Leuchtdichte von 1000 cd/m² gemessen.

### Verwendung von erfindungsgemäßen Verbindungen als Emittermaterialien in phosphoreszierenden OLEDs

Die erfindungsgemäßen Verbindungen lassen sich unter anderem als phosphoreszierende Emittermaterialien in der Emissionsschicht in OLEDs einsetzen. Die verwendeten Materialien sind in Tabelle 4 dargestellt. Die Ergebnisse der noch nicht vollständig optimierten OLEDs sind in Tabelle 2 zusammengefasst.

**Tabelle 1: Aufbau der OLEDs**

| **Bsp.** | **HTL2 Dicke** | **EML Dicke** | **HBL Dicke** | **ETL Dicke** |
|---|---|---|---|---|
| D1 | HTM2 10 nm | M1:IrPt(L1A) (95%:5%) 40 nm | ETM1 10nm | ETM1:ETM2 (50%:50%) 60 nm |
| D2 | HTM2 10 nm | M1:M2:IrPt(L1A) (75%:20%:5%) 40 nm | ETM1 10nm | ETM1:ETM2 (50%:50%) 60 nm |
| D3 | HTM2 10 nm | M1:IrPt(L1C) (95%:5%) 40 nm | ETM1 10nm | ETM1:ETM2 (50%:50%) 60 nm |
| D4 | HTM2 10 nm | M1:Irpt(L1E) (95%:5%) 40 nm | ETM1 10nm | ETM1:ETM2 (50%:50%) 60 nm |
| D5 | HTM2 10 nm | M1:IrPt(L4A) (95%:5%) 40 nm | ETM1 10nm | ETM1:ETM2 (50%:50%) 60 nm |
| D6 | HTM2 10 nm | M1:IrPt(L5B) (95%:5%) 40 nm | ETM1 10nm | ETM1:ETM2 (50%:50%) 60 nm |
| D7 | HTM2 10 nm | M1:IrPt(L8A) (90%:10%) 40 nm | ETM1 10nm | ETM1:ETM2 (50%:50%) 60 nm |
| D8 | HTM2 10 nm | M1:Irpt(L1G) (93%:7%) 40 nm | ETM1 10nm | ETM1:ETM2 (50%:50%) 60 nm |

**Tabelle 2: Ergebnisse der Vakuum-prozessierten OLEDs**

| **Bsp.** | **Spannung [V] @ 10 mA/cm²** | **EQE (%) @ 10 mA/cm²** | **Emissionsmaximum [nm]** | **Sichtbare Restemission*** |
|---|---|---|---|---|
| D1 | 4.9 | 3.8 | > 700 nm | schwach |
| D2 | 4.5 | 3.7 | > 700 nm | schwach |
| D3 | 4.8 | 2.1 | > 850 nm | keine |
| D4 | 5.1 | 3.2 | > 800 nm | keine |
| D5 | 5.2 | 3.3 | > 700 nm | schwach |
| D6 | 4.7 | 2.8 | > 750 nm | keine |
| D7 | 4.8 | 2.3 | > 800 nm | keine |
| D8 | 4.6 | 1.7 | > 850 nm | keine |

| | | | | |
|---|---|---|---|---|
| * bei Dunkelheit nach Adaption | | | | |

### Lösungs-prozessierte Devices:

### A: Aus niedermolekularen löslichen Funktionsmaterialien

Die erfindungsgemäßen Iridiumkomplexe können auch aus Lösung verarbeitet werden und führen dort zu prozesstechnisch wesentlich einfacheren OLEDs, im Vergleich zu den vakuumprozessierten OLEDs, mit dennoch guten Eigenschaften. Die Herstellung solcher Bauteile lehnt sich an die Herstellung polymerer Leuchtdioden (PLEDs) an, die in der Literatur bereits vielfach beschrieben ist (z. B. in der WO 2004/037887). Der Aufbau setzt sich zusammen aus Substrat / ITO / Lochinjektionsschicht (130 nm) / Interlayer (20 nm) / Emissionsschicht (60 nm) / Lochblockierschicht (10 nm) / Elektronentransportschicht (50 nm) / Kathode. Dazu werden Substrate der Firma Technoprint (Sodalimeglas) verwendet, auf welche die ITO-Struktur (Indium-Zinn-Oxid, eine transparente, leitfähige Anode) aufgebracht wird. Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum eine 20 nm Lochinjektionsschicht durch Spin-Coating aufgebracht. Die benötigte Spinrate hängt vom Verdünnungsgrad und der spezifischen Spin-Coater-Geometrie ab. Um Restwasser aus der Schicht zu entfernen, werden die Substrate für 30 Minuten bei 200 °C auf einer Heizplatte ausgeheizt. Die verwendete Interlayer dient dem Lochtransport, in diesem Fall wird HL-X von Merck verwendet. Die Interlayer kann alternativ auch durch eine oder mehrere Schichten ersetzt werden, die lediglich die Bedingung erfüllen müssen, durch den nachgelagerten Prozessierungsschritt der EML-Abscheidung aus Lösung nicht wieder abgelöst zu werden. Zur Herstellung der Emissionsschicht werden die erfindungsgemäßen Triplettemitter zusammen mit den Matrixmaterialien in Toluol oder Chlorbenzol gelöst. Der typische Feststoffgehalt solcher Lösungen liegt zwischen 16 und 25 g/L, wenn, wie hier, die für eine Device typische Schichtdicke von 60 nm mittels Spincoating erzielt werden soll. Die lösungsprozessierten Devices vom Typ1 enthalten eine Emissionsschicht aus M1:M3:M4:IrPtL (20%:30%:30%:20%), die vom Typ2 enthalten eine Emissionsschicht aus M3:M4:Ir-Red:IrPtL (30%:34%:28%:8%). Die Emissionsschicht wird in einer Inertgasatmosphäre, im vorliegenden Fall Argon, aufgeschleudert und 10 min bei 160 °C ausgeheizt. Darüber wird die Lochblockierschicht (10 nm ETM1) und die Elektronentransportschicht (50 nm ETM1 (50%) / ETM2 (50%)) aufgedampft (Aufdampfanlagen von Lesker o. a., typischer Aufdampfdruck 5 x 10⁻⁶ mbar). Zuletzt wird eine Kathode aus Aluminium (100 nm) (hochreines Metall von Aldrich) aufgedampft. Um das Device vor Luft und Luftfeuchtigkeit zu schützen, wird die Vorrichtung abschließend verkapselt und dann charakterisiert. Die genannten OLED-Beispiele sind noch nicht optimiert, Tabelle 3 fasst die erhaltenen Daten zusammen.

**Tabelle 3: Ergebnisse mit aus Lösung prozessierten Materialien**

| **Bsp.** | **Emitter Device** | **Spannung [V] @ 10 mA/cm²** | **EQE (%) @ 10 mA/cm²** | **Emissions -maximum [nm]** | **Sichrbare Restemission*** |
|---|---|---|---|---|---|
| DS1 | IrPt(L1B) Typ1 | 5.8 | 2.1 | > 700 | schwach |
| DS2 | IrPt(L1B) Typ2 | 5.5 | 3.6 | > 700 | schwach |
| DS3 | IrPt(L2A) Typ2 | 5.8 | 2.0 | > 850 | keine |
| DS4 | IrPt(L3A) Typ2 | 5.7 | 3.1 | > 750 | schwach |
| DS5 | IrPt(L6A) Typ2 | 5.5 | 2.0 | > 900 | keine |
| DS6 | IrPt(L7A) Typ2 | 5.5 | 1.9 | > 850 | keine |
| DS7 | IrPt(L1G) Typ2 | 5.3 | 1.1 | > 900 | keine |

| | | | | | |
|---|---|---|---|---|---|
| * bei Dunkelheit nach Adaption | | | | | |

**Tabelle 4: Strukturformeln der verwendeten Materialien**

| | |
|---|---|
| 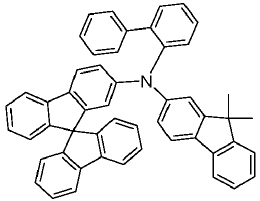 | 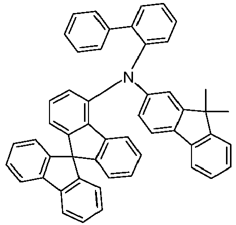 |
| HTM1 | HTM2 |
| [136463-07-5] | [1450933-44-4] |
| 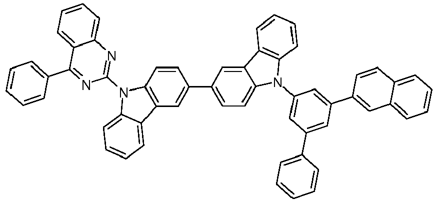 | 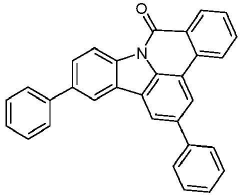 |
| M1 1398399-68-2 | M2 1915695-76-5 |
| 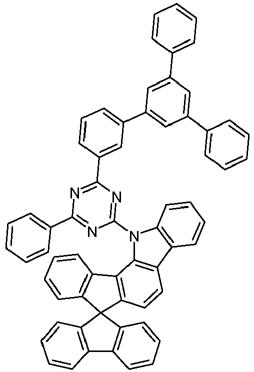 | 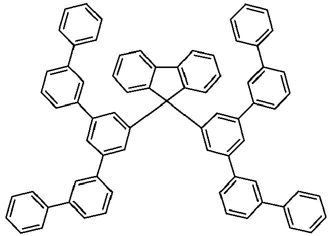 |
| M3 1616231-60-7 | M4 1246496-85-4 |
| 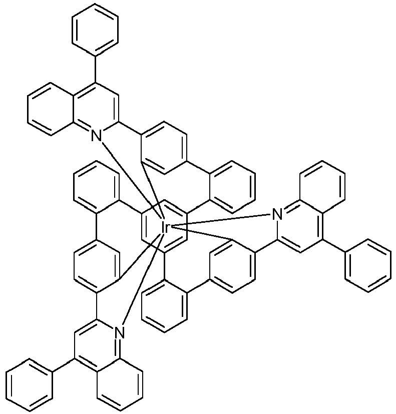 | 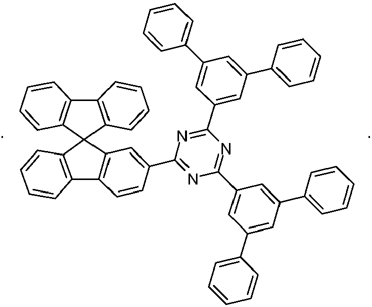 |
| Ir-Red [1989605-98-2] | ETM1 = M10 [1233200-52-6] |
| 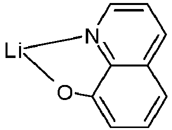 | |
| ETM2 [25387-93-3] | |

## Patentansprüche

1. Verbindung gemäß Formel (1a), (1b), (1c), (1d), (1e) oder (1f), 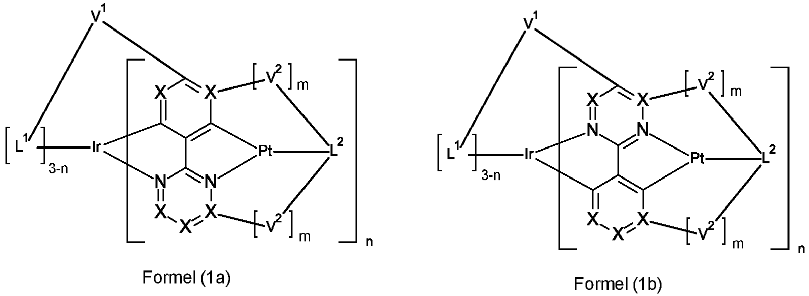 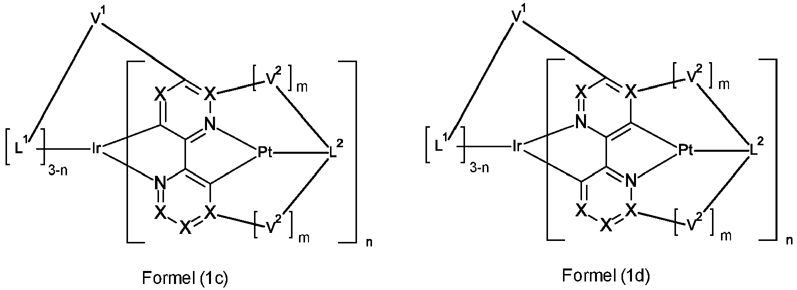 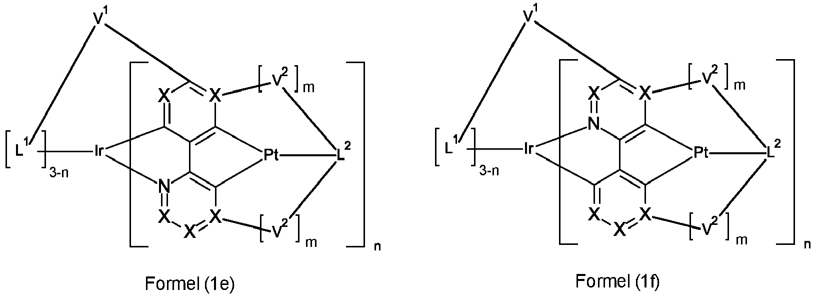 wobei für die verwendeten Symbole und Indizes gilt:
X ist bei jedem Auftreten gleich oder verschieden CR oder N;
L¹, L² ist gleich oder verschieden bei jedem Auftreten ein bidentater Teilligand;
V¹ ist eine trivalente Gruppe, die den bzw. die zentralen Teilliganden, je nach Wahl von n, miteinander und mit L¹ verknüpft;
V² ist eine bivalente Gruppe oder eine Einfachbindung, die den zentralen Teilliganden und L² miteinander verknüpft;
n ist 1, 2 oder 3;
m ist bei jedem Auftreten gleich oder verschieden 0 oder 1, wobei für m = 1 das Atom X, an das die entsprechende Gruppe V² gebunden ist, für C steht; mit der Maßgabe, dass mindestens ein m = 1 ist;
R ist bei jedem Auftreten gleich oder verschieden H, D, F, Cl, Br, I, N(R¹)₂, CN, NO₂, OR¹, SR¹, COOR¹, C(=O)N(R¹)₂, Si(R¹)₃, B(OR¹)₂, C(=O)R¹, P(=O)(R¹)₂, S(=O)R¹, S(=O)₂R¹, OSO₂R¹, eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R¹ substituiert sein kann, wobei eine oder mehrere nicht benachbarte CH₂-Gruppen durch Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substituiert sein kann; dabei können zwei Reste R auch miteinander ein Ringsystem bilden;
R¹ ist bei jedem Auftreten gleich oder verschieden H, D, F, Cl, Br, I, N(R²)₂, CN, NO₂, OR², SR², Si(R²)₃, B(OR²)₂, COOR², C(=O)R², P(=O)(R²)₂, S(=O)R², S(=O)₂R², OSO₂R², eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R² substituiert sein kann, wobei eine oder mehrere nicht benachbarte CH₂-Gruppen durch Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann; dabei können zwei oder mehrere Reste R¹ miteinander ein Ringsystem bilden;
R² ist bei jedem Auftreten gleich oder verschieden H, D, F oder ein aliphatischer, aromatischer oder heteroaromatischer organischer Rest, insbesondere ein Kohlenwasserstoffrest, mit 1 bis 20 C-Atomen, in dem auch ein oder mehrere H-Atome durch F ersetzt sein können.

2. Verbindung nach Anspruch 1 gemäß einer der Formeln (1a-1) bis (1f-1), 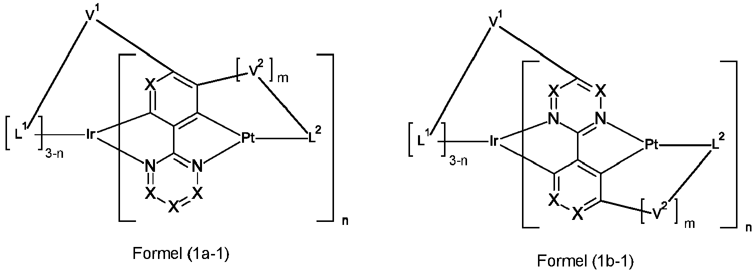 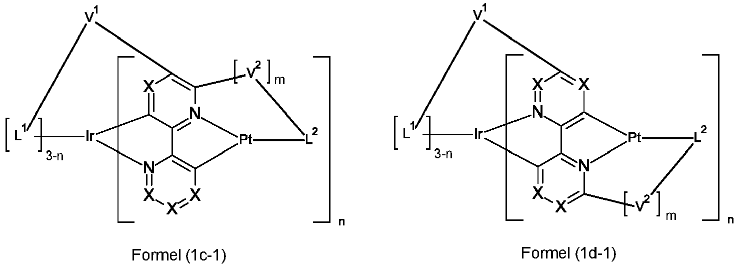 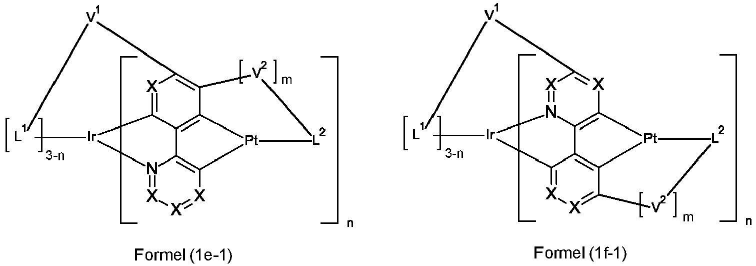 wobei die verwendeten Symbole und Indizes die in Anspruch 1 genannten Bedeutungen aufweisen.

3. Verbindung nach Anspruch 1 oder 2 gemäß einer der Formeln (1a-3) bis (1f-3), 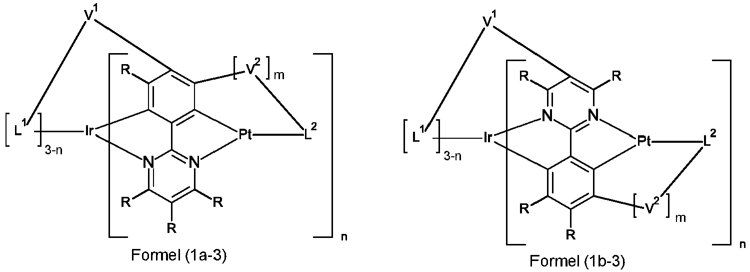 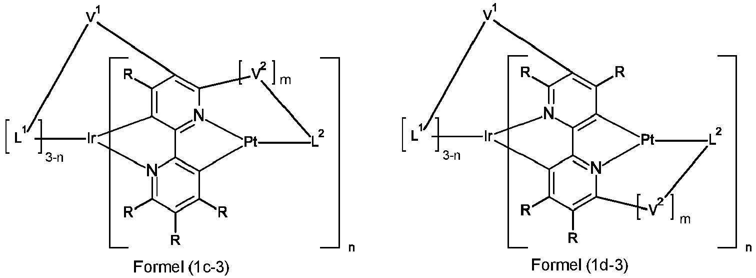 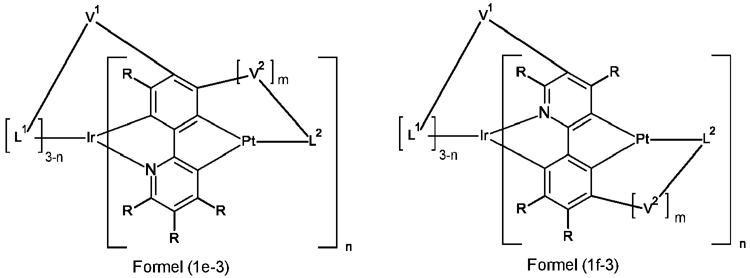 wobei die verwendeten Symbole und Indizes die in Anspruch 1 genannten Bedeutungen aufweisen und die Reste R in ortho-Position zur Koordination an das Metall bei jedem Auftreten gleich oder verschieden ausgewählt sind aus der Gruppe bestehend aus H, D, F, CH₃ und CD₃.

4. Verbindung nach einem oder mehreren der Ansprüche 1 bis 3, **dadurch gekennzeichnet, dass** V¹ ausgewählt ist aus den Gruppen der Formeln (2) oder (3), 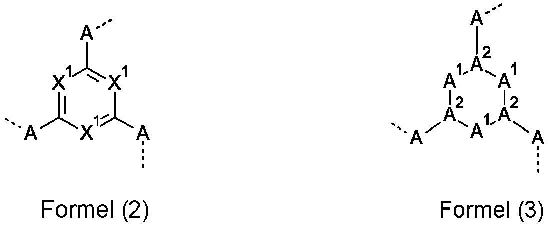 wobei die gestrichelten Bindungen die Bindungen an den zentralen Teilliganden und an den oder die Teilliganden L¹ darstellen, R die in Anspruch 1 genannten Bedeutungen aufweist und für die weiteren verwendeten Symbole gilt:
A ist bei jedem Auftreten gleich oder verschieden -CR=CR-, -C(=O)-NR'-, -C(=O)-O-, -CR₂-CR₂-, -CR₂-O- oder eine Gruppe der folgenden Formel (4), 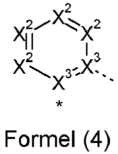
wobei die gestrichelte Bindung die Position der Bindung des zentralen Teilliganden oder eines Teilliganden L¹ an diese Struktur darstellt und * die Position der Verknüpfung der Einheit der Formel (4) mit der zentralen cyclischen Gruppe darstellt, also der Gruppe, die explizit in Formel (2) bzw. (3) aufgeführt ist;
X¹ ist bei jedem Auftreten gleich oder verschieden CR oder N;
X² ist bei jedem Auftreten gleich oder verschieden CR oder N, oder zwei benachbarte Gruppen X² stehen zusammen für NR, O oder S, so dass ein Fünfring entsteht, und die verbleibenden X² stehen gleich oder verschieden bei jedem Auftreten für CR oder N; oder zwei benachbarte Gruppen X² stehen zusammen für CR oder N, wenn in dem Cyclus eine der Gruppen X³ für N steht, so dass ein Fünfring entsteht; mit der Maßgabe, dass maximal zwei benachbarte Gruppen X² für N stehen;
X³ ist bei jedem Auftreten C oder eine Gruppe X³ steht für N und die anderen Gruppen X³ in demselben Cyclus stehen für C; mit der Maßgabe, dass zwei benachbarte Gruppen X² zusammen für CR oder N stehen, wenn in dem Cyclus eine der Gruppen X³ für N steht;
A¹ ist bei jedem Auftreten gleich oder verschieden C(R)₂ oder O;
A² ist bei jedem Auftreten gleich oder verschieden CR, P(=O), B oder SiR, mit der Maßgabe, dass für A² = P(=O), B oder SiR das Symbol A¹ für O steht und das Symbol A, das an dieses A² gebunden ist, nicht für -C(=O)-NR- oder -C(=O)-O- steht;
R' ist bei jedem Auftreten gleich oder verschieden H, D, eine geradkettige Alkylgruppe mit 1 bis 20 C-Atomen oder eine verzweigte oder cyclische Alkylgruppe mit 3 bis 20 C-Atomen, wobei die Alkylgruppe jeweils mit einem oder mehreren Resten R¹ substituiert sein kann und wobei eine oder mehrere nicht benachbarte CH₂-Gruppen durch Si(R¹)₂ ersetzt sein können, oder ein aromatisches oder heteroaromatisches Ringsystem mit 5 bis 40 aromatischen Ringatomen, das jeweils durch einen oder mehrere Reste R¹ substituiert sein kann.

5. Verbindung nach Anspruch 4, **dadurch gekennzeichnet, dass** die Gruppe der Formel (2) gewählt ist aus der Struktur der Formel (5') und die Gruppe der Formel (3) gewählt ist aus den Strukturen der Formel (9') oder (9"), 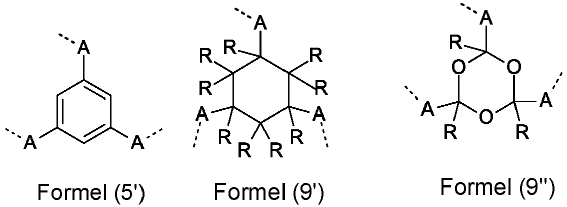 wobei die Symbole die in Anspruch 1 und 4 genannten Bedeutungen aufweisen.

6. Verbindung nach Anspruch 4 oder 5, **dadurch gekennzeichnet, dass** die Gruppen der Formel (4) gleich oder verschieden bei jedem Auftreten ausgewählt sind aus den Strukturen der Formeln (14) bis (38), 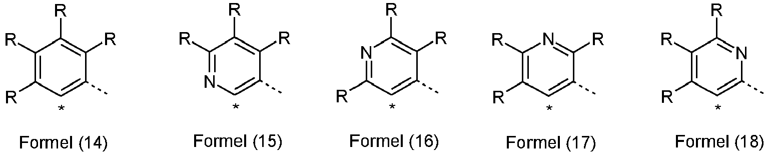 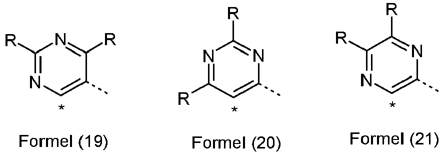 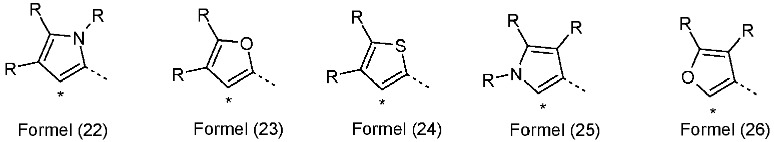 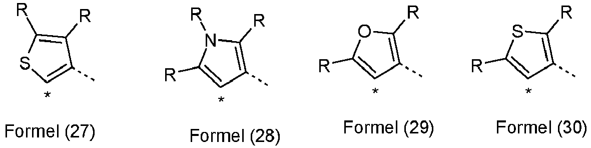 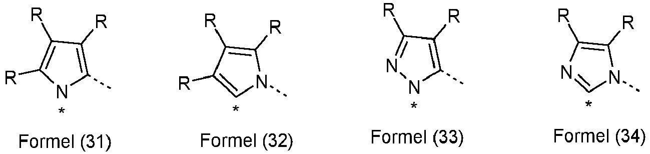 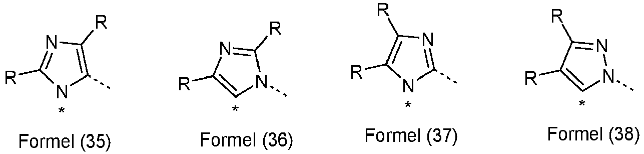 wobei die Symbole die in Anspruch 1 und 4 genannten Bedeutungen aufweisen.

7. Verbindung nach einem oder mehreren der Ansprüche 4 bis 6, **dadurch gekennzeichnet, dass** die Gruppe der Formel (2) gewählt ist aus den Strukturen der Formel (5a"), 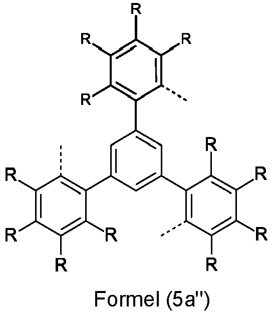 wobei die Symbole die in Anspruch 1 und 8 genannten Bedeutungen aufweisen.

8. Verbindung nach einem oder mehreren der Ansprüche 1 bis 3, **dadurch gekennzeichnet, dass** V¹ sind eine Struktur gemäß Formel (V¹-a) aufweist, 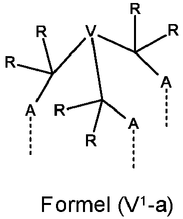 wobei R und A die in Anspruch 1 und 4 genannten Bedeutungen aufweisen und V für CR, N, SiR, P oder P=O steht.

9. Verbindung nach einem oder mehreren der Ansprüche 1 bis 8, **dadurch gekennzeichnet, dass** V² ausgewählt ist aus der Gruppe bestehend aus CR₂, NR, O, S, Se, -CR₂-CR₂-, -CR₂-O-, -CR=CR- oder einer orthoverknüpften Arylen- oder Heteroarylengruppe mit 5 oder 6 aromatischen Ringatomen, welche durch einen oder mehrere Reste R substituiert sein kann.

10. Verbindung nach einem oder mehreren der Ansprüche 1 bis 9, **dadurch gekennzeichnet, dass** einer oder beide Teilliganden L¹ und/oder der Teilligand L² gleich oder verschieden bei jedem Auftreten ausgewählt sind aus den Strukturen der Formeln (L-1), (L-2) oder (L-3), 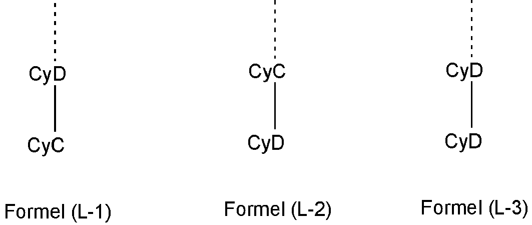 wobei die gestrichelte Bindung die Bindung des Teilliganden L¹ an V¹ bzw. die Bindung des Teilliganden L² an V² darstellt und für die weiteren Symbole gilt:
CyC ist gleich oder verschieden bei jedem Auftreten eine substituierte
oder unsubstituierte Aryl- oder Heteroarylgruppe mit 5 bis 14 aromatischen Ringatomen, welche über ein Kohlenstoffatom an M koordiniert und welche über eine kovalente Bindung mit CyD verbunden ist;
CyD ist gleich oder verschieden bei jedem Auftreten eine substituierte
oder unsubstituierte Heteroarylgruppe mit 5 bis 14 aromatischen Ringatomen, welche über ein Stickstoffatom oder über ein Carben-Kohlenstoffatom an M koordiniert und welche über eine kovalente Bindung mit CyC verbunden ist;
dabei können mehrere der optionalen Substituenten miteinander ein Ringsystem bilden.

11. Verbindung nach einem oder mehreren der Ansprüche 1 bis 10, **dadurch gekennzeichnet, dass** einer oder mehrere der Teilliganden L¹ und/oder L² gleich oder verschieden bei jedem Auftreten eine Struktur der Formel (L-1-1), (L-1-2) oder (L-2-1) bis (L-2-3) aufweisen, 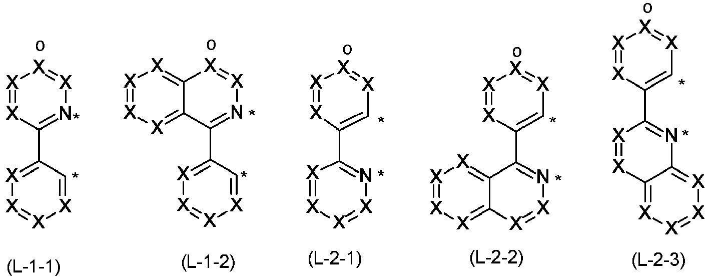 wobei die Symbole die in Anspruch 1 genannten Bedeutungen aufweisen, * die Position der Koordination an das Ir bzw. das Pt andeutet und "o" die Position der Bindung an V¹ darstellt, falls es sich bei den Strukturen um eine Ausführungsform von L¹ handelt; falls es sich bei den Strukturen um eine Ausführungsform von L² handelt, ist V² in einer Position ortho zur Koordination an das Pt gebunden, dabei steht das Symbol X, an das V¹ bzw. V² gebunden ist, für C.

12. Verfahren zur Herstellung einer Verbindung nach einem oder mehreren der Ansprüche 1 bis 11, **gekennzeichnet durch** die folgenden Verfahrensschritte:
a) Synthese eines hexadentaten Liganden, der die Gruppe L²-V² noch nicht enthält;
b) Synthese eines Ir-Komplexes aus dem hexadentaten Liganden;
c) Funktionalisierung des Ir-Komplexes;
d) Einführung der Gruppe L²-V² durch eine Kupplungsreaktion; und
e) Synthese des Pt-Komplexes.

13. Formulierung, enthaltend mindestens eine Verbindung nach einem oder mehreren der Ansprüche 1 bis 11 und mindestens eine weitere Verbindung, insbesondere mindestens ein Lösemittel oder ein Matrixmaterial.

14. Verwendung einer Verbindung nach einem oder mehreren der Ansprüche 1 bis 11 in einer elektronischen Vorrichtung oder als Sauerstoff-Sensibilisator oder als Photokatalysator.

15. Elektronische Vorrichtung enthaltend mindestens eine Verbindung nach einem oder mehreren der Ansprüche 1 bis 11.

16. Elektronische Vorrichtung nach Anspruch 15, wobei es sich um eine organische Elektrolumineszenzvorrichtung handelt, **dadurch gekennzeichnet, dass** die Verbindung als emittierende Verbindung in einer oder mehreren emittierenden Schichten eingesetzt wird.

## Claims

1. Compound of formula (1a), (1b), (1c), (1d), (1e) or (1f) 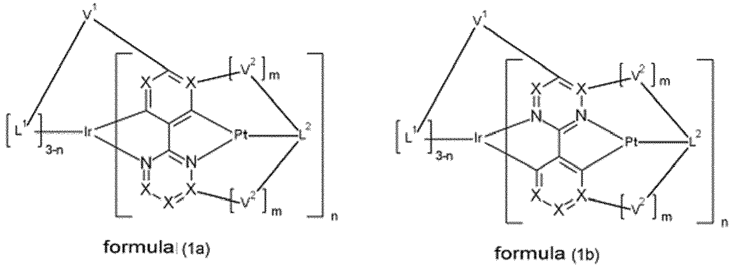 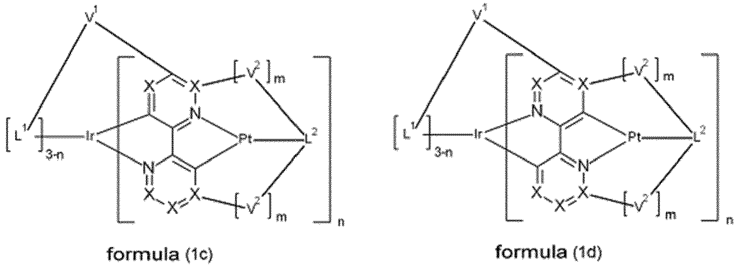 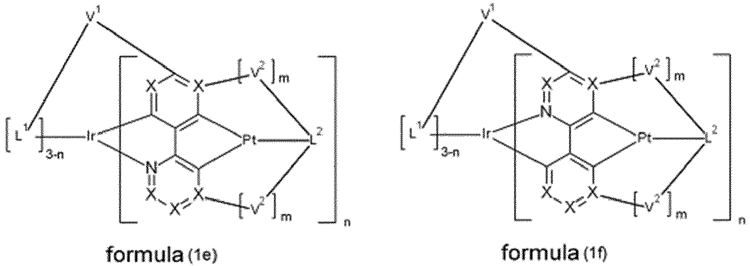 where the symbols and indices used are as follows:
X is the same or different at each instance and is CR or N;
L¹, L² is the same or different at each instance and is a bidentate sub-ligand;
V¹ is a trivalent group that joins the central subligand(s), according to the choice of n, to one another and to L¹;
V² is a bivalent group or a single bond that joins the central sub-ligand and L² to one another;
n is 1, 2 or 3;
m is the same or different at each instance and is 0 or 1, where, when m = 1, the atom X to which the corresponding V² group is bonded is C, with the proviso that at least one m = 1;
R is the same or different at each instance and is H, D, F, Cl, Br, I, N(R¹)₂, CN, NO₂, OR¹, SR¹, COOR¹, C(=O)N(R¹)₂, Si(R¹)₃, B(OR¹)₂, C(=O)R¹, P(=O)(R¹)₂, S(=O)R¹, S(=O)₂R¹, OSO₂R¹, a straightchain alkyl group having 1 to 20 carbon atoms or an alkenyl or alkynyl group having 2 to 20 carbon atoms or a branched or cyclic alkyl group having 3 to 20 carbon atoms, where the alkyl, alkenyl or alkynyl group may in each case be substituted by one or more R¹ radicals, where one or more nonadjacent CH₂ groups may be replaced by Si(R¹)₂, C=O, NR¹, O, S or CONR¹, or an aromatic or heteroaromatic ring system which has 5 to 40 aromatic ring atoms and may be substituted in each case by one or more R¹ radicals; at the same time, two R radicals together may also form a ring system;
R¹ is the same or different at each instance and is H, D, F, Cl, Br, I, N(R²)₂, CN, NO₂, OR², SR², Si(R²)₃, B(OR²)₂, COOR², C(=O)R², P(=O)(R²)₂, S(=O)R², S(=O)₂R², OSO₂R², a straight-chain alkyl group having 1 to 20 carbon atoms or an alkenyl or alkynyl group having 2 to 20 carbon atoms or a branched or cyclic alkyl group having 3 to 20 carbon atoms, where the alkyl, alkenyl or alkynyl group may in each case be substituted by one or more R² radicals, where one or more nonadjacent CH₂ groups may be replaced by Si(R²)₂, C=O, NR², O, S or CONR², or an aromatic or heteroaromatic ring system which has 5 to 40 aromatic ring atoms and may be substituted in each case by one or more R² radicals; at the same time, two or more R¹ radicals together may form a ring system;
R² is the same or different at each instance and is H, D, F or an aliphatic, aromatic or heteroaromatic organic radical, especially a hydrocarbyl radical, having 1 to 20 carbon atoms, in which one or more hydrogen atoms may also be replaced by F.

2. Compound according to Claim 1 of one of the formulae (1a-1) to (1f-1) 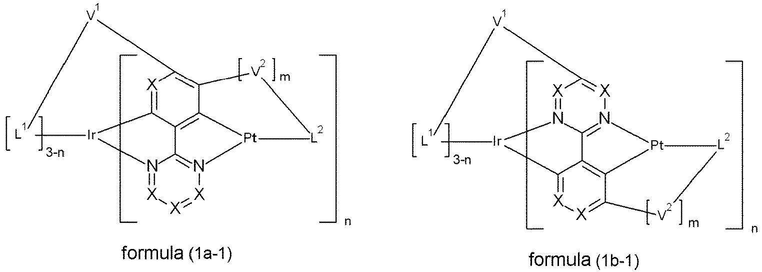 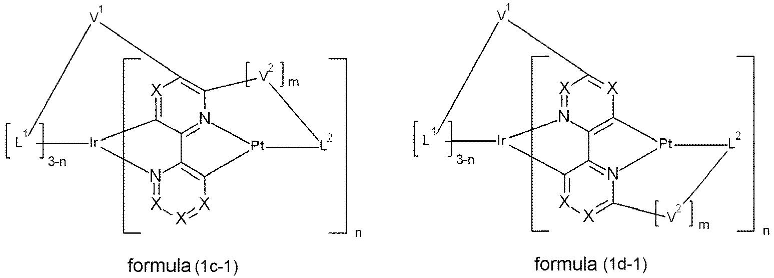 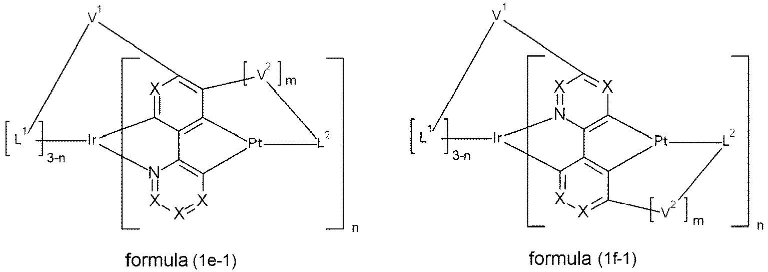 where the symbols and indices used have the definitions given in Claim 1.

3. Compound according to Claim 1 or 2 of one of the formulae (1a-3) to (1f-3) 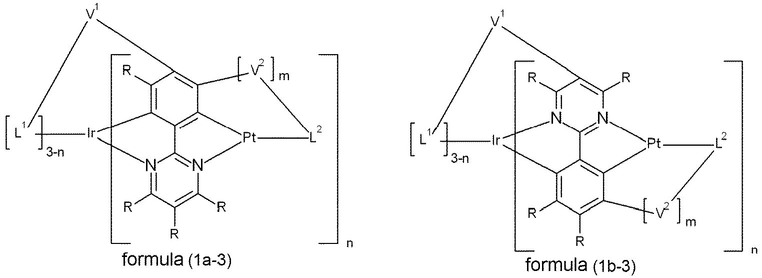 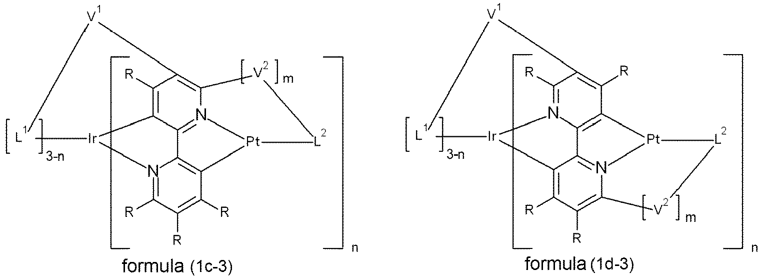 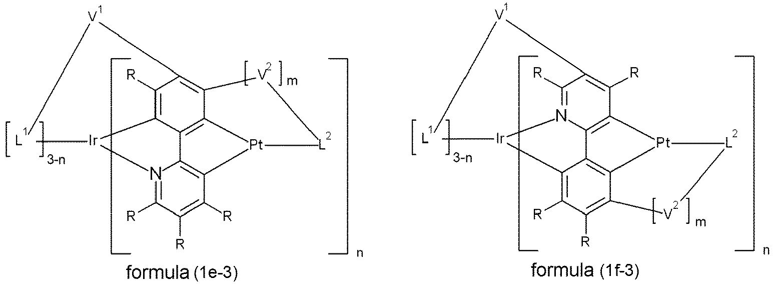 where the symbols and indices used have the definitions given in Claim 1 and the R radicals in the ortho position to the coordination to the metal are the same or different at each instance and are selected from the group consisting of H, D, F, CH₃ and CD₃.

4. Compound according to one or more of Claims 1 to 3, **characterized in that** V¹ is selected from the groups of the formulae (2) and (3) 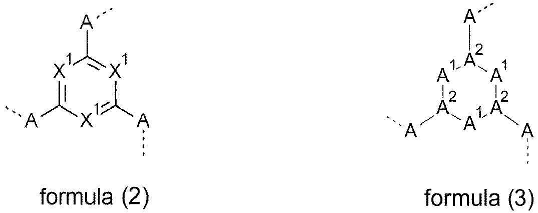 where the dotted bonds represent the bonds to the central sub-ligand or to the sub-ligand(s) L¹, R has the definitions given in Claim 1 and the other symbols used are as follows:
A is the same or different at each instance and is -CR=CR-, -C(=O)-NR'-, -C(=O)-O-, -CR₂-CR₂-, -CR₂-O- or a group of the following formula (4): 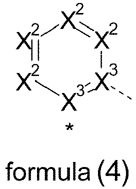
where the dotted bond represents the position of the bond of the central sub-ligand or of a sub-ligand L¹ to this structure and * represents the position of the linkage of the unit of the formula (4) to the central cyclic group, i.e. the group explicitly included in formula (2) or (3);
X¹ is the same or different at each instance and is CR or N;
X² is the same or different at each instance and is CR or N, or two adjacent X² groups together are NR, O or S, thus forming a five-membered ring, and the remaining X² are the same or different at each instance and are CR or N; or two adjacent X² groups together are CR or N when one of the X³ groups in the cycle is N, thus forming a five-membered ring; with the proviso that not more than two adjacent X² groups are N;
X³ is C at each instance or one X³ group is N and the other X³ groups in the same cycle are C; with the proviso that two adjacent X² groups together are CR or N when one of the X³ groups in the cycle is N;
A¹ is the same or different at each instance and is C(R)₂ or O;
A² is the same or different at each instance and is CR, P(=O), B or SiR, with the proviso that, when A² = P(=O), B or SiR, the symbol A¹ is O and the symbol A bonded to this A² is not -C(=O)-NR'- or -C(=O)-O-;
R' is the same or different at each instance and is H, D, a straight-chain alkyl group having 1 to 20 carbon atoms or a branched or cyclic alkyl group having 3 to 20 carbon atoms, where the alkyl group in each case may be substituted by one or more R¹ radicals and where one or more nonadjacent CH₂ groups may be replaced by Si(R¹)₂, or an aromatic or heteroaromatic ring system which has 5 to 40 aromatic ring atoms and may be substituted in each case by one or more R¹ radicals.

5. Compound according to Claim 4, **characterized in that** the group of the formula (2) is selected from the structure of the formula (5') and the group of the formula (3) is selected from the structures of the formula (9') or (9") 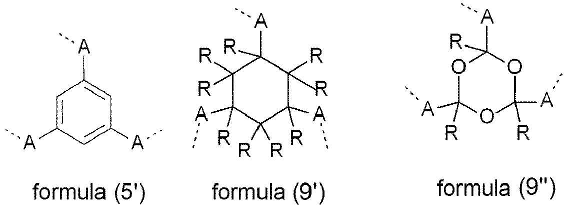 where the symbols have the definitions given in Claims 1 and 4.

6. Compound according to Claim 4 or 5, **characterized in that** the groups of the formula (4) are the same or different at each instance and are selected from the structures of the formulae (14) to (38): 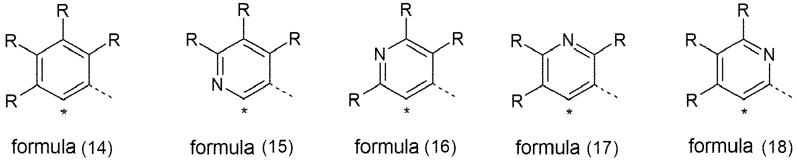 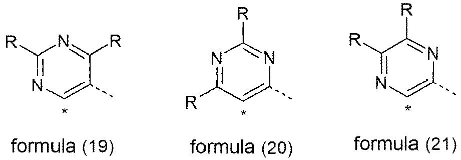 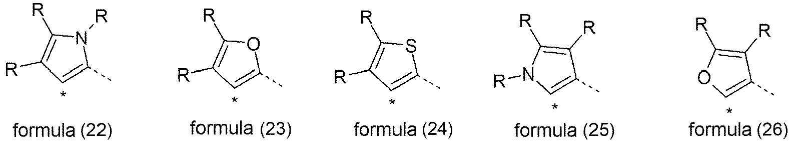 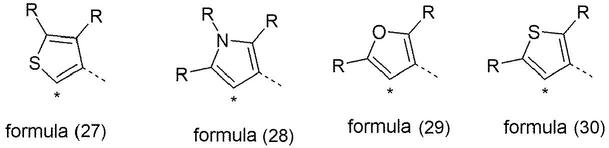 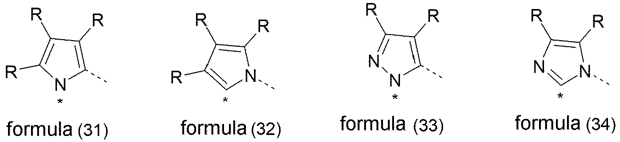 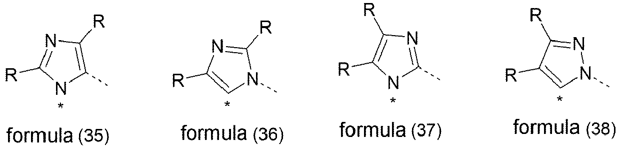 where the symbols have the definitions given in Claims 1 and 4.

7. Compound according to one or more of Claims 4 to 6, **characterized in that** the group of the formula (2) is selected from the structures of the formula (5a"): 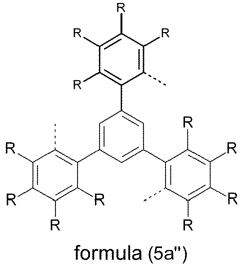 where the symbols have the definitions given in Claims 1 and 8.

8. Compound according to one or more of Claims 1 to 3, **characterized in that** V¹ are a structure of formula (V¹-a) 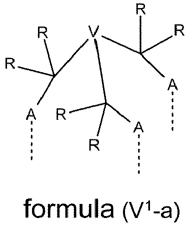 where R and A have the definitions given in Claims 1 and 4 and V is CR, N, SiR, P or P=O.

9. Compound according to one or more of Claims 1 to 8, **characterized in that** V² is selected from the group consisting of CR₂, NR, O, S, Se, -CR₂-CR₂-, -CR₂-O-, -CR=CR- or an ortho-bonded arylene or heteroarylene group which has 5 or 6 aromatic ring atoms and may be substituted by one or more R radicals.

10. Compound according to one or more of Claims 1 to 9, **characterized in that** one or both of sub-ligands L¹ and/or sub-ligand L² are the same or different at each instance and are selected from the structures of the formulae (L-1), (L-2) and (L-3) 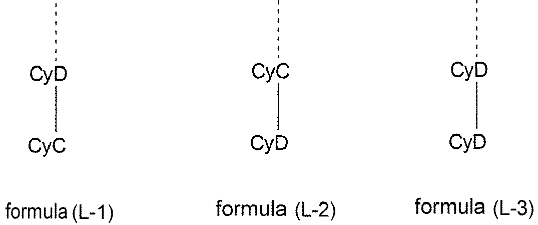 where the dotted bond represents the bond of the sub-ligand L¹ to V¹ or the bond of the sub-ligand L² to V² and the other symbols are as follows:
CyC is the same or different at each instance and is a substituted or unsubstituted aryl or heteroaryl group which has 5 to 14 aromatic ring atoms and coordinates to M via a carbon atom and is bonded to CyD via a covalent bond;
CyD is the same or different at each instance and is a substituted or unsubstituted heteroaryl group which has 5 to 14 aromatic ring atoms and coordinates to M via a nitrogen atom or via a carbene carbon atom and is bonded to CyC via a covalent bond;
at the same time, two or more of the optional substituents together may form a ring system.

11. Compound according to one or more of Claims 1 to 10, **characterized in that** one or more of sub-ligands L¹ and/or L² are the same or different at each instance and have a structure of the formula (L-1-1), (L-1-2) or (L-2-1) to (L-2-3) 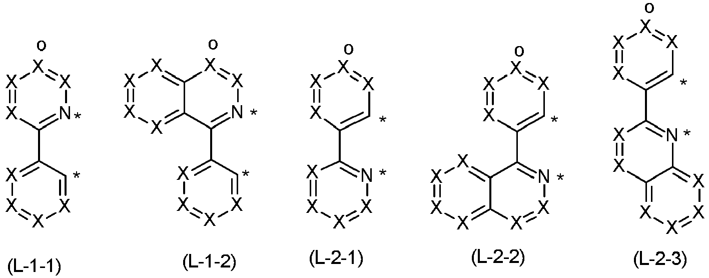 where the symbols have the definitions given in Claim 1, * indicates the position of coordination to the Ir or the Pt and "o" represents the position of the bond to V¹ if the structures are an embodiment of L¹; if the structures are an embodiment of L², V² is bonded in a position ortho to the coordination to the Pt; at the same time, the symbol X to which V¹ or V² is bonded is C.

12. Process for preparing a compound according to one or more of Claims 1 to 11, **characterized by** the following process steps:
a) synthesis of a hexadentate ligand that does not yet contain the L²-V² group;
b) synthesis of an Ir complex from the hexadentate ligand;
c) functionalization of the Ir complex;
d) introduction of the L²-V² group by a coupling reaction; and
e) synthesis of the Pt complex.

13. Formulation comprising at least one compound according to one or more of Claims 1 to 11 and at least one further compound, especially at least one solvent or a matrix material.

14. Use of a compound according to one or more of Claims 1 to 11 in an electronic device or as oxygen sensitizer or as photocatalyst.

15. Electronic device comprising at least one compound according to one or more of Claims 1 to 11.

16. Electronic device according to Claim 15 which is an organic electroluminescent device, **characterized in that** the compound is used as emitting compound in one or more emitting layers.

## Revendications

1. Composé de formule (1a), (1b), (1e), (1d), (1e) ou (1f), 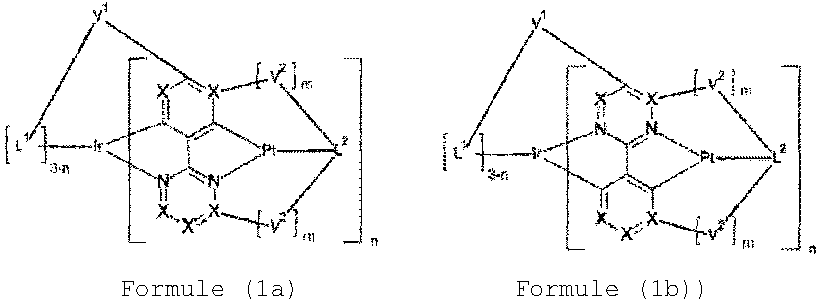 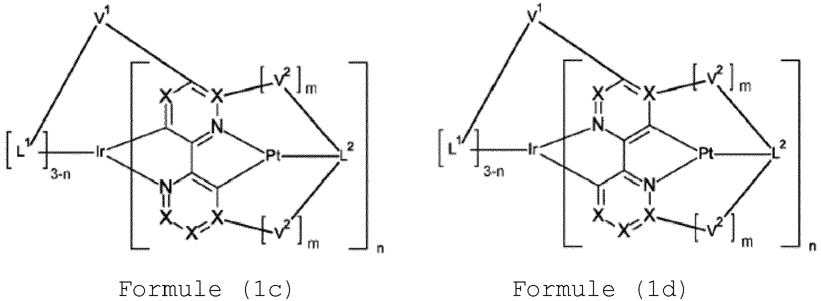 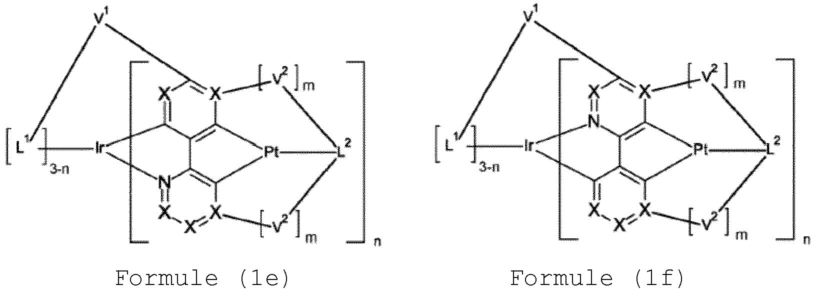 dans lesquelles, pour les symboles et indices utilisés :
X à chaque occurrence, est identique ou différent et représente CR ou N ;
L¹ L² à chaque occurrence, sont identiques ou différents, représentent un ligand partiel bidenté ;
V¹ représente un groupe trivalent, qui relie le ou les ligands partiels centraux, selon le choix de n, les uns avec les autres et avec L¹ ;
V² représente un groupe bivalent ou une simple liaison, qui relie les ligands partiels centraux et L² les uns avec l'autre ;
n représente 1, 2 ou 3 ;
m à chaque occurrence, est identique ou différent et représente 0 ou 1, l'atome X auquel le groupe correspondant V² est lié représentant C quand m = 1 ; à la condition qu'au moins un m = 1 ;
R à chaque occurrence, est identique ou différent et représente H, D, F, Cl, Br, I, N(R¹)₂, CN, NO₂, OR¹, SR¹, COOR¹, C(=O)N(R¹)₂, Si(R¹)₃, B(OR¹)₂, C(=O)R¹, P(=O)(R¹)₂, S(=O)R¹, S(=O)₂R¹, OSO₂R¹, un groupe alkyle à chaîne droite ayant 1 à 20 atomes de carbone ou un groupe alcényle ou alcynyle ayant 2 à 20 atomes de carbone ou un groupe alkyle ramifié ou cyclique ayant 3 à 20 atomes de carbone, le groupe alkyle, alcényle ou alcynyle pouvant chacun être substitué par un ou plusieurs radicaux R¹, un ou plusieurs groupes CH₂ non voisins pouvant être remplacés par Si(R¹)₂, C=O, NR¹, O, S ou CONR¹, ou un système cyclique aromatique ou hétéroaromatique ayant 5 à 40 atomes nucléaires aromatiques, qui peuvent chacun être substitués par un ou plusieurs radicaux R¹ ; les deux radicaux R pouvant alors aussi former l'un avec l'autre un système cyclique ;
R¹ à chaque occurrence, est identique ou différent et représente H, D, F, Cl, Br, I, N(R²)₂, CN, NO₂, OR², SR², Si(R²)₃, B(OR²)₂, COOR², C(=O)R², P(=O)(R²)₂, S(=O)R², S (=O)₂R², OSO₂R², un groupe alkyle à chaîne droite ayant 1 à 20 atomes de carbone ou un groupe alcényle ou alcynyle ayant 2 à 20 atomes de carbone ou un groupe alkyle ramifié ou cyclique ayant 3 à 20 atomes de carbone, le groupe alkyle, alcényle ou alcynyle pouvant chacun être substitué par un ou plusieurs radicaux R², un ou plusieurs groupes CH₂ non voisins pouvant être remplacés par Si(R²)₂, C=O, NR², O, S ou CONR², ou un système cyclique aromatique ou hétéroaromatique ayant 5 à 40 atomes nucléaires aromatiques, qui chacun peuvent être substitués par un ou plusieurs radicaux R² ; deux ou plusieurs radicaux R¹ peuvent alors former les uns avec les autres un système cyclique ;
R² à chaque occurrence, est identique ou différent et représente H, D, F ou un radical organique aliphatique, aromatique ou hétéroaromatique, en particulier un radical hydrocarboné ayant 1 à 20 atomes de carbone, dans lequel aussi un ou plusieurs atomes H peuvent être remplacés par F.

2. Composés selon la revendication 1 ayant l'une des formules (1a-1) à (1f-1), 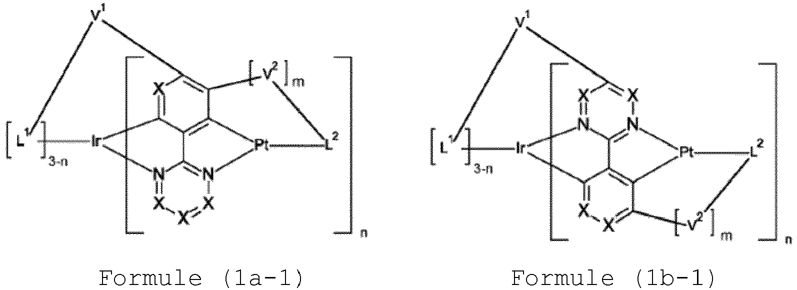 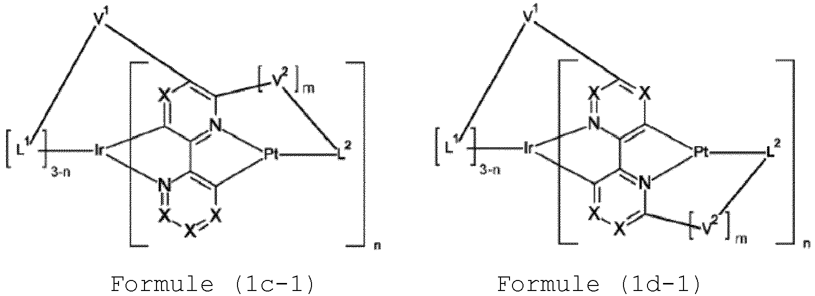 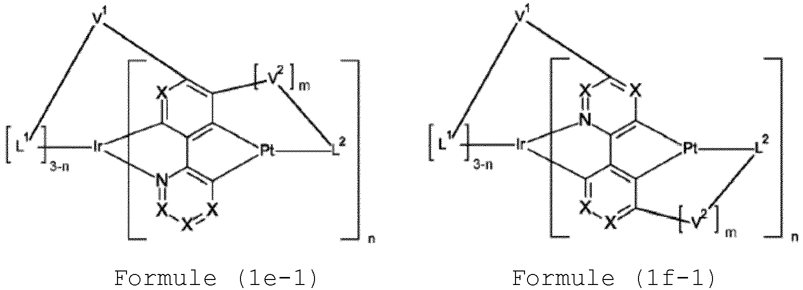 dans lesquelles les symboles et indices utilisés présentent les significations données dans la revendication 1.

3. Composé selon la revendication 1 ou 2 ayant l'une des formules (1a-3) à (1f-3), 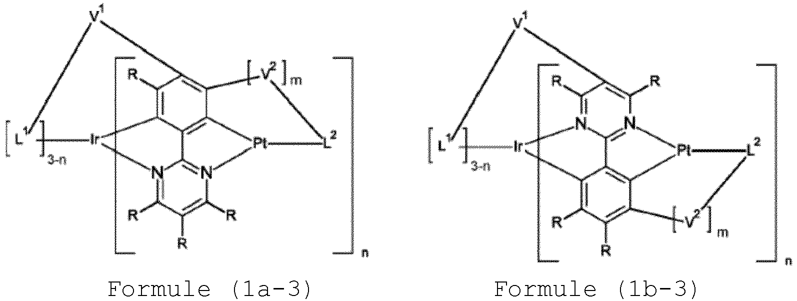 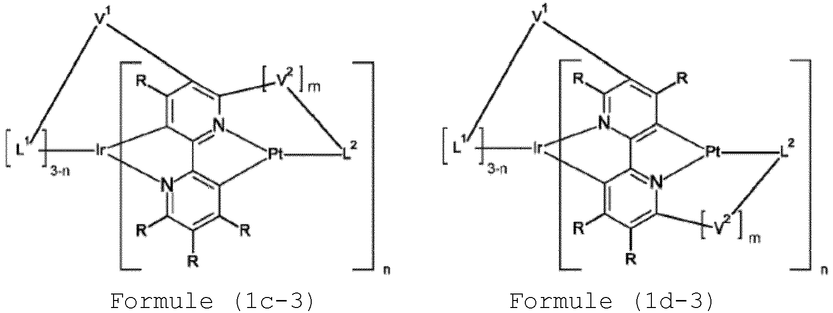 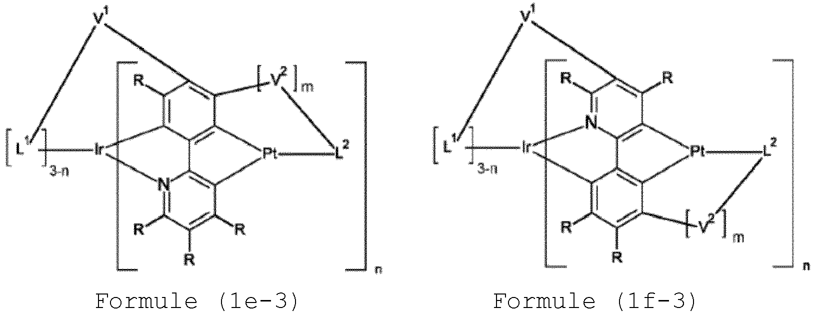 dans lesquelles les symboles et indices utilisés ont les significations données dans la revendication 1 et les radicaux R, à chaque occurrence identiques ou différents, en position ortho pour coordination au métal, sont choisis dans le groupe consistant en H, D, F, CH₃ et CD₃.

4. Composé selon l'une ou plusieurs des revendications 1 à 3, **caractérisé en ce que** V¹ est choisi dans les groupes de formules (2) ou (3), 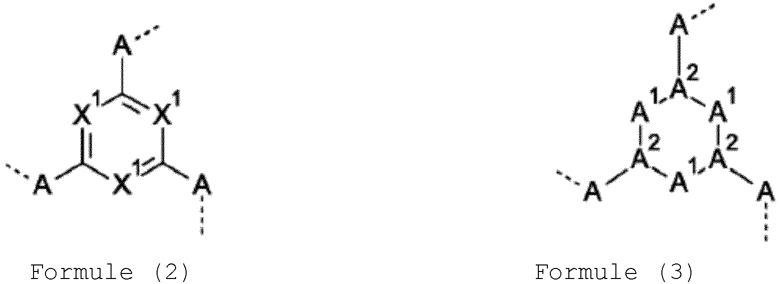 dans lesquelles les liaisons en tirets représentent les liaisons aux ligands partiels centraux ou aux ligands partiels L¹, R a les significations données dans la revendication 1 et, pour les autres symboles utilisés :
A à chaque occurrence, est identique ou différent et représente -CR=CR-, -C(=O)-NR'-, -C(=O)-O-, -CR₂-CR₂-, -CR₂-O- ou un groupe ayant la formule (4) ci-après, 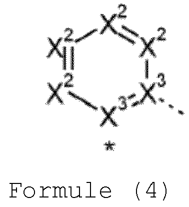
dans laquelle la liaison en tirets représente la position de la liaison du ligand partiel central ou d'un ligand partiel L¹ à cette structure et * représente la position de la liaison du motif de formule (4) avec le groupe cyclique central, c'est-à-dire le groupe qui est présenté explicitement dans la formule (2) ou (3) ;
X¹ à chaque occurrence, est identique ou différent et représente CR ou N ;
X² à chaque occurrence, est identique ou différent et représente CR ou N, ou deux groupes voisins X² représentent ensemble NR, O ou S, de façon qu'il se crée un cycle à cinq chaînons, et les X² restants sont identiques ou différents et, à chaque occurrence, représentent CR ou N ; ou deux groupes voisins X² représentent ensemble CR ou N, quand dans le cycle l'un des groupes X³ représente N, de sorte qu'il se crée un cycle à cinq chaînons ; à la condition qu'au maximum, deux groupes voisins X² représentent N ;
X³ à chaque occurrence, représente C, ou un groupe X³ représente N et les autres groupes X³ du même cycle représentent C ; à la condition que deux groupes voisins X² représentent ensemble CR ou N quand dans le cycle l'un des groupes X³ représente N ;
A¹ à chaque occurrence, est identique ou différent et représente C(R)₂ ou O ;
A² à chaque occurrence, est identique ou différent et représente CR, P(=O), B ou SiR, à la condition que, pour A² = P(=0), B ou SiR, le symbole A¹ représente O et le symbole A qui est lié à cet A² ne représente pas -C(=O)-NR'- ou -C(=O)-O- ;
R' à chaque occurrence, est identique ou différent et représente H, D, un groupe alkyle à chaîne droite ayant 1 à 20 atomes de carbone ou un groupe alkyle ramifié ou cyclique ayant 3 à 20 atomes de carbone, chaque groupe alkyle pouvant être substitué par un ou plusieurs radicaux R¹, et un ou plusieurs groupes CH₂ non voisins pouvant être remplacés par Si(R¹)₂, ou un système cyclique aromatique ou hétéroaromatique ayant 5 à 40 atomes nucléaires aromatiques, qui chacun peuvent être substitués par un ou plusieurs radicaux R¹.

5. Composé selon la revendication 4, **caractérisé en ce que** le groupe de formule (2) est choisi parmi la structure de formule (5') et le groupe de formule (3) est choisi parmi les structures de formules (9') ou (9"), 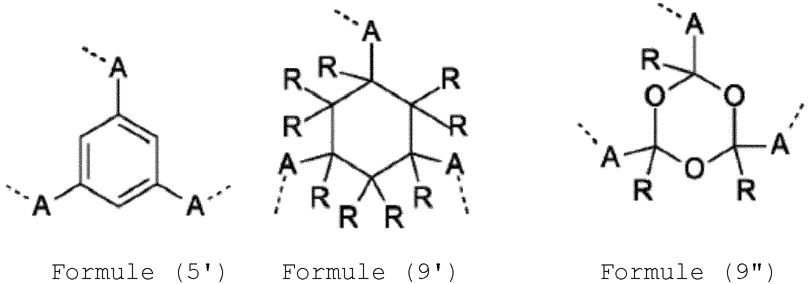 les symboles ayant les significations données dans les revendications 1 et 4.

6. Composé selon la revendication 4 ou 5, **caractérisé en ce que** les groupes de formule (4), identiques ou différents à chaque occurrence, sont choisis parmi les structures de formules (14) à (38), 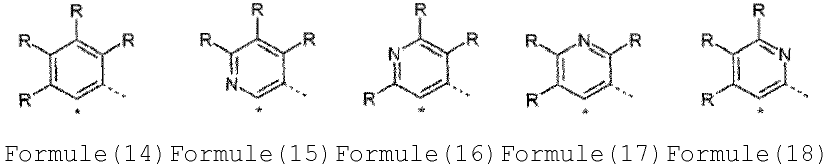 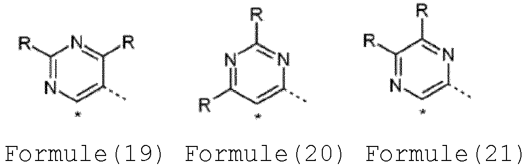 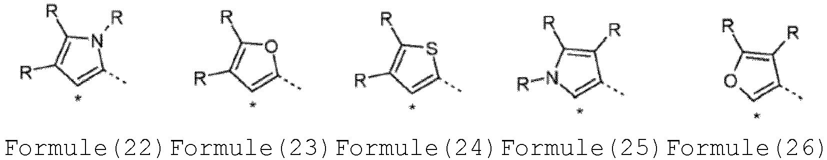 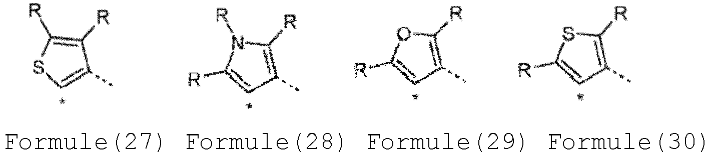 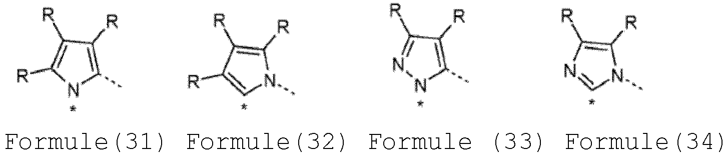 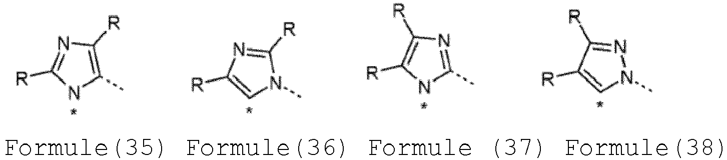 dans lesquelles les symboles ont les significations données dans les revendications 1 et 4.

7. Composé selon l'une ou plusieurs des revendications 4 à 6, **caractérisé en ce que** le groupe de formule (2) est choisi parmi les structures de formule (5a"), 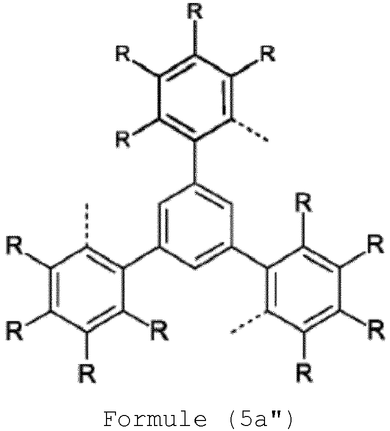 dans laquelle les symboles ont les significations données dans les revendications 1 et 8.

8. Composé selon l'une ou plusieurs des revendications 1 à 3, **caractérisé en ce que** V¹ présente une structure de formule (V¹-a), 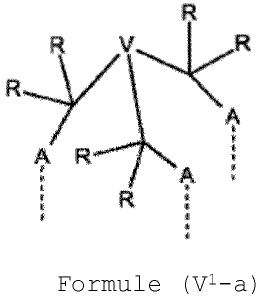 dans laquelle R et A ont les significations données dans les revendications 1 et 4, et V représente CR, N, SiR, P ou P=O.

9. Composé selon l'une ou plusieurs des revendications 1 à 8, **caractérisé en ce que** V² est choisi dans le groupe consistant en CR₂, NR, O, S, Se, -CR₂-CR₂- , -CR₂-O-, -CR=CR- ou un groupe arylène ou hétéroarylène attaché en position ortho, ayant 5 ou 6 atomes nucléaires aromatiques, qui peuvent être substitués par un ou plusieurs radicaux R.

10. Composé selon l'une ou plusieurs des revendications 1 à 9, **caractérisé en ce que** l'un des ligands partiels L¹, ou les deux, et/ou le ligand partiel L², identiques ou différents à chaque occurrence, sont choisis parmi les structures de formules (L-1), (L-2) ou (L-3), 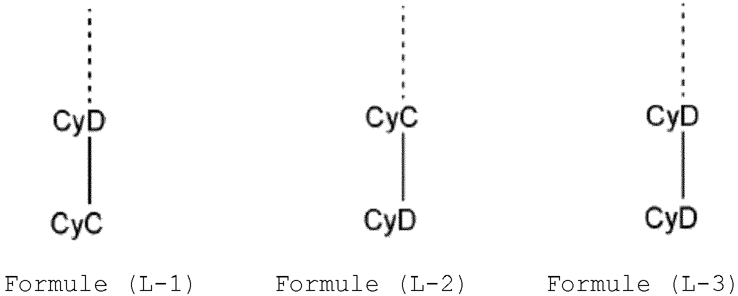 dans lesquelles la liaison en tirets représente la liaison du ligand partiel L¹ à V¹ ou la liaison des ligands partiels L² à V², et, pour les autres symboles :
CyC à chaque occurrence, est identique ou différent et représente un groupe aryle ou hétéroaryle substitué ou non substitué ayant 5 à 14 atomes nucléaires aromatiques, qui par l'intermédiaire d'un atome de carbone est coordonné à M et qui est relié à CyD par l'intermédiaire d'une liaison covalente ;
CyD à chaque occurrence, est identique ou différent et représente un groupe hétéroaryle substitué ou non substitué ayant 5 à 14 atomes nucléaires aromatiques qui, par l'intermédiaire d'un atome d'azote ou par l'intermédiaire d'un atome de carbone de carbène, sont coordonné à M, et qui par l'intermédiaire d'une liaison covalente sont reliés à CyC ;
plusieurs des substituants éventuels pouvant alors former les uns avec les autres un système cyclique.

11. Composé selon l'une ou plusieurs des revendications 1 à 10, **caractérisé en ce qu'**un ou plusieurs des ligands partiels L¹ et/ou L² sont, à chaque occurrence, identiques ou différents et présentent une structure de formule (L-1-1), (L-1-2) ou (L-2-1) à (L-2-3), 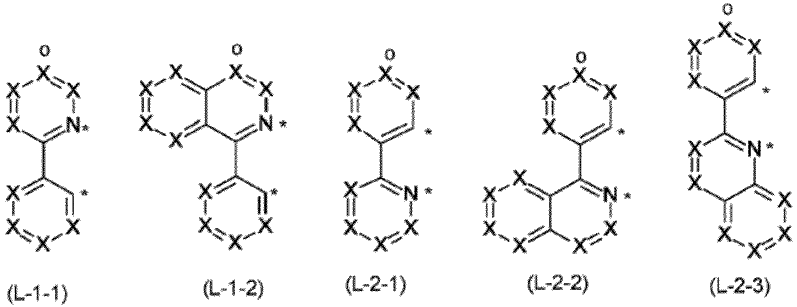 dans lesquelles les symboles ont les significations données dans la revendication 1, * indique la position de la coordination à Ir ou à Pt, et « o » représente la position de la liaison à V¹, dans le cas dans lequel les structures sont un mode de réalisation de L¹ ; dans le cas dans lequel les structures sont un mode de réalisation de L², V² est attaché sur une position ortho pour coordination à Pt, le symbole X auquel V¹ et V² sont liés représentant alors C.

12. Procédé de préparation d'un composé selon l'une ou plusieurs des revendications 1 à 11, **caractérisé par** les étapes suivantes :
a) synthèse d'un ligand hexadenté, qui ne contient pas encore le groupe L²-V² ;
b) synthèse d'un complexe d'Ir à partir des ligands hexadentés ;
c) fonctionnalisation du complexe d'Ir ;
d) introduction du groupe L²-V² par une réaction de couplage ; et
e) synthèse du complexe de Pt.

13. Formulation contenant au moins un composé selon l'une ou plusieurs des revendications 1 à 11 et au moins un autre composé, en particulier au moins un solvant ou un matériau de matrice.

14. Utilisation d'un composé selon l'une ou plusieurs des revendications 1 à 11 dans un dispositif électronique ou en tant que sensibilisateur à l'oxygène ou en tant que photocatalyseur.

15. Dispositif électronique contenant au moins un composé selon l'une ou plusieurs des revendications 1 à 11.

16. Dispositif électronique selon la revendication 15, dans lequel il s'agit d'un dispositif électroluminescent organique, **caractérisé en ce que** le composé est utilisé en tant que composé émetteur dans une ou plusieurs couches émettrices.
